# EUROPEAN PATENT APPLICATION

(11) **EP 4 236 659 A1**
(43) Date of publication of application: **30.08.2023**
(21) Application number: 23157903.8
(22) Date of filing: 22.02.2023
(51) Int. Cl.: H10K 85/30, H10K 85/60, H10K 85/40

(54) **LIGHT-EMITTING DEVICE, ELECTRONIC APPARATUS INCLUDING THE LIGHTEMITTING DEVICE, AND MIXTURE**

(30) Priority: 25.02.2022 KR 20220025500
(71) Applicant: Samsung Electronics Co., Ltd., Suwon-si, Gyeonggi-do 16677 (KR)
(72) Inventor: LEE, Yong Joo, 16678 Suwon-si (KR); KWON, Ohyun, 16678 Suwon-si (KR); LEE, Kum Hee, 16678 Suwon-si (KR); LEE, Sunghun, 16678 Suwon-si (KR); CHO, Hwayoung, 16678 Suwon-si (KR); CHOI, Byoungki, 16678 Suwon-si (KR); KOISHIKAWA, Yasushi, 16678 Suwon-si (KR); HONG, Youngki, 16678 Suwon-si (KR)
(74) Representative: Elkington and Fife LLP

(57) **Abstract**

Provided are a light-emitting device, an electronic apparatus including the light-emitting device, and a mixture, the light-emitting device including: a first electrode; a second electrode; and an interlayer arranged between the first electrode and the second electrode and including an emission layer, wherein the interlayer includes a first compound represented by Formula 1, a second compound that is free of an electron-transporting group, and a third compound represented by Formula 7, the second compound does not include an indolocarbazole group, and the second compound and the third compound are different from each other. In addition, provided is a mixture including the first compound, the second compound, and the third compound. The first compound, the second compound, and the third compound are respectively the same as those described in the present specification.

## Description

### FIELD OF THE INVENTION

The present disclosure relates to a light-emitting device, an electronic apparatus including the light-emitting device, and a mixture (also referred to as "a composition").

### BACKGROUND OF THE INVENTION

From among light-emitting devices, organic light-emitting devices are self-emissive devices, which have improved characteristics in terms of viewing angles, response time, luminance, driving voltage, and response speed, and produce full-color images.

In an example, an organic light-emitting device includes an anode, a cathode, and an interlayer arranged between the anode and the cathode, wherein the interlayer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state, thereby generating light.

### SUMMARY OF THE INVENTION

Provided are a light-emitting device having excellent luminescence efficiency and lifespan characteristics at the same time and an apparatus including the light-emitting device. In addition, provided is a mixture that may be used in manufacturing the light-emitting device.

Additional aspects will be set forth in part in the description which follows and, in part, will be apparent from the description, or may be learned by practice of the presented embodiments of the disclosure.

According to an aspect of an embodiment, a light-emitting device includes:
a first electrode;
a second electrode; and
an interlayer arranged between the first electrode and the second electrode and including an emission layer,
wherein the interlayer includes a first compound represented by Formula 1, a second compound that is free of an electron-transporting group, and a third compound represented by Formula 7,
the second compound does not include an indolocarbazole group, and
the second compound and the third compound are different from each other:

   Formula 1 M(L₁)ₙ₁(L₂)ₙ₂

   wherein, in Formula 1,
   M is a transition metal,
   L₁ is a ligand represented by Formula 2A,
   L₂ is a ligand represented by Formula 2B,
   n1 and n2 are each independently 1 or 2, wherein, when n1 is 2, two of L₁(s) are identical to or different from each other, and when n2 is 2, two of L₂(s) are identical to or different from each other,
   the sum of n1 and n2 is 2 or 3, and
   L₁ and L₂ are different from each other, 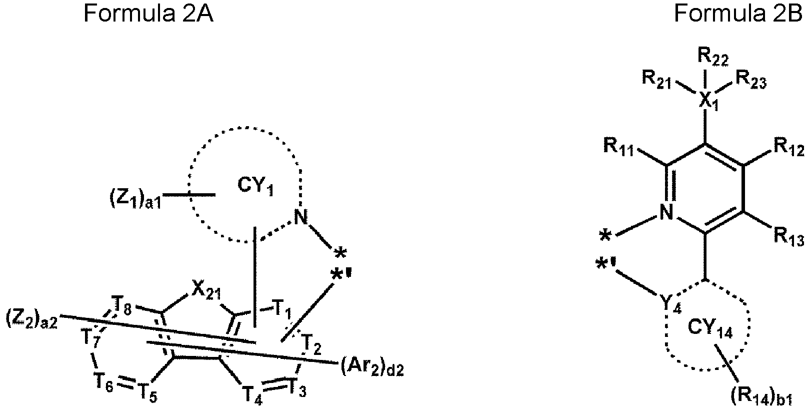 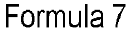 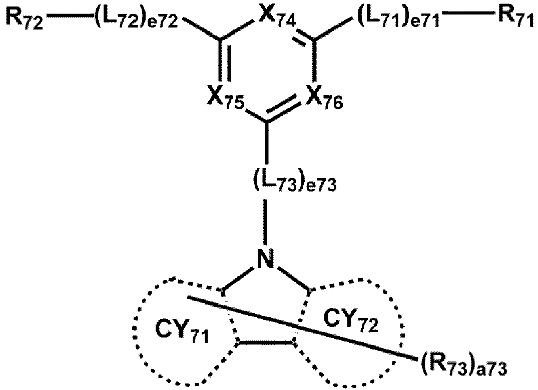
   in Formulae 2A, 2B, and 7,
   Y₄ is C or N,
   X₁ is Si or Ge,
   X₂₁ is O, S, S(=O), N(Z₂₉), C(Z₂₉)(Z₃₀), or Si(Z₂₉)(Z₃₀),
   T₁ to T₄ are each independently C, N, a carbon atom bonded to ring CY₁, or a carbon atom bonded to M in Formula 1, wherein one of T₁ to T₄ may be a carbon atom bonded to M in Formula 1, and one of the remaining T₁ to T₄ that are not bonded to M may be a carbon atom bonded to ring CY₁,
   T₅ to T₈ are each independently C or N,
   X₇₄ is C(R₇₄) or N, X₇₅ is C(R₇₅) or N, X₇₆ is C(R₇₆) or N, and at least one of X₇₄ to X₇₆ is N,
   ring CY₁ and ring CY₁₄ are each independently a C₅-C₃₀ carbocyclic group or a C₁-C₃₀ heterocyclic group,
   Ar₂ is ring CY₂ unsubstituted or substituted with at least one Z₀, wherein ring CY₂ is an unsaturated C₅-C₃₀ carbocyclic group or an unsaturated C₁-C₃₀ heterocyclic group,
   ring CY₇₁ and ring CY₇₂ are each independently a benzene group, a dibenzofuran group, a dibenzothiophene group, a carbazole group, or a fluorene group,
   L₇₁ to L₇₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
   R₂₁ to R₂₃ are each independently a C₁-C₆₀ alkyl group or a C₆-C₆₀ aryl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof,
   Z₀, Z₁, Z₂, Z₂₉, Z₃₀, R₁₁ to R₁₄, and R₇₁ to R₇₆ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
   d2 and e71 to e73 are each independently an integer from 1 to 6, wherein, when d2 is 2 or more, two or more of Ar₂(s) are identical to or different from each other, when e71 is 2 or more, two or more of L₇₁(s) are identical to or different from each other, when e72 is 2 or more, two or more of L₇₂(s) are identical to or different from each other, and when e73 is 2 or more, two or more of L₇₃(s) are identical to or different from each other,
   a1 and b1 are each independently be an integer from 0 to 20, wherein, when a1 is 2 or more, two or more of Z₁(s) are identical to or different from each other, and when b1 is 2 or more, two or more of R₁₄(s) are identical to or different from each other,
   a2 is an integer from 0 to 5, wherein, when a2 is 2 or more, two or more of Z₂(s) are identical to or different from each other,
   a73 may be an integer from 0 to 8, wherein, when a73 is 2 or more, two or more of R₇₃(s) are identical to or different from each other,
   each of: i) two or more of R₂₁ to R₂₃; ii) two or more of a plurality of Z₁(s); iii) two or more of a plurality of Z₂(s); iv) R₁₂ and R₁₃; v) two or more of a plurality of R₁₄(s); and vi) two or more of Z₀, Z₁, Z₂, Z₂₉, Z₃₀, and R₁₁ to R₁₄ may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ,
   R₁₀ₐ is the same as described in connection with R₁₄,
   * and *' in Formulae 2A and 2B each indicate a binding site to M in Formula 1,
   at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
      deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
   a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q28)(Q29), or any combination thereof;
      -N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
      any combination thereof, and
      Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group;
   a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₂-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

According to an aspect of another embodiment, an electronic apparatus includes the light-emitting device.

According to an aspect of another embodiment, a mixture includes:
i) a third compound represented by Formula 7; and
ii) at least one of a first compound represented by Formula 1 and a second compound that is free of an electron-transporting group.

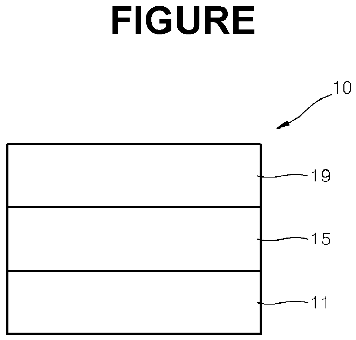

### BRIEF DESCRIPTION OF THE DRAWING

The above and other aspects, features, and advantages of certain embodiments of the disclosure will be more apparent from the following description taken in conjunction with FIGURE which shows a schematic cross-sectional view of a light-emitting device according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween. In contrast, when an element is referred to as being "directly on" another element, there are no intervening elements present

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

A light-emitting device according to an embodiment of the present disclosure may include: a first electrode; a second electrode; and an interlayer arranged between the first electrode and the second electrode and including an emission layer.

The interlayer may include a first compound represented by Formula 1, a second compound that is free of an electron-transporting group, and a third compound represented by Formula 7. In this regard, the second compound may not include an indolocarbazole group. In addition, the second compound and the third compound may be different from each other.

Formula 1 M(L₁)ₙ₁(L₂)ₙ₂

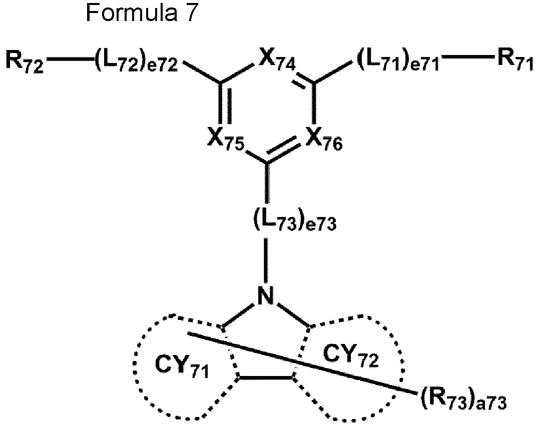

M in Formula 1 may be a transition metal.

For example, M may be a Period 1 transition metal, a Period 2 transition metal, or a Period 3 transition metal.

In one or more embodiments, M may be iridium (Ir), platinum (Pt), osmium (Os), titanium (Ti), zirconium (Zr), hafnium (Hf), europium (Eu), terbium (Tb), thulium (Tm), or rhodium (Rh).

In an embodiment, M may be Ir, Pt, Os, or Rh.

L₁ in Formula 1 may be a ligand represented by Formula 2A, and n1 in Formula 1 indicates the number of L₁(s) in Formula 1 and may be 1 or 2. When n1 is 2, two of L₁(s) may be identical to or different from each other.

L₂ in Formula 1 may be a ligand represented by Formula 2B, and n2 in Formula 1 indicates the number of L₂(s) in Formula 1 and may be 1 or 2. When n2 is 2, two of L₂(s) may be identical to or different from each other.

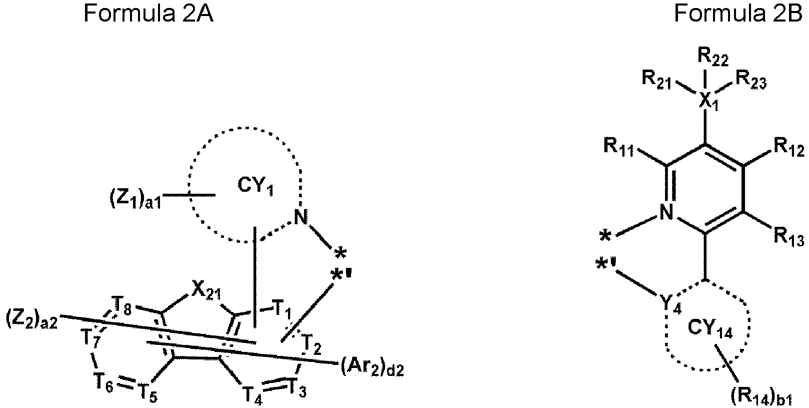

Formulae 2A and 2B will be described in detail later.

The sum of n1 and n2 in Formula 1 may be 2 or 3.

L₁ and L₂ in Formula 1 may be different from each other. That is, the first compound represented by Formula 1 may be a heteroleptic complex.

In an embodiment, M may be Ir, and the sum of n1 and n2 may be 3; or M may be Pt, and the sum of n1 and n2 may be 2.

In one or more embodiments, M may be Ir, and i) n1 may be 1 and n2 may be 2; or ii) n1 may be 2 and n2 may be 1.

Y₄ in Formula 2B may be C or N.

For example, Y₄ in Formula 2B may be C.

X₁ in Formula 2B may be Si or Ge.

In an embodiment, X₁ in Formula 2B may be Si.

In one or more embodiments, in Formula 2B, X₁ may be Si, and R₁₂ may not be hydrogen, or R₁₂ may not be hydrogen or a methyl group.

In one or more embodiments, in Formula 2B, X₁ may be Si, and R₁₂ may be - CD₃, -CD₂H, or -CDH₂.

In one or more embodiments, in Formula 2B, X₁ may be Si, and the number of carbon atoms included in R₁₂ may be 2 or more.

In one or more embodiments, X₁ in Formula 2B may be Ge.

In one or more embodiments, in Formula 2B, X₁ may be Ge, and R₁₂ may not be hydrogen, or R₁₂ may not be hydrogen or a methyl group.

In one or more embodiments, in Formula 2B, X₁ may be Ge, and R₁₂ may be - CD₃, -CD₂H, or -CDH₂.

In one or more embodiments, in Formula 2B, X₁ may be Ge, and the number of carbon atoms included in R₁₂ may be 2 or more.

X₂₁ in Formula 2A may be O, S, S(=O), N(Z₂₉), C(Z₂₉)(Z₃₀), or Si(Z₂₉)(Z₃₀). Z₂₉ and Z₃₀ are respectively the same as those described herein.

For example, X₂₁ in Formula 2A may be O or S.

In Formula 2A, T₁ to T₄ may each independently be C, N, a carbon atom bonded to ring CY₁, or a carbon atom bonded to M in Formula 1, one of T₁ to T₄ may be a carbon atom bonded to M in Formula 1, one of the remaining T₁ to T₄ that are not bonded to M may be a carbon atom bonded to ring CY₁, and T₅ to T₈ may each independently be C or N.

In an embodiment, the number of N(s) among T₁ to T₈ in Formula 2A may be 0, 1, 2, or 3.

In one or more embodiments, the number of N(s) among T₁ to T₈ in Formula 2A may be 0.

In one or more embodiments, T₈ in Formula 2A may be N.

Ring CY₁ and ring CY₁₄ in Formulae 2A and 2B may each independently be a C₅-C₃₀ carbocyclic group or a C₁-C₃₀ heterocyclic group, Ar₂ in Formula 2A may be ring CY₂ unsubstituted or substituted with at least one Z₀, and ring CY₂ may be an unsaturated C₅-C₃₀ carbocyclic group or an unsaturated C₁-C₃₀ heterocyclic group. Z₀ is the same as Z₀ described herein.

In an embodiment, ring CY₁ and ring CY₁₄ in Formulae 2A and 2B may each independently be a cyclopentane group, a cyclohexane group, a cycloheptane group, a cyclopentene group, a cyclohexene group, a cycloheptene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a silole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, ring CY₁ and ring CY₁₄ may each independently be a benzene group, a naphthalene group, a 1 ,2,3,4-tetrahydronaphthalene group, a phenanthrene group, a pyridine group, a pyrimidine group, a pyrazine group, a triazine group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group.

In one or more embodiments, ring CY₁ in Formula 2A may be a pyridine group, a 5,6,7,8-tetrahydroisoquinoline group, or a 5,6,7,8-tetrahydroquinoline group.

In one or more embodiments, ring CY₁₄ in Formula 2B may be a benzene group, a naphthalene group, a 1,2,3,4-tetrahydronaphthalene group, a phenanthrene group, a dibenzothiophene group, a dibenzofuran group, or a pyridine group.

In one or more embodiments, ring CY₂ may be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a silole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

Ring CY₇₁ and ring CY₇₂ in Formula 7 may each independently be a benzene group, a dibenzofuran group, a dibenzothiophene group, a carbazole group, or a fluorene group.

In an embodiment, ring CY₇₁ may be a benzene group.

In one or more embodiments, ring CY₇₂ may be a benzene group or a carbazole group.

L₇₁ to L₇₃ in Formula 7 may each independently be a single bond, a C₅-C₃₀ carbocyclic group unsubstituted or substituted with at least one R₁₀ₐ, or a C₁-C₃₀ heterocyclic group unsubstituted or substituted with at least one R₁₀ₐ.

For example, L₇₁ to L₇₃ may each independently be:
a single bond; or
a benzene group, a naphthalene group, a dibenzofuran group, or a dibenzothiophene group, each unsubstituted or substituted with at least one R₁₀ₐ.

R₂₁ to R₂₃ in Formula 2B may each independently be a C₁-C₆₀ alkyl group or a C₆-C₆₀ aryl group, each unsubstituted or substituted with deuterium, -F, -Cl, -Br, -I, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof.

For example, R₂₁ to R₂₃ in Formula 2B may each independently be a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, a phenyl group, a biphenyl group, or a naphthyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof.

In an embodiment, R₂₁ to R₂₃ in Formula 2B may each independently be -CH₃, -CH₂CH₃, -CD₃, -CD₂H, -CDH₂, -CH₂CD₃, or -CD₂CH₃.

In one or more embodiments, R₂₁ to R₂₃ in Formula 2B may be identical to each other.

In one or more embodiments, two or more of R₂₁ to R₂₃ in Formula 2B may be different from each other.

Z₀, Z₁, Z₂, Z₂₉, Z₃₀, R₁₁ to R₁₄, and R₇₁ to R₇₆ in Formulae 2A, 2B, and 7 may each independently be hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉). Q₁ to Q₉ are respectively the same as those described herein.

d2 and e71 to e73 in Formulae 2A and 7 indicate the numbers of Ar₂(s) and L₇₁(s) to L₇₃(s), respectively, and may each independently be an integer from 1 to 6. When d2 is 2 or more, two or more of Ar₂(s) may be identical to or different from each other, when e71 is 2 or more, two or more of L₇₁(s) may be identical to or different from each other, when e72 is 2 or more, two or more of L₇₂(s) may be identical to or different from each other, and when e73 is 2 or more, two or more of L₇₃(s) may be identical to or different from each other. For example, d2 and e71 to e73 may each independently be 1, 2, or 3. In an embodiment, d2 and e71 to e73 may each independently be 1 or 2.

a1 and b1 in Formulae 2A and 2B indicate the numbers of Z₁(s) and R₁₄(s), respectively, and may each independently be an integer from 0 to 20. When a1 is 2 or more, two or more of Z₁(s) may be identical to or different from each other, and when b1 is 2 or more, two or more of R₁₄(s) may be identical to or different from each other. For example, a1 and b1 may each independently be an integer from 0 to 10.

a2 in Formula 2A indicates the number of Z₂(s), and may be an integer from 0 to 5. When a2 is 2 or more, two or more of Z₂(s) may be identical to or different from each other. For example, a2 may be 0, 1, 2, or 3.

a73 in Formula 7 indicates the number of R₇₃(s), and may be an integer from 0 to 8. When a73 is 2 or more, two or more of R₇₃(s) may be identical to or different from each other. For example, a73 may be 0, 1, or 2.

In an embodiment, Z₁ in Formula 2A and R₁₁ to R₁₃ in Formula 2B may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof; or
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In one or more embodiments, Z₁ in Formula 2A and R₁₁ to R₁₃ in Formula 2B may each independently be:
hydrogen or deuterium;
a C₁-C₂₀ alkyl group unsubstituted or substituted with deuterium, a C₃-C₁₀ cycloalkyl group, a deuterated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, or any combination thereof; or
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a C₁-C₂₀ alkoxy group, a deuterated C₁-C₂₀ alkoxy group, a C₃-C₁₀ cycloalkyl group, a deuterated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a (C₁-C₂₀ alkyl)C₁-C₁₀ heterocycloalkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, or any combination thereof.

In one or more embodiments, Z₀ and Z₂ in Formula 2A and R₁₄ in Formula 2B may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof;
a C₃-C₁₀ cycloalkyl group, a C₁-C₁₀ heterocycloalkyl group, a phenyl group, or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof; or
-Si(Q₃)(Q₄)(Q₅) or -Ge(Q₃)(Q₄)(Q₅).

In one or more embodiments, R₁₂ in Formula 2B may be hydrogen or a methyl group.

In one or more embodiments, R₁₂ in Formula 2B may be a deuterated methyl group (for example, -CD₃, -CD₂H, or -CDH₂).

In one or more embodiments, the number of carbon atoms included in R₁₂ in Formula 2B may be 2 or more.

In one or more embodiments, R₁₂ in Formula 2B may be:
a C₂-C₂₀ alkyl group or a C₂-C₂₀ alkoxy group;
a methyl group or a methoxy group, each substituted with a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₁₄ aryl group, a C₁-C₁₄ heteroaryl group, a monovalent non-aromatic condensed polycyclic group, a monovalent non-aromatic condensed heteropolycyclic group, or any combination thereof;
a C₂-C₂₀ alkyl group or a C₂-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₁₄ aryl group, a C₁-C₁₄ heteroaryl group, a monovalent non-aromatic condensed polycyclic group, a monovalent non-aromatic condensed heteropolycyclic group, or any combination thereof; or
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₁₄ aryl group, a C₁-C₁₄ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₁₄ aryl group, a C₁-C₁₄ heteroaryl group, a monovalent non-aromatic condensed polycyclic group, a monovalent non-aromatic condensed heteropolycyclic group, or any combination thereof.

In one or more embodiments, R₁₂ in Formula 2B may be:
a methyl group or a methoxy group, each substituted with a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a naphthyl group, a pyridinyl group, a pyrimidinyl group, or any combination thereof;
a methyl group or a methoxy group, each substituted with i) a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a naphthyl group, a pyridinyl group, a pyrimidinyl group, or any combination thereof, and ii) at least one deuterium atom;
a C₂-C₂₀ alkyl group or a C₂-C₂₀ alkoxy group, each unsubstituted or substituted with deuterium, -F, -Cl, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a naphthyl group, a pyridinyl group, a pyrimidinyl group, or any combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof.

In one or more embodiments, R₇₁ to R₇₃ in Formula 7 may each independently be:
hydrogen, deuterium, -F, or a cyano group;
a C₁-C₂₀ alkyl group unsubstituted or substituted with deuterium, -F, a cyano group, or any combination thereof; or
a phenyl group, a biphenyl group, a dibenzofuranyl group, or a dibenzothiophenyl group, each unsubstituted or substituted with deuterium, - F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In one or more embodiments, Z₀, Z₁, Z₂, Z₂₉, Z₃₀, R₁₁ to R₁₄, and R₇₁ to R₇₆ in Formulae 2A, 2B, and 7 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SFs, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with deuterium, -F, -Cl, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a (phenyl)C₁-C₁₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), - P(=O)(Q₈)(Q₉), or -P(Q₈)(Q₉), and
Q₁ to Q₉ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In one or more embodiments, Z₁ in Formula 2A may not include Si.

In one or more embodiments, Z₁ in Formula 2A may not be a group represented by -Si(Q₃)(Q₄)(Q₅).

In one or more embodiments, R₂₁ to R₂₃, Z₁, Z₂, and R₁₁ to R₁₄ in Formulae 2A and 2B may each not include silicon (Si). As a result, an electronic device, such as an organic light-emitting device, including the first compound represented by Formula 1 may have improved out-coupling characteristics.

In one or more embodiments, the first compound represented by Formula 1 may satisfy at least one of Conditions A to C:
Condition A: in Formula 2A, Z₁ is not hydrogen, and a1 is not 0.
Condition B: in Formula 2A, Z₂ is not hydrogen, and a2 is not 0.
Condition C: in Formula 2B, R₁₄ is not hydrogen, and b1 is not 0.

In one or more embodiments, the first compound represented by Formula 1 may include at least one deuterium atom, at least one fluoro group (-F), at least one cyano group (-CN), or any combination thereof.

In one or more embodiments, the first compound represented by Formula 1 may include at least one deuterium atom.

In one or more embodiments, the first compound represented by Formula 1 may satisfy at least one of Conditions (1) to (6), or Condition (7):
Condition (1): in Formula 2A, a1 is not 0, and at least one of Z₁(s) in the number of a1 includes deuterium.
Condition (2): in Formula 2A, a2 is not 0, and at least one of Z₂(s) in the number of a2 includes deuterium, a fluoro group (-F), a cyano group, or any combination thereof.
Condition (3): at least one of Ar₂(s) in the number of d2 in Formula 2A includes deuterium, a fluoro group (-F), a cyano group, or any combination thereof.
Condition (4): at least one of R₂₁ to R₂₃ in Formula 2B includes deuterium.
Condition (5): R₁₂ in Formula 2B includes at least one deuterium atom.
Condition (6): in Formula 2B, b1 is not 0, and at least one of R₁₄(s) in the number of b1 includes deuterium, a fluoro group (-F), a cyano group, or any combination thereof.
Condition (7): Z₁, Z₂, and Ar₂ in Formula 2A and R₁₁ to R₁₄ and R₂₁ to R₂₃ in Formula 2B each consist of only carbon and hydrogen.

In one or more embodiments, Z₀, Z₁, Z₂, Z₂₉, Z₃₀, R₁₁ to R₁₄, and R₇₁ to R₇₆ in Formulae 2A, 2B, and 7 may each independently be hydrogen, deuterium, -F, a cyano group, a nitro group, -SFs, -CH₃, -CD₃, -CD₂H, -CDH₂, -CF₃, -CF₂H, -CFH₂, -OCH₃, - OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, -Si(Q₃)(Q₄)(Q₅), or -Ge(Q₃)(Q₄)(Q₅) (wherein Q₃ to Q₅ are respectively the same as those described herein).

In one or more embodiments, Z₁ in Formula 2A and R₁₁ to R₁₃ in Formula 2B may each independently be hydrogen, deuterium, -CH₃, -CD₃, -CD₂H, -CDH₂, -OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-201 to 9-230, a group represented by one of Formulae 9-201 to 9-230 in which at least one hydrogen is substituted with deuterium, a group represented by one of Formulae 10-1 to 10-138 and 10-145, or a group represented by one of Formulae 10-1 to 10-138 and 10-145 in which at least one hydrogen is substituted with deuterium.

In one or more embodiments, Ar₂ in Formula 2A may be a group represented by one of Formulae 10-12 to 10-145, a group represented by one of Formulae 10-12 to 10-145 in which at least one hydrogen is substituted with deuterium, a group represented by one of Formulae 10-12 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F.

In one or more embodiments, R₁₂ in Formula 2B may be hydrogen, -CH₃, - CH₂D, -CHD₂, or -CD₃.

In one or more embodiments, R₁₂ in Formula 2B may be hydrogen or a methyl group (-CH₃).

In one or more embodiments, R₁₂ in Formula 2B may be -CH₂D, -CHD₂, or - CD₃.

In one or more embodiments, R₁₂ in Formula 2B may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F.

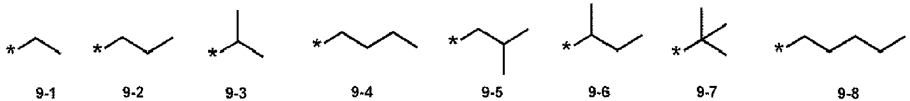

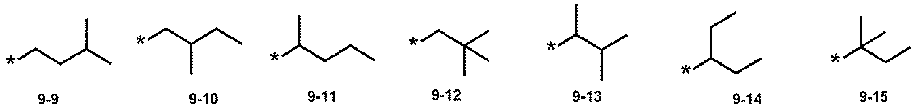

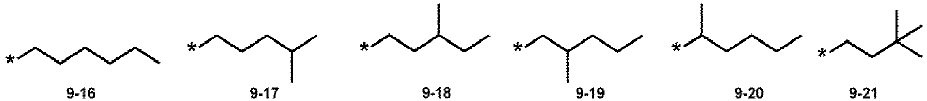

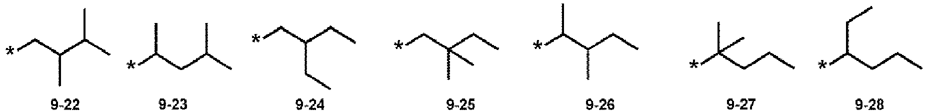

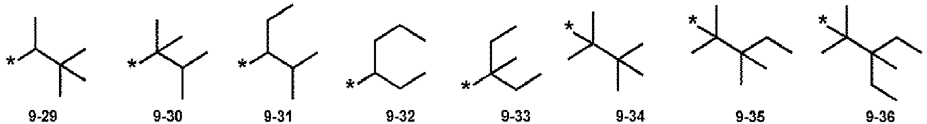

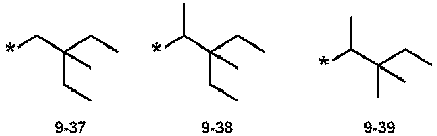

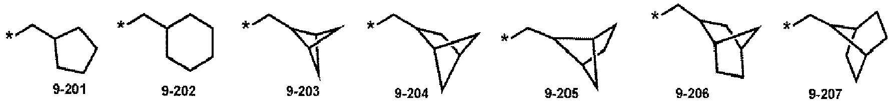

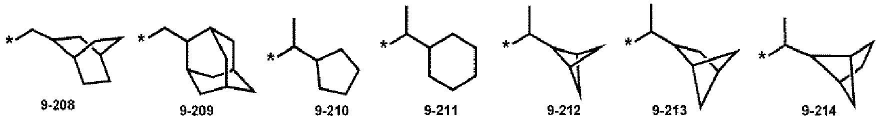

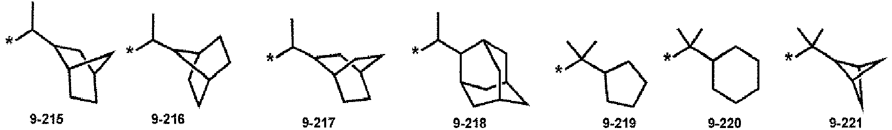

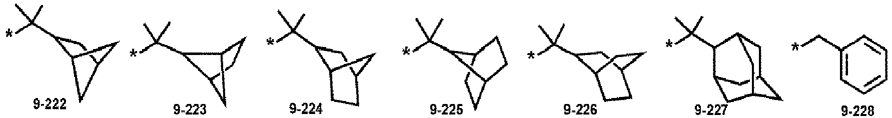

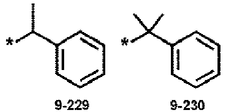

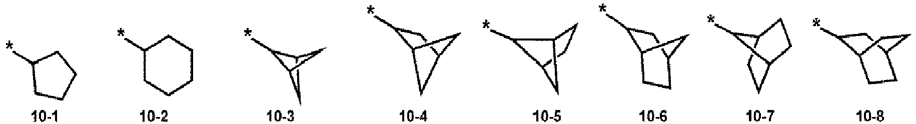

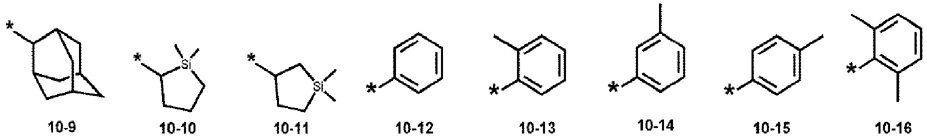

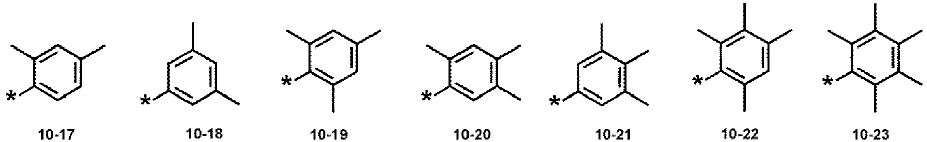

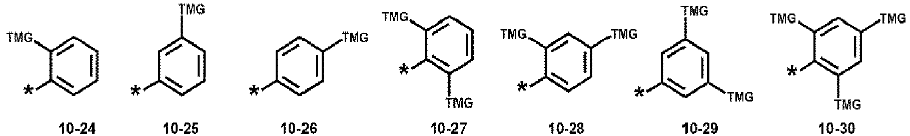

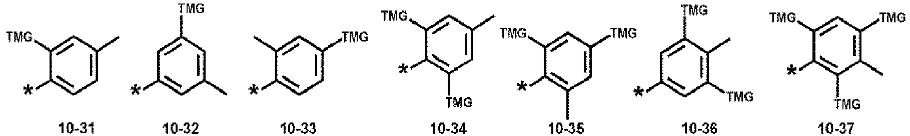

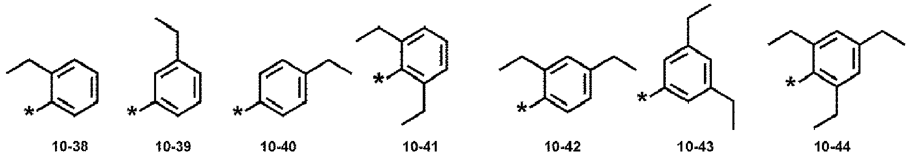

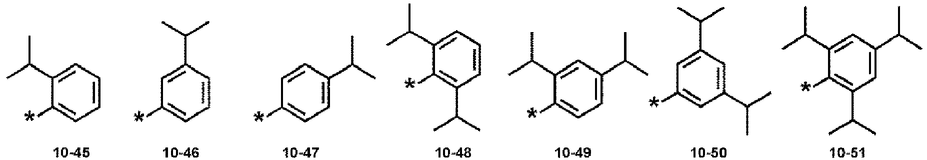

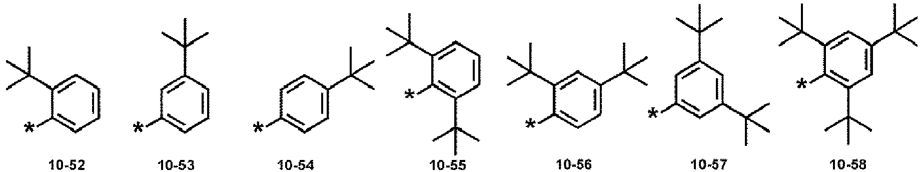

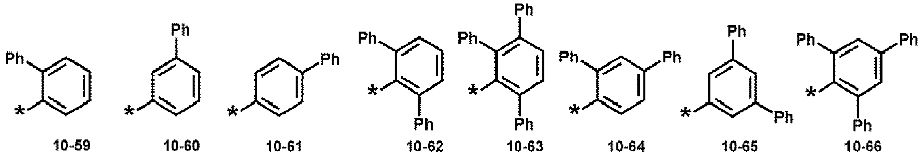

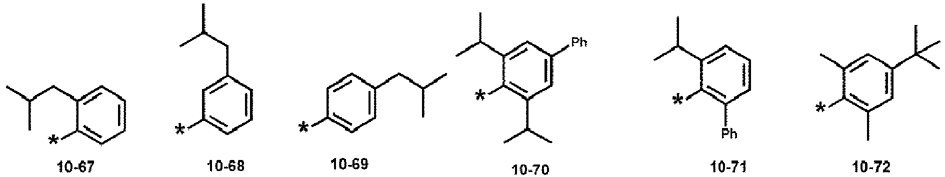

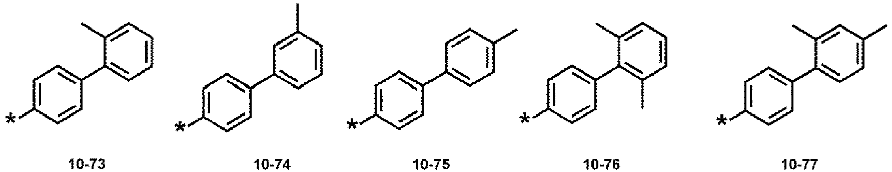

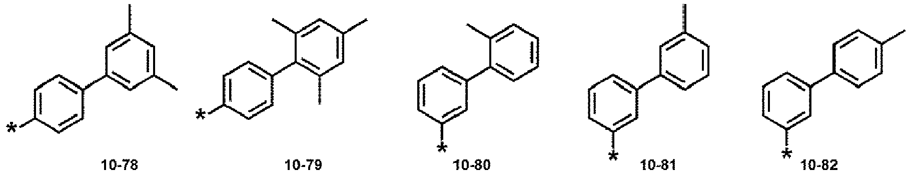

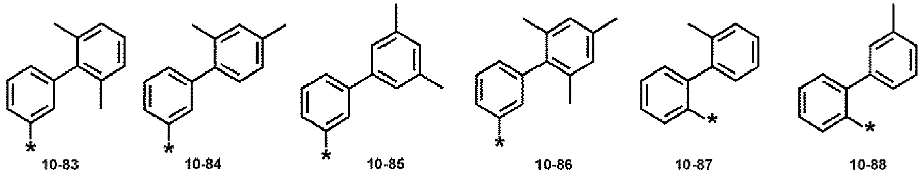

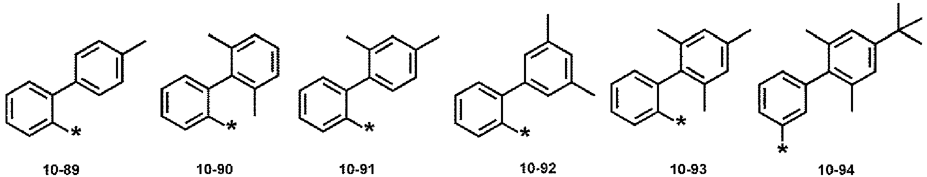

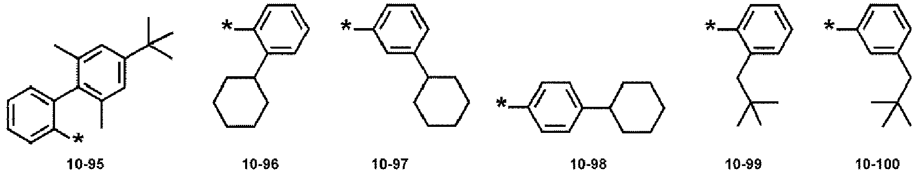

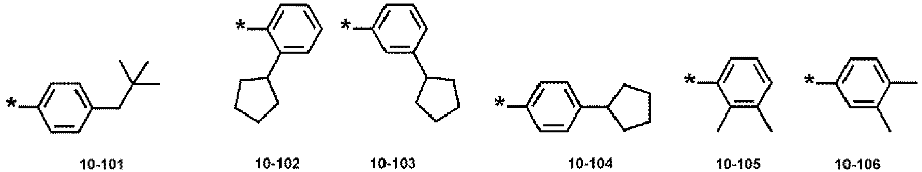

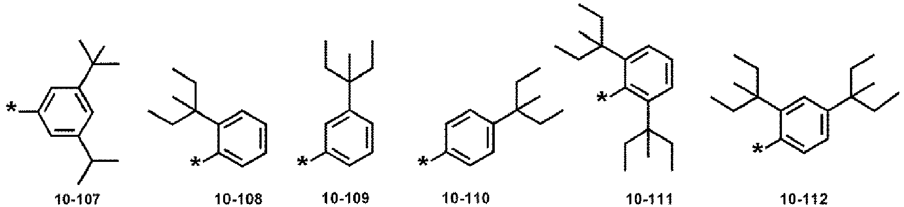

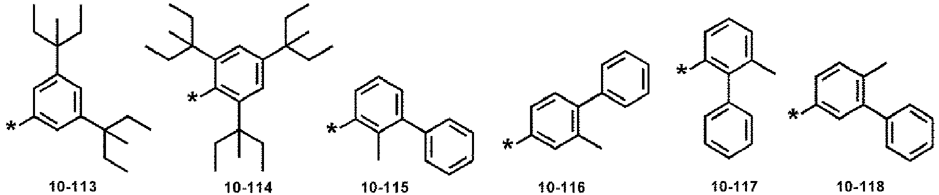

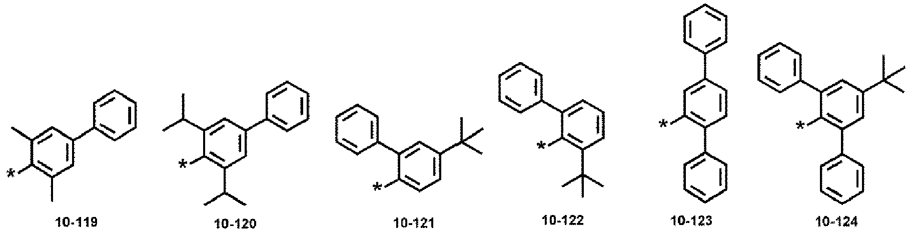

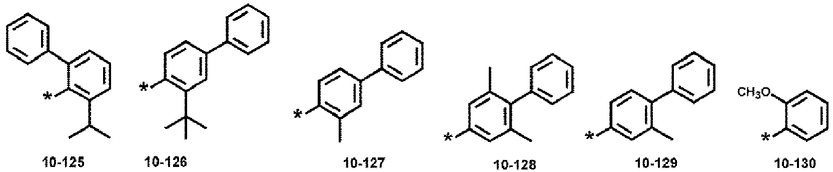

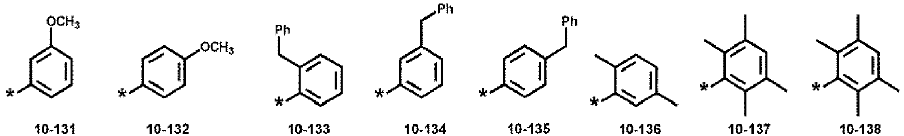

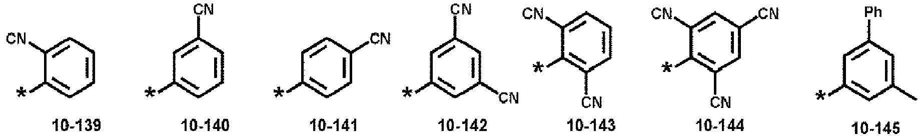

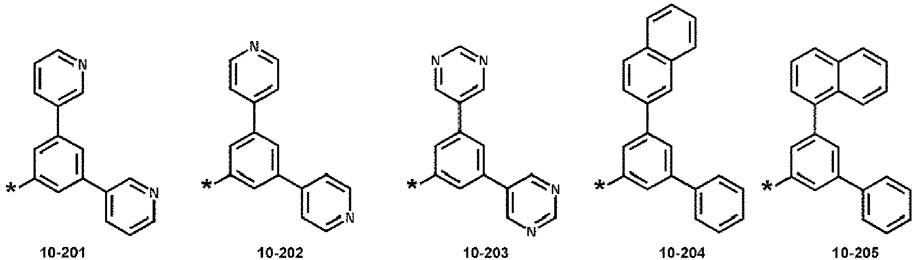

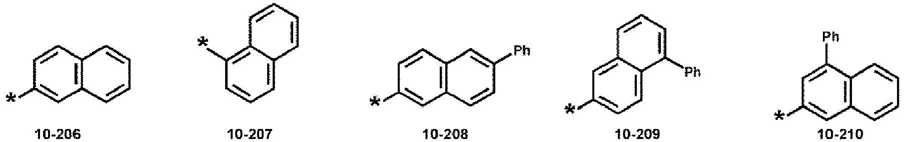

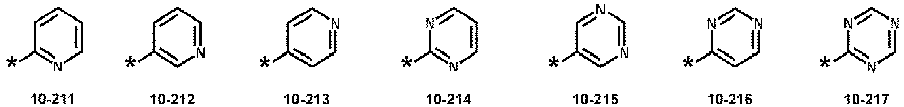

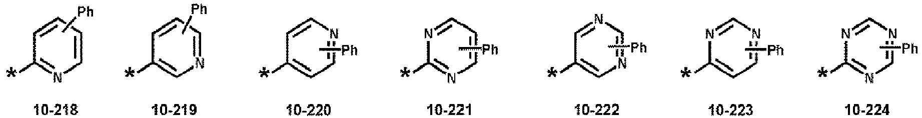

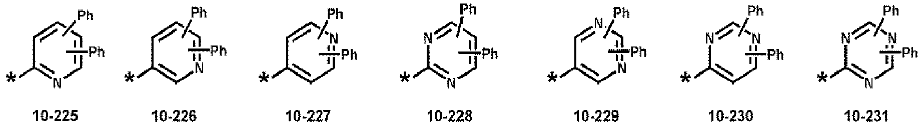

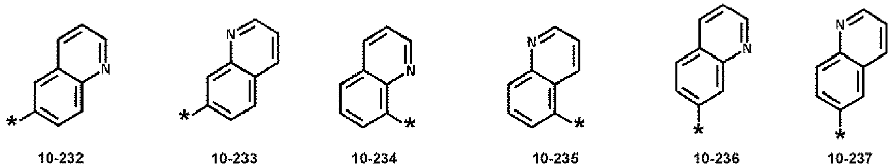

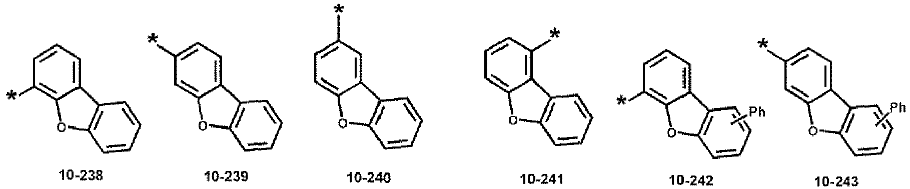

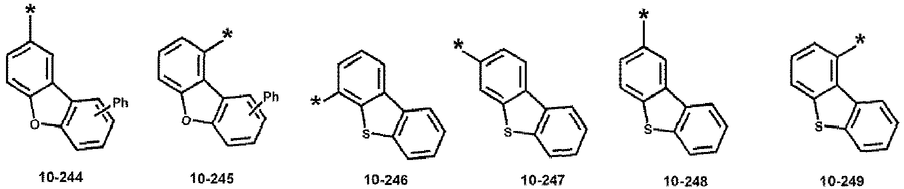

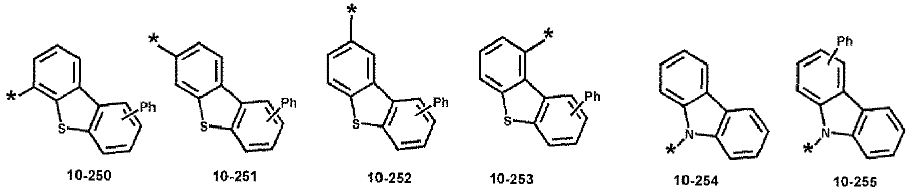

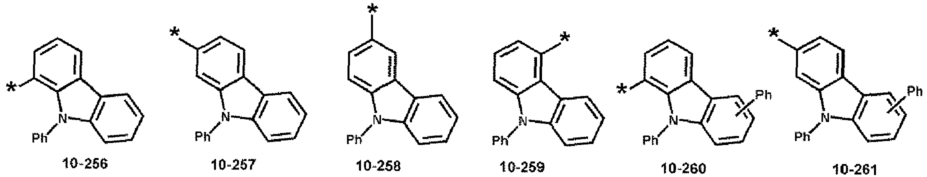

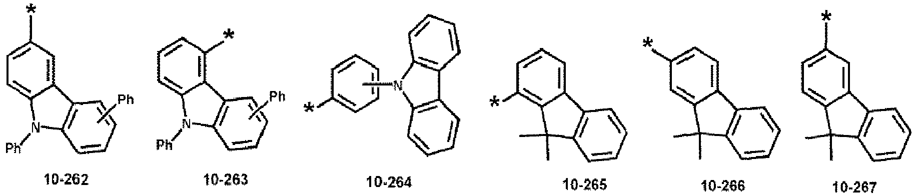

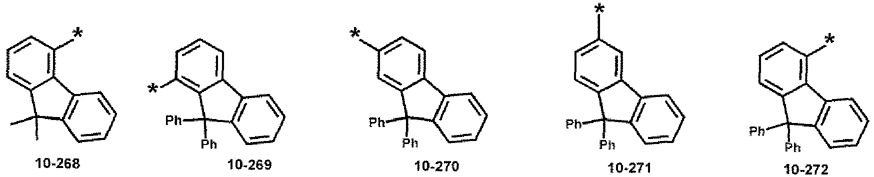

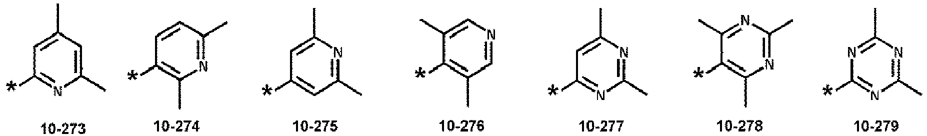

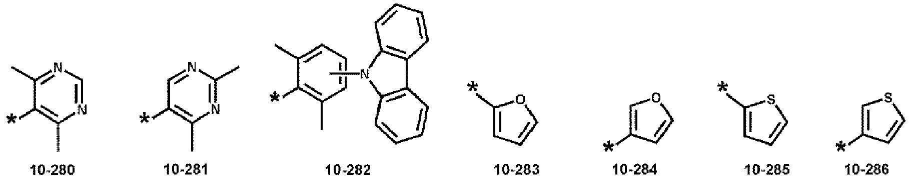

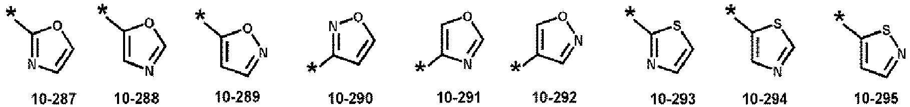

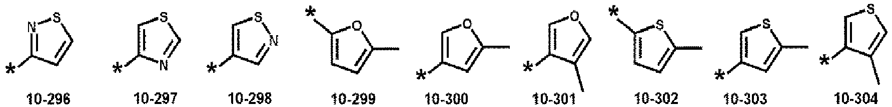

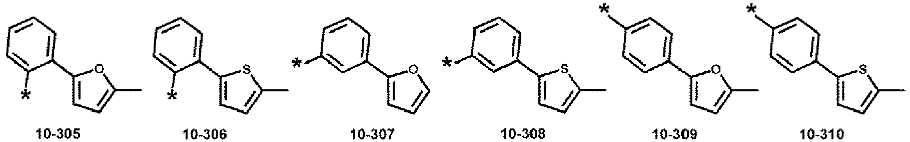

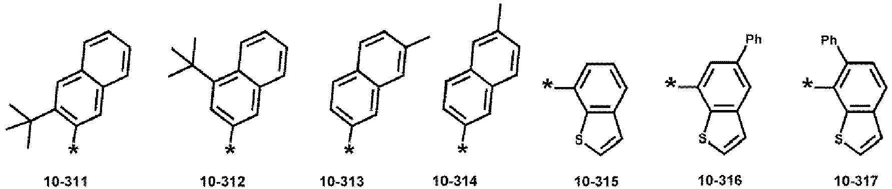

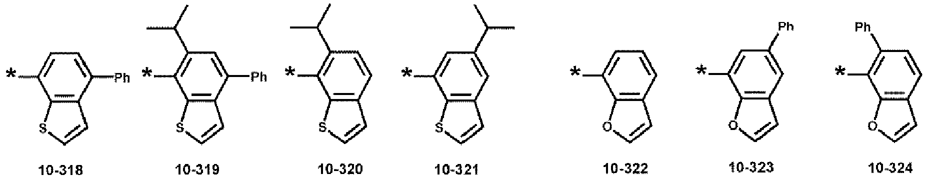

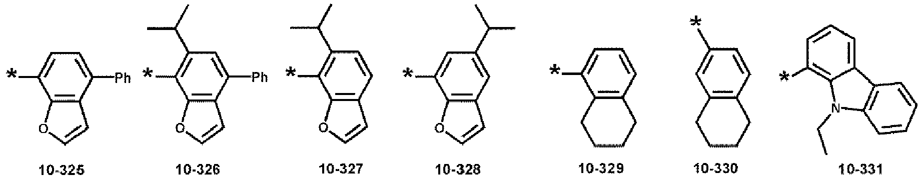

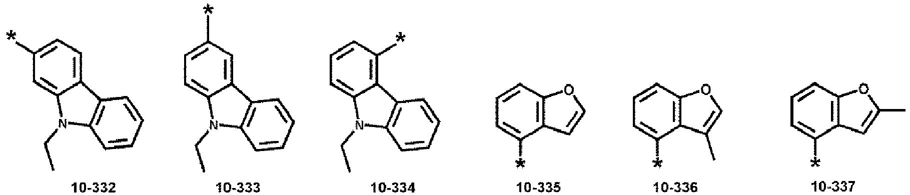

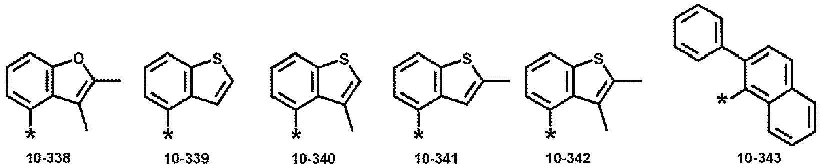

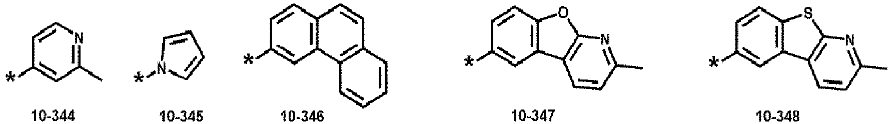

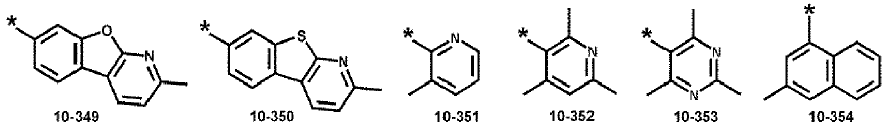

In Formulae 9-1 to 9-39, 9-201 to 9-230, 10-1 to 10-145, and 10-201 to 10-354, * indicates a binding site to a neighboring atom, Ph is a phenyl group, TMS is a trimethylsilyl group, TMG is a trimethylgermyl group, and OMe is a methoxy group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may be, for example, a group represented by one of Formulae 9-501 to 9-514 and 9-601 to 9-637:

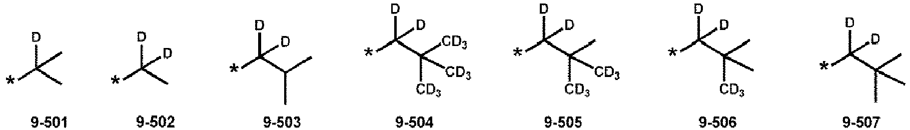

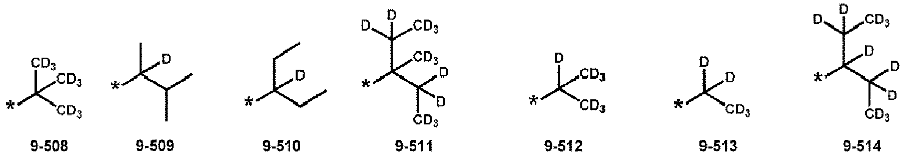

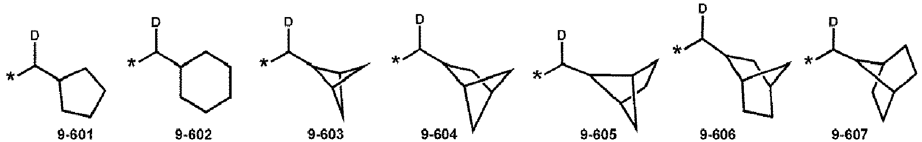

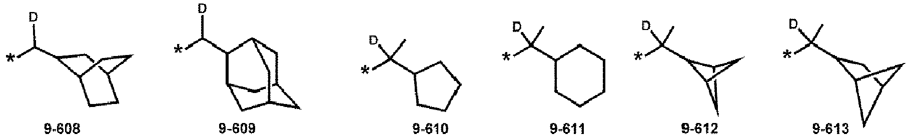

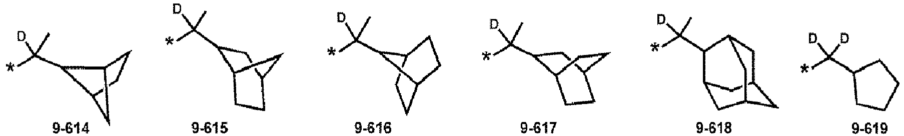

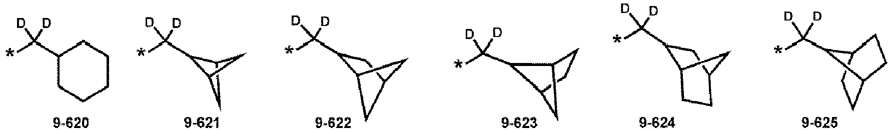

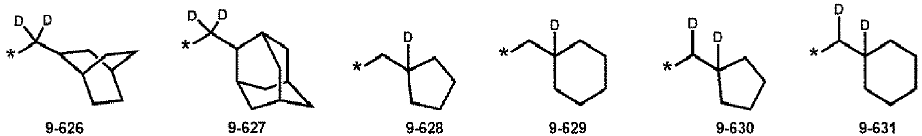

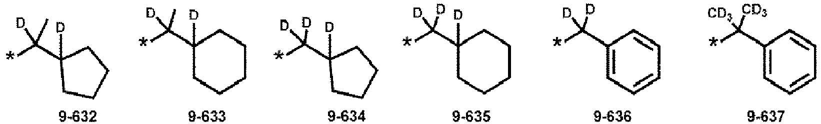

The "group represented by one of Formulae 9-1 to 9-39 in which at least one hydrogen is substituted with -F" and the "group represented by one of Formulae 9-201 to 9-230 in which at least one hydrogen is substituted with -F" may be, for example, a group represented by one of Formulae 9-701 to 9-710:

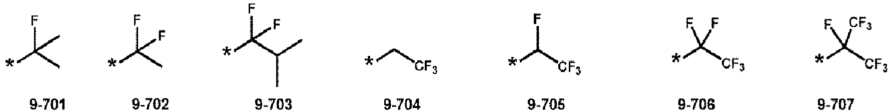

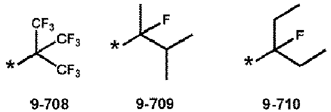

The "group represented by one of Formulae 10-1 to 10-145 in which at least one hydrogen is substituted with deuterium" and the "group represented by one of Formulae 10-201 to 10-354 in which at least one hydrogen is substituted with deuterium" may be, for example, a group represented by one of Formulae 10-501 to 10-553:

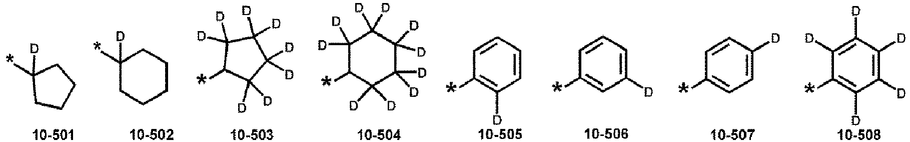

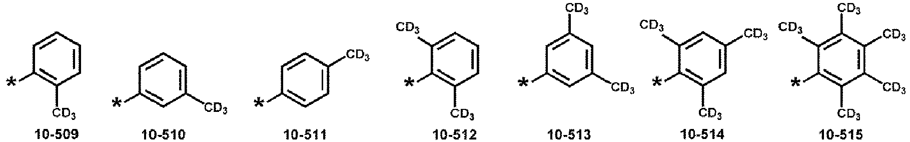

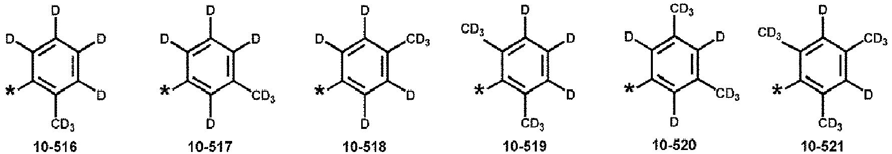

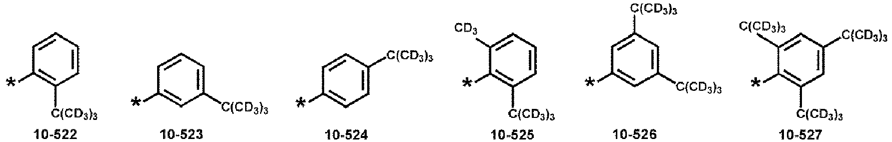

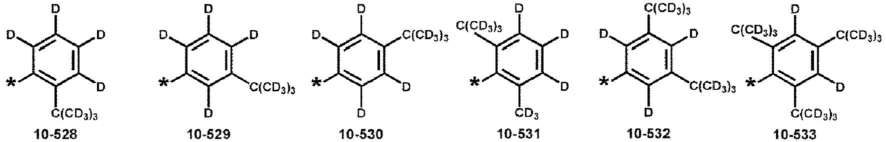

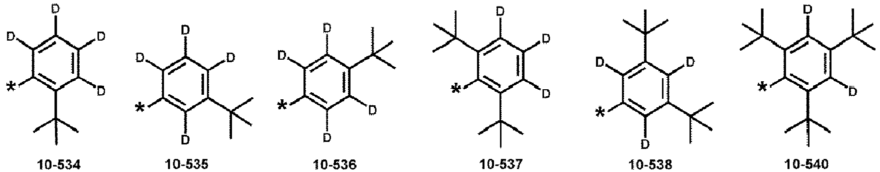

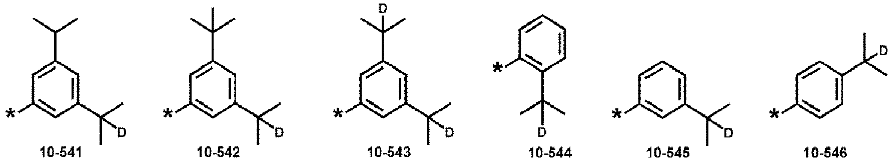

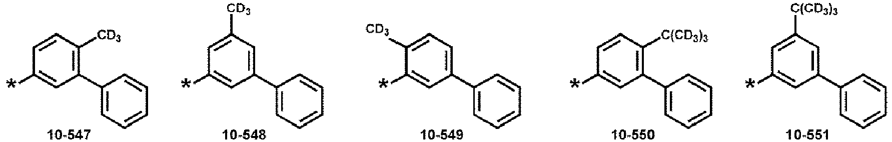

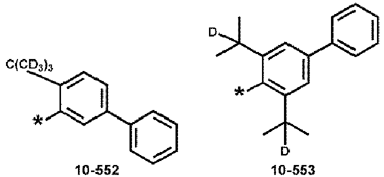

The "group represented by one of Formulae 10-1 to 10-145 in which at least one hydrogen is substituted with -F" and the "group represented by one of Formulae 10-201 to 10-354 in which at least one hydrogen is substituted with -F" may be, for example, a group represented by one of Formulae 10-601 to 10-636:

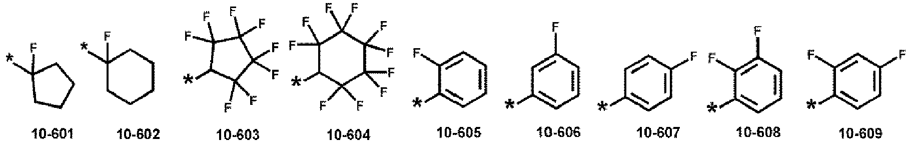

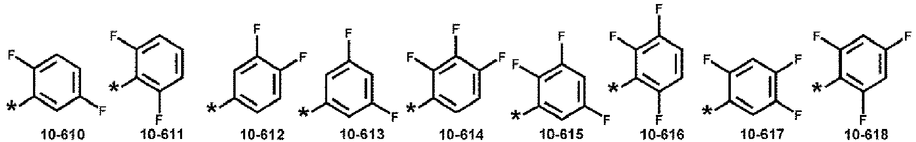

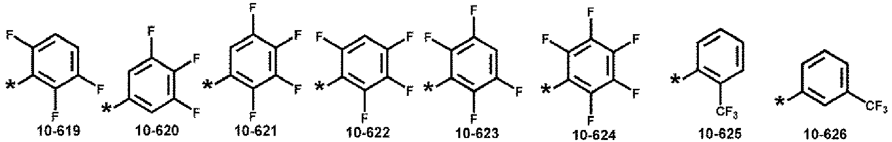

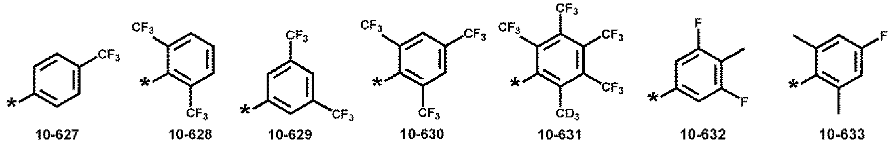

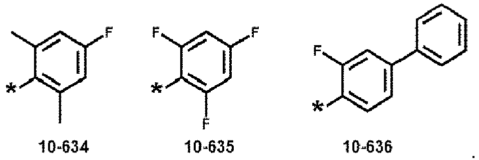

In Formulae 2A and 2B, each of: i) two or more of R₂₁ to R₂₃; ii) two or more of a plurality of Z₁(s); iii) two or more of a plurality of Z₂(s); iv) R₁₂ and R₁₃; v) two or more of a plurality of R₁₄(s); and vi) two or more of Z₀, Z₁, Z₂, Z₂₉, Z₃₀, and R₁₁ to R₁₄ may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ. That is, i) two or more of R₂₁ to R₂₃ may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ, ii) two or more of a plurality of Z₁(s) may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ, iii) two or more of a plurality of Z₂(s) may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ, iv) R₁₂ and R₁₃ may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ, v) two or more of a plurality of R₁₄(s) may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ, and vi) two or more of Z₀, Z₁, Z₂, Z₂₉, Z₃₀, and R₁₁ to R₁₄ may optionally be linked together to form a C₅-C₃₀ carbocyclic group unsubstituted or substituted with at least one R₁₀ₐ or a C₁-C₃₀ heterocyclic group unsubstituted or substituted with at least one R₁₀ₐ.

R₁₀ₐ is the same as described in connection with R₁₄.

* and *' in Formulae 2A and 2B each indicate a binding site to M in Formula 1.

In an embodiment, a group represented by 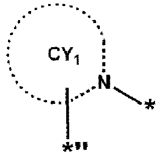 in Formula 2A may be a group represented by one of Formulae CY1(1) to CY1(16): 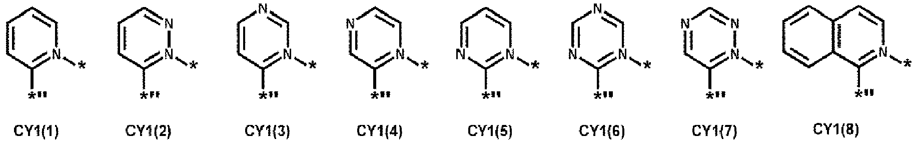 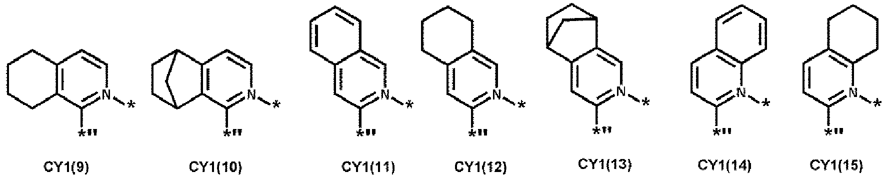 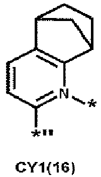 wherein, in Formulae CY₁ (1) to CY₁ (16),
* indicates a binding site to M in Formula 1, and
*" indicates a binding site to one of T₁ to T₄ in Formula 2A.

In one or more embodiments, a group represented by 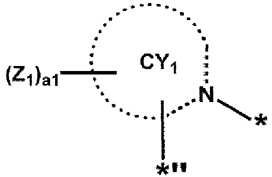 in Formula 2A may be a group represented by one of Formulae CY1-1 to CY1-28: 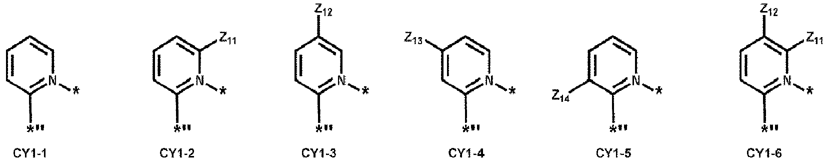 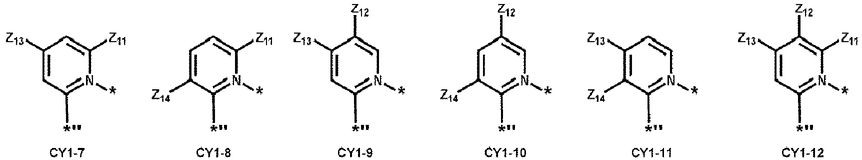 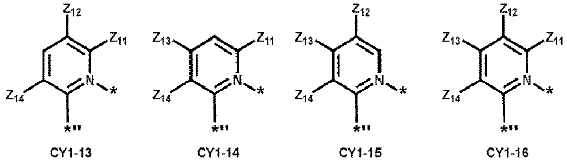 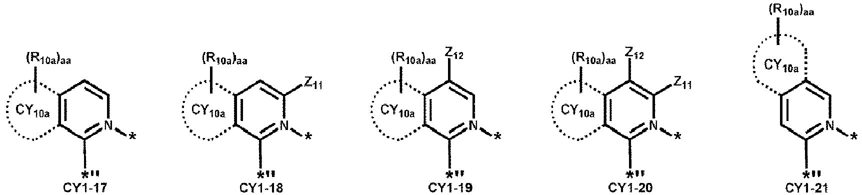 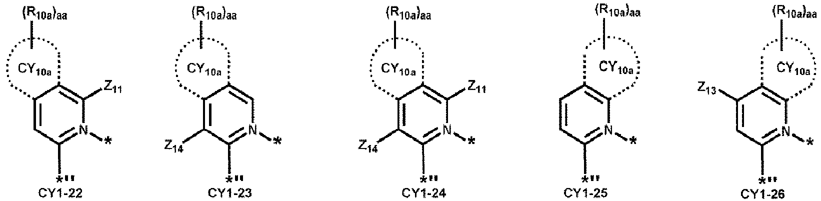 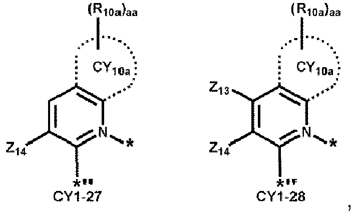 wherein, in Formulae CY1-1 to CY1-28,
Z₁₁ to Z₁₄ are each the same as described in connection with Z₁, wherein Z₁₁ to Z₁₄ may each not be hydrogen,
ring CY₁₀ₐ may be a C₅-C₃₀ carbocyclic group or a C₁-C₃₀ heterocyclic group,
R₁₀ₐ is the same as R₁₀ₐ described herein,
aa may be an integer from 0 to 10,
* indicates a binding site to M in Formula 1, and
*" indicates a binding site to one of T₁ to T₄ in Formula 2A.

For example, ring CY₁₀ₐ may be a cyclohexane group, a norbornane group, a benzene group, or a naphthalene group.

In one or more embodiments, a group represented by 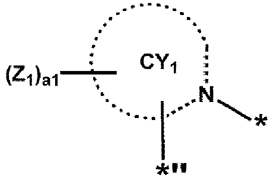 in Formula 2A may be a group represented by one of Formulae CY1-1, CY1-4, CY1-7, CY1-9, CY1-11, CY1-12, and CY1-14 to CY1-24.

In one or more embodiments, a group represented by 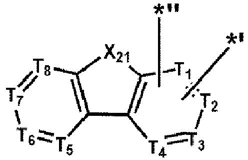 in Formula 2A may be a group represented by one of Formulae CY2-1 to CY2-6: 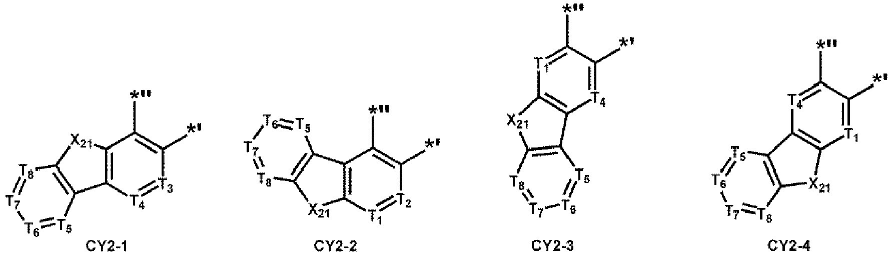 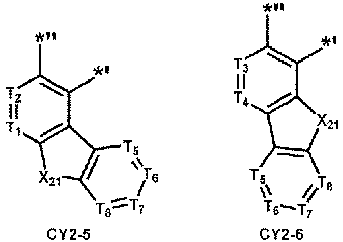 wherein, in Formulae CY2-1 to CY2-6,
T₁ to T₈ may each independently be C or N,
X₂₁ is the same as X₂₁ described herein,
*" indicates a binding site to ring CY₁ in Formula 2A, and
*' indicates a binding site to M in Formula 1.

For example, a group represented by 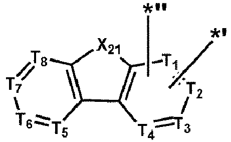 in Formula 2A may be a group represented by one of Formulae CY2-1 to CY2-6, and
a) R₁₂ in Formula 2B may not be hydrogen or a methyl group (for example, the number of carbon atoms included in R₁₂ may be 2 or more), and the number of N(s) among T₁ to T₈ in Formulae CY2-1 to CY2-6 may be 0 or 1 (for example, the number of N(s) among T₁ to T₈ may be 0; or T₁ to T₇ may each not be N, and T₈ may be N), or
b) R₁₂ in Formula 2B may be hydrogen, a methyl group, or a deuterated methyl group, and the number of N(s) among T₁ to T₈ in Formulae CY2-1 to CY2-6 may be 0 or 1 (for example, the number of N(s) among T₁ to T₈ may be 0; or T₁ to T₇ may each not be N, and T₈ may be N).

In one or more embodiments,
1) T₁ to T₈ in Formulae CY2-1 to CY2-6 may each be C;
2) in Formula CY2-1, one of T₃ to T₈ may be N, and the remaining T₃ to T₈ that are not N may each be C;
3) in Formula CY2-1, T₃ and T₈ may each be N, and T₄ to T₇ may each be C;
4) in Formula CY2-1, T₆ and T₈ may each be N, and T₃ to T₅ and T₇ may each be C;
5) in Formula CY2-2, one of T₁, T₂, and T₈ may be N, and the remaining T₁, T₂, and T₅ to T₈ that are not N may each be C;
6) in Formula CY2-2, T₁ and T₈ may each be N, and T₂ and T₅ to T₇ may each be C;
7) in Formula CY2-2, T₂ and T₈ may each be N, and T₁ and T₅ to T₇ may each be C;
8) in Formulae CY2-3 and CY2-4, one of T₁, T₄, and T₈ may be N, and the remaining T₁, T₄, and T₅ to T₈ that are not N may each be C;
9) in Formulae CY2-3 and CY2-4, T₁ and T₈ may each be N, and T₄ and T₅ to T₇ may each be C;
10) in Formulae CY2-3 and CY2-4, T₄ and T₈ may each be N, and T₁ and T₅ to T₇ may each be C;
11) in Formula CY2-5, one of T₁ and T₈ may be N, and the remaining T₁, T₂, and T₅ to T₈ that are not N may each be C;
12) in Formula CY2-5, T₁ and T₈ may each be N, and T₂ and T₅ to T₇ may each be C;
13) in Formula CY2-6, one of T₄ and T₈ may be N, and the remaining T₃ to T₈ that are not N may each be C; or
14) in Formula CY2-6, T₄ and T₈ may each be N, and T₃ and T₅ to T₇ may each be C.

In one or more embodiments, a group represented by 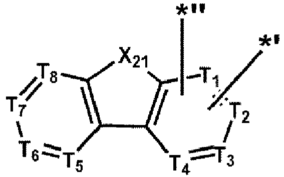 in Formula 2A may be a group represented by one of Formulae CY2(1) to CY2(6): 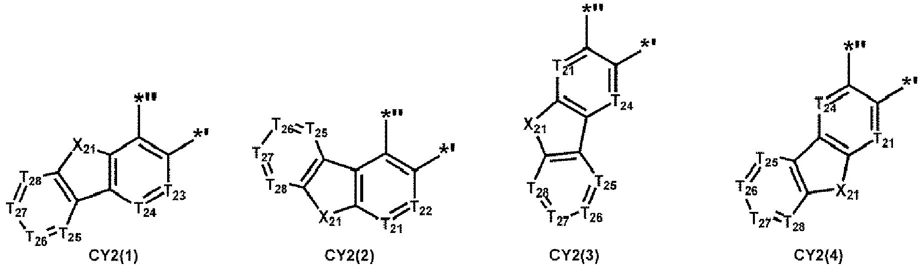 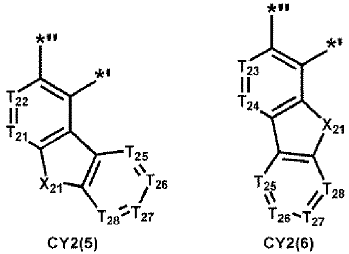 wherein, in Formulae CY2(1) to CY2(6),
T₂₁ may be N, C(Z₂₁), or C(Ar₂₁), T₂₂ may be N, C(Z₂₂), or C(Ar₂₂), T₂₃ may be N, C(Z₂₃), or C(Ar₂₃), T₂₄ may be N, C(Z₂₄), or C(Ar₂₄), T₂₅ may be N, C(Z₂₅), or C(Ar₂₅), T₂₆ may be N, C(Z₂₆), or C(Ar₂₆), T₂₇ may be N, C(Z₂₇), or C(Ar₂₇), and T₂₈ may be N, C(Z₂₈), or C(Ar₂₈),
the number of N(s) among T₂₃ to T₂₈ in Formulae CY2(1) and CY2(6) may be 0 or 1, the number of N(s) among T₂₁, T₂₂, T₂₅, T₂₆, T₂₇, and T₂₈ in Formulae CY2(2) and CY2(5) may be 0 or 1, and the number of N(s) among T₂₁, T₂₄, T₂₅, T₂₆, T₂₇, and T₂₈ in Formulae CY2(2) and CY2(4) may be 0 or 1,
X₂₁ is the same as X₂₁ described herein,
Z₂₁ to Z₂₈ are each the same as described in connection with Z₂,
Ar₂₁ to Ar₂₈ are each the same as described in connection with Ar₂, Formulae CY2(1) and CY2(6) may include at least one of Ar₂₃ to Ar₂₈, Formulae CY2(2) and CY2(5) may include at least one of Ar₂₁, Ar₂₂, Ar₂₅, Ar₂₆, Ar₂₇, and Ar₂₈, Formulae CY2(3) and CY2(4) may include at least one of Ar₂₁, Ar₂₄, Ar₂₅, Ar₂₆, Ar₂₇, and Ar₂₈,
*" indicates a binding site to ring CY₁ in Formula 2A, and
*' indicates a binding site to M in Formula 1.

In one or more embodiments, a group represented by 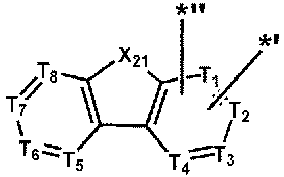 in Formula 2A may be a group represented by one of Formulae CY2(1) to CY2(6), and may satisfy at least one of Conditions 1-1 to 1-8:
Condition 1-1: T₂₈ in Formulae CY2(1) to CY2(6) is C(Ar₂₈).
Condition 1-2: T₂₇ in Formulae CY2(1) to CY2(6) is C(Ar₂₇).
Condition 1-3: T₂₆ in Formulae CY2(1) to CY2(6) is C(Ar₂₆).
Condition 1-4: T₂₅ in Formulae CY2(1) to CY2(6) is C(Ar₂₅).
Condition 1-5: T₂₄ in Formulae CY2(1), CY2(3), CY2(4), and CY2(6) is C(Ar₂₄).
Condition 1-6: T₂₃ in Formulae CY2(1) and CY2(6) is C(Ar₂₃).
Condition 1-7: T₂₂ in Formulae CY2(2) and CY2(5) is C(Ar₂₂).
Condition 1-8: T₂₁ in Formulae CY2(2) to CY2(5) is C(Ar₂₁).

In one or more embodiments, a group represented by 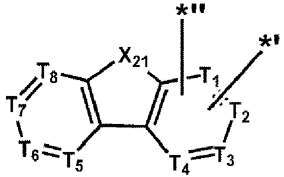 in Formula 2A may be a group represented by one of Formulae CY2(1) to CY2(6), and may satisfy at least one of Conditions 2-1 to 2-8:
Condition 2-1: in Formulae CY2(1) to CY2(6), T₂₈ is C(Z₂₈), and Z₂₈ is not hydrogen.
Condition 2-2: in Formulae CY2(1) to CY2(6), T₂₇ is C(Z₂₇), and Z₂₇ is not hydrogen.
Condition 2-3: in Formulae CY2(1) to CY2(6), T₂₆ is C(Z₂₆), and Z₂₆ is not hydrogen.
Condition 2-4: in Formulae CY2(1) to CY2(6), T₂₅ is C(Z₂₅), and Z₂₅ is not hydrogen.
Condition 2-5: in Formulae CY2(1), CY2(3), CY2(4), and CY2(6), T₂₄ is C(Z₂₄), and Z₂₄ is not hydrogen.
Condition 2-6: in Formulae CY2(1) and CY2(6), T₂₃ is C(Z₂₃), and Z₂₃ is not hydrogen.
Condition 2-7: in Formulae CY2(2) and CY2(5), T₂₂ is C(Z₂₂), and Z₂₂ is not hydrogen.
Condition 2-8: in Formulae CY2(2) to CY2(5), T₂₁ is C(Z₂₁), and Z₂₁ is not hydrogen.

In one or more embodiments, a group represented by 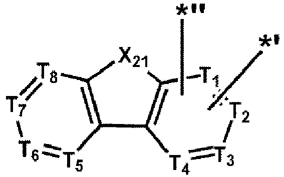 in Formula 2A may be a group represented by one of Formulae CY2(1) to CY2(6), and may satisfy one of Conditions 3-1 to 3-9.
Condition 3-1: each of T₂₁ to T₂₈ in Formulae CY2(1) to CY2(6) is not N.
Condition 3-2: T₂₈ in Formulae CY2(1) to CY2(6) is N.
Condition 3-3: T₂₇ in Formulae CY2(1) to CY2(6) is N.
Condition 3-4: T₂₆ in Formulae CY2(1) to CY2(6) is N.
Condition 3-5: T₂₅ in Formulae CY2(1) to CY2(6) is N.
Condition 3-6: T₂₄ in Formulae CY2(1), CY2(3), CY2(4), and CY2(6) is N.
Condition 3-7: T₂₃ in Formulae CY2(1) and CY2(6) is N.
Condition 3-8: T₂₂ in Formulae CY2(2) and CY2(5) is N.
Condition 3-9: T₂₁ in Formulae CY2(2) to CY2(5) is N.

In one or more embodiments, a group represented by Formula CY2(1) may be a group represented by one of Formulae CY2(1)-1 to CY2(1)-4, a group represented by Formula CY2(2) may be a group represented by one of Formulae CY2(2)-1 to CY2(2)-4, a group represented by Formula CY2(3) may be a group represented by one of Formulae CY2(3)-1 to CY2(3)-3, a group represented by Formula CY2(4) may be a group represented by one of Formulae CY2(4)-1 to CY2(4)-3, a group represented by Formula CY2(5) may be a group represented by one of Formulae CY2(5)-1 to CY2(5)-4, and a group represented by Formula CY2(6) may be a group represented by one of Formulae CY2(6)-1 to CY2(6)-4: 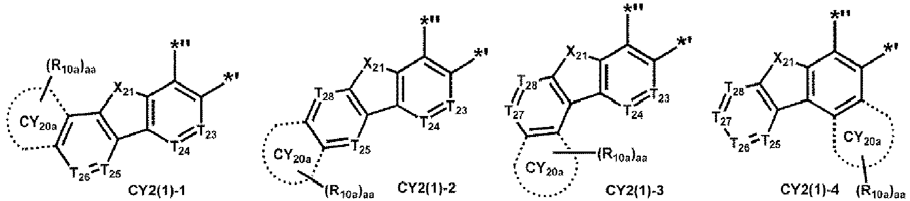 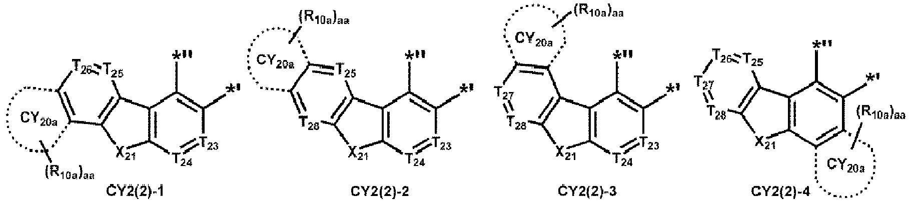 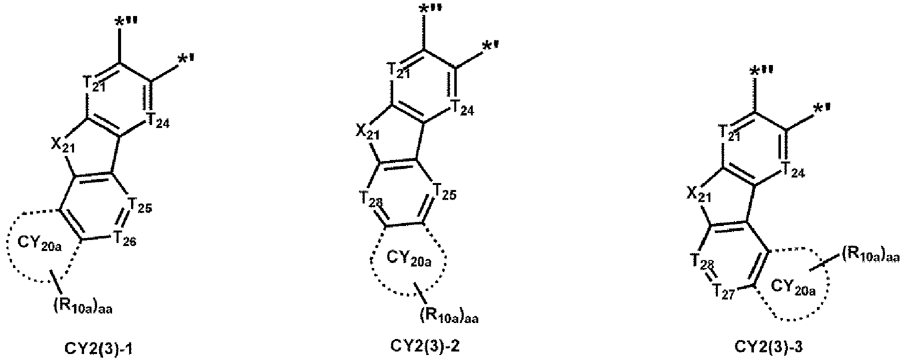 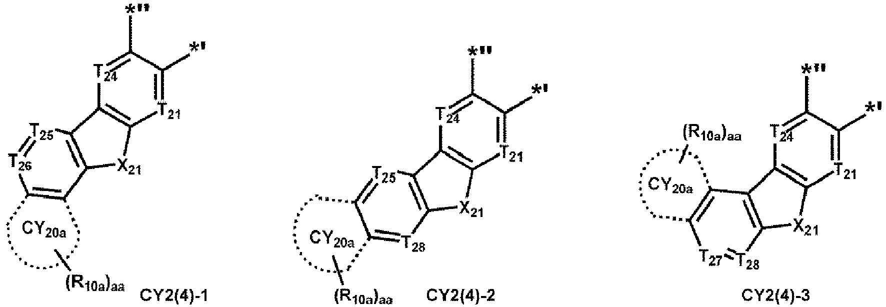 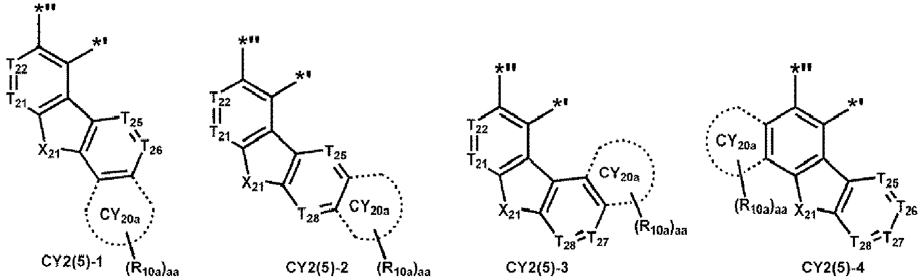 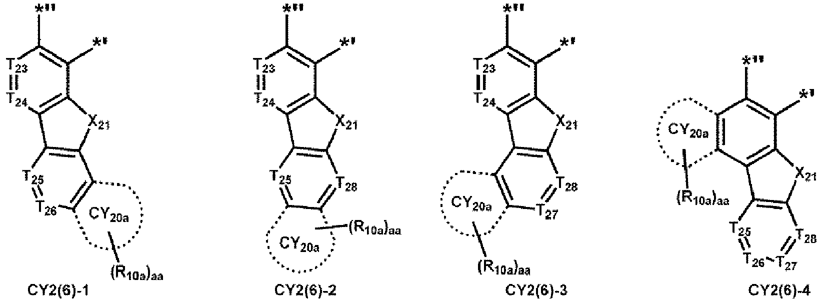 wherein, in Formulae CY2(1)-1 to CY2(1)-4, CY2(2)-1 to CY2(2)-4, CY2(3)-1 to CY2(3)-3, CY2(4)-1 to CY2(4)-3, CY2(5)-1 to CY2(5)-4, and CY2(6)-1 to CY2(6)-4,
T₂₁ to T₂₈, X₂₁, *", and *' are respectively the same as those described in connection with Formulae CY2(1) to CY2(6),
ring CY₂₀ₐ may be a C₅-C₃₀ carbocyclic group or a C₁-C₃₀ heterocyclic group,
R₁₀ₐ is the same as R₁₀ₐ described herein, and
aa may be an integer from 0 to 10.

For example, ring CY₂₀ₐ may be a cyclohexane group, a norbornane group, a benzene group, or a naphthalene group.

In one or more embodiments, a group represented by 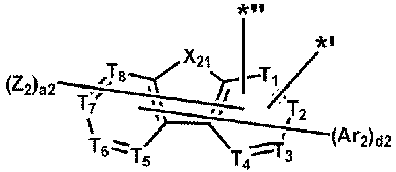 in Formula 2A may be a group represented by one of Formulae CY2-1-1 to CY2-1-65, CY2-2-1 to CY2-2-65, CY2-3-1 to CY2-3-65, CY2-4-1 to CY2-4-65, CY2-5-1 to CY2-5-65, CY2-6-1 to CY2-6-65, and CY2-1-1N to CY2-1-25N: 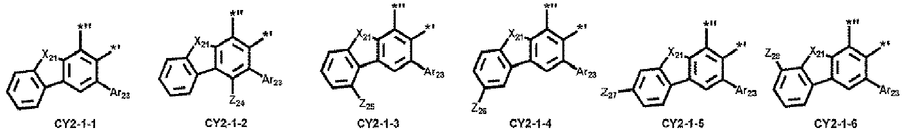 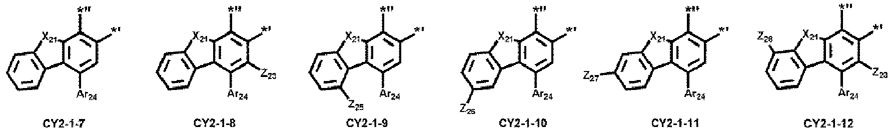 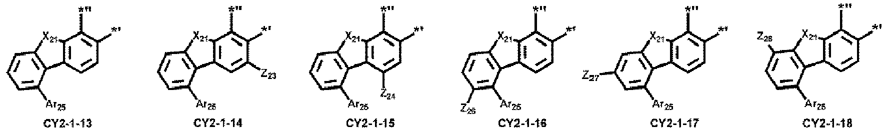 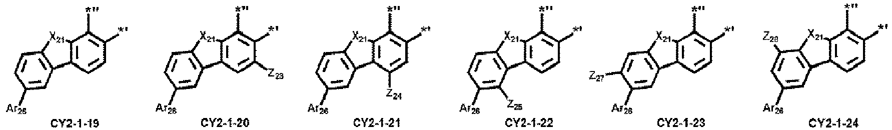 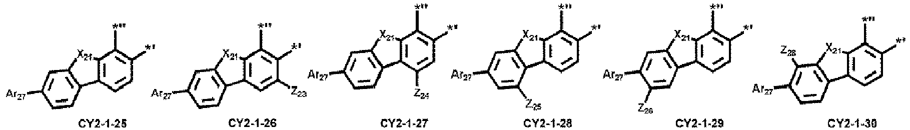 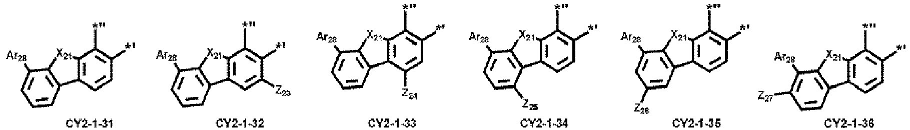 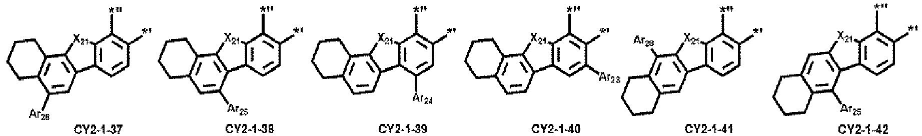 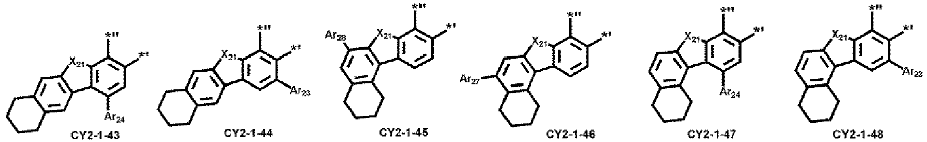 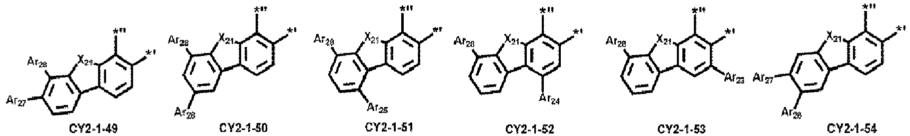 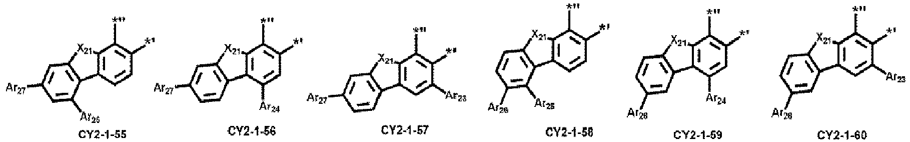 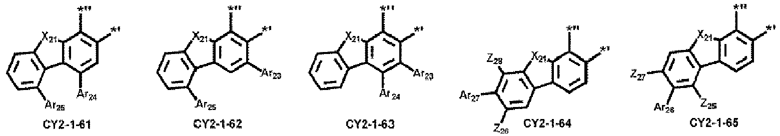 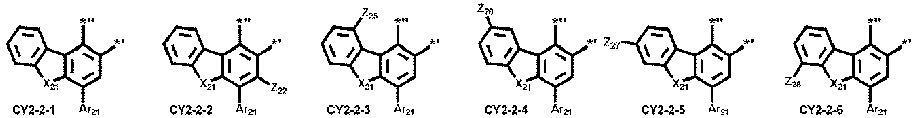 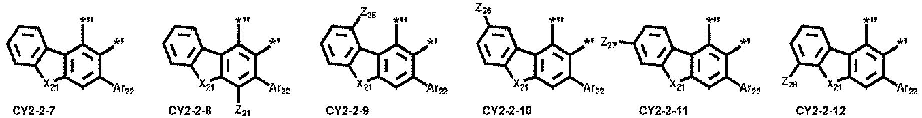 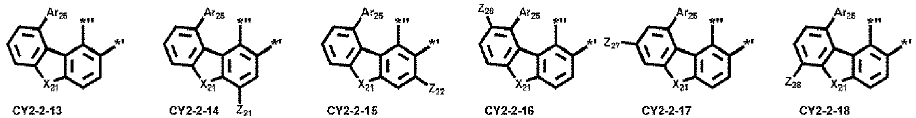 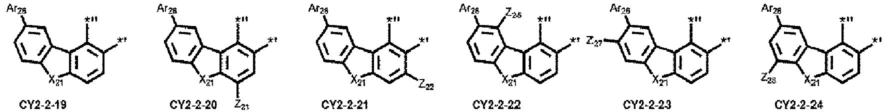 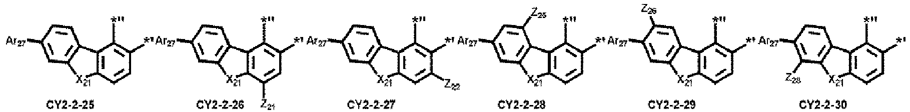 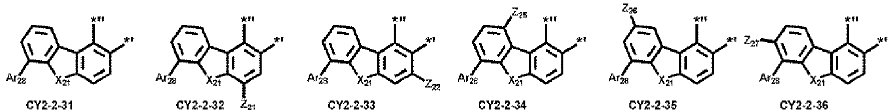 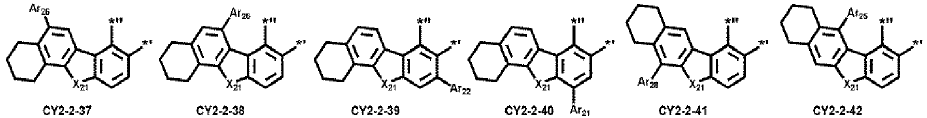 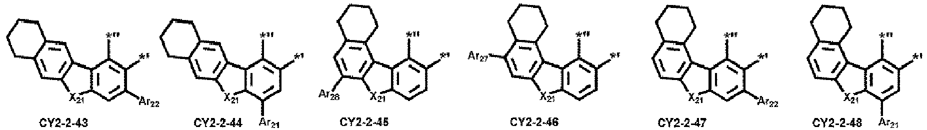 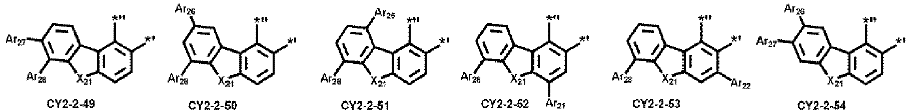 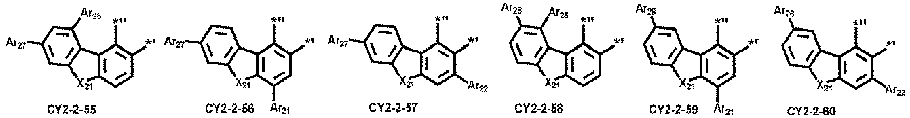 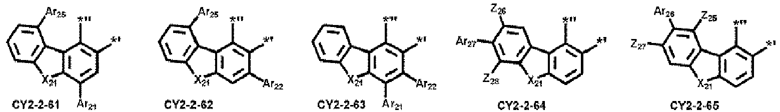 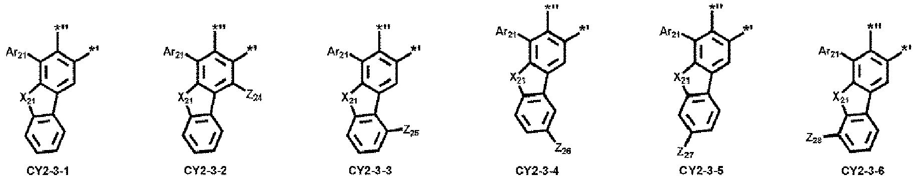 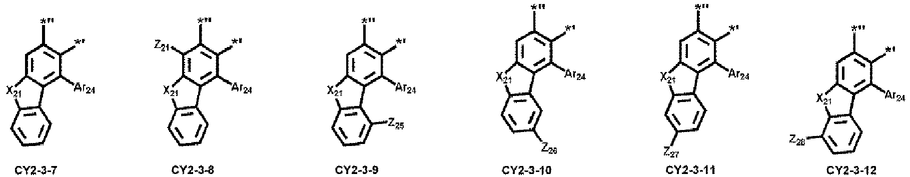 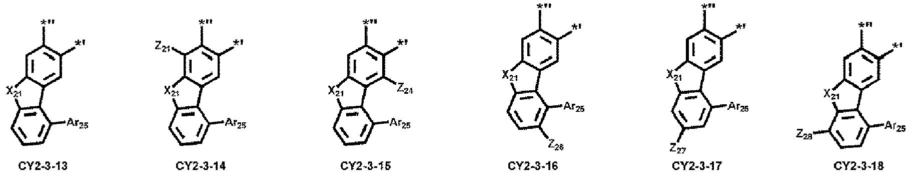 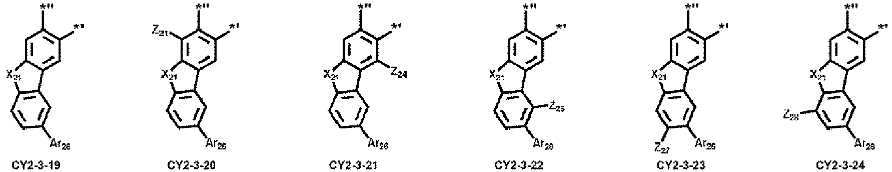 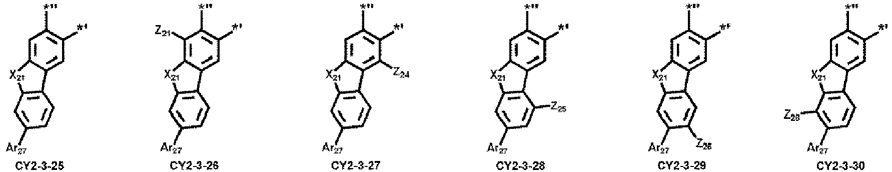 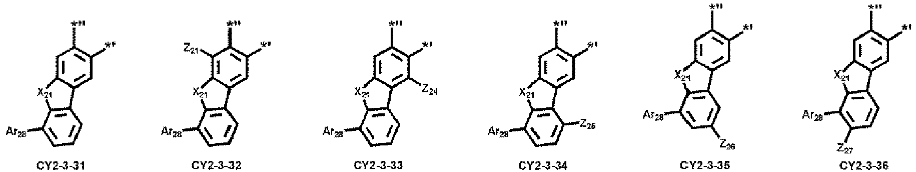 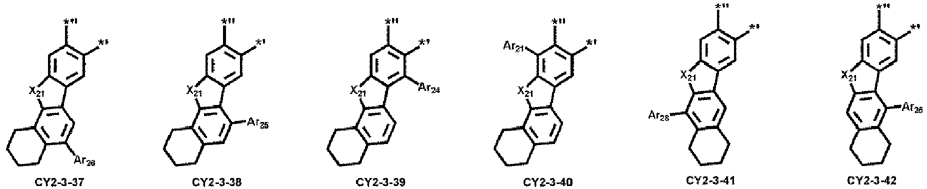 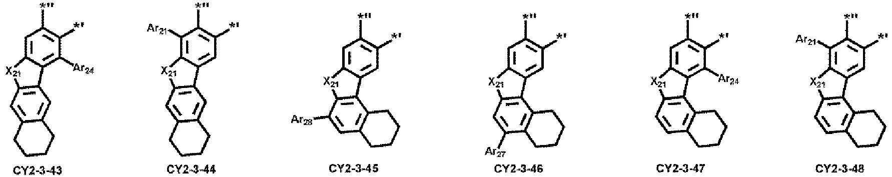 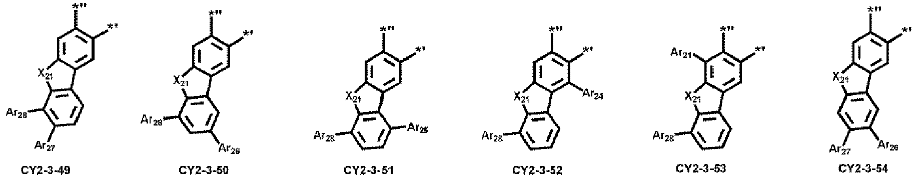 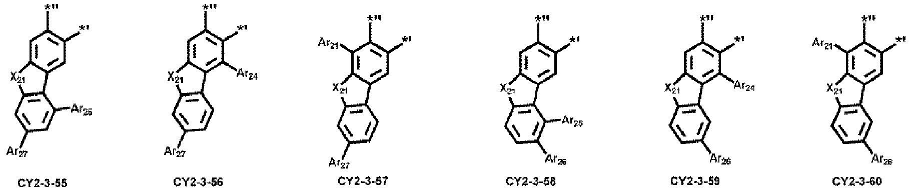 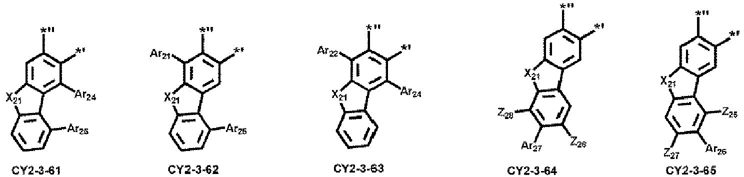 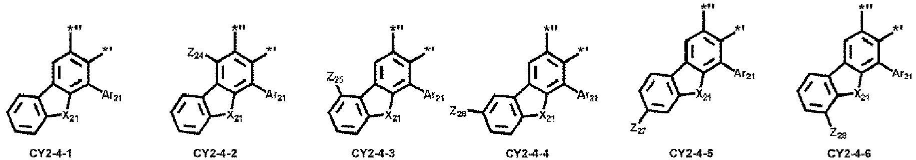 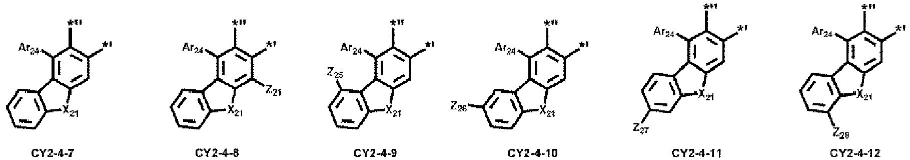 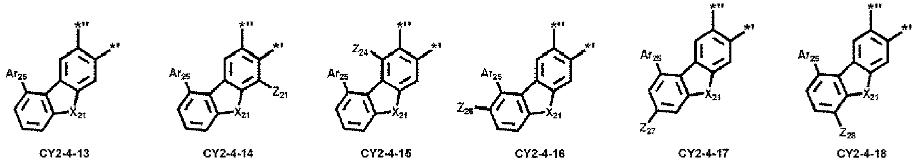 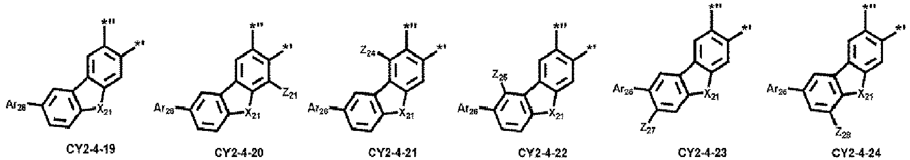 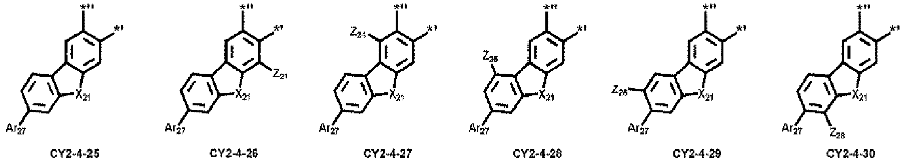 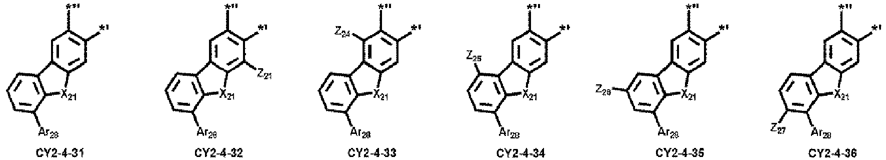 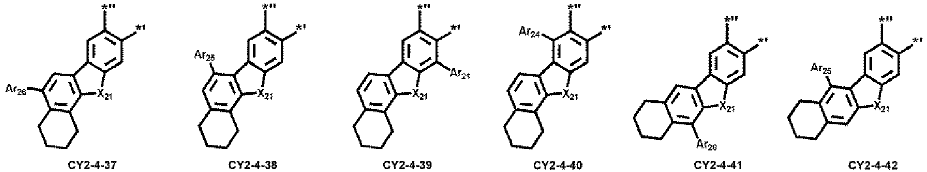 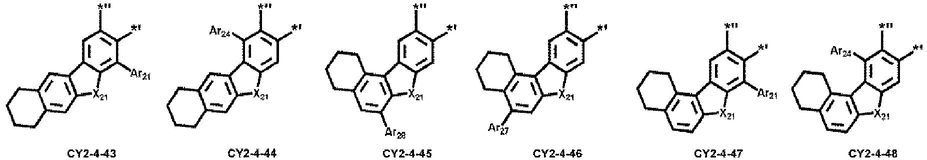 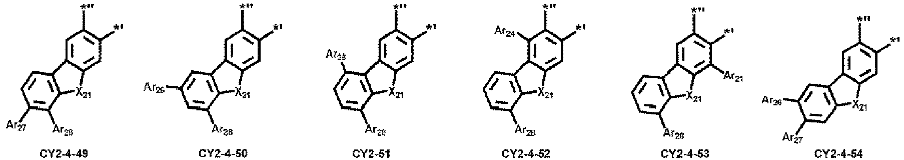 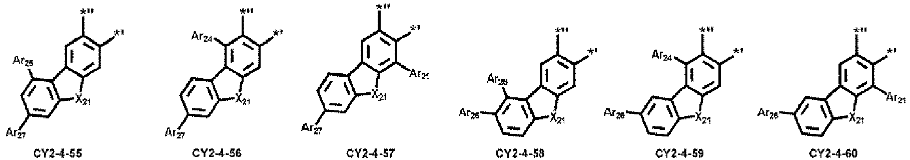 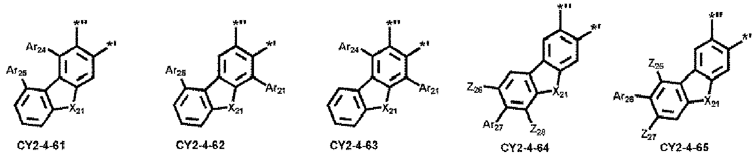 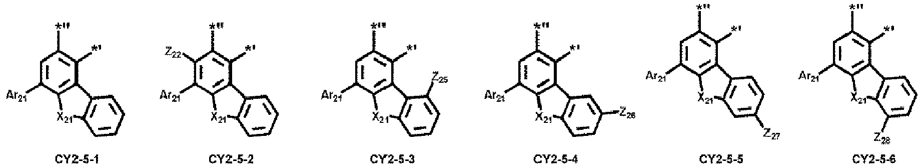 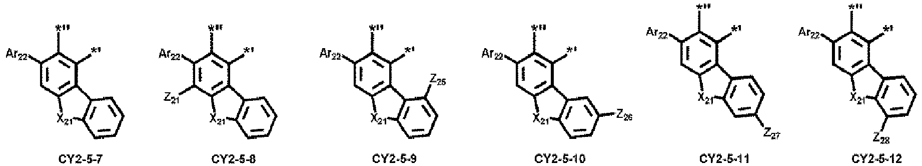 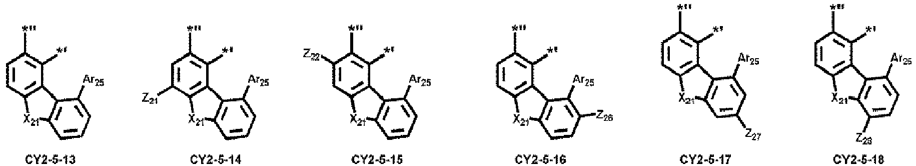 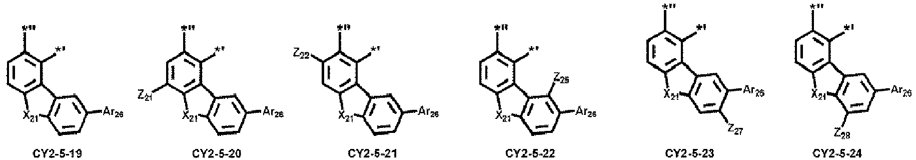 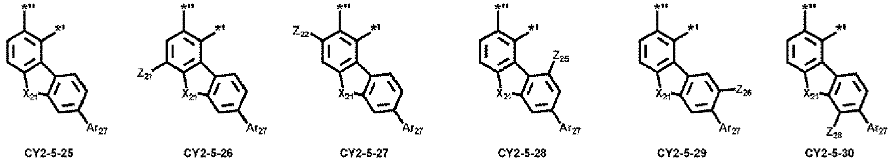 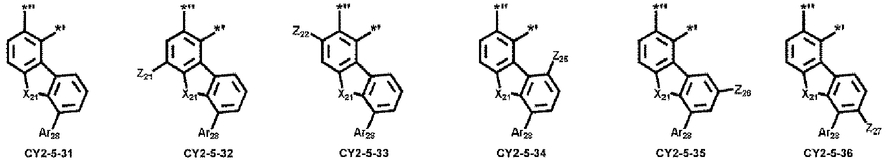 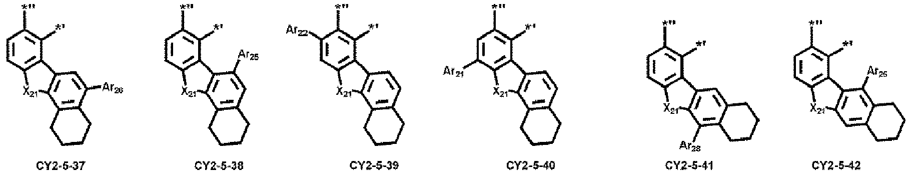 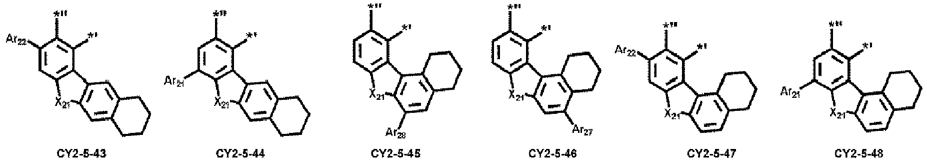 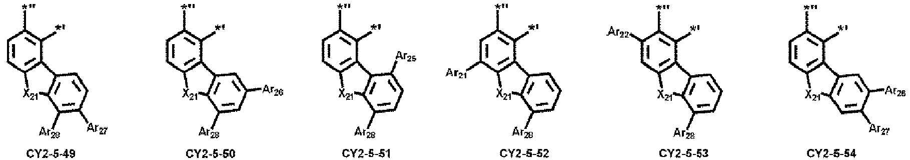 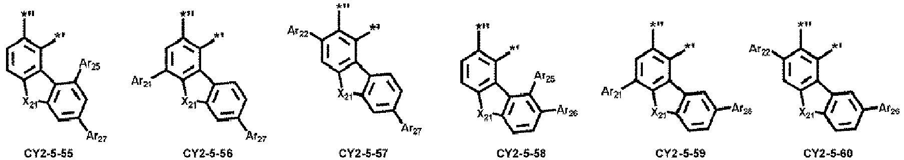 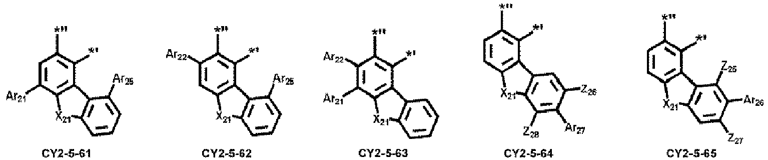 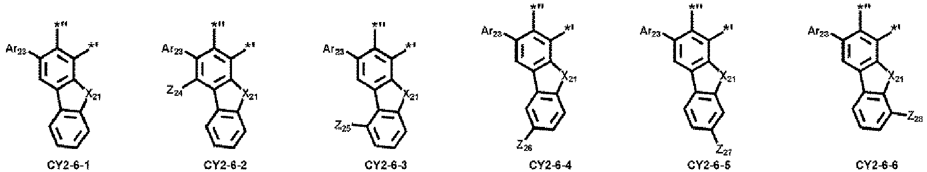 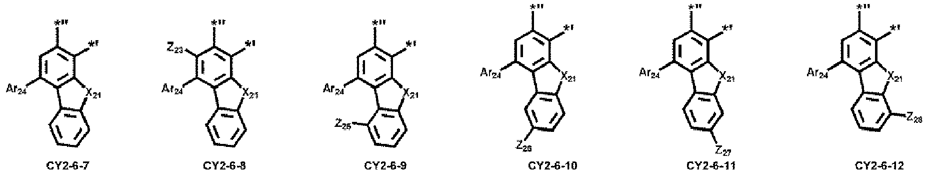 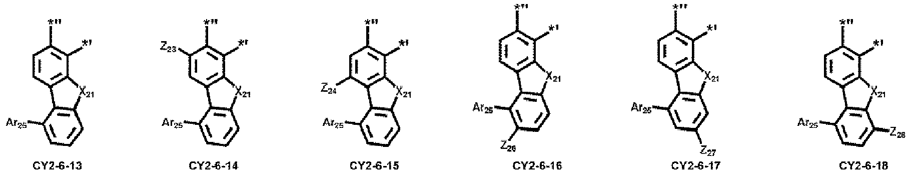 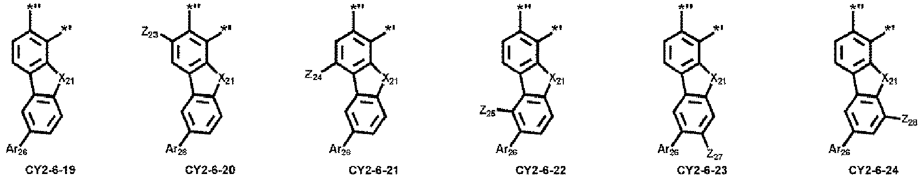 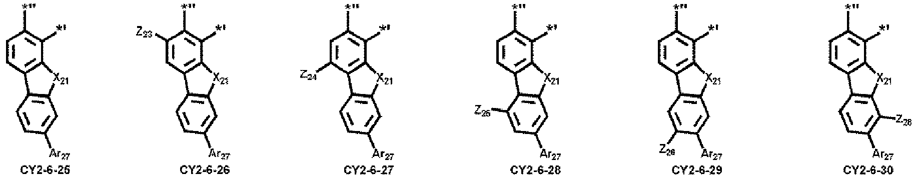 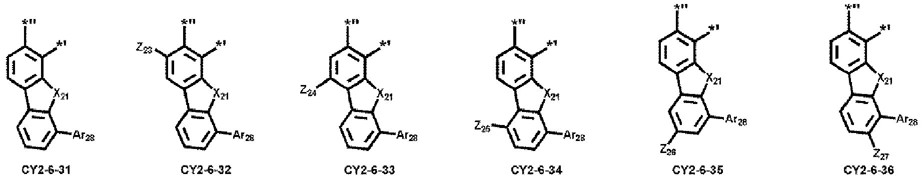 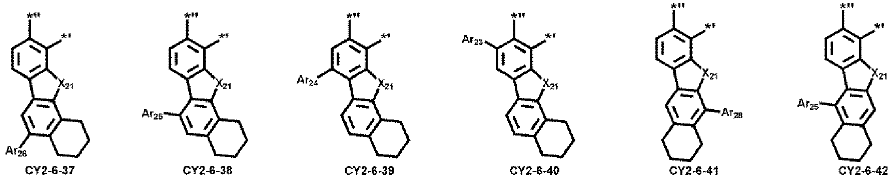 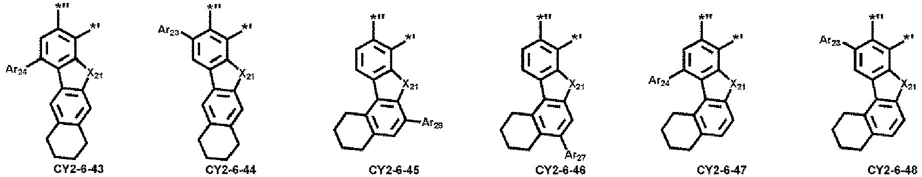 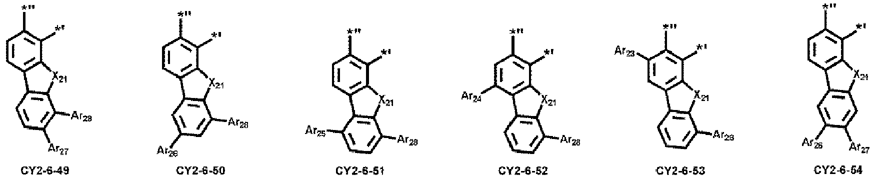 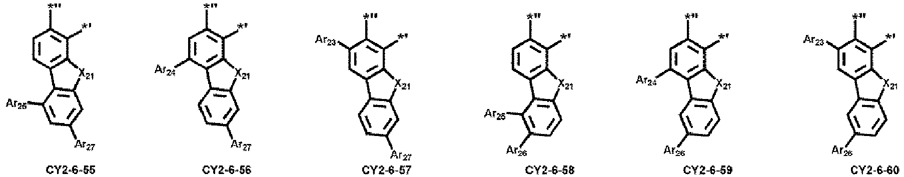 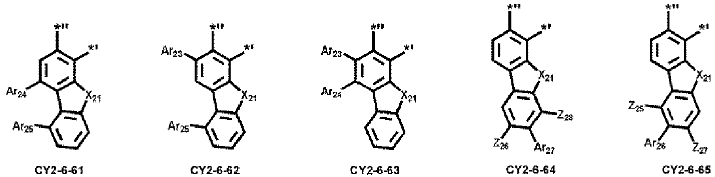 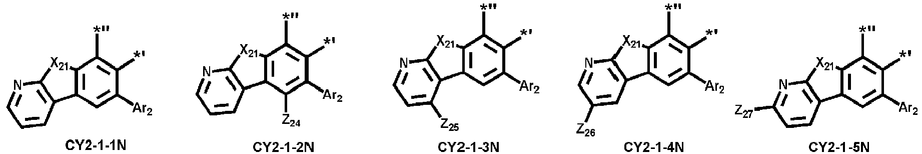 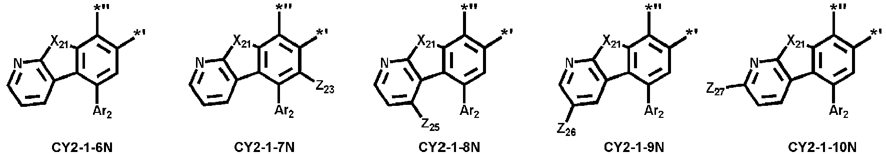 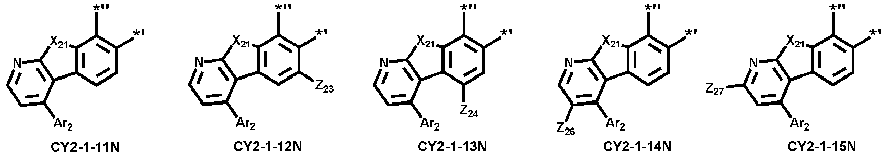 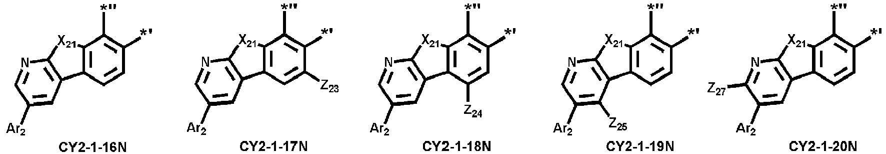 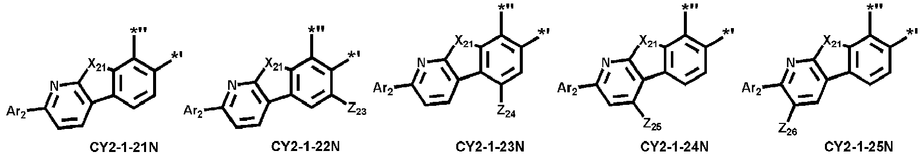
wherein, in Formulae CY2-1-1 to CY2-1-65, CY2-2-1 to CY2-2-65, CY2-3-1 to CY2-3-65, CY2-4-1 to CY2-4-65, CY2-5-1 to CY2-5-65, CY2-6-1 to CY2-6-65, and CY2-1-1N to CY2-1-25N,
X₂₁ is the same as X₂₁ described herein,
Z₂₁ to Z₂₈ are each the same as described in connection with Z₂, wherein Z₂₁ to Z₂₈ may each not be hydrogen,
Ar₂₁ to Ar₂₈ are each the same as described in connection with Ar₂,
*" indicates a binding site to ring CY₁ in Formula 2A, and
*' indicates a binding site to M in Formula 1.

In one or more embodiments, a group represented by 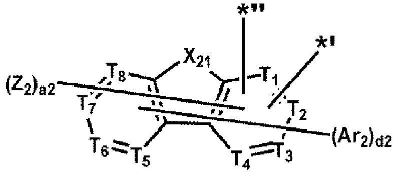 in Formula 2A may be a group represented by Formula CY2-1-25 or CY2-1-21N.

In one or more embodiments, a group represented by 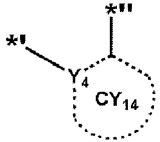 in Formula 2B may be a group represented by one of Formulae CY14-1 to CY14-64: 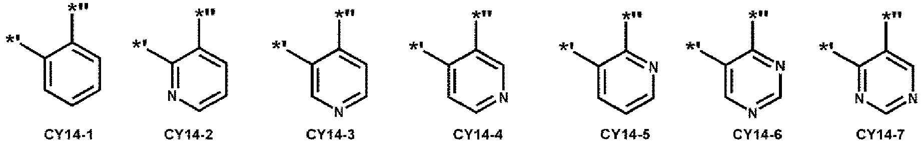 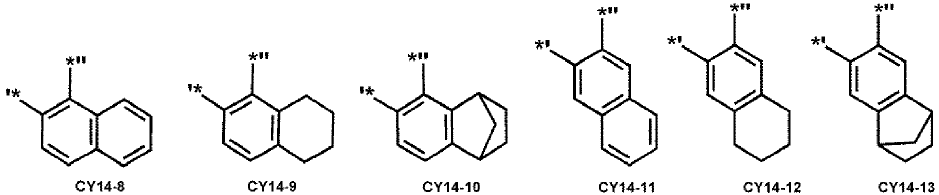 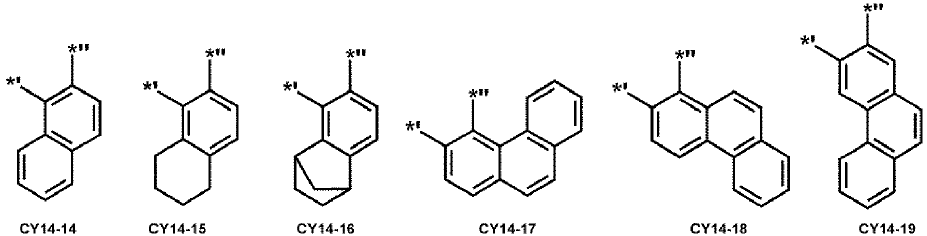 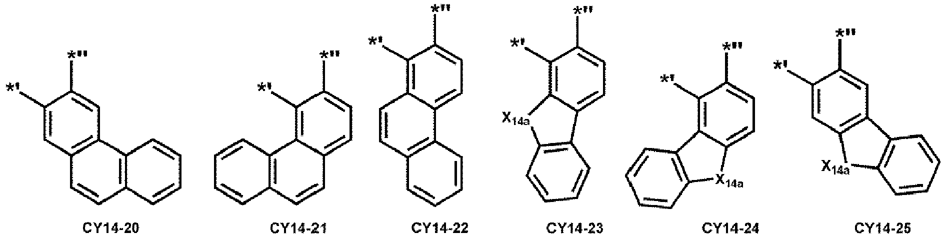 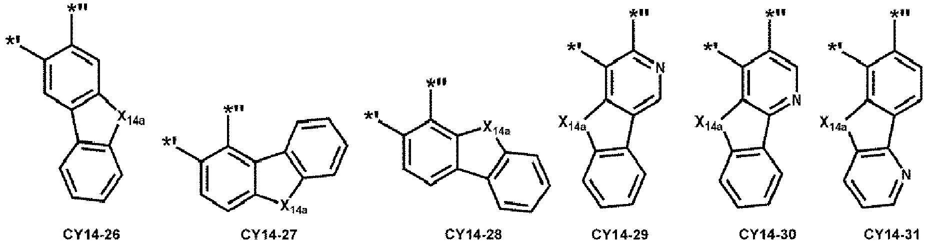 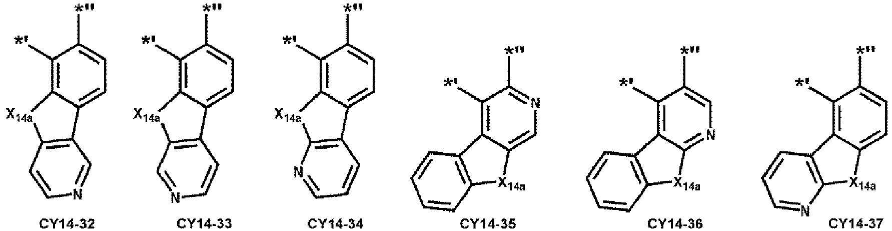 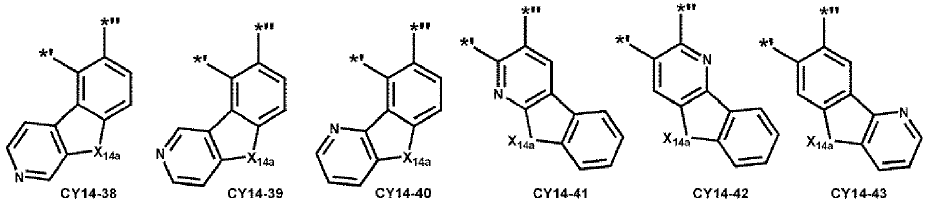 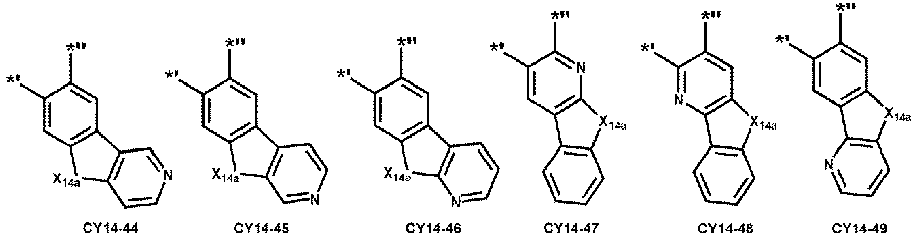 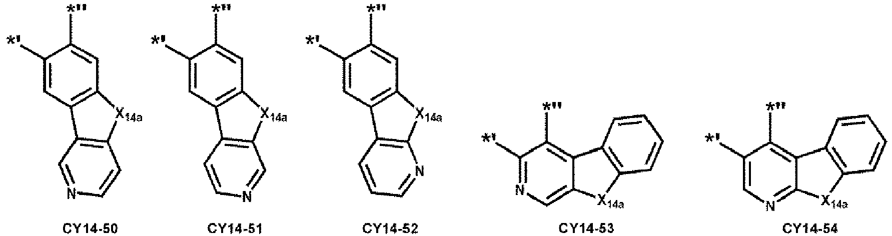 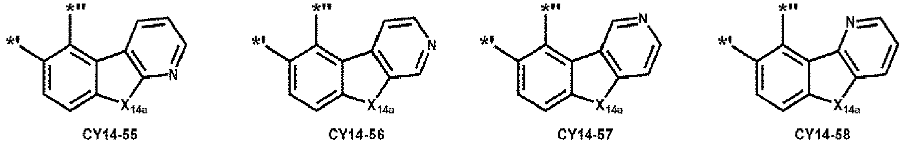 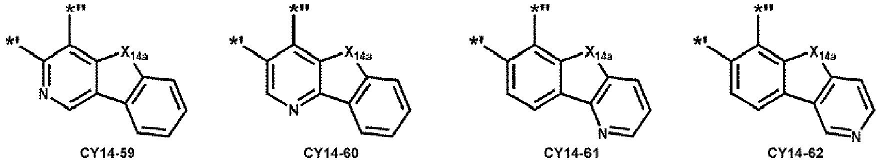 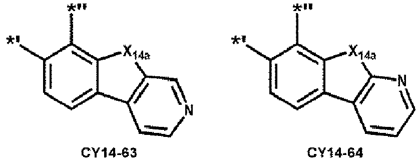
wherein, in Formulae CY14-1 to CY14-64,
X₁₄ₐ may be O, S, N, C, or Si,
*" indicates a binding site to a carbon atom of a neighboring pyridine ring in Formula 2B,
*' indicates a binding site to M in Formula 1, and
each of carbon and X₁₄ₐ in Formulae CY14-1 to CY14-64 may be unsubstituted or substituted with R₁₄ as described herein.

Alternatively, in Formulae CY14-1 to CY14-64,
X₁₄ₐ may be O, S, N(R₁₄ₐ), C(R₁₄ₐ)(R_{14b}), or Si(R₁₄ₐ)(R_{14b}),
R₁₄ₐ and R_{14b} may each independently be the same as described for R₁₄ herein,
*" indicates a binding site to a carbon atom of a neighboring pyridine ring in Formula 2B,
*' indicates a binding site to M in Formula 1, and
carbon(s) in Formulae CY14-1 to CY14-64 may be unsubstituted or substituted with R₁₄ as described herein.

In one or more embodiments, a group represented by 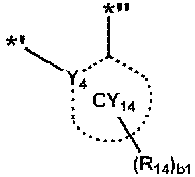 in Formula 2B may be a group represented by one of Formulae CY14(1) to CY14(63): 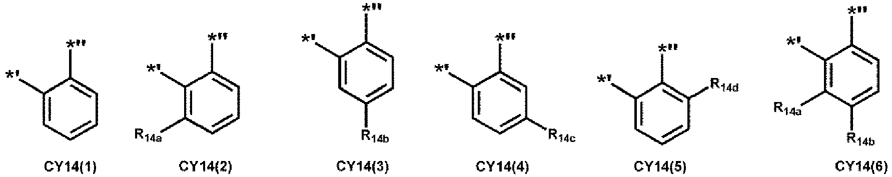 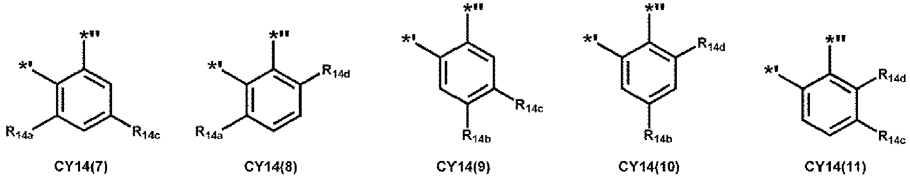 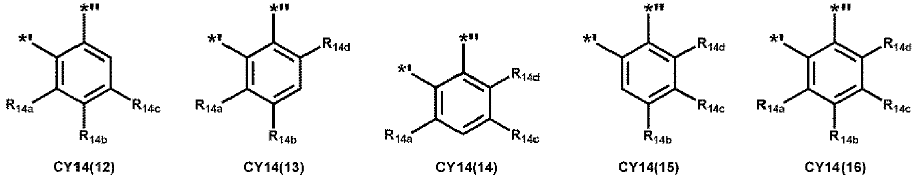 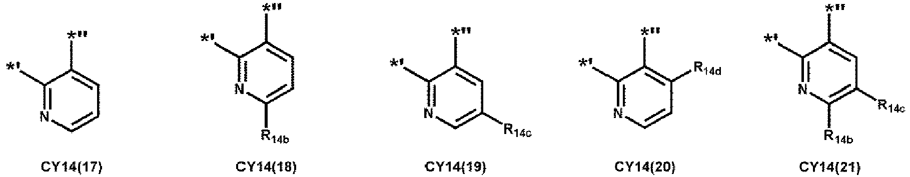 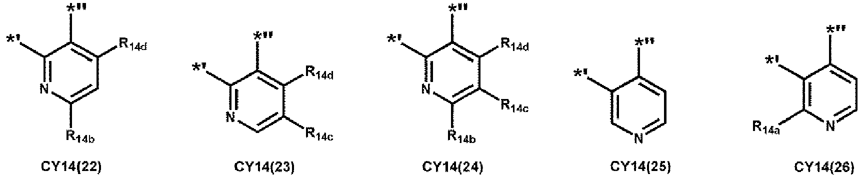 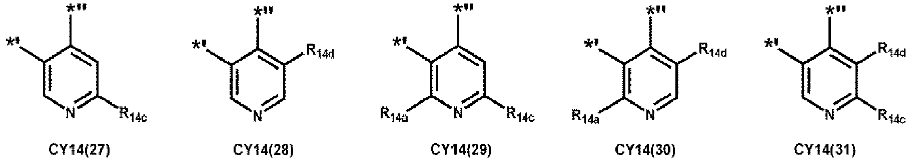 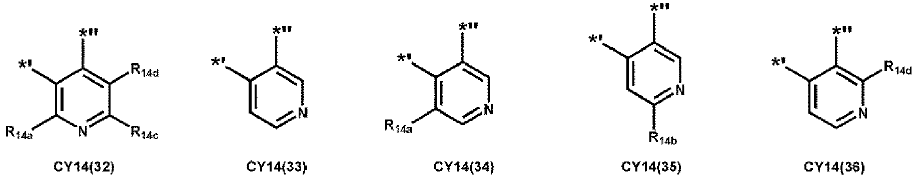 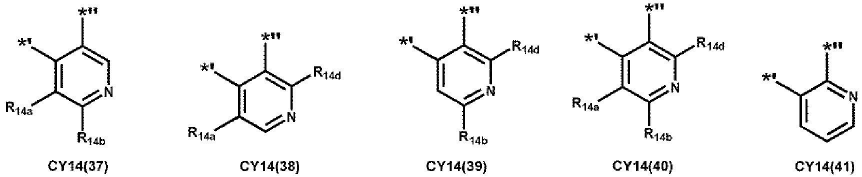 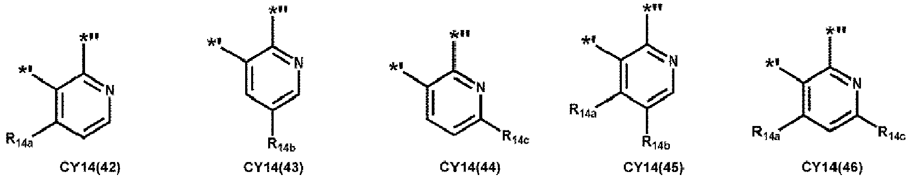 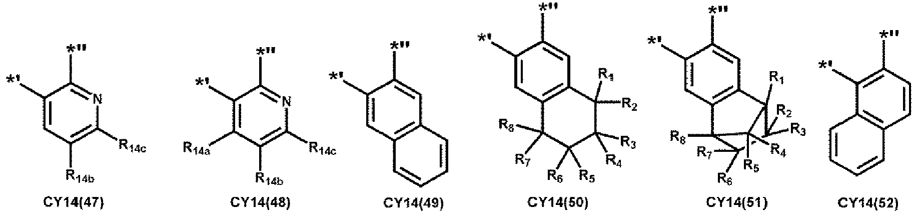 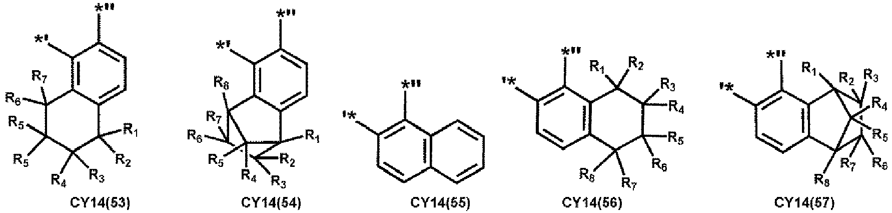 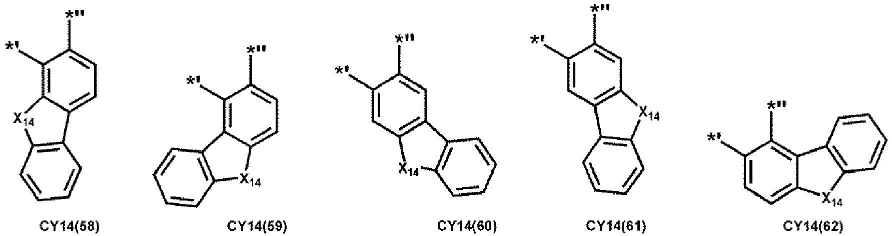 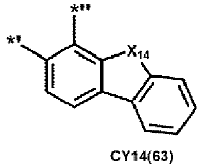 wherein, in Formulae CY14(1) to CY14(63),
R₁₄ₐ to R_{14d} are each the same as described in connection with of R₁₄, wherein R₁₄ₐ to R_{14d} may each not be hydrogen,
X₁₄ may be C(R₁)(R₂), N(R₁), O, S, or Si(R₁)(R₂),
R₁ to R₈ are each the same as described in connection with R₁₄,
*" indicates a binding site to a carbon atom of a neighboring pyridine ring in Formula 2B, and
*' indicates a binding site to M in Formula 1.

In one or more embodiments, the number of silicon (Si) atoms in the first compound represented by Formula 1 may be 1 or 2.

In one or more embodiments, the first compound represented by Formula 1 may be one of Compounds 1 to 5140 of Group A, one of Compounds 661 to 800, 1001 to 1280, and 1381 to 1620 of Group B, or one of Compounds 1-1 to 1-5 of Group C:

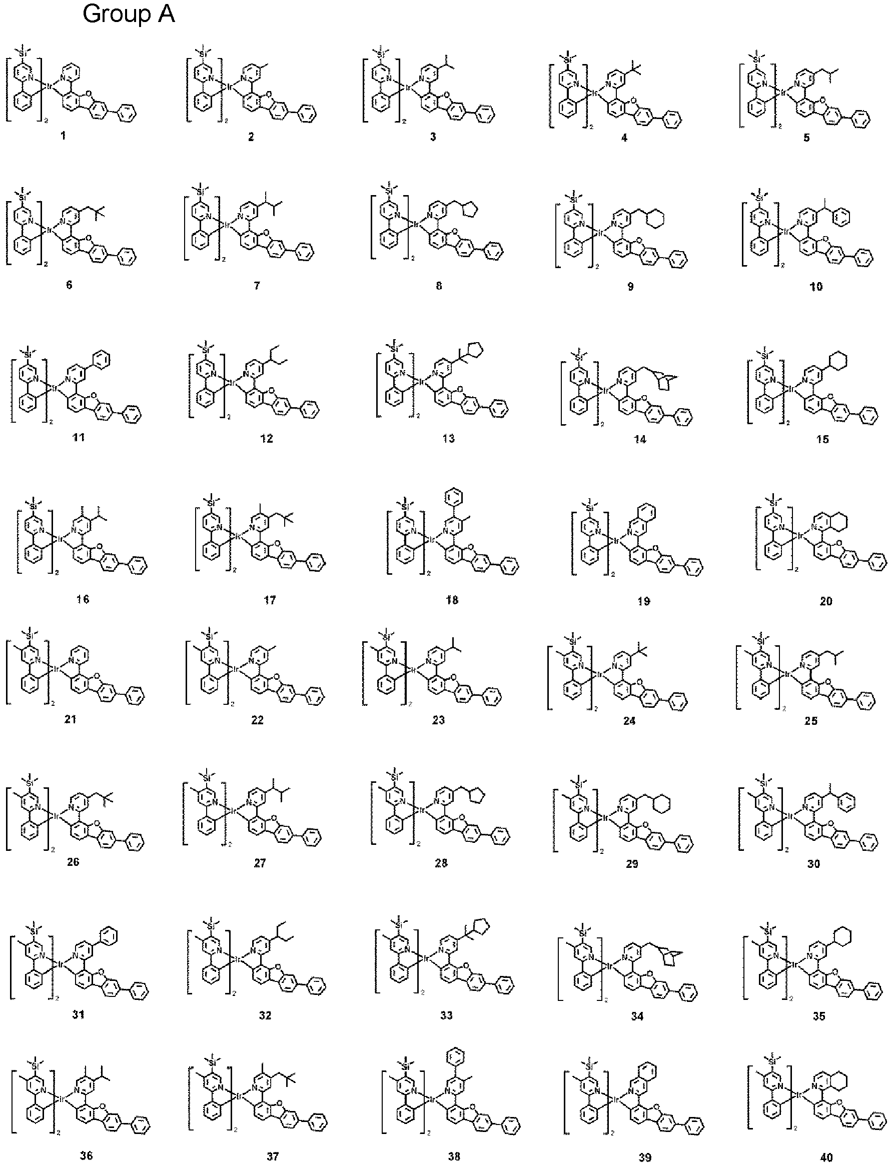

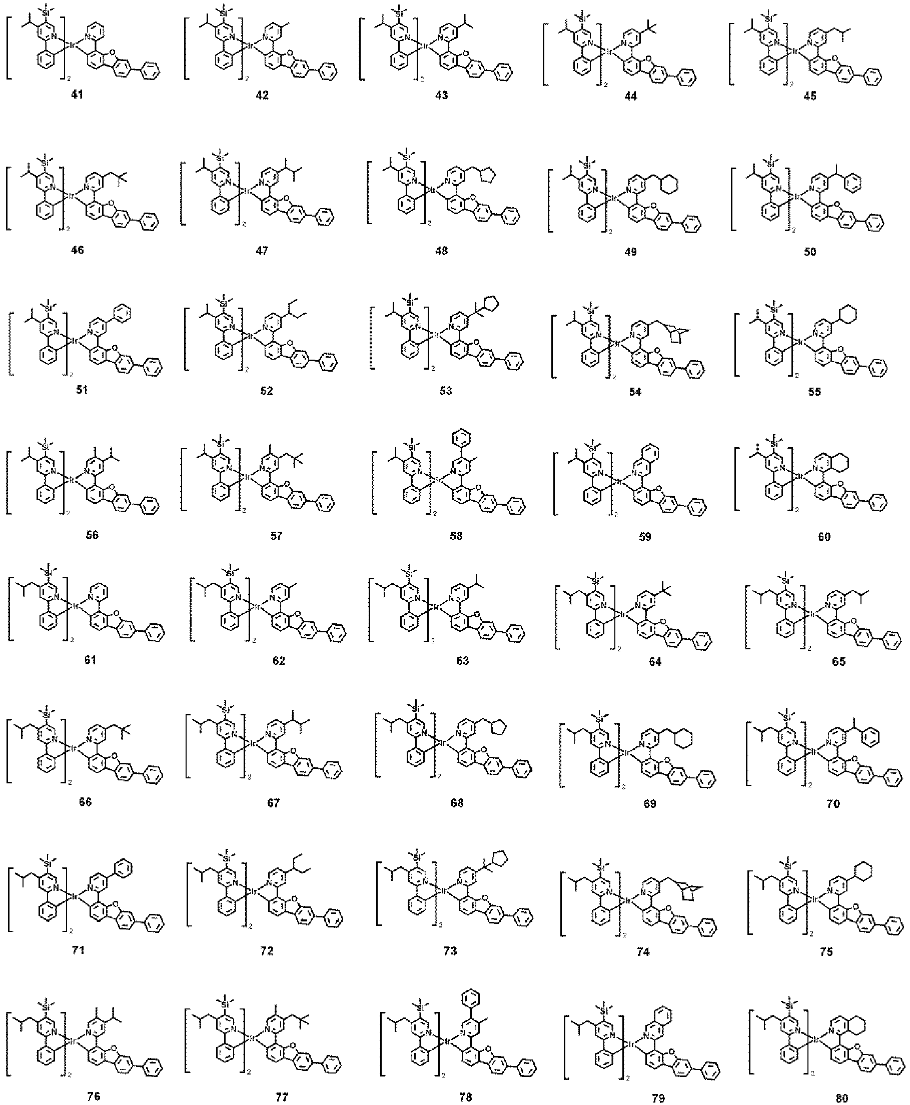

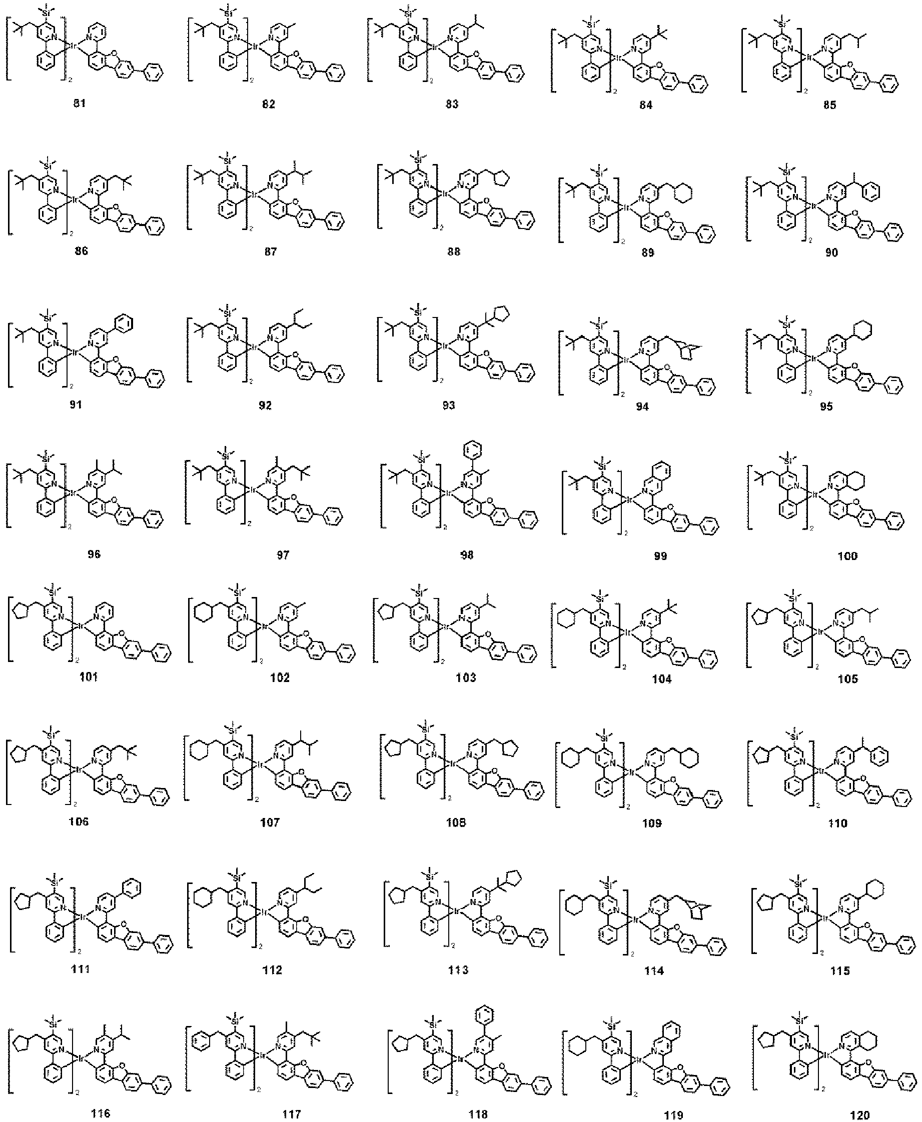

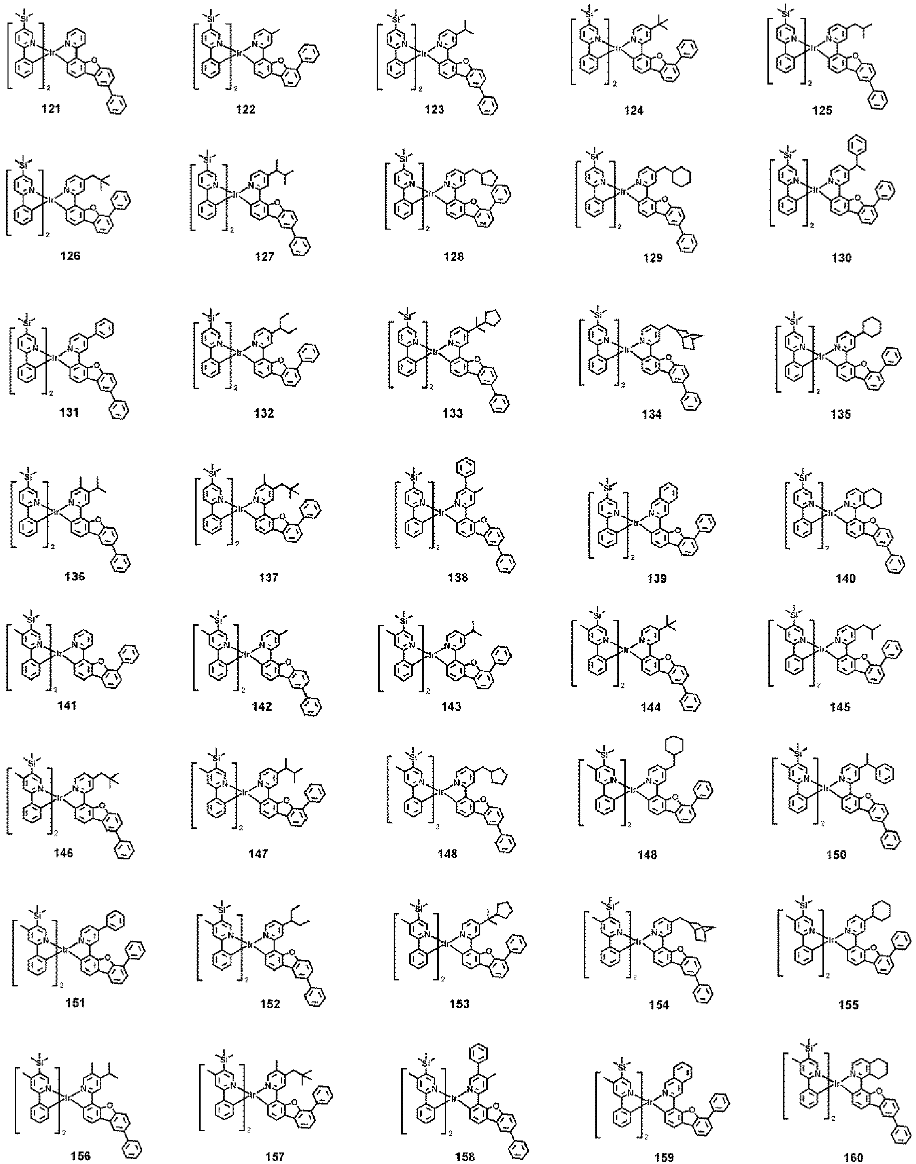

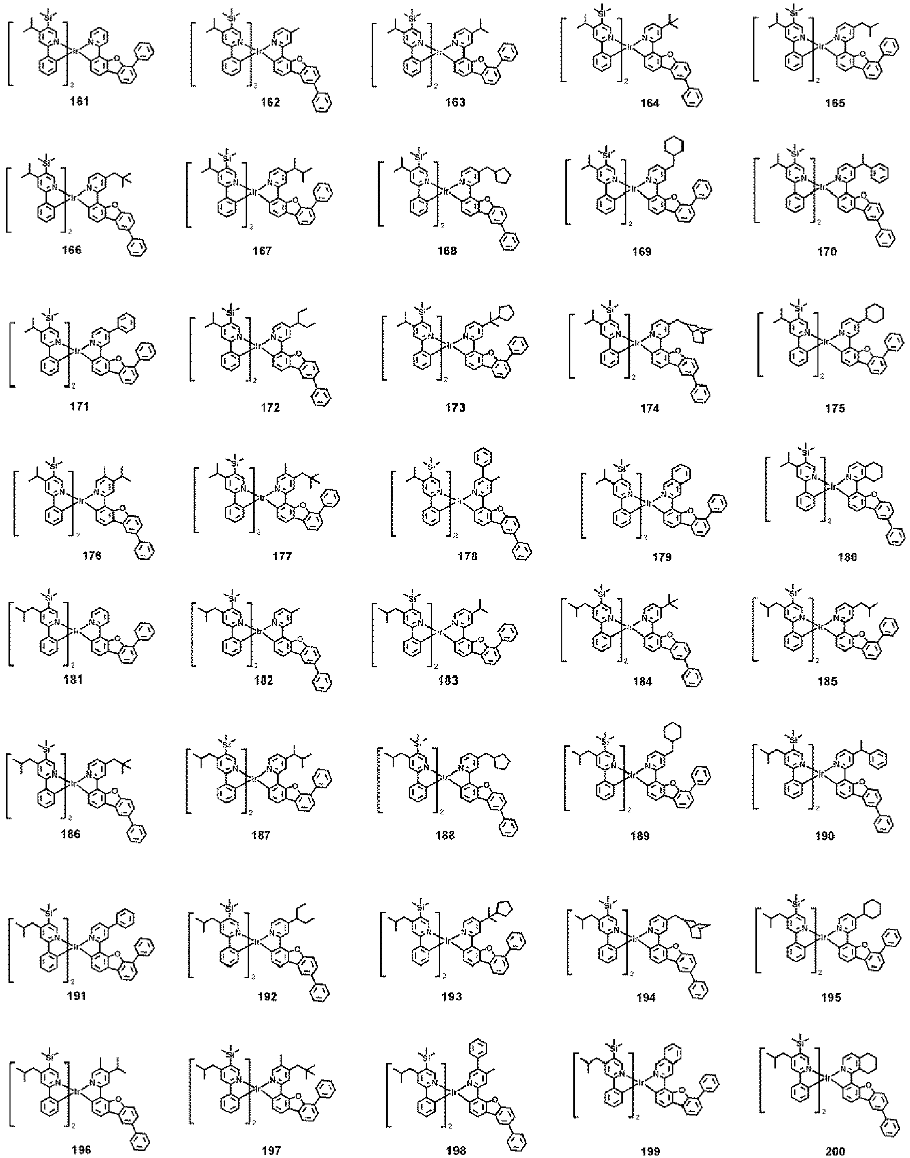

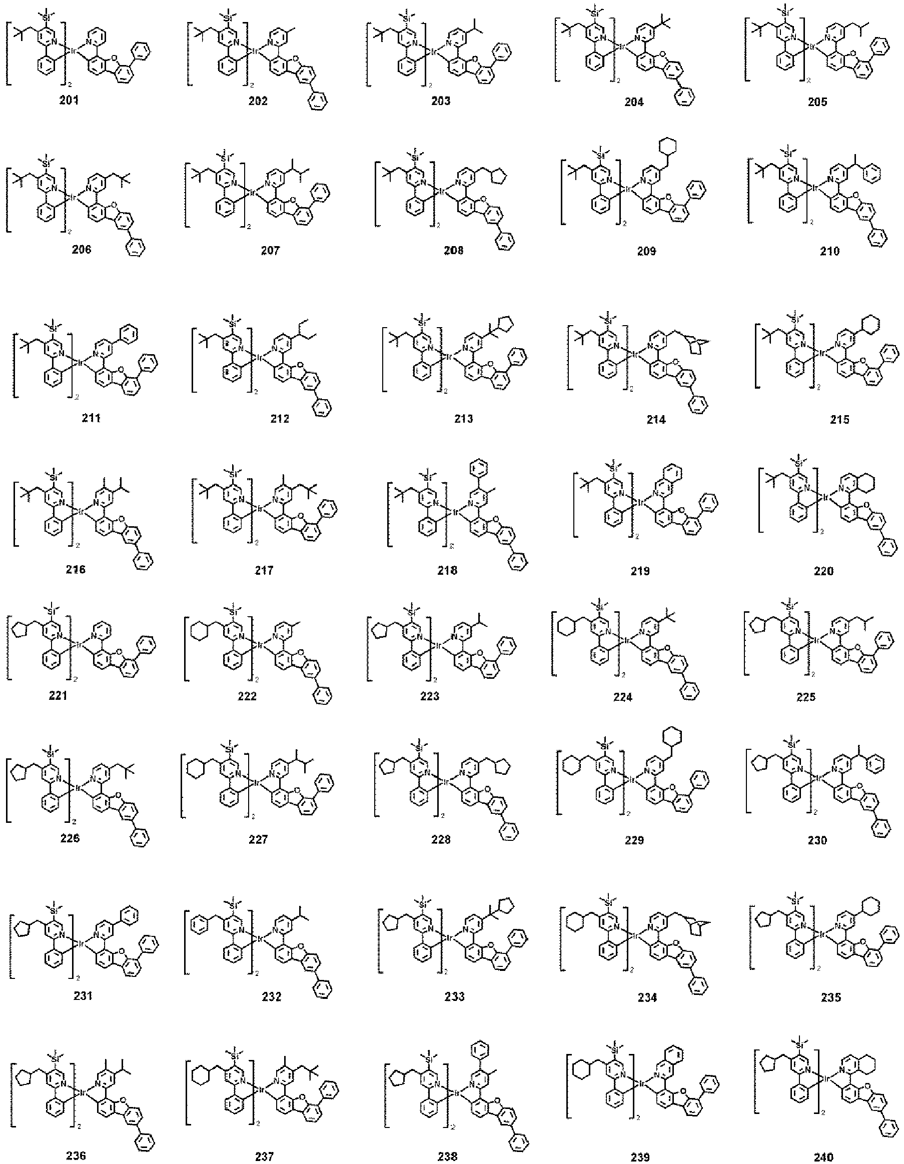

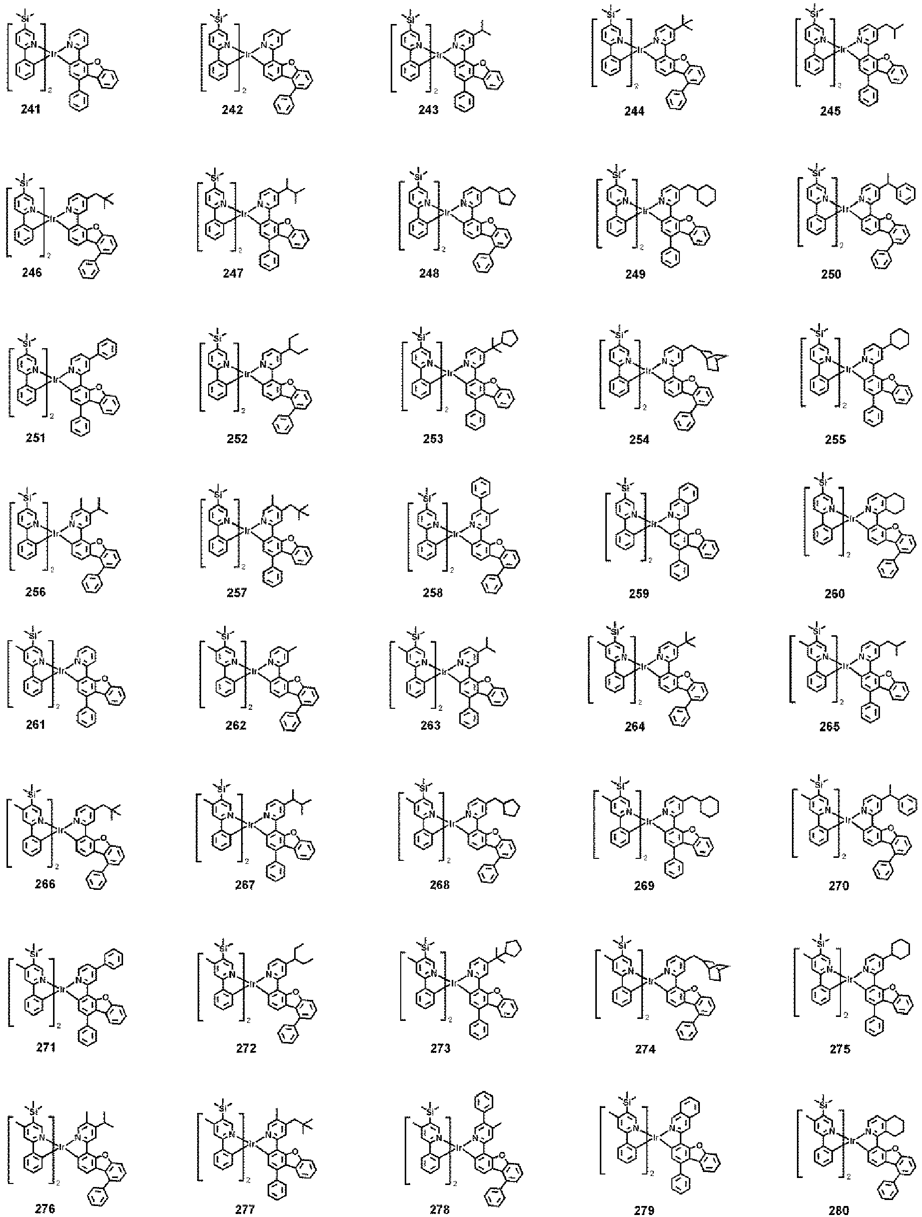

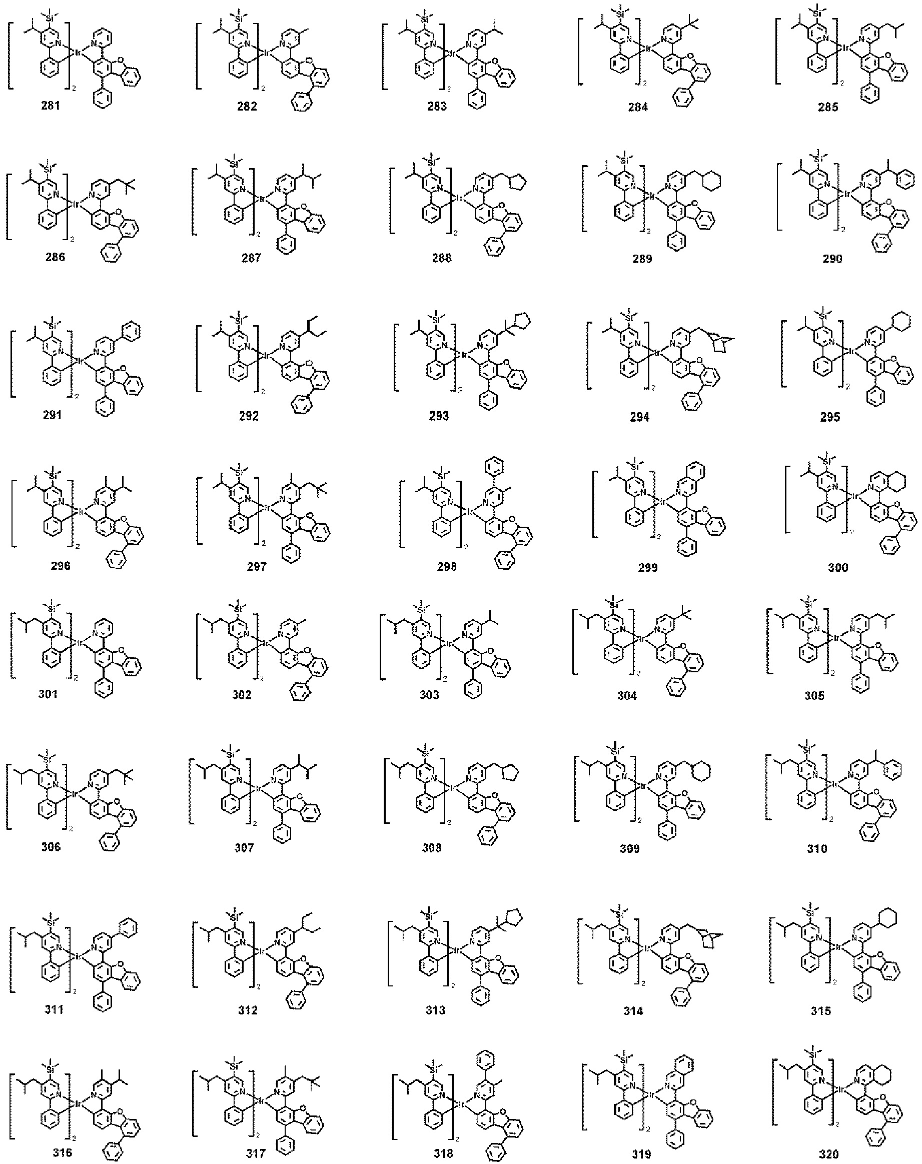

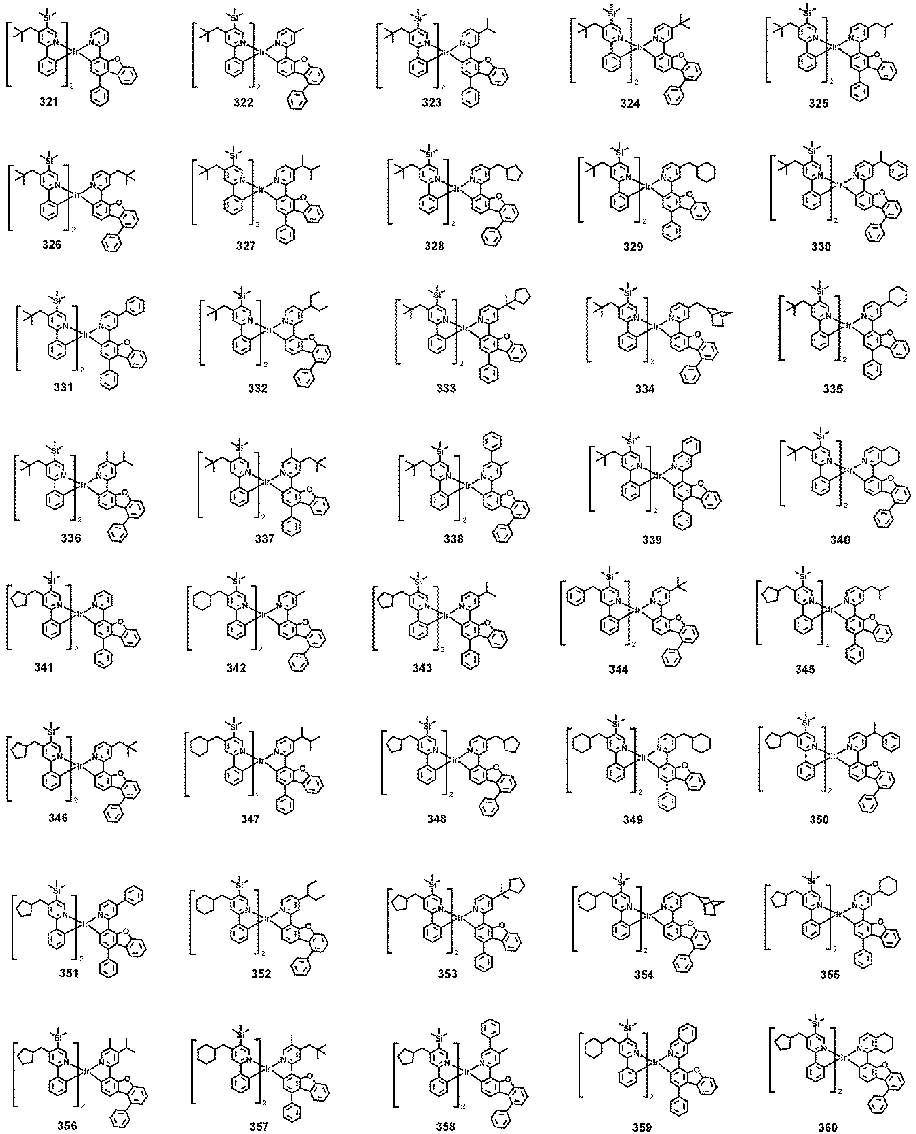

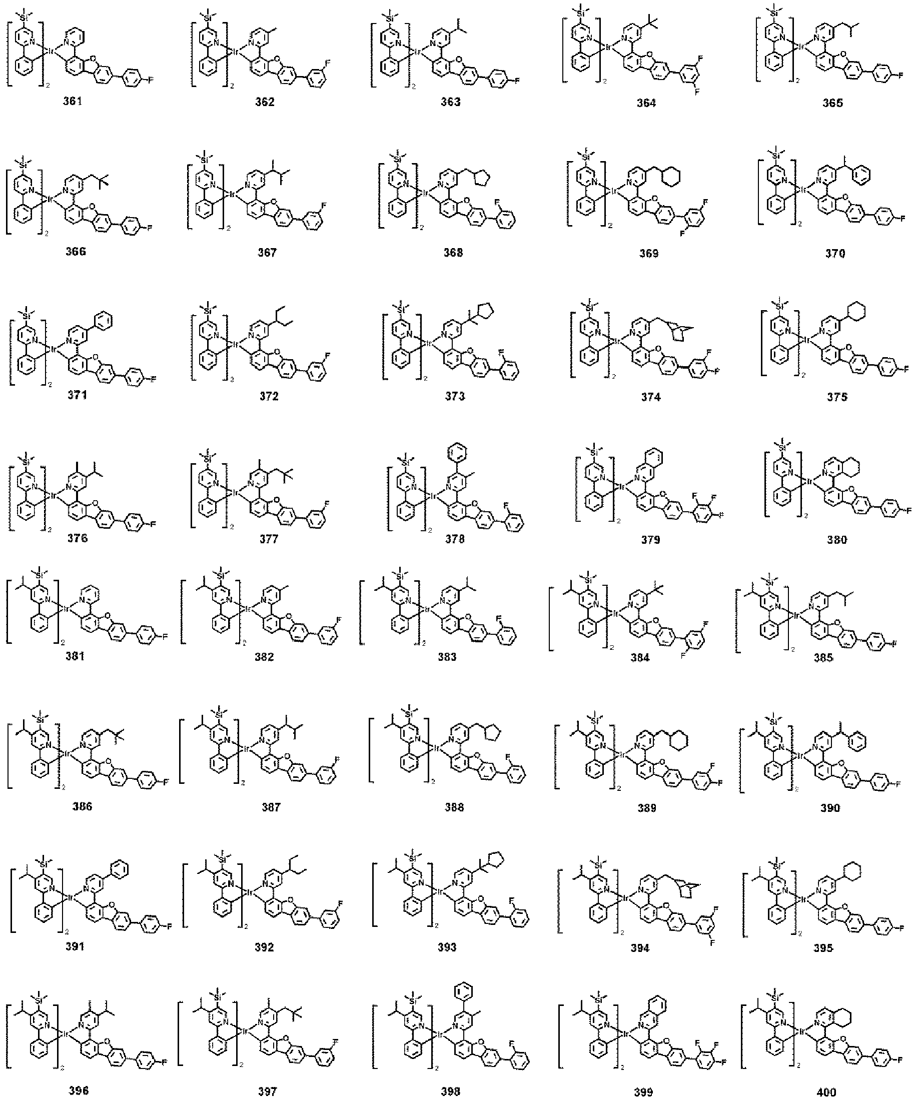

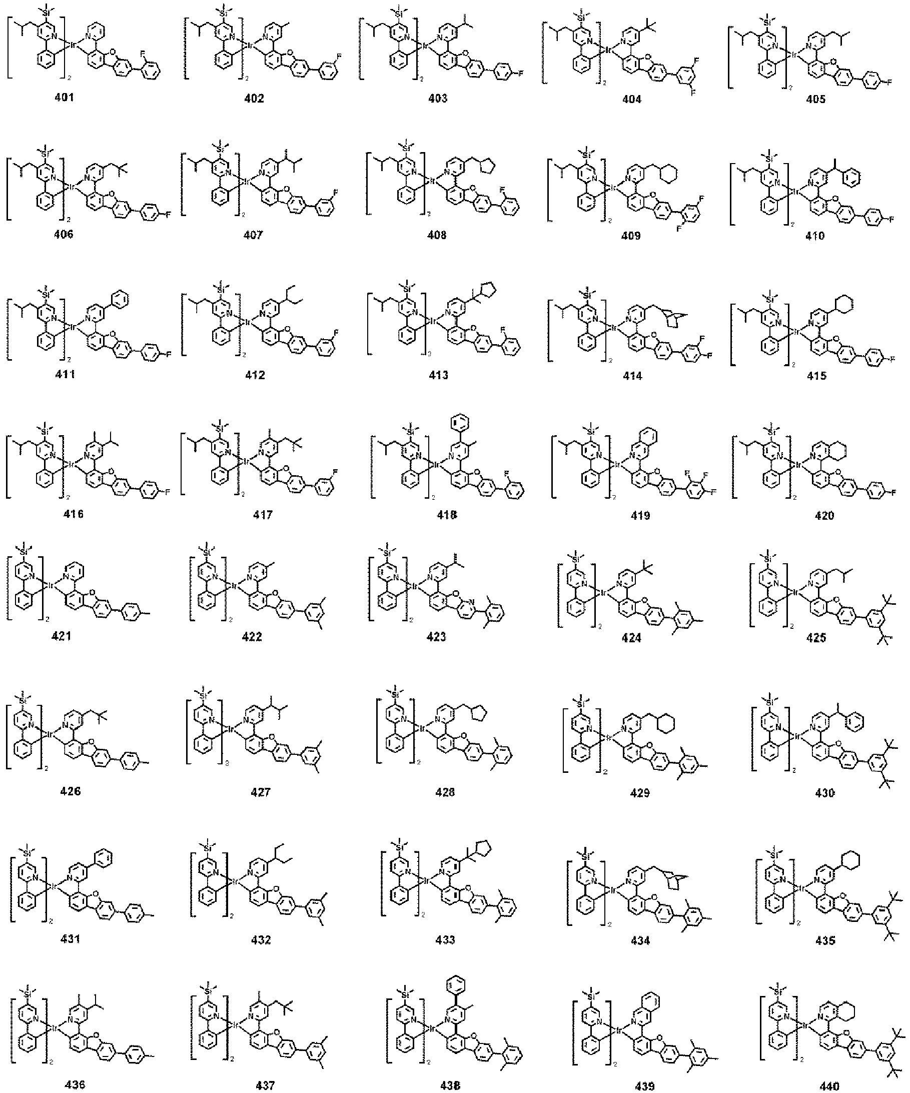

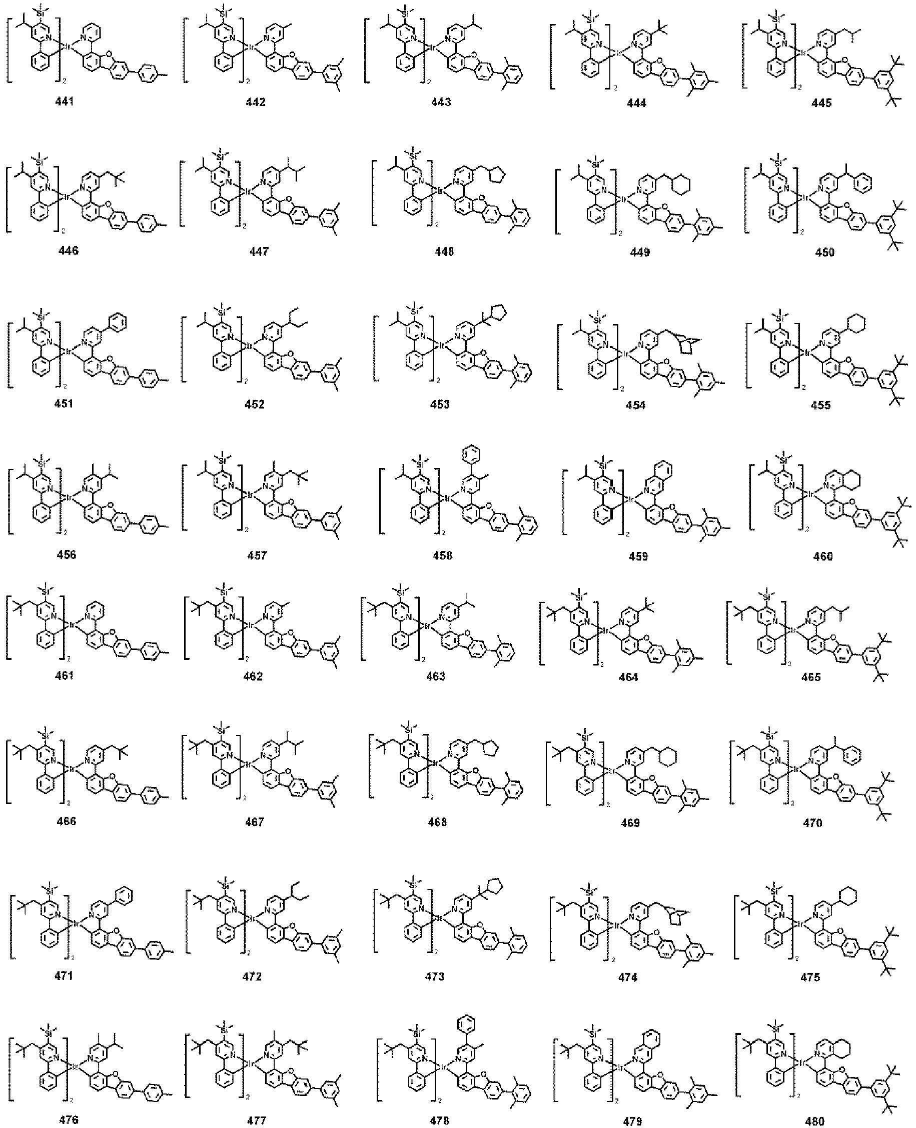

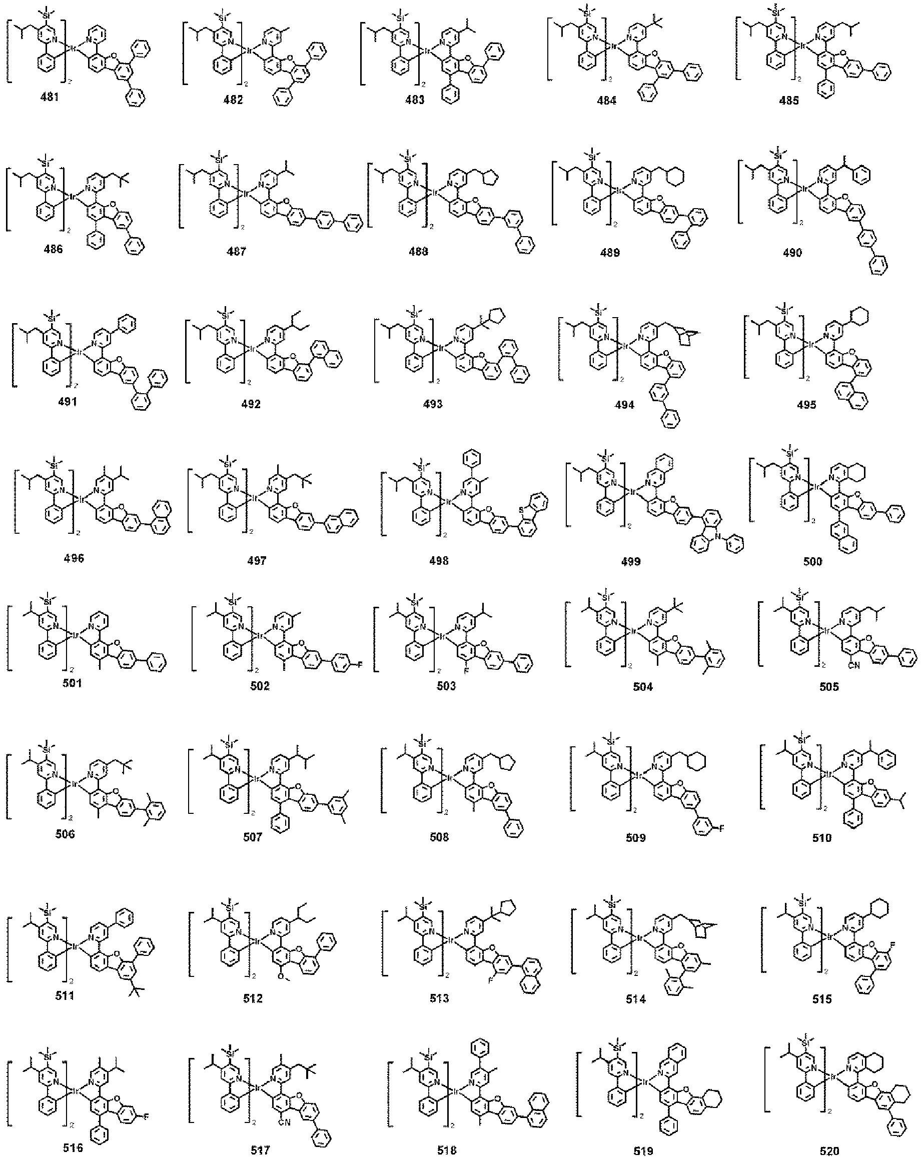

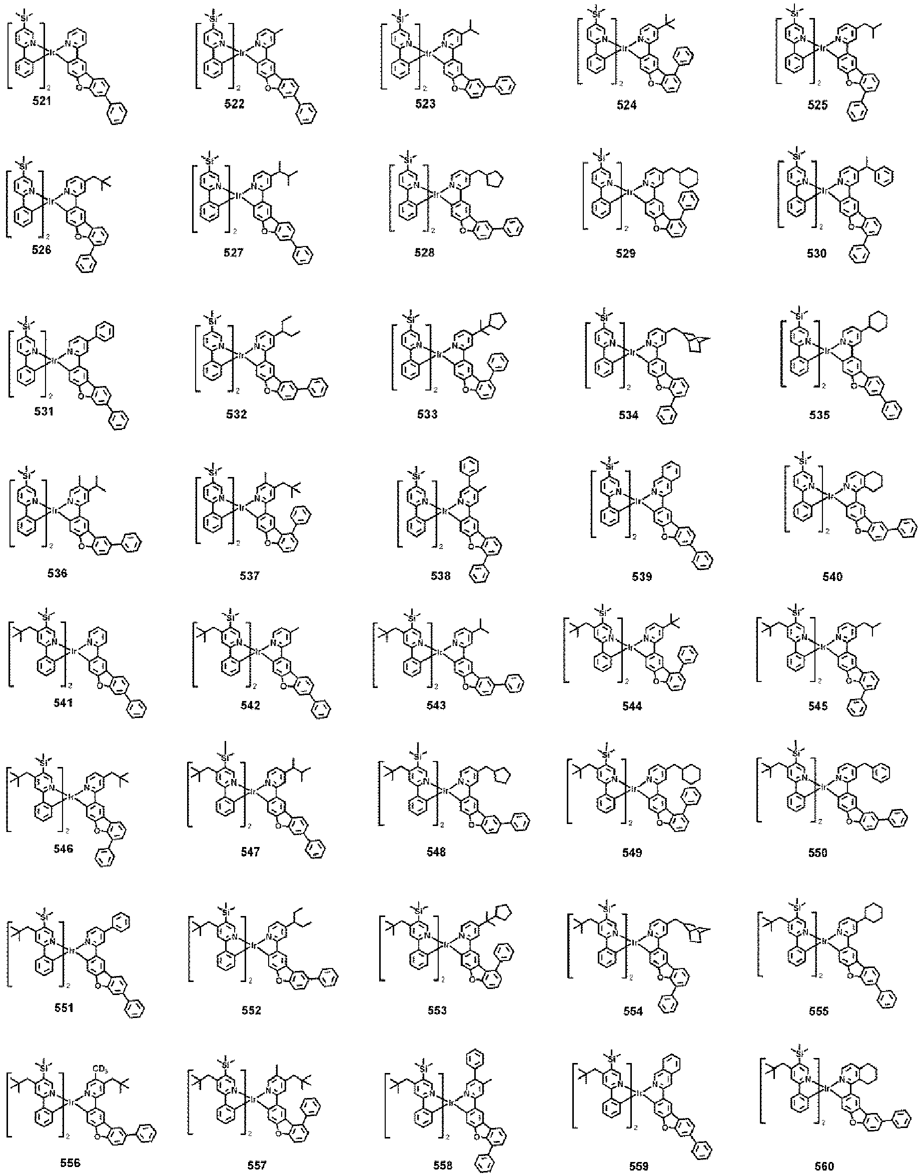

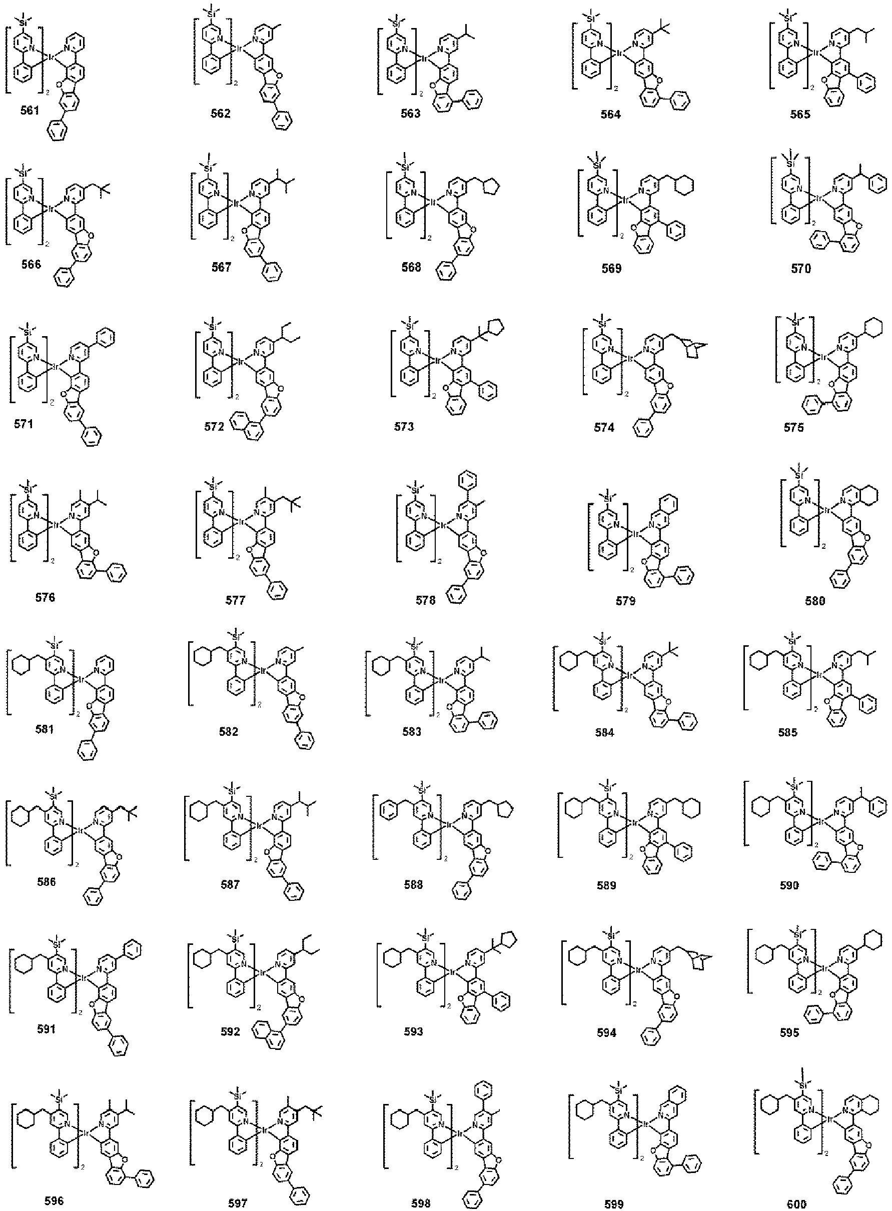

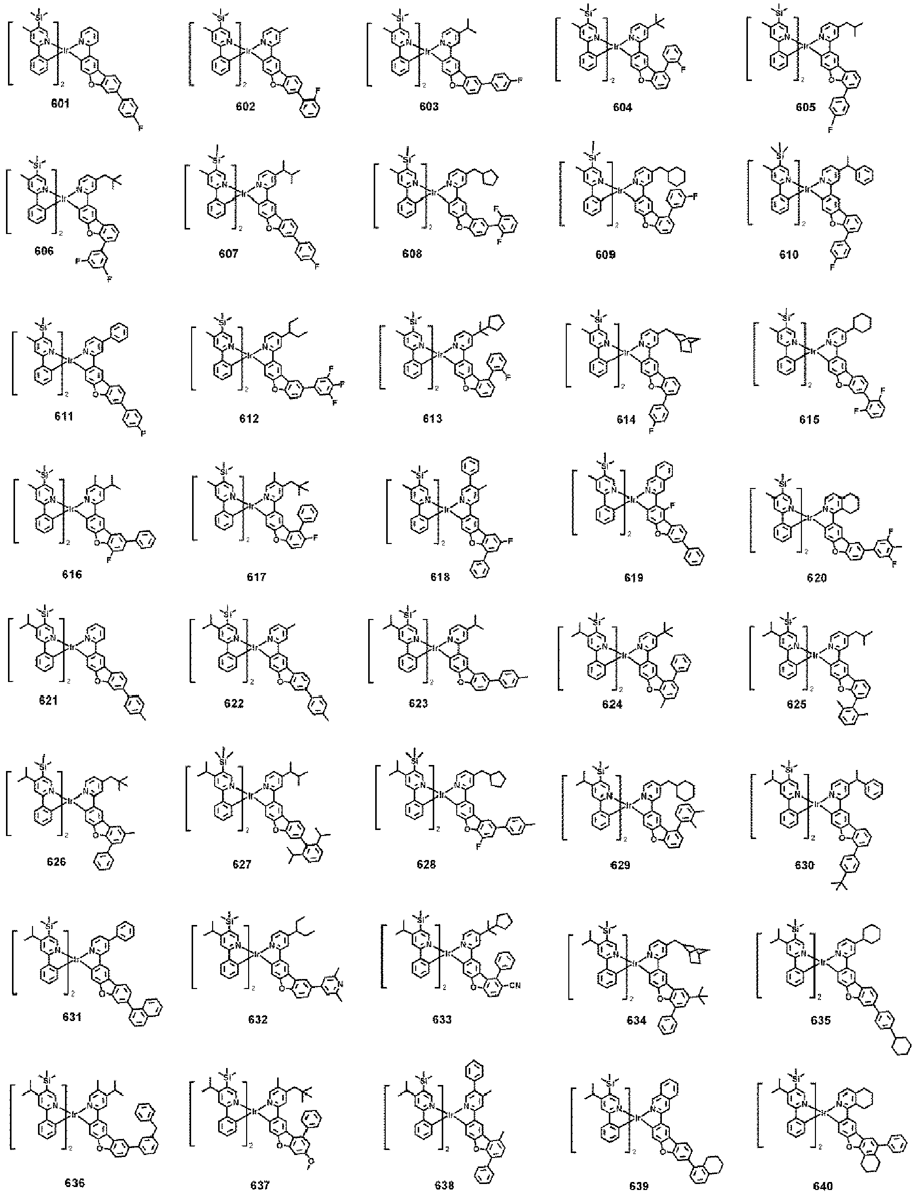

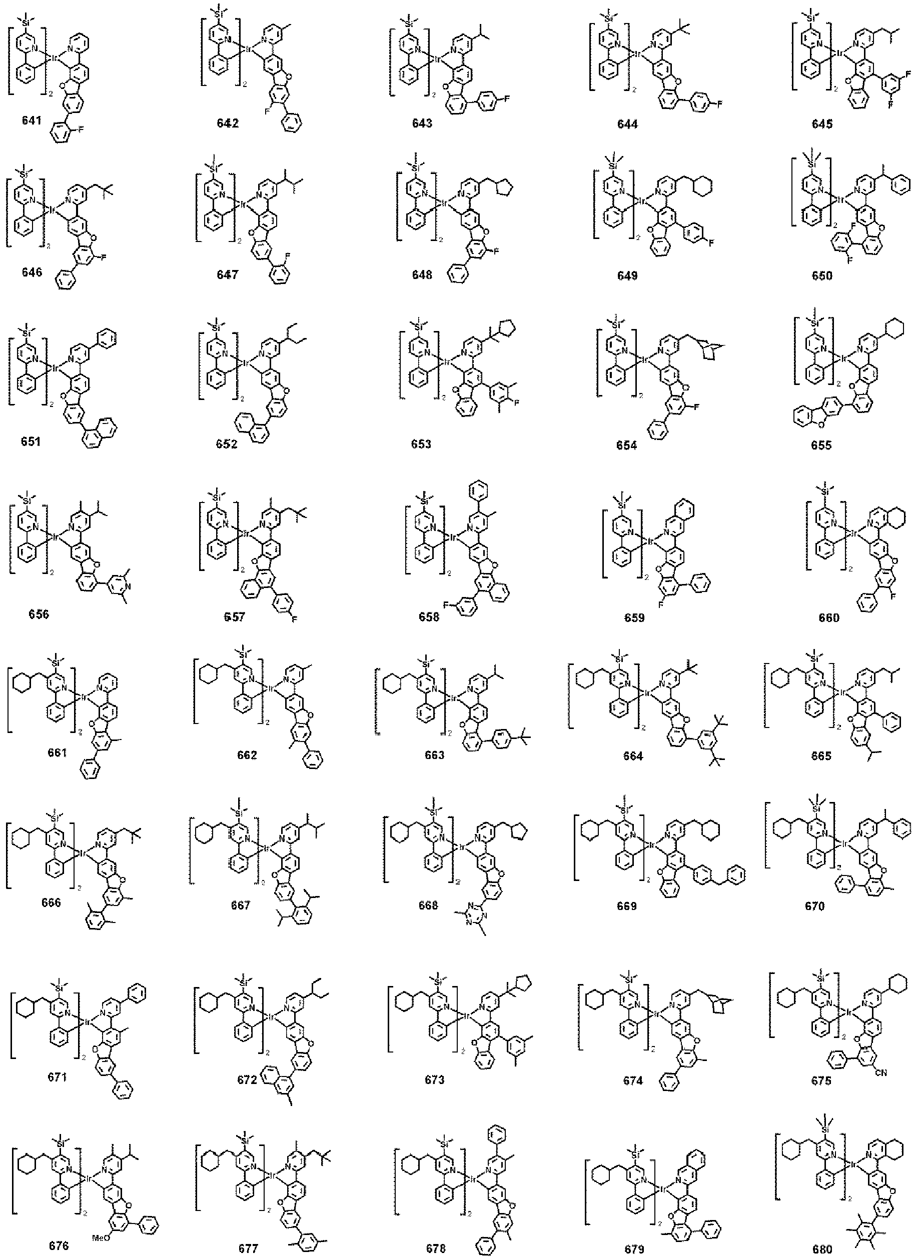

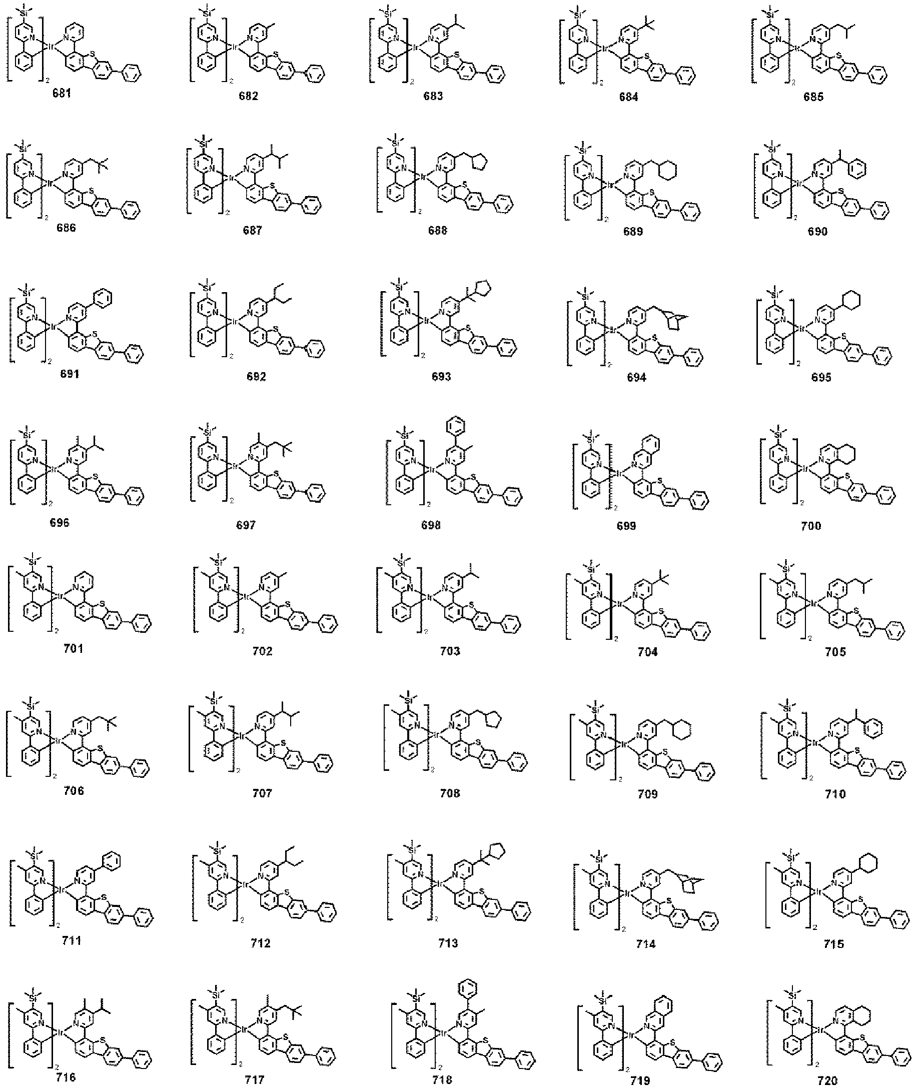

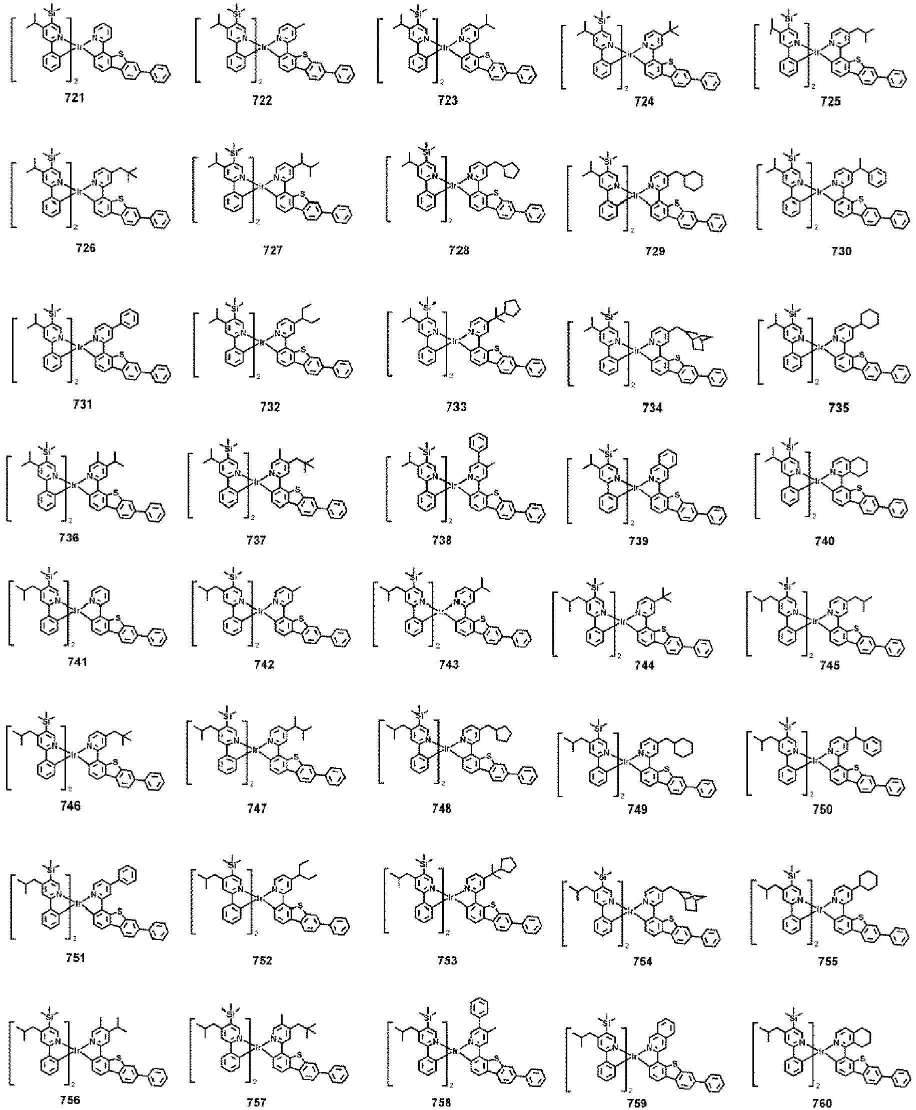

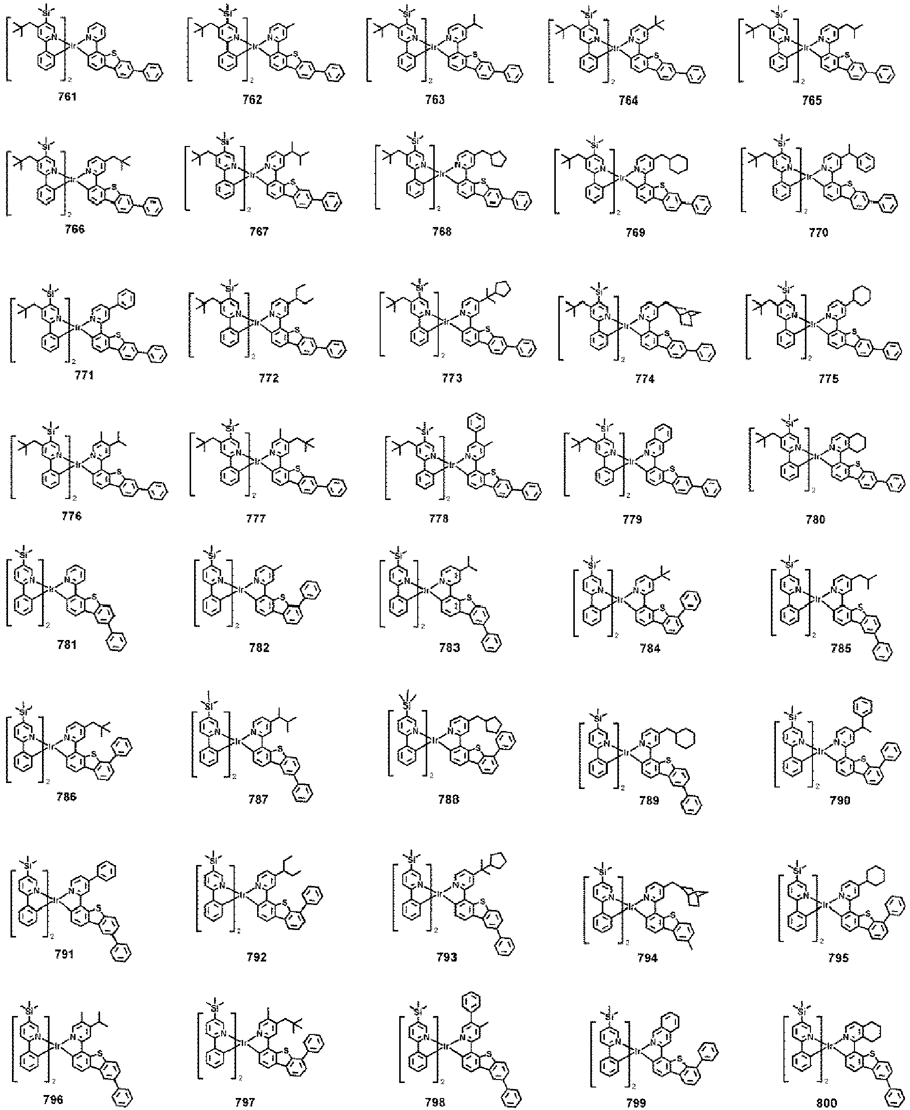

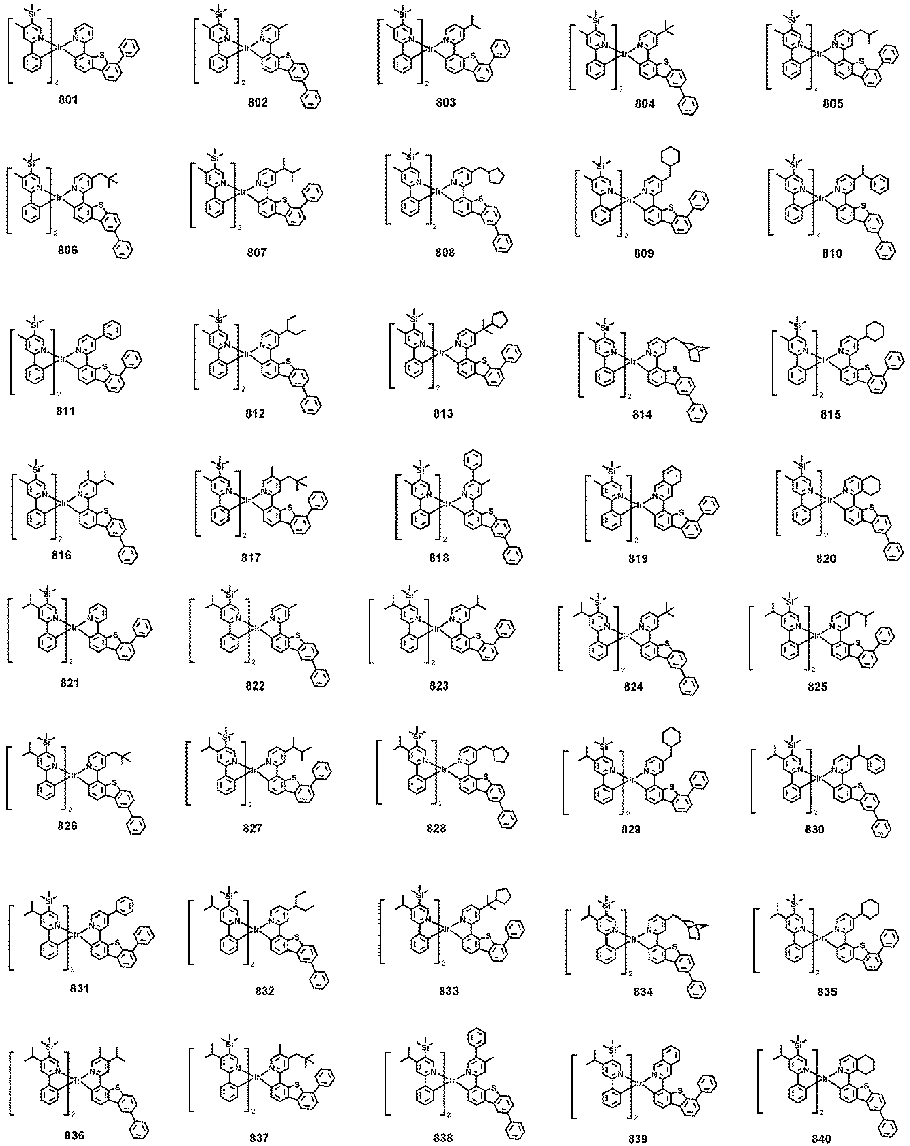

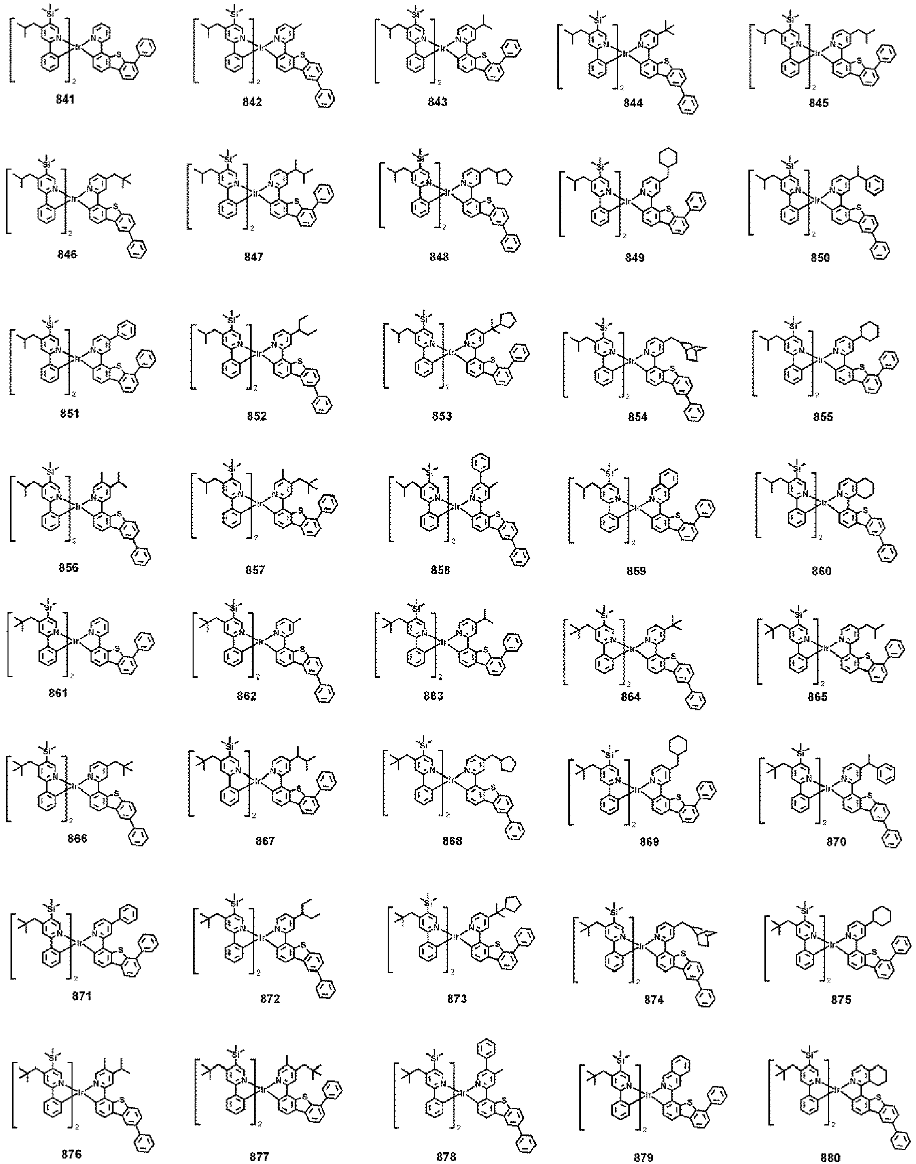

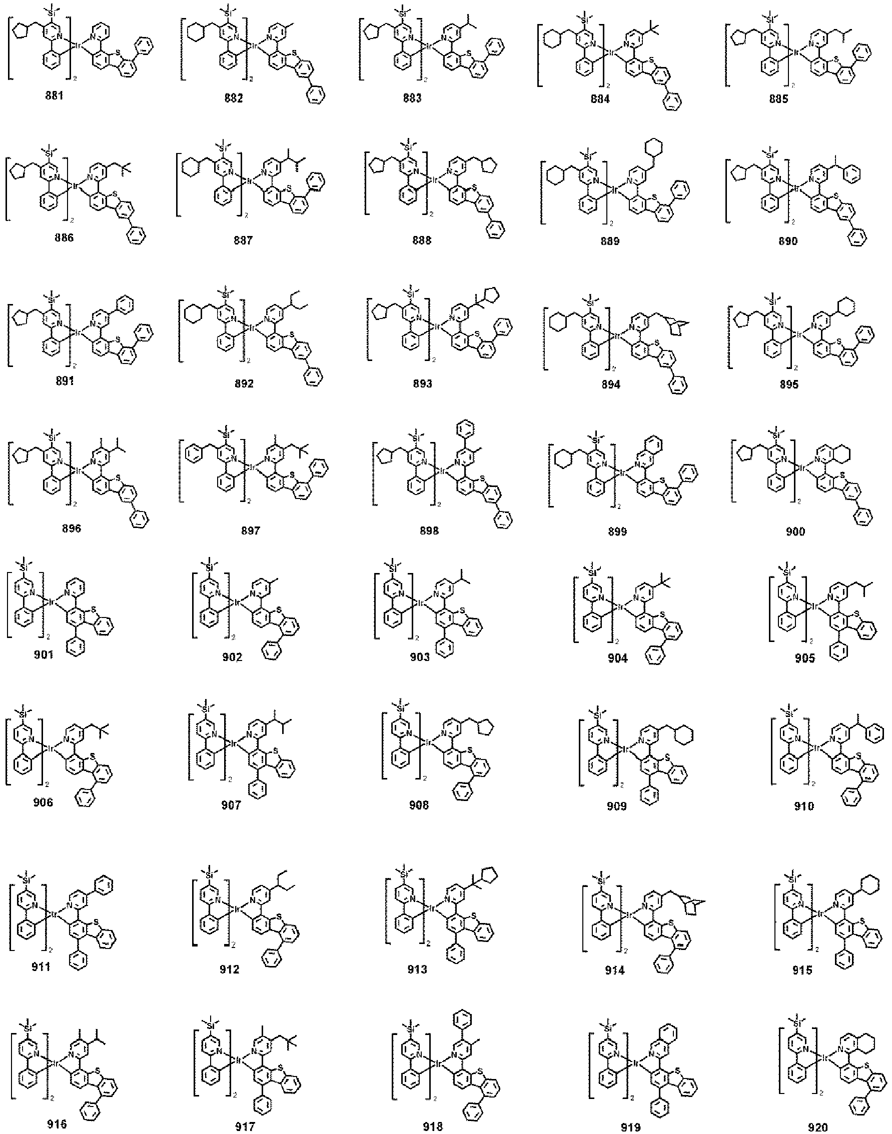

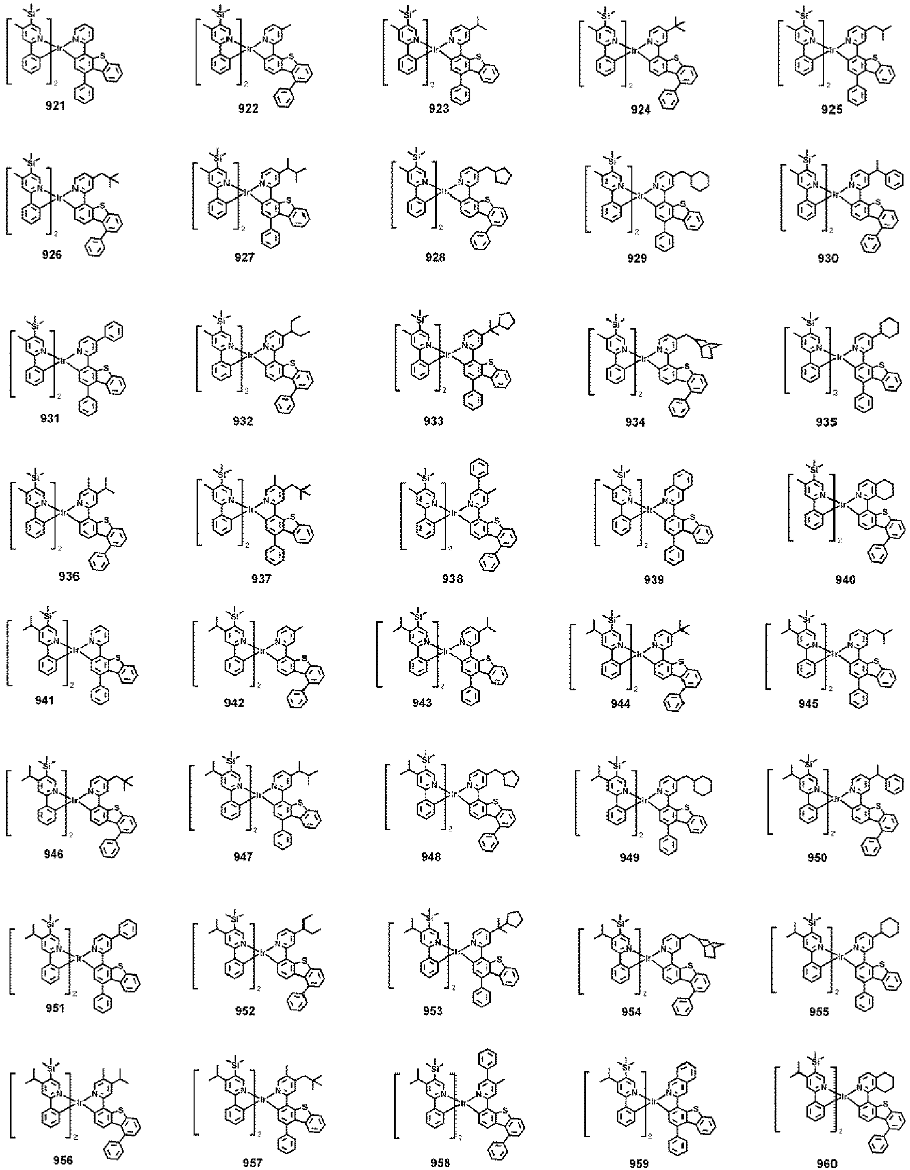

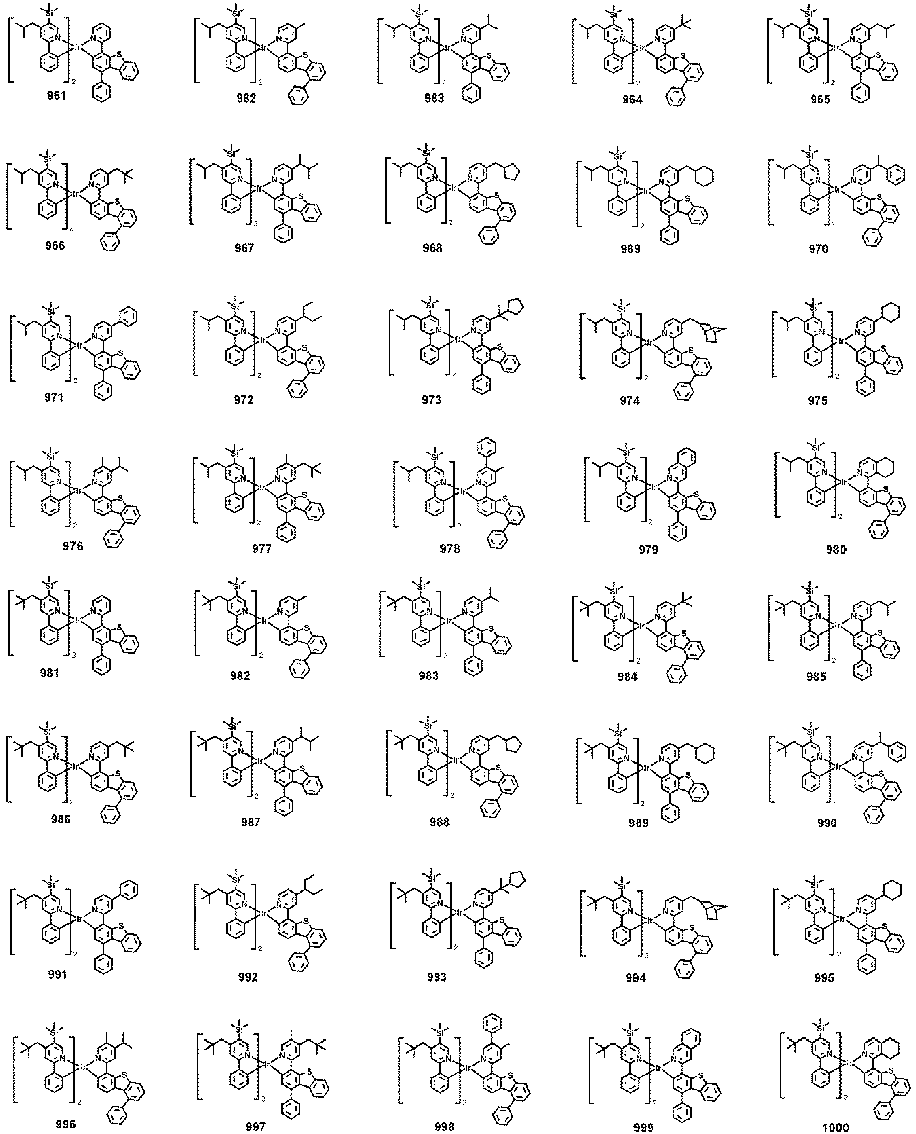

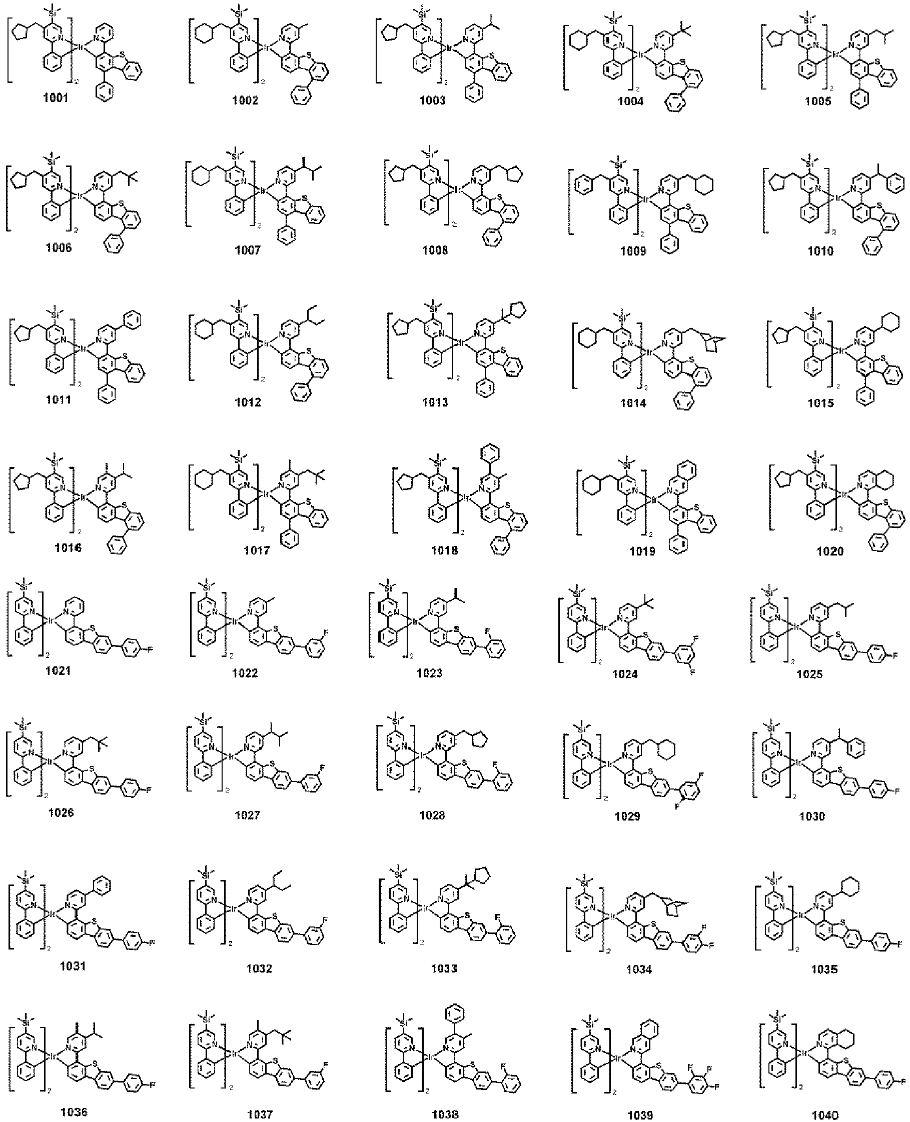

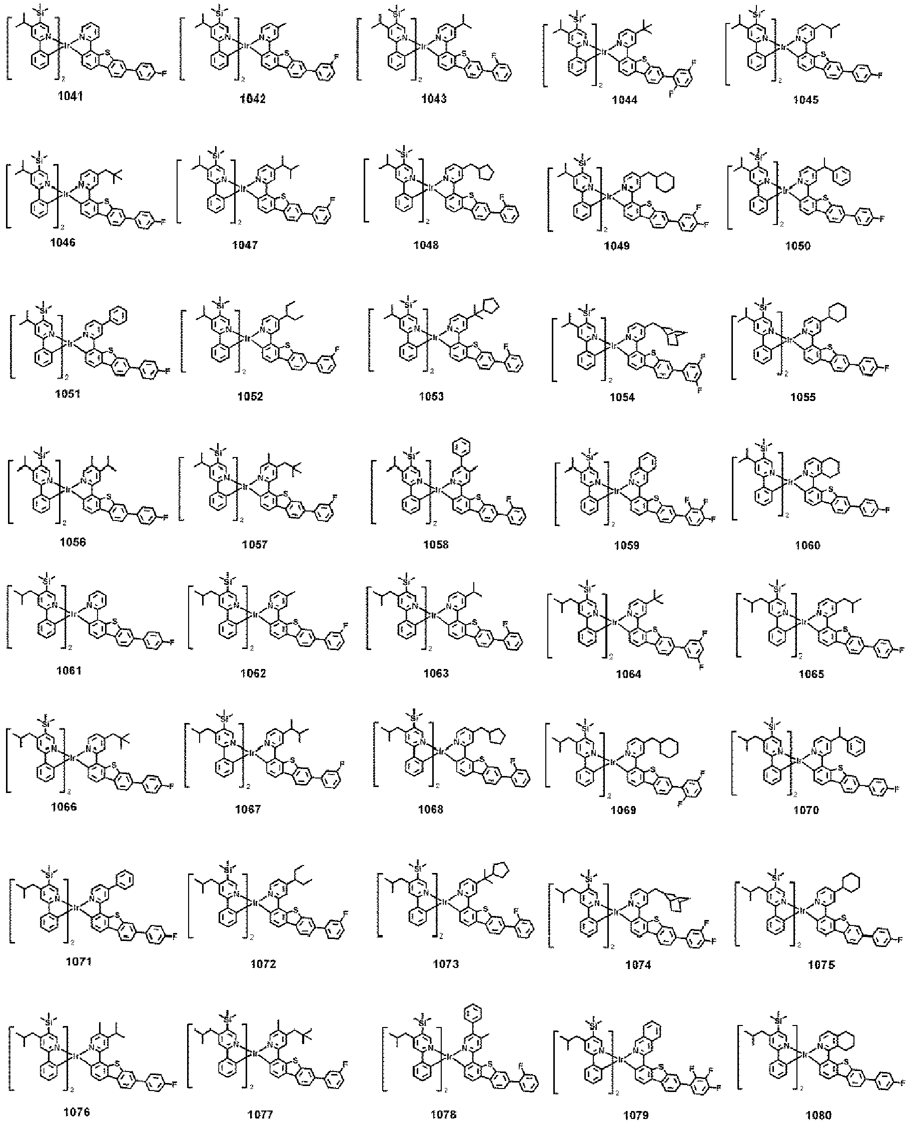

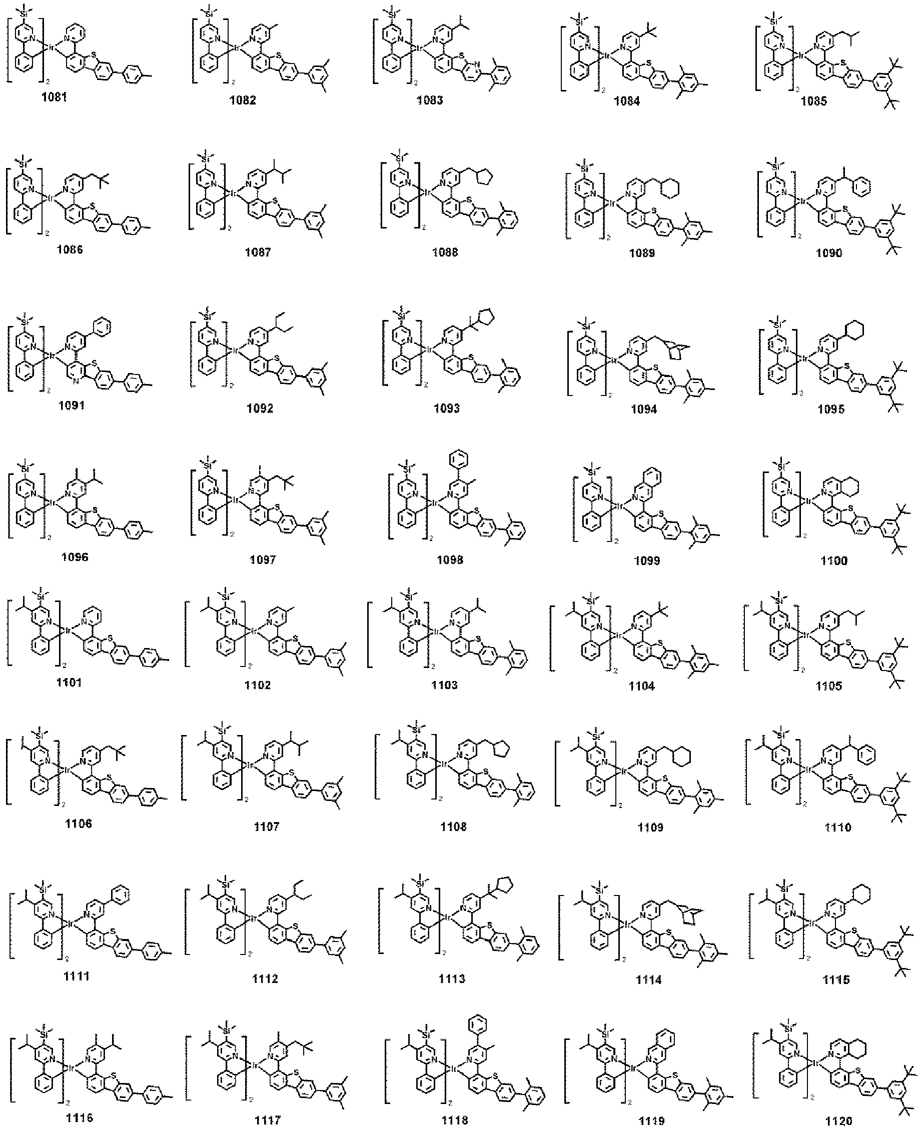

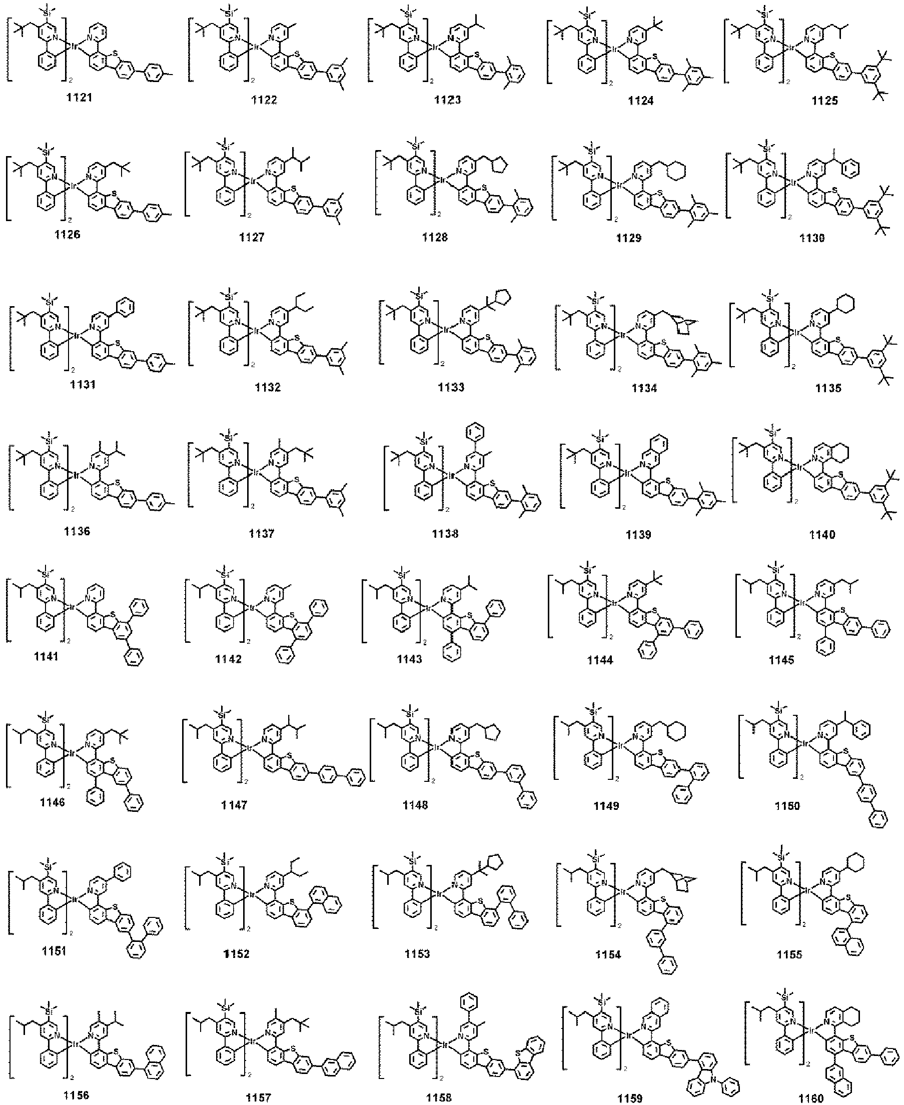

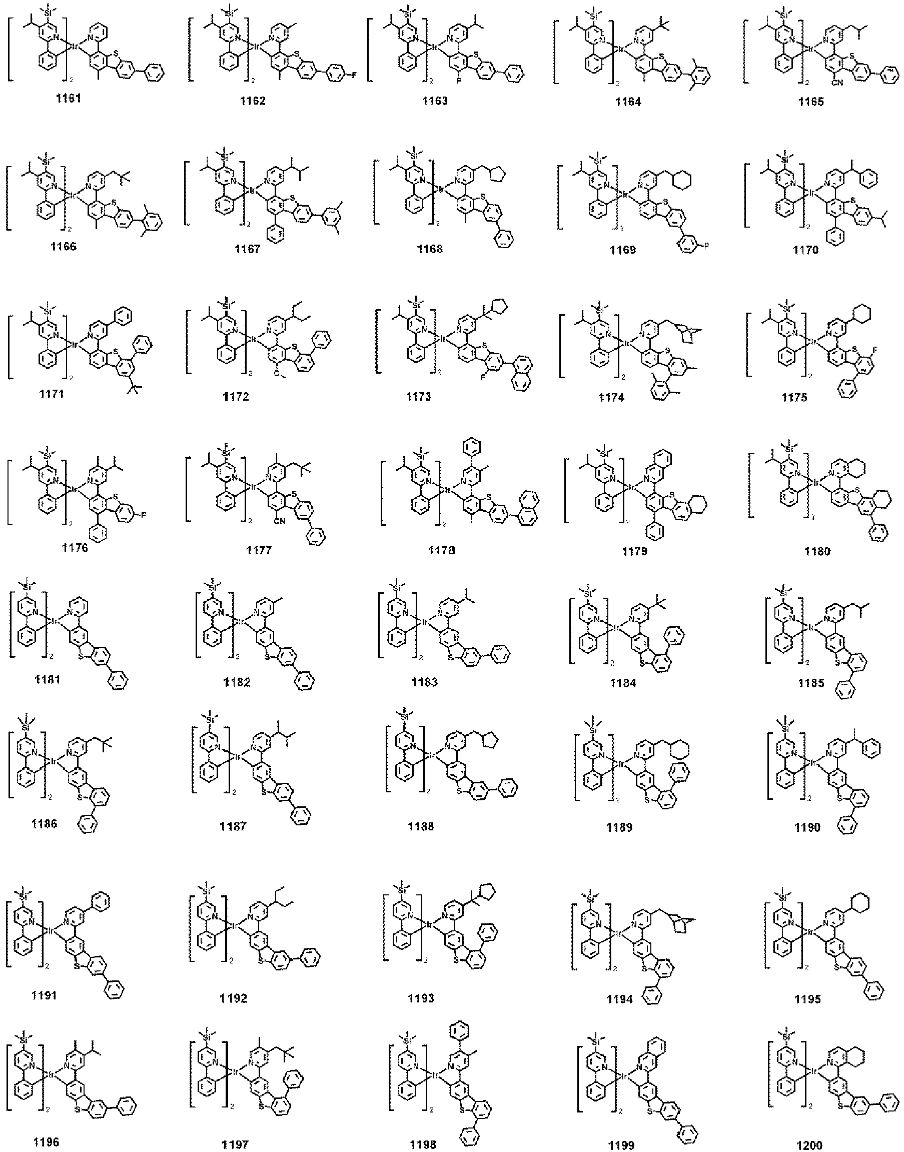

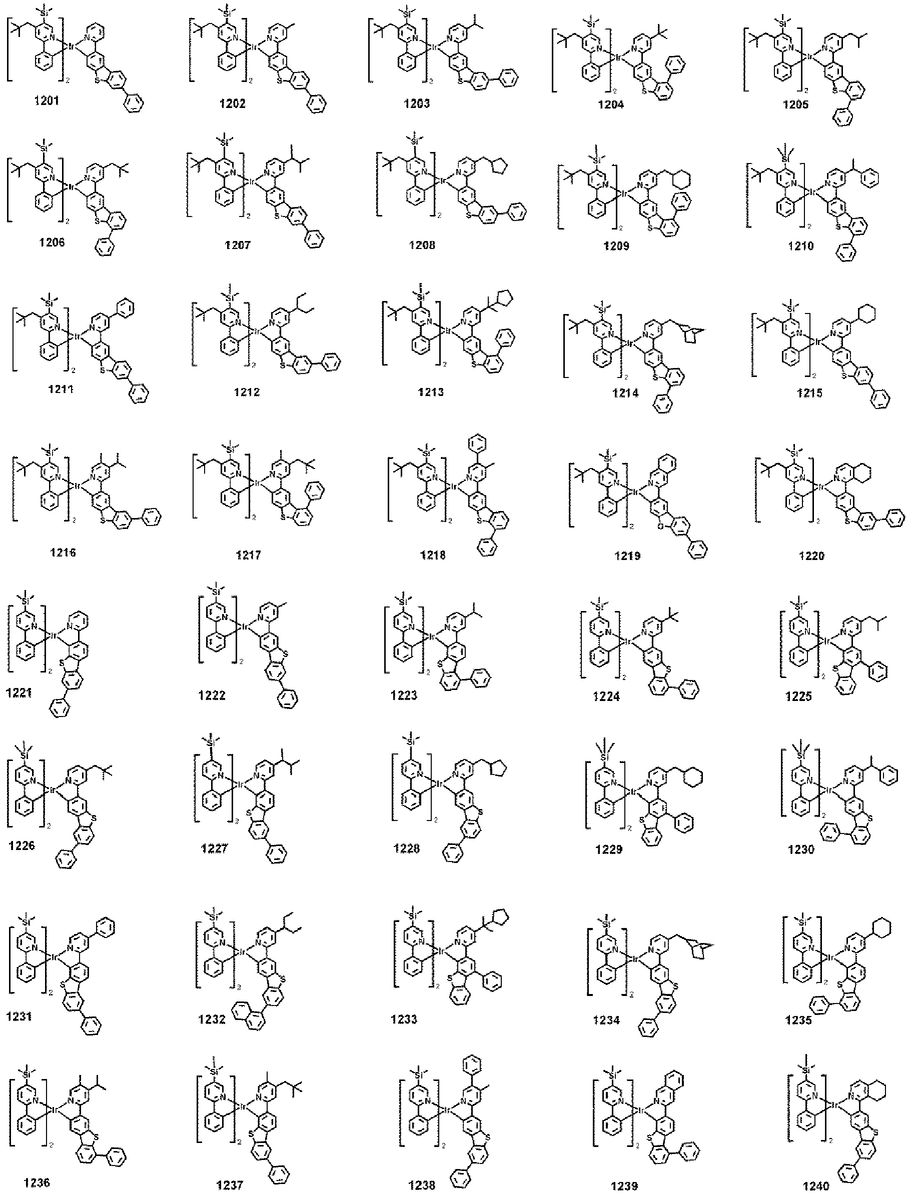

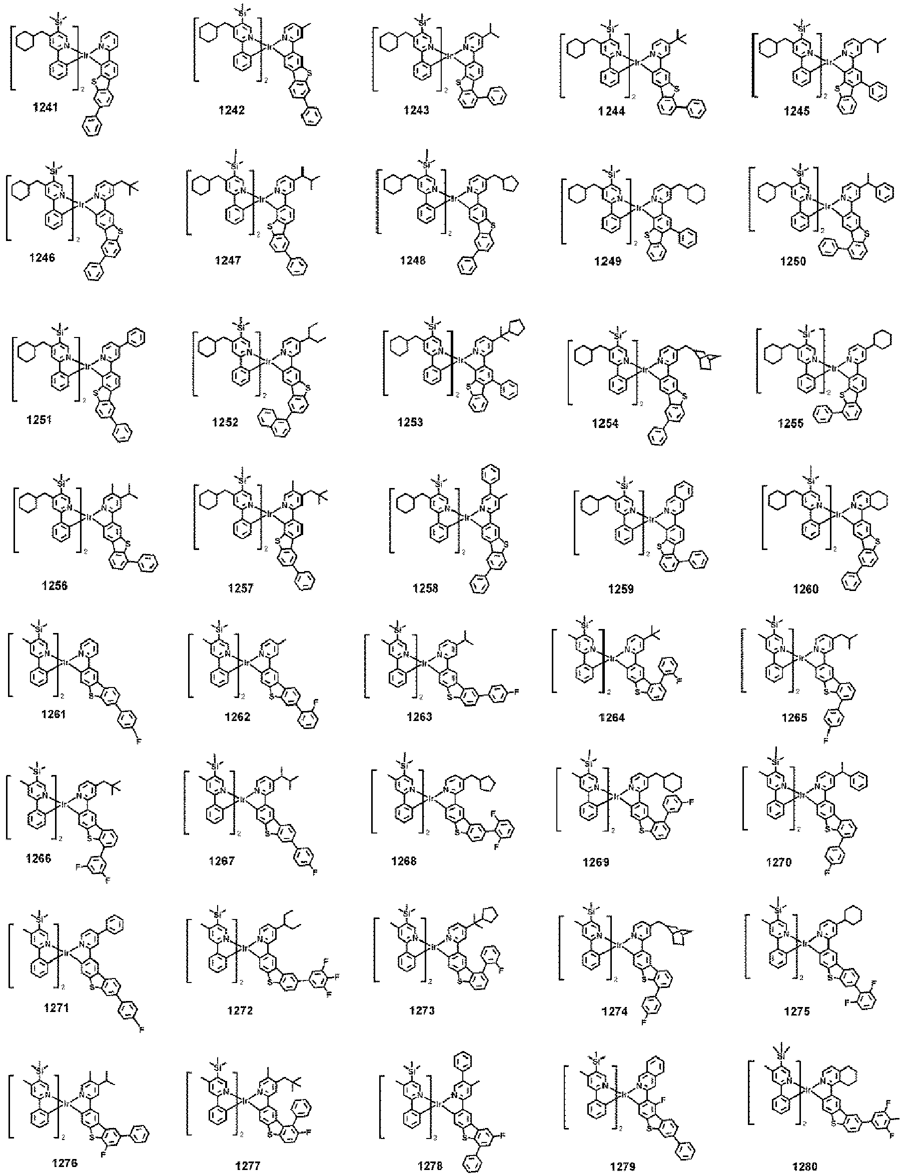

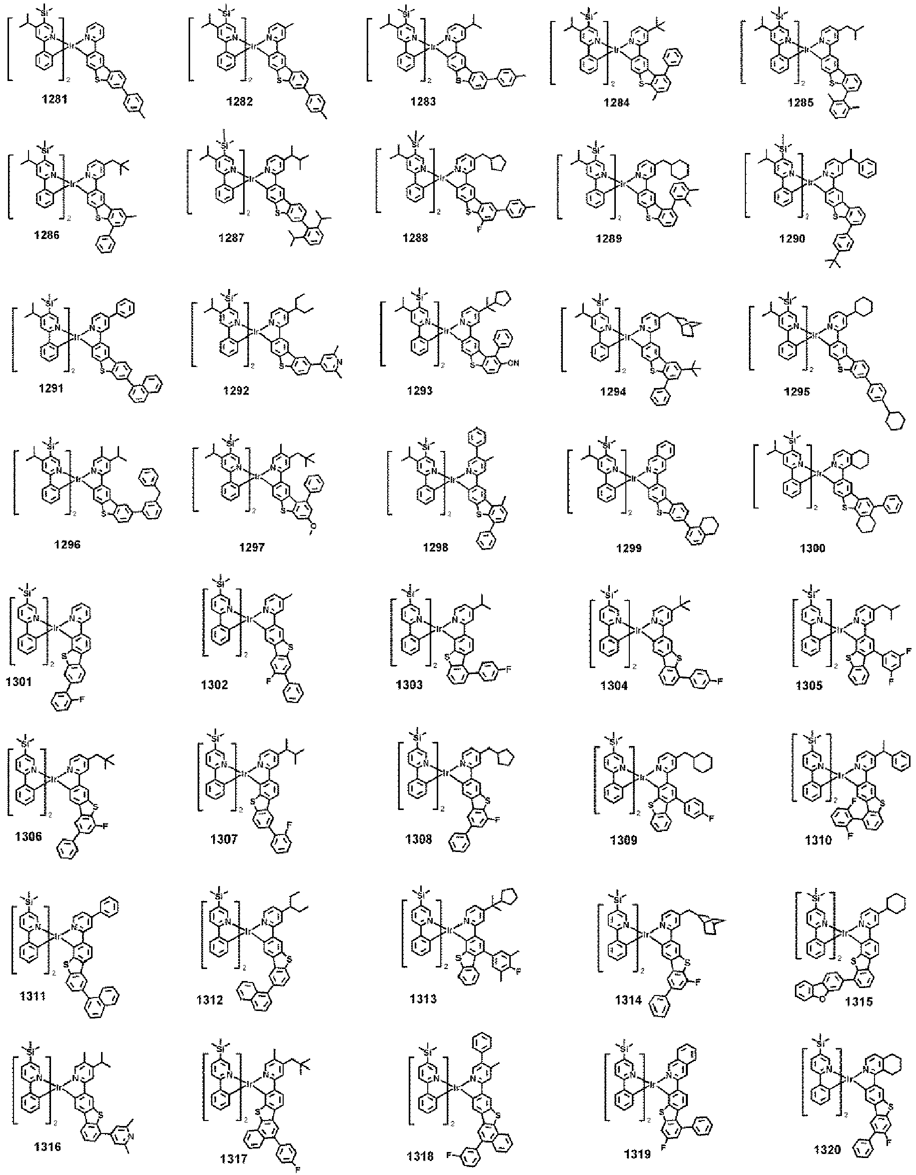

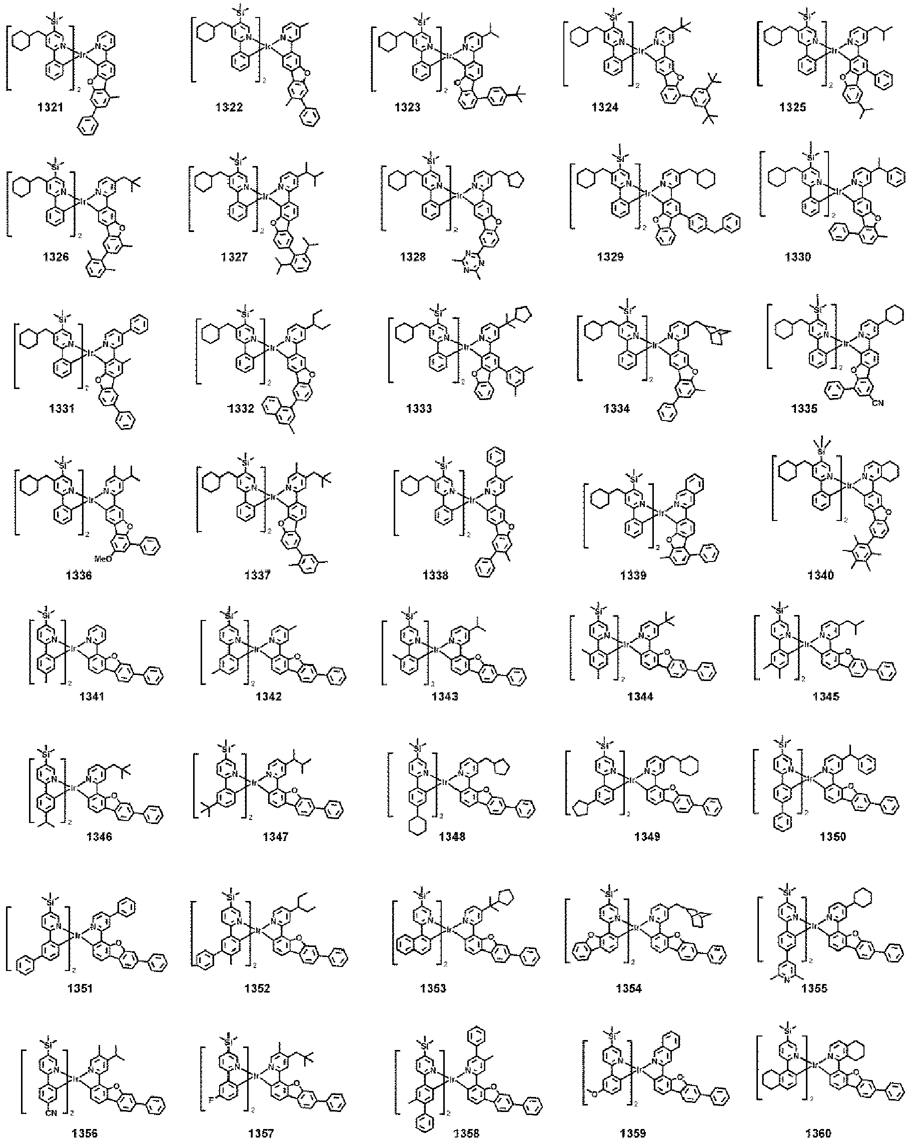

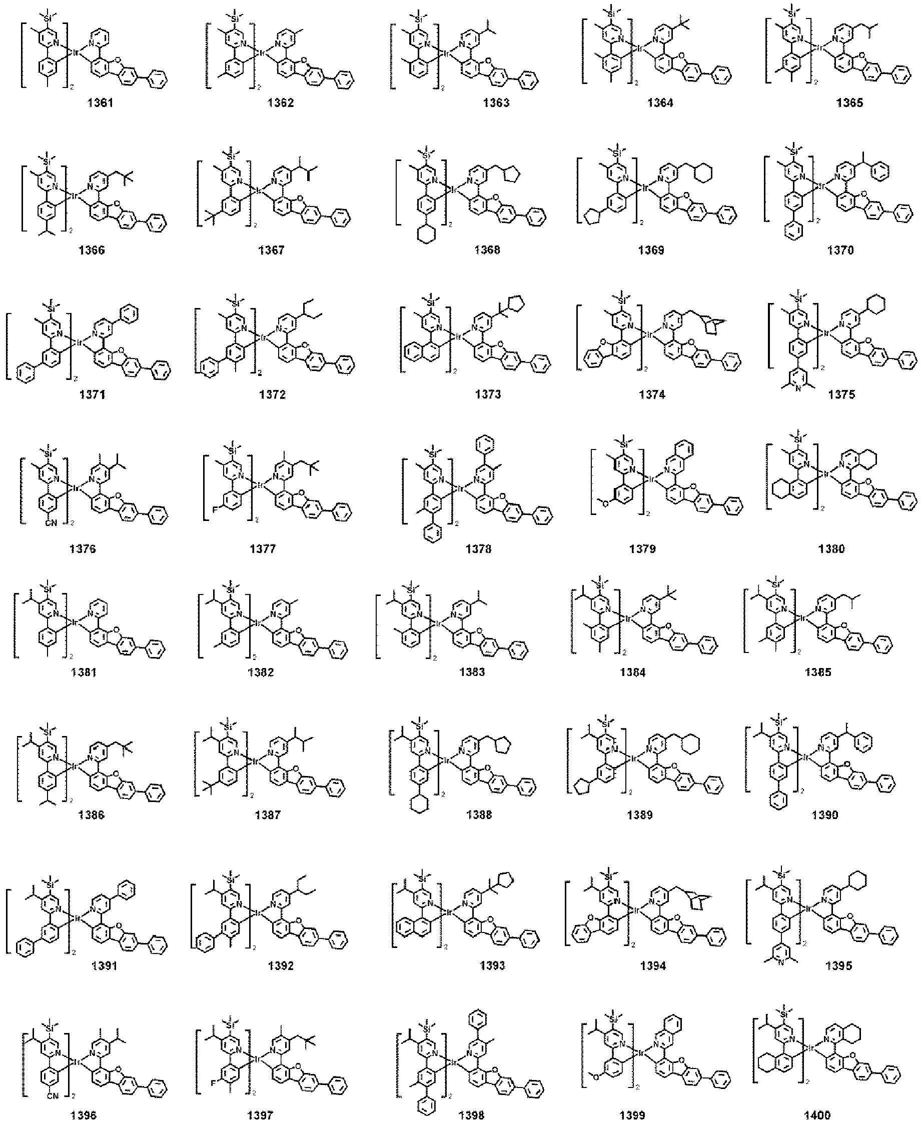

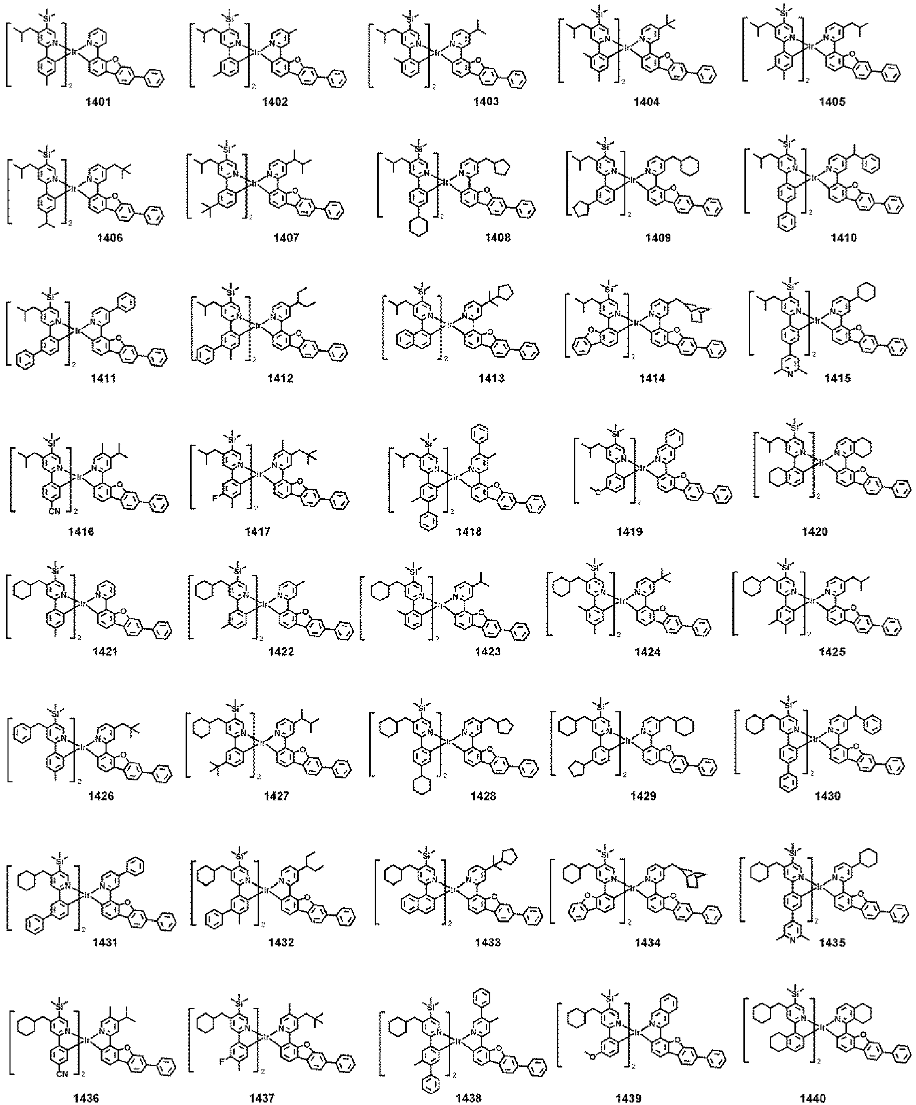

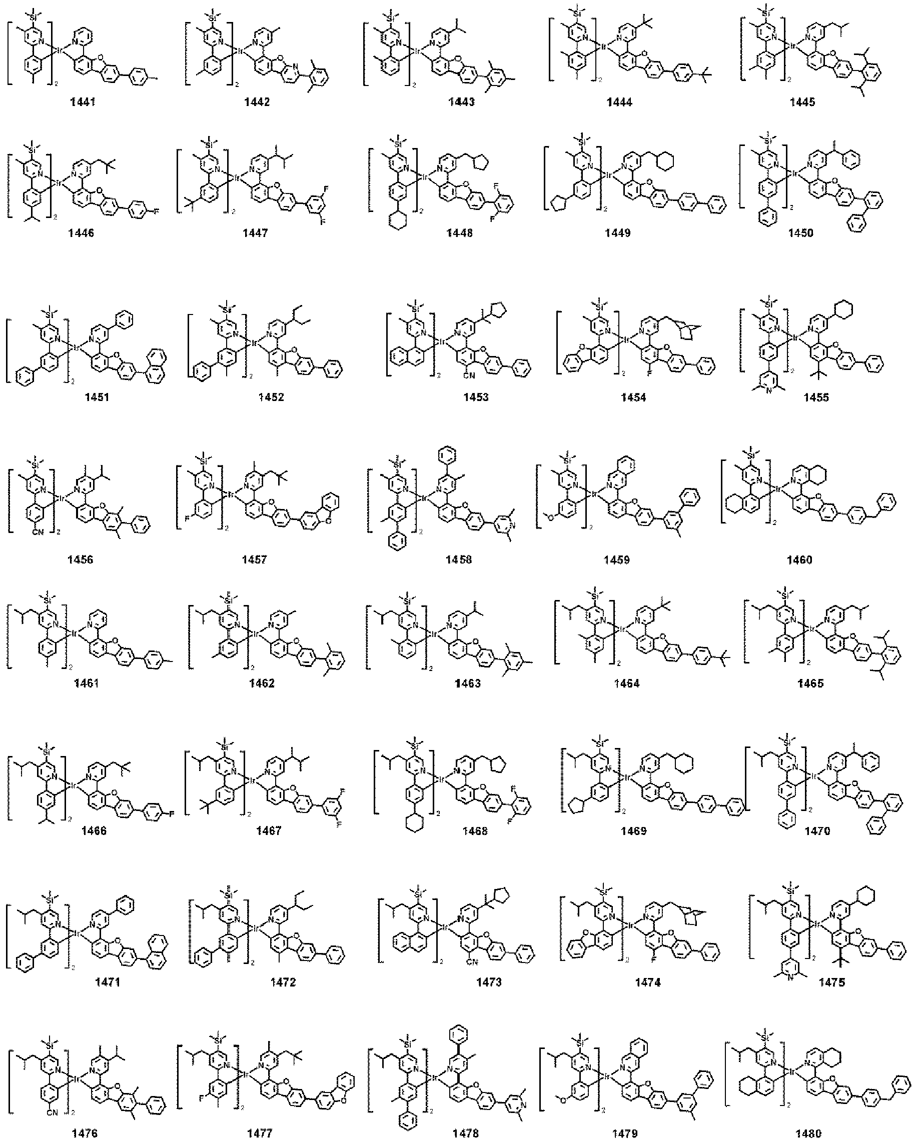

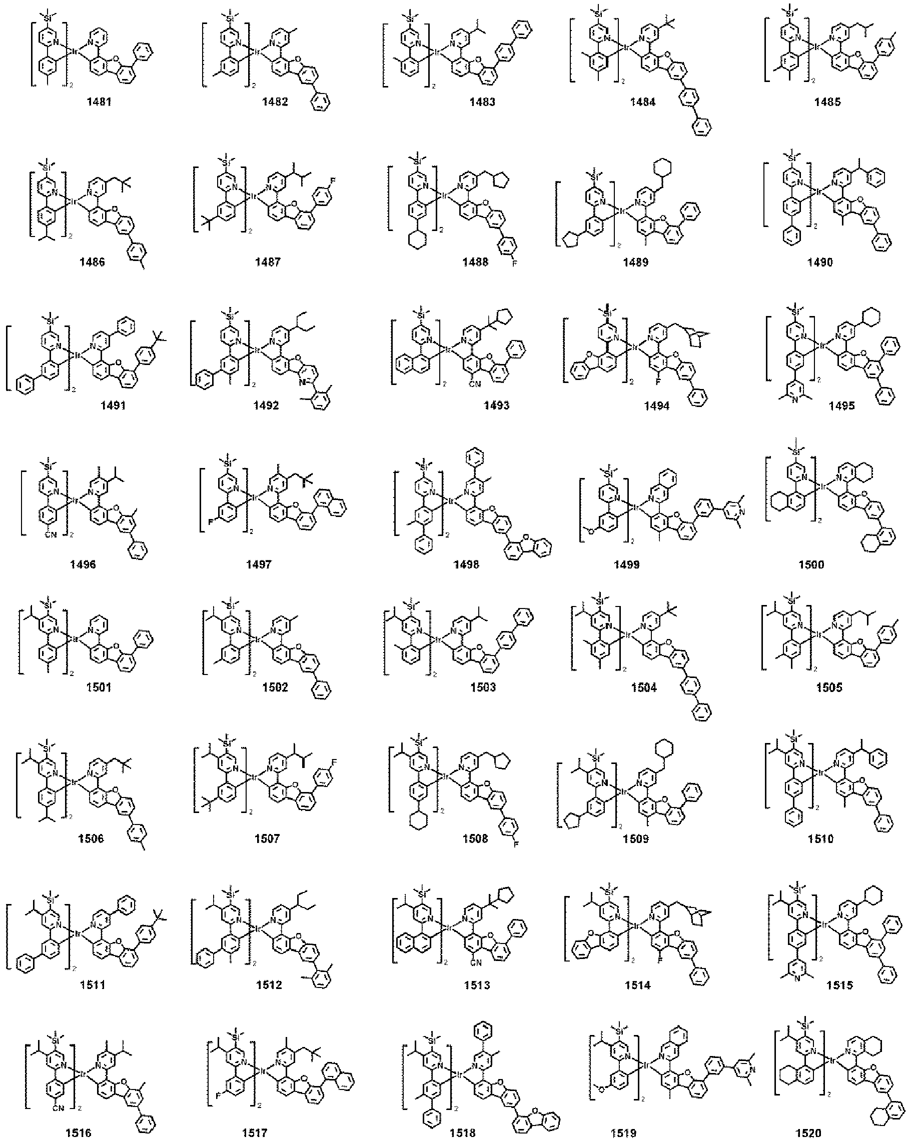

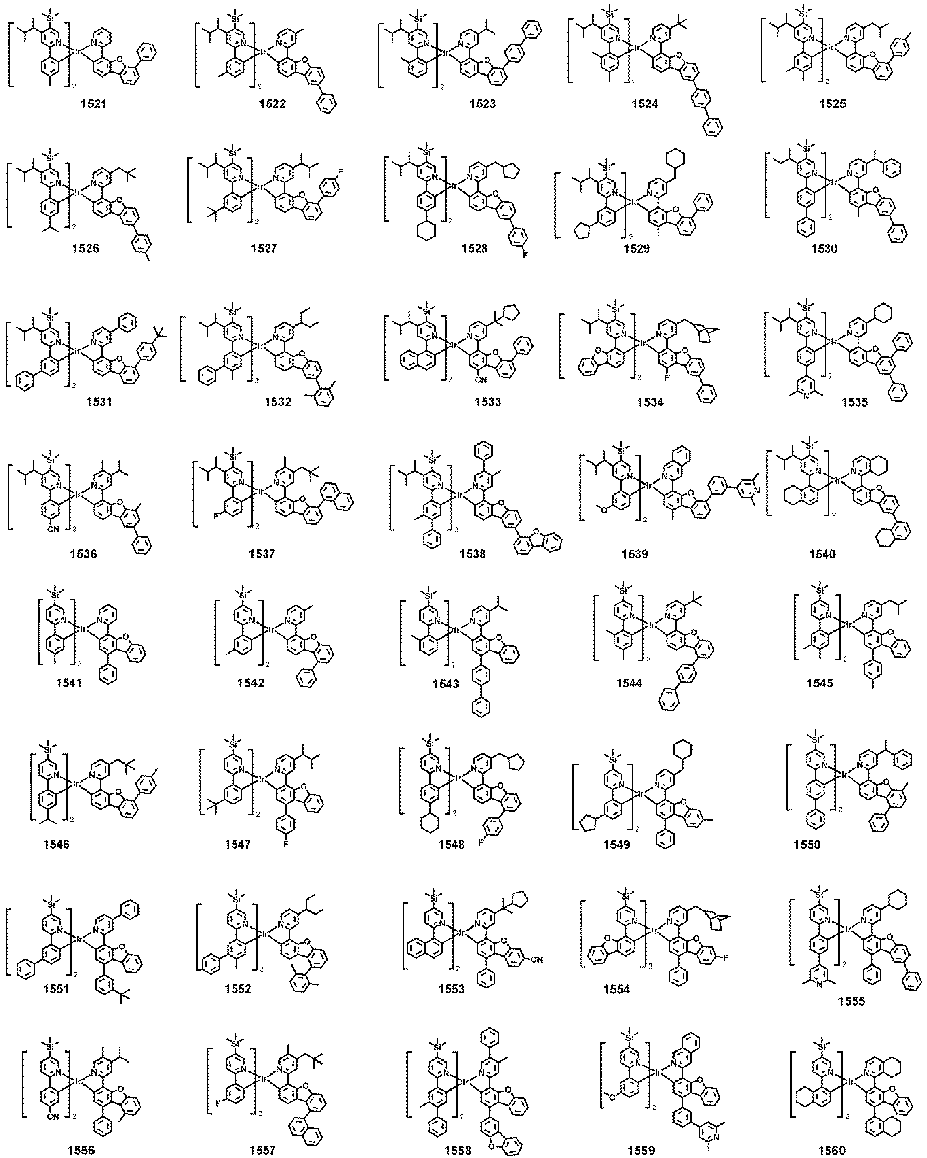

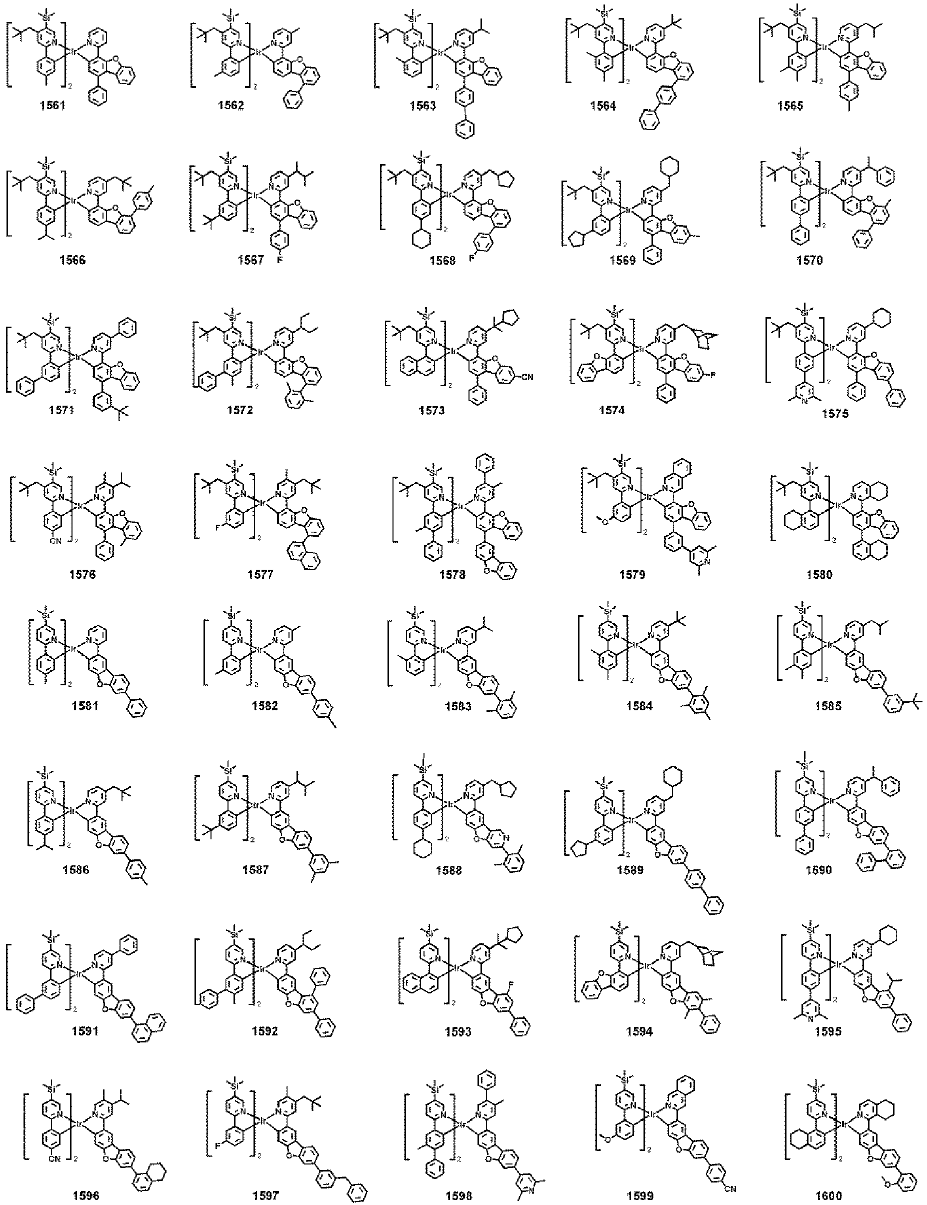

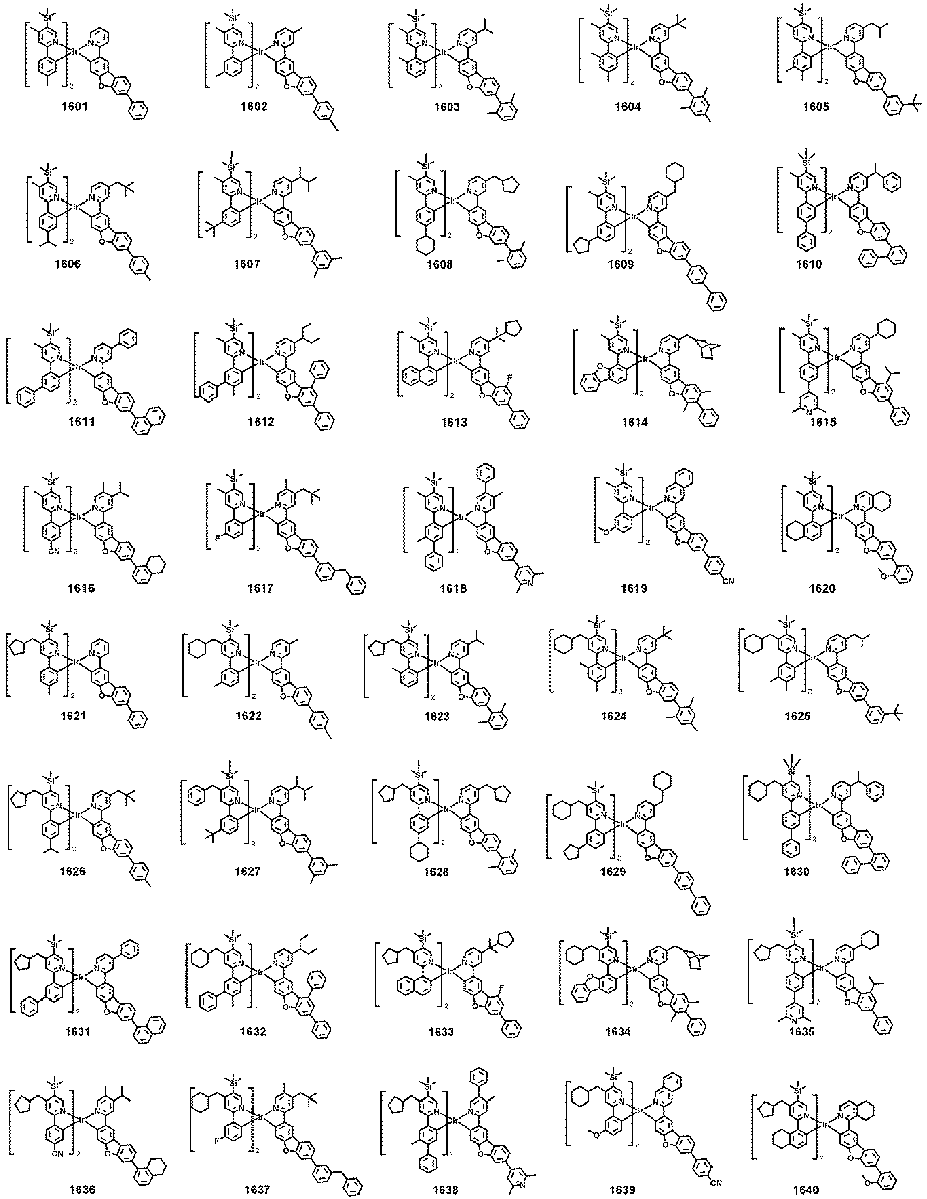

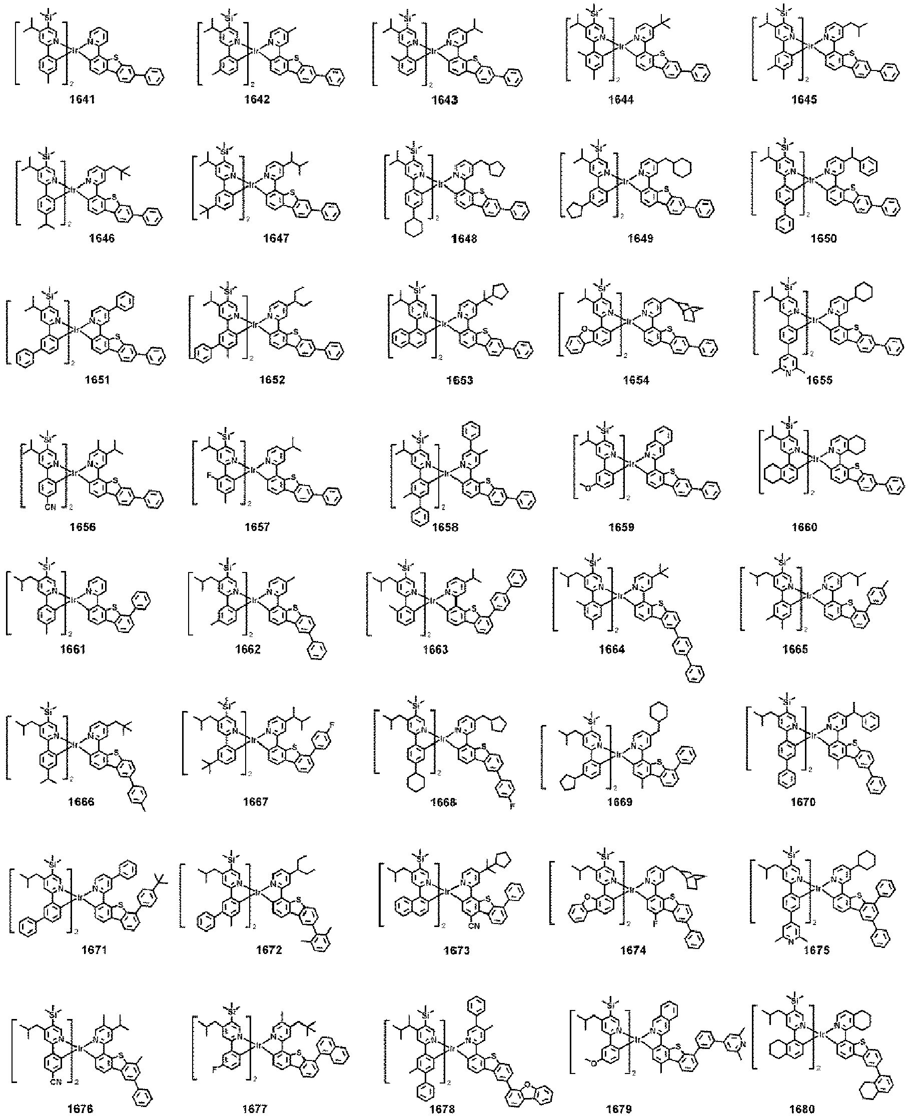

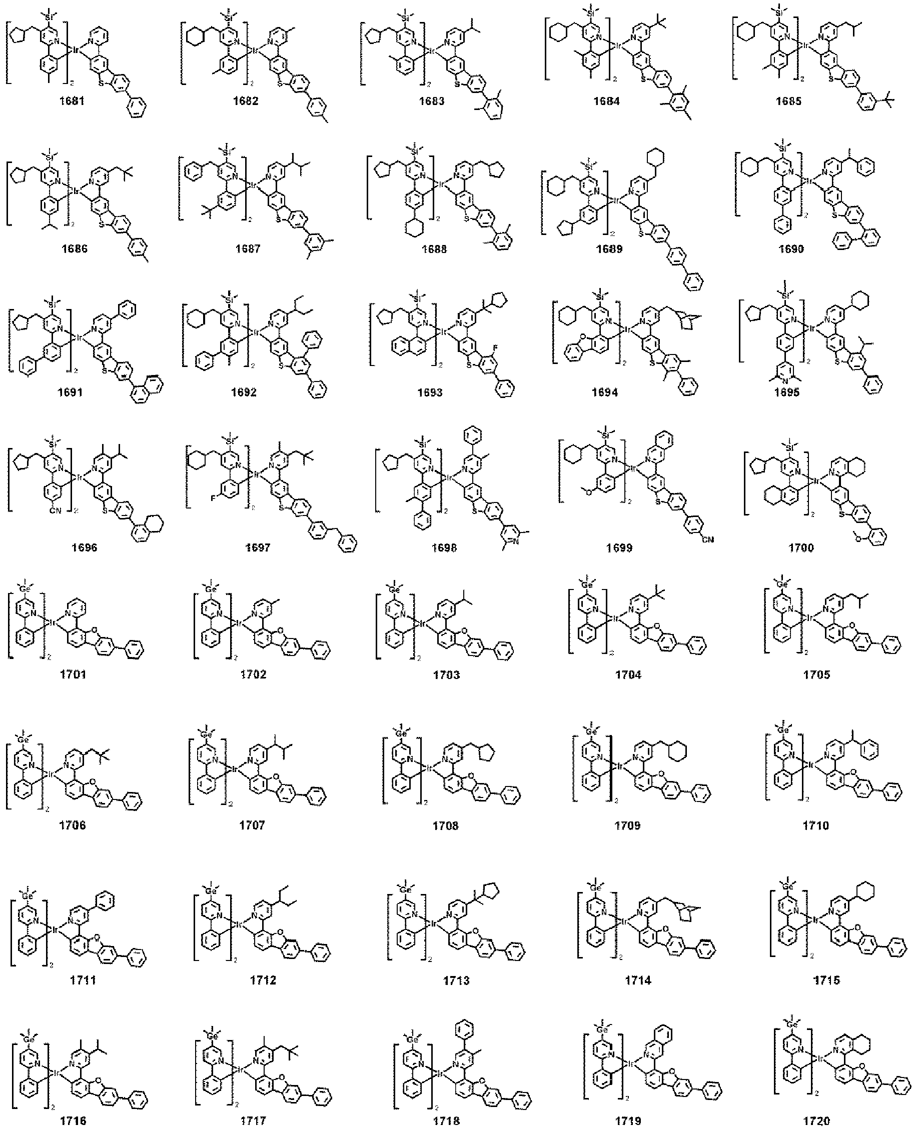

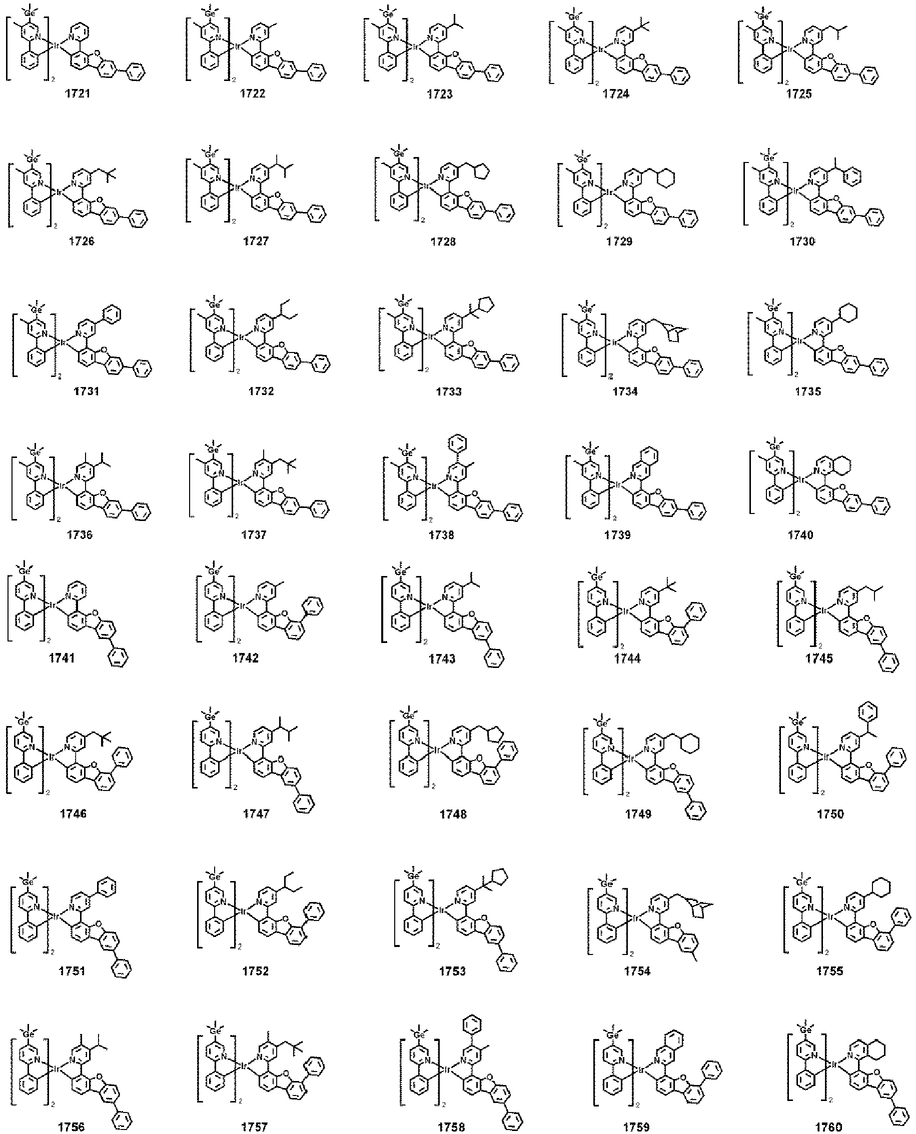

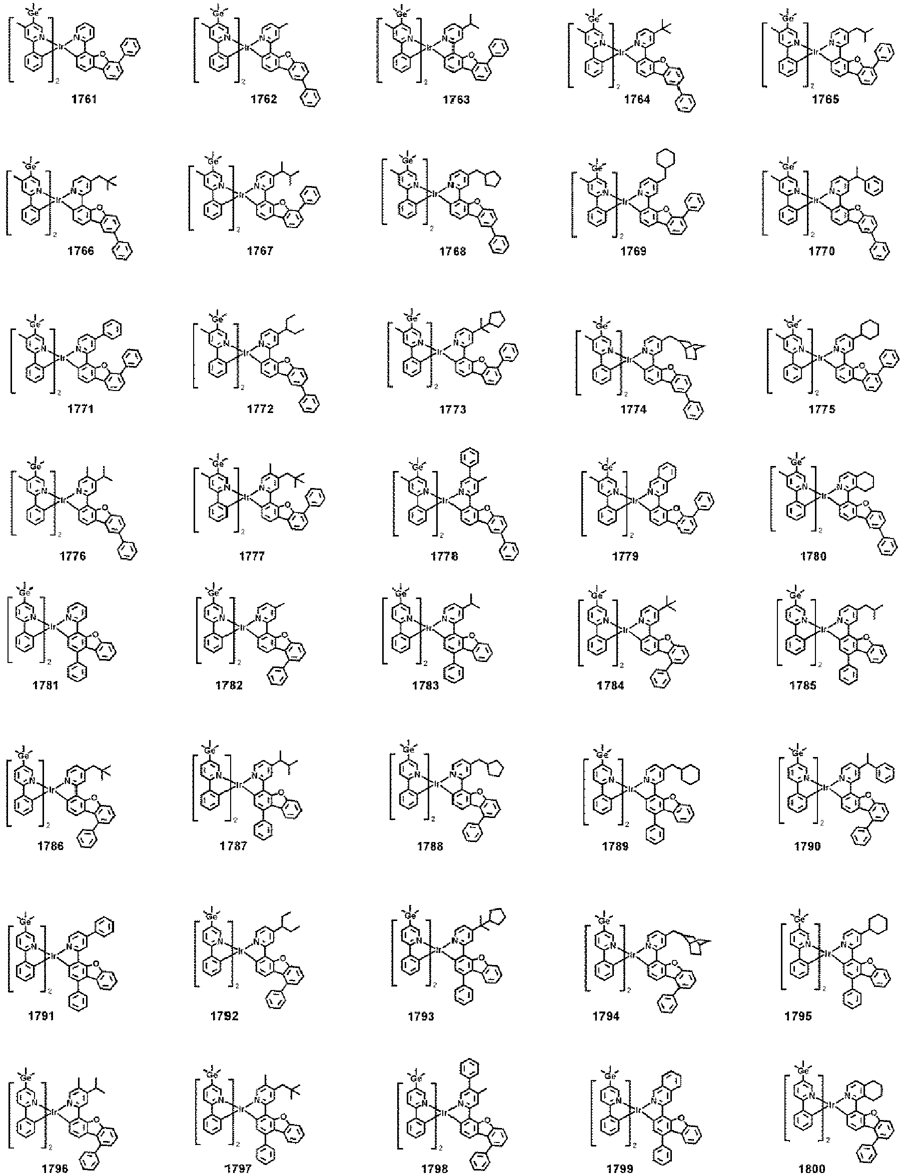

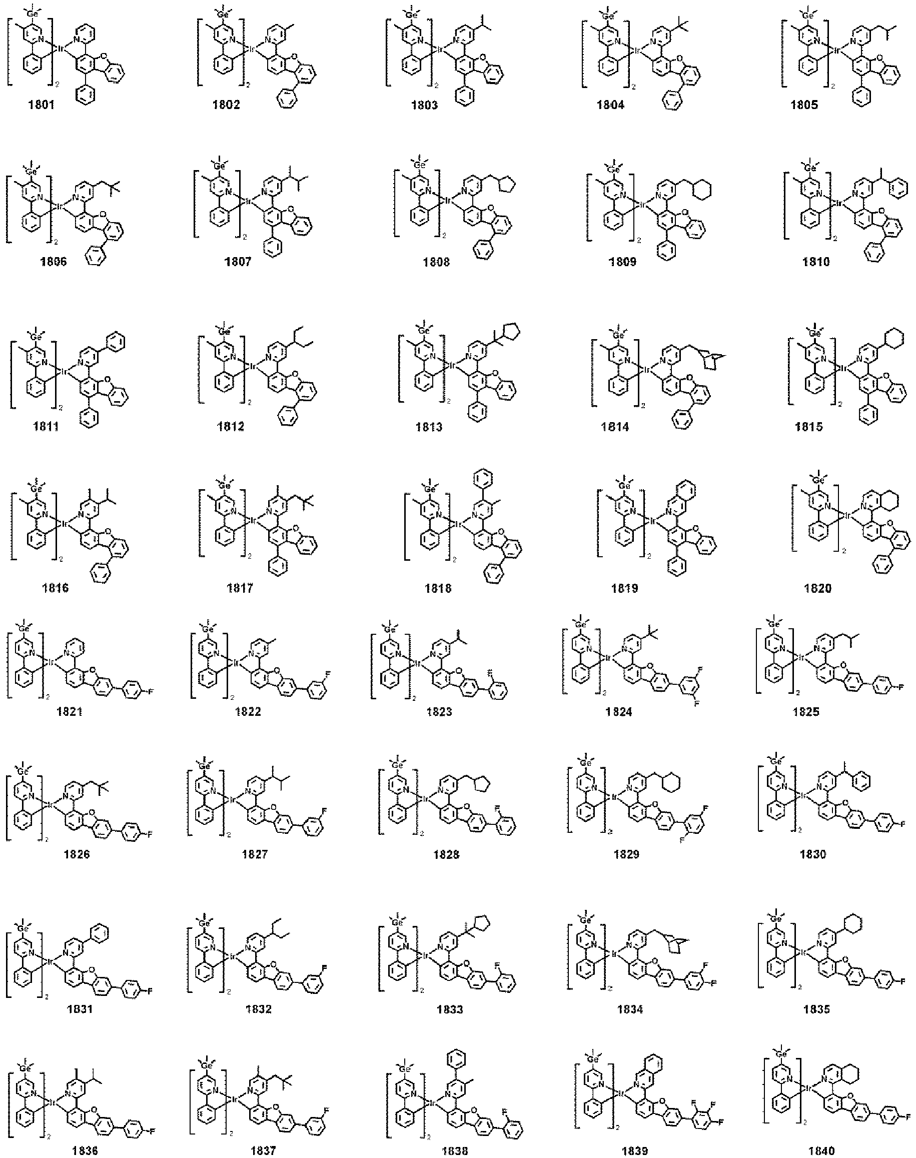

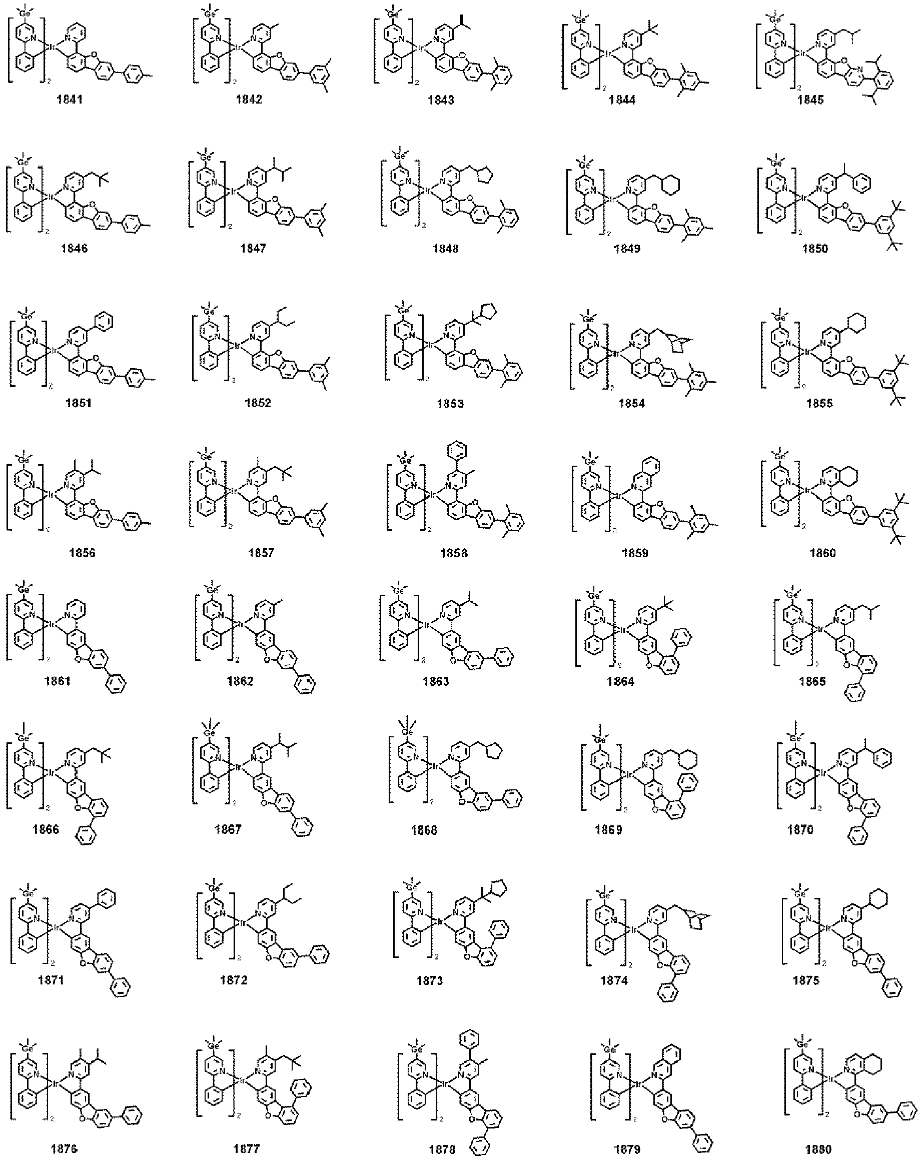

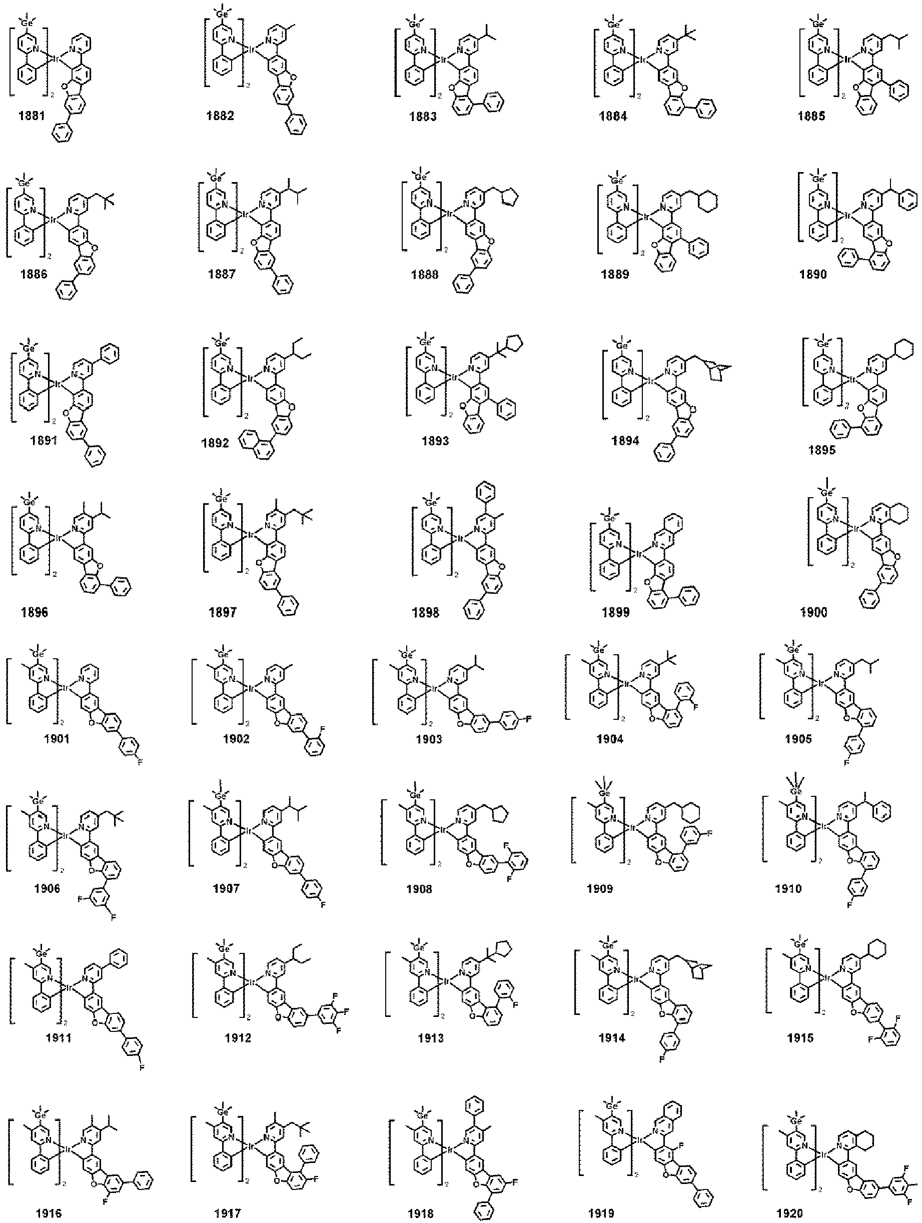

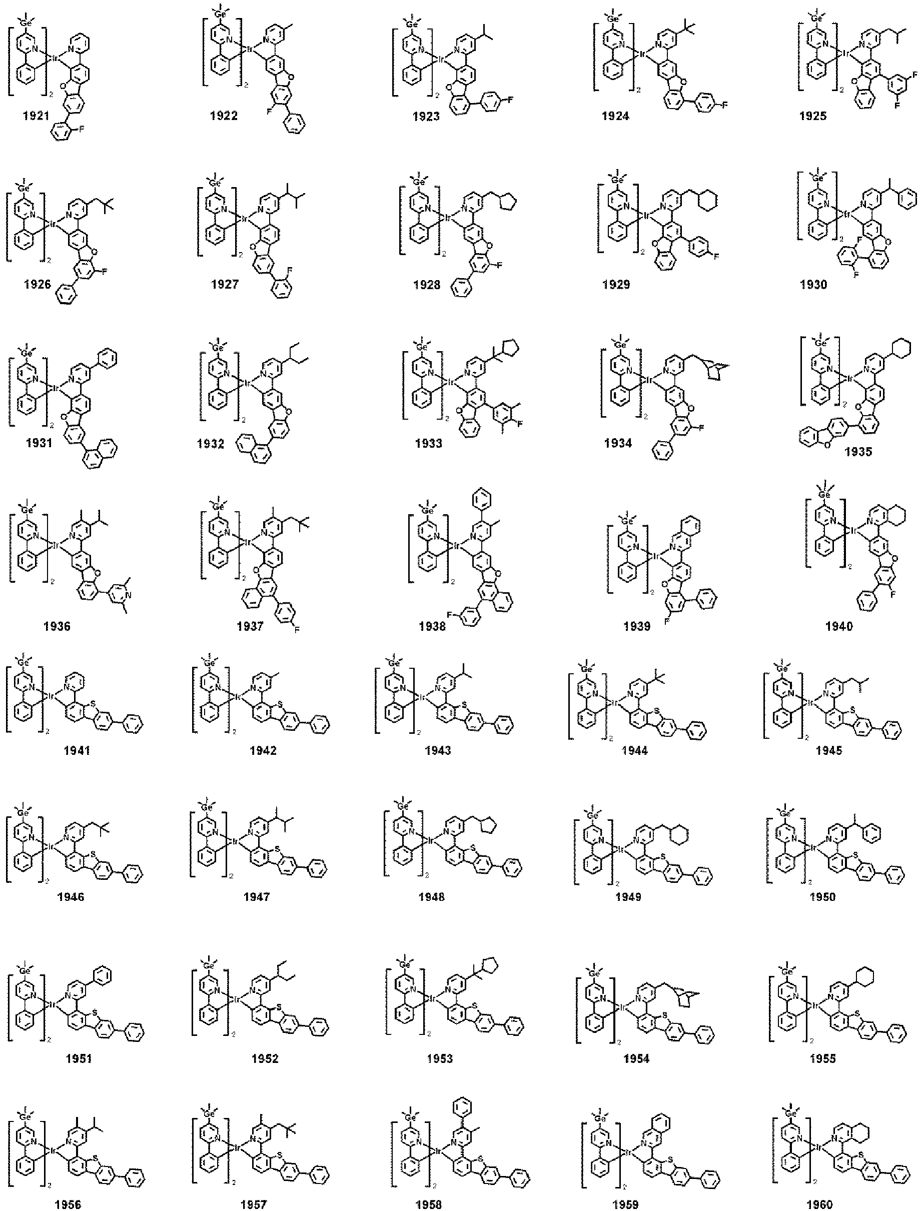

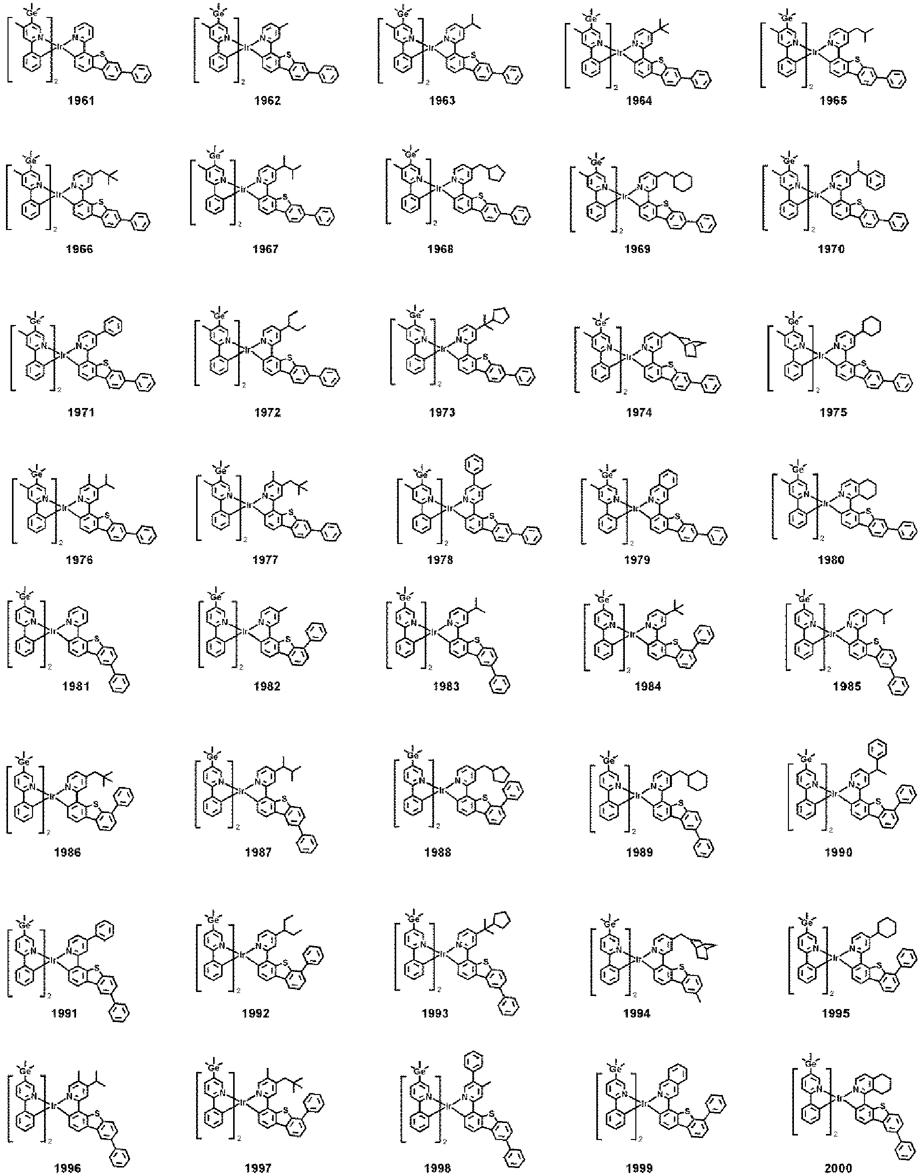

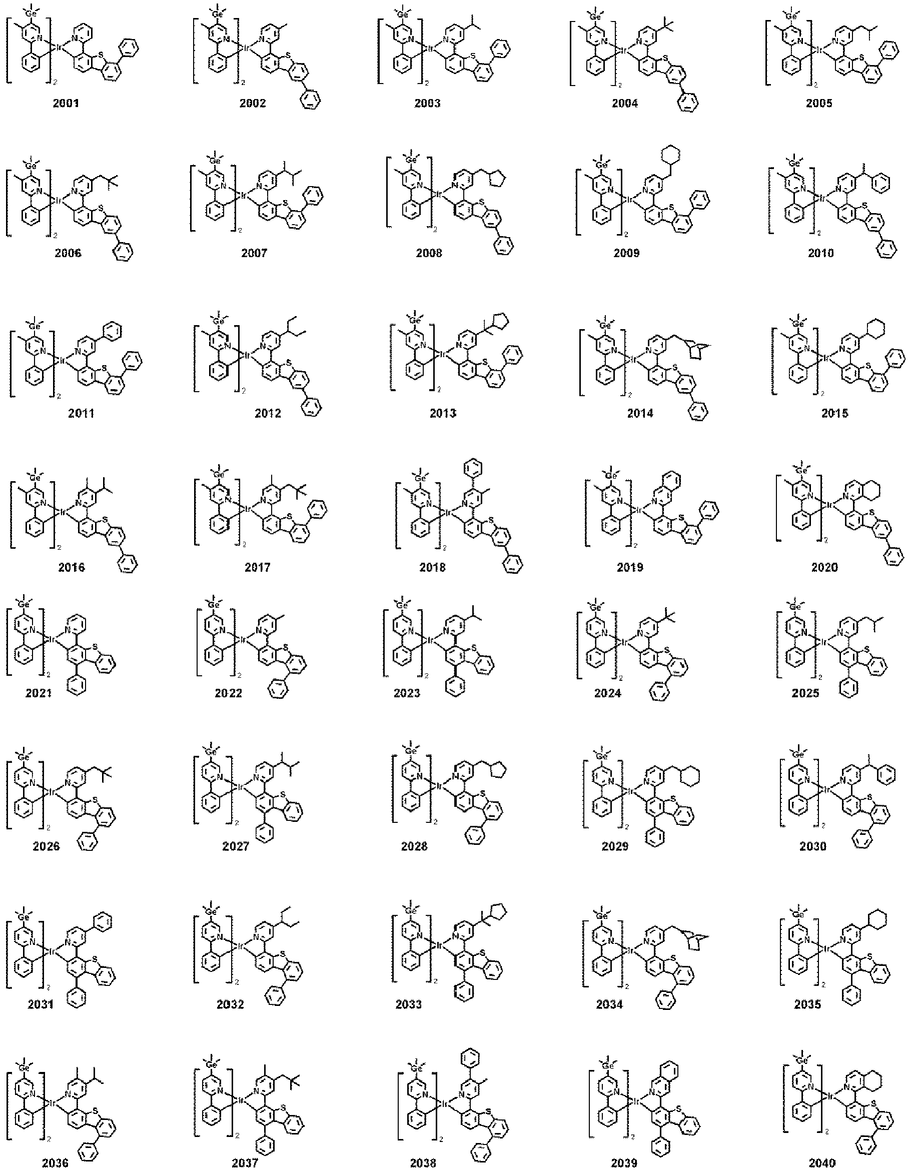

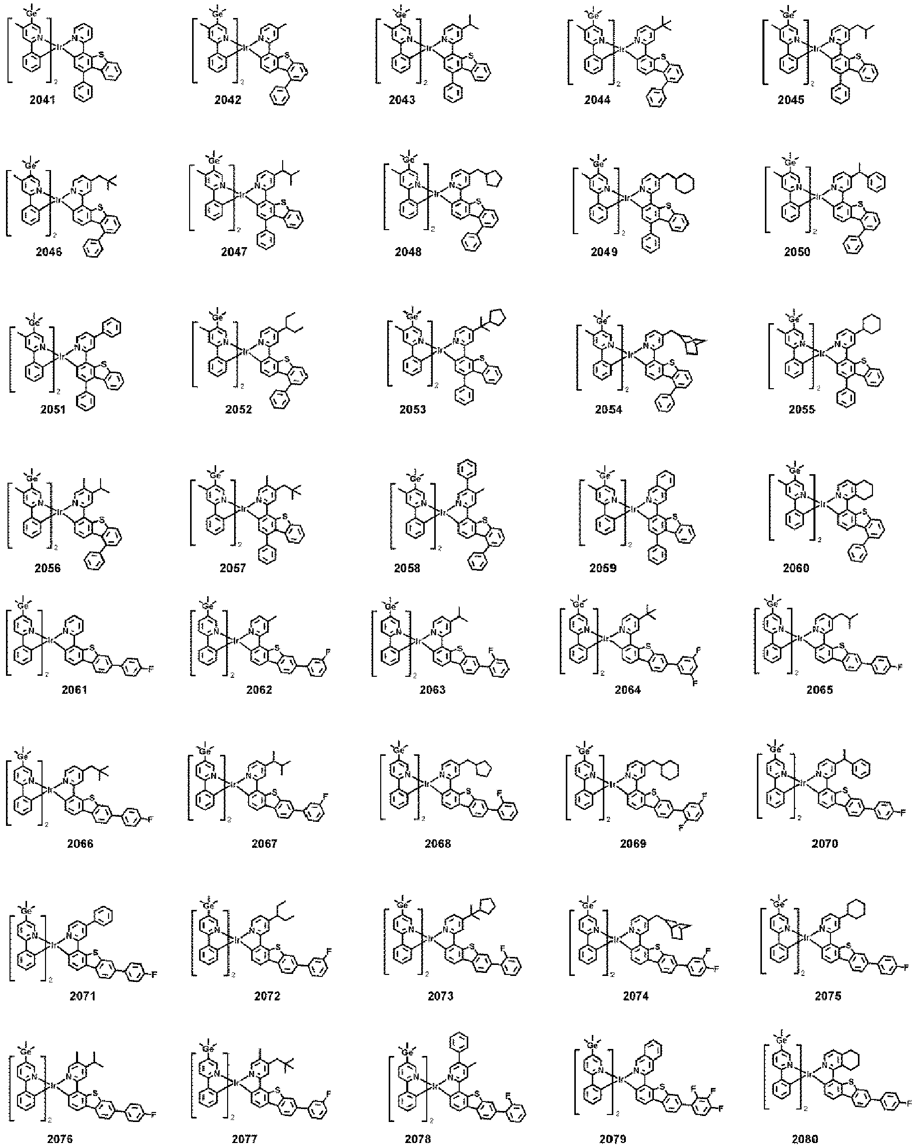

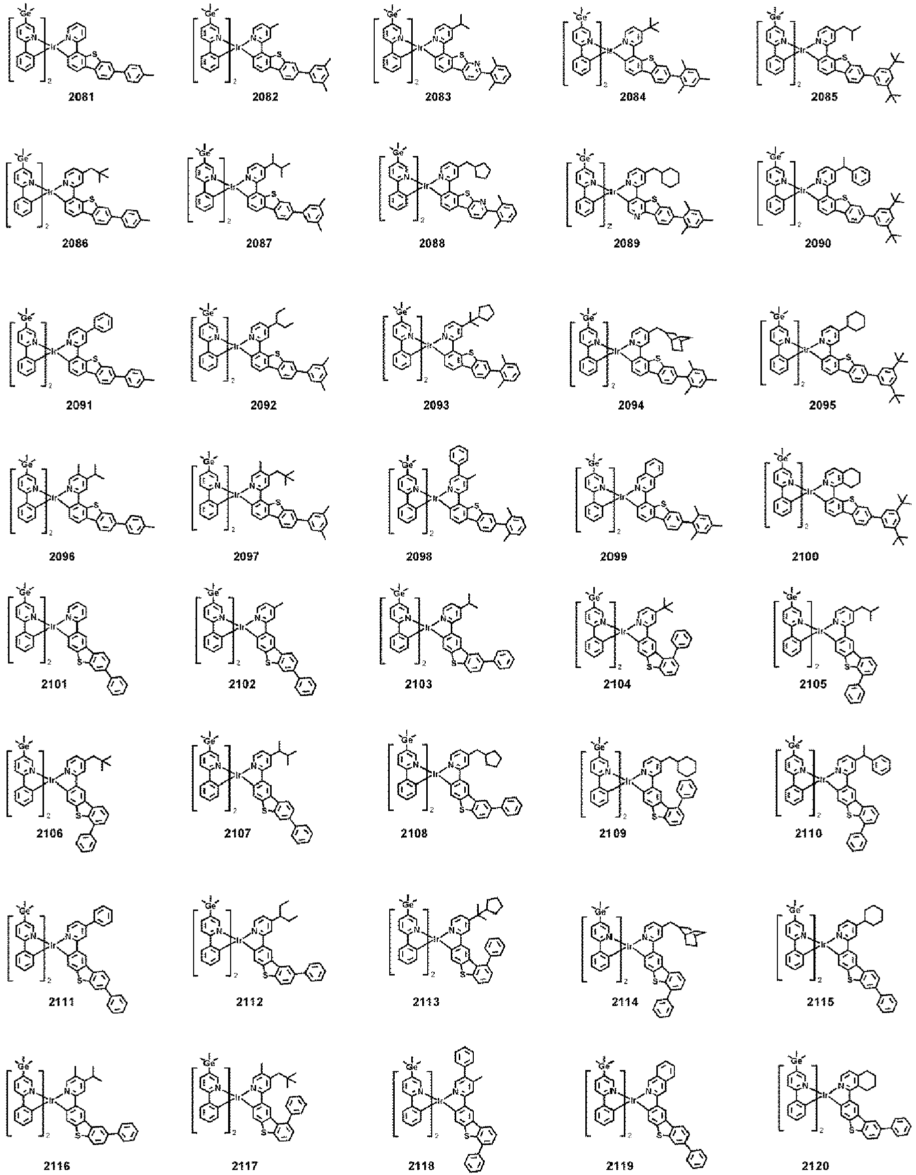

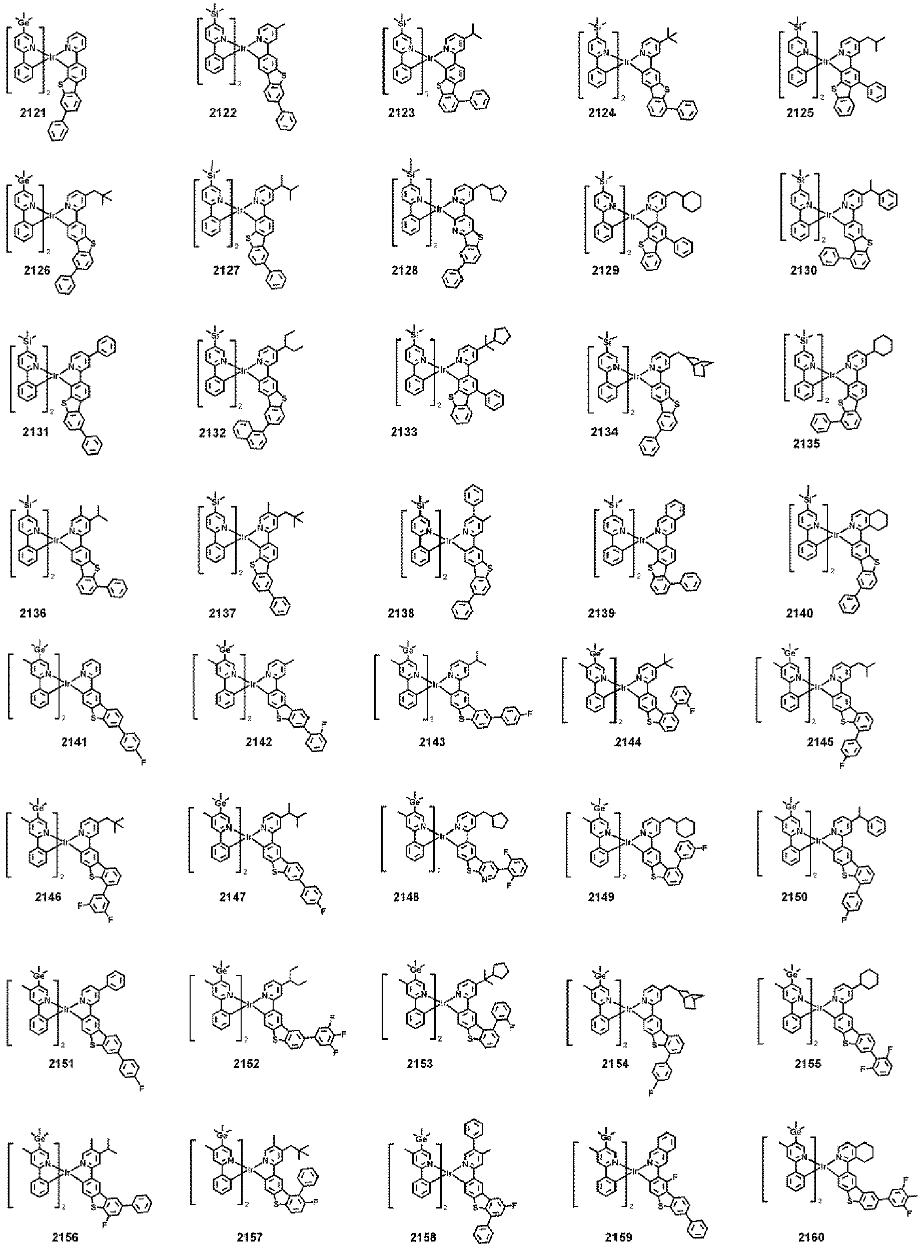

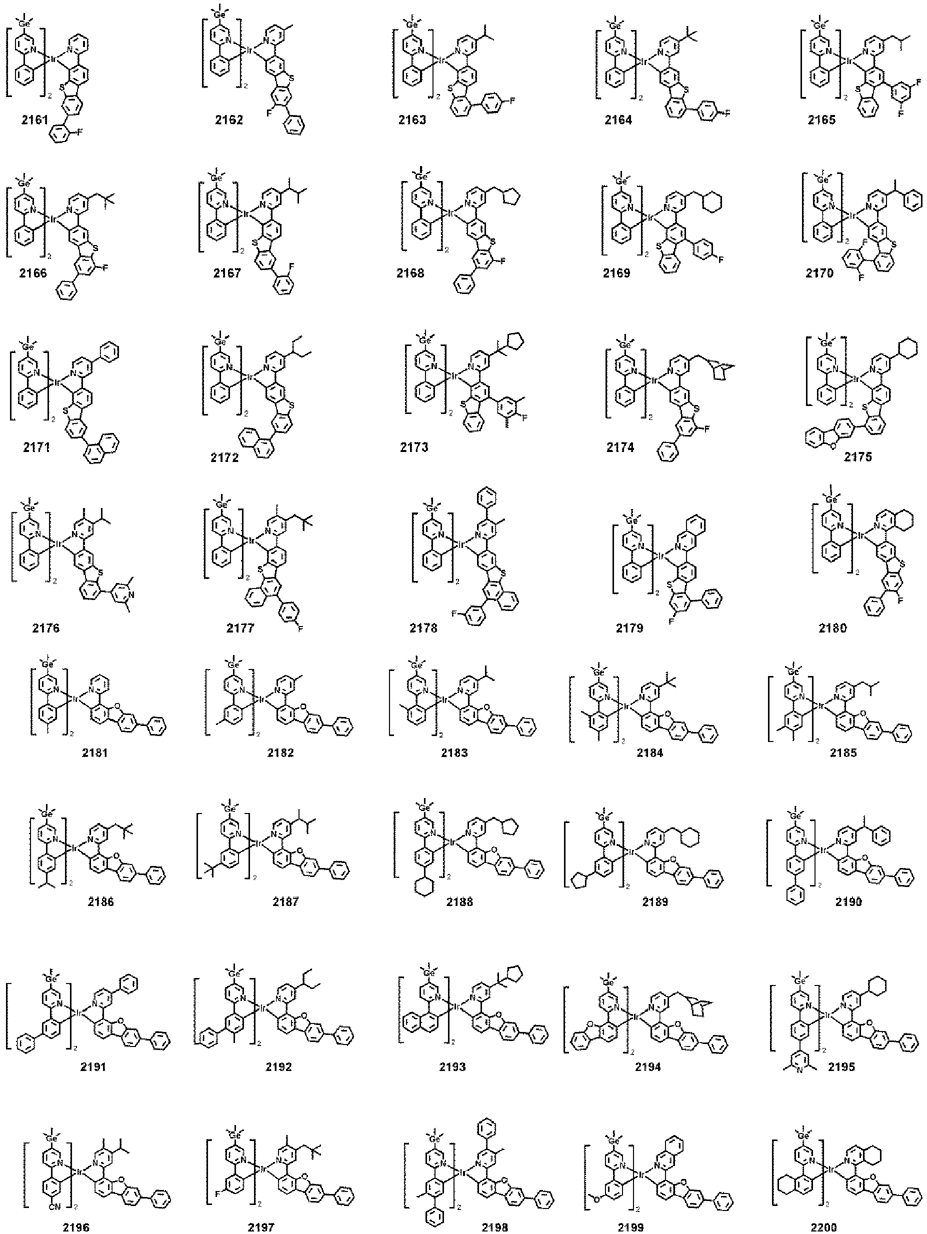

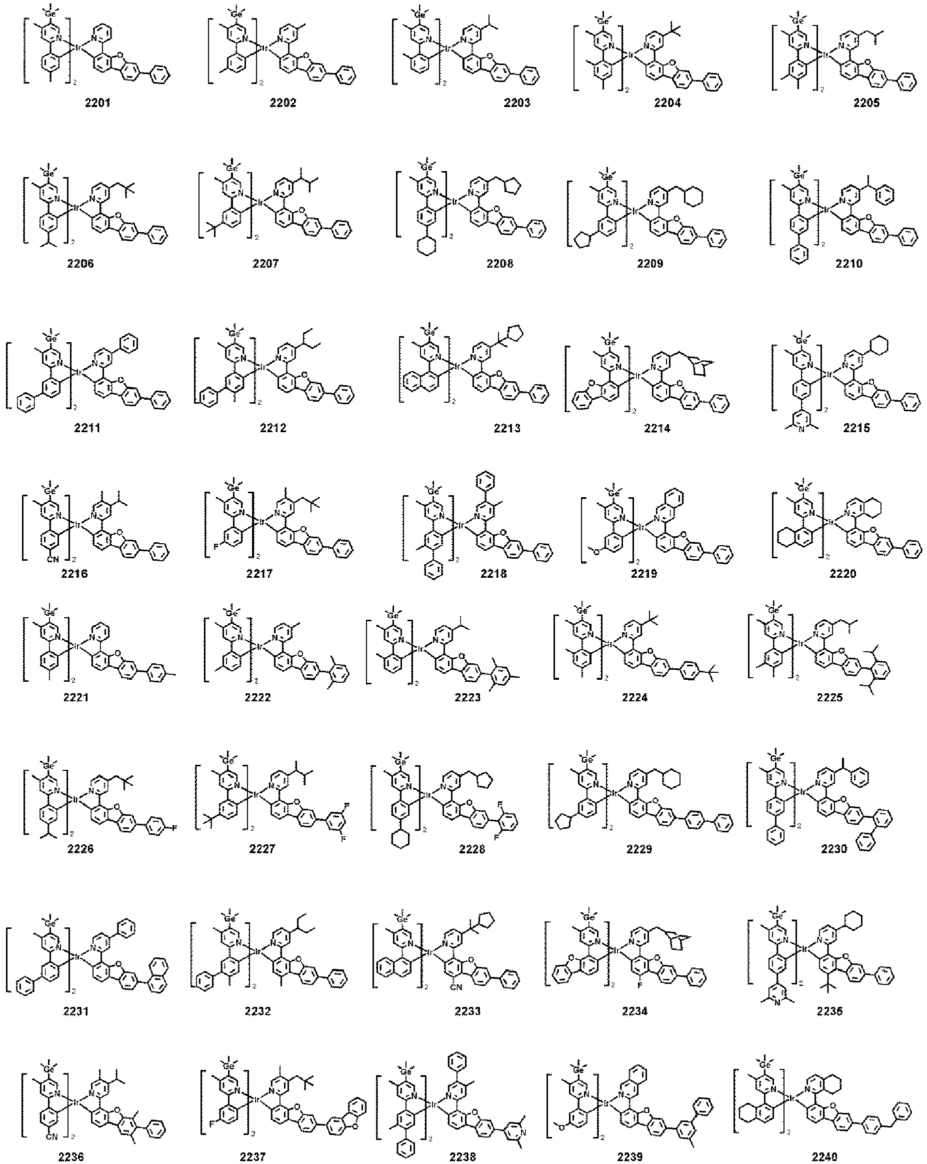

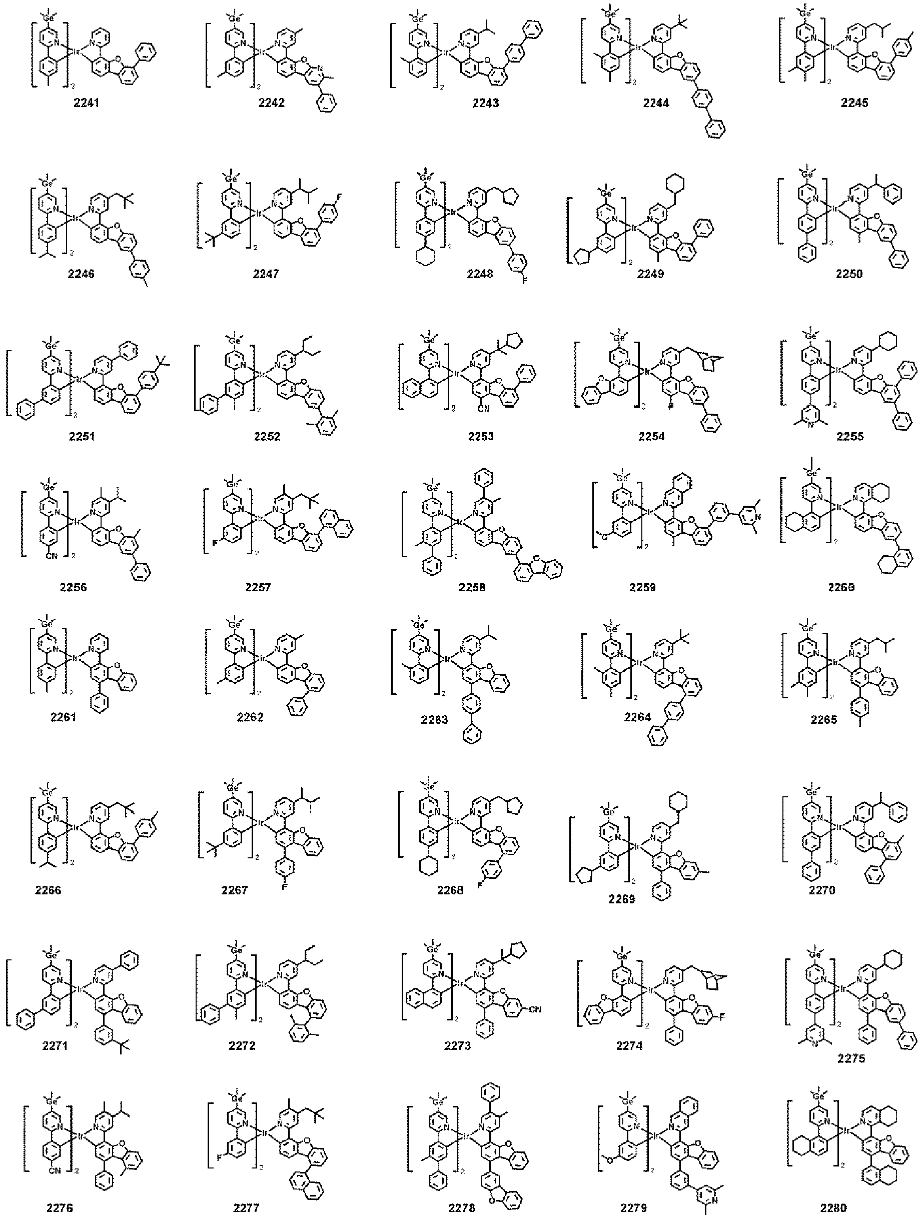

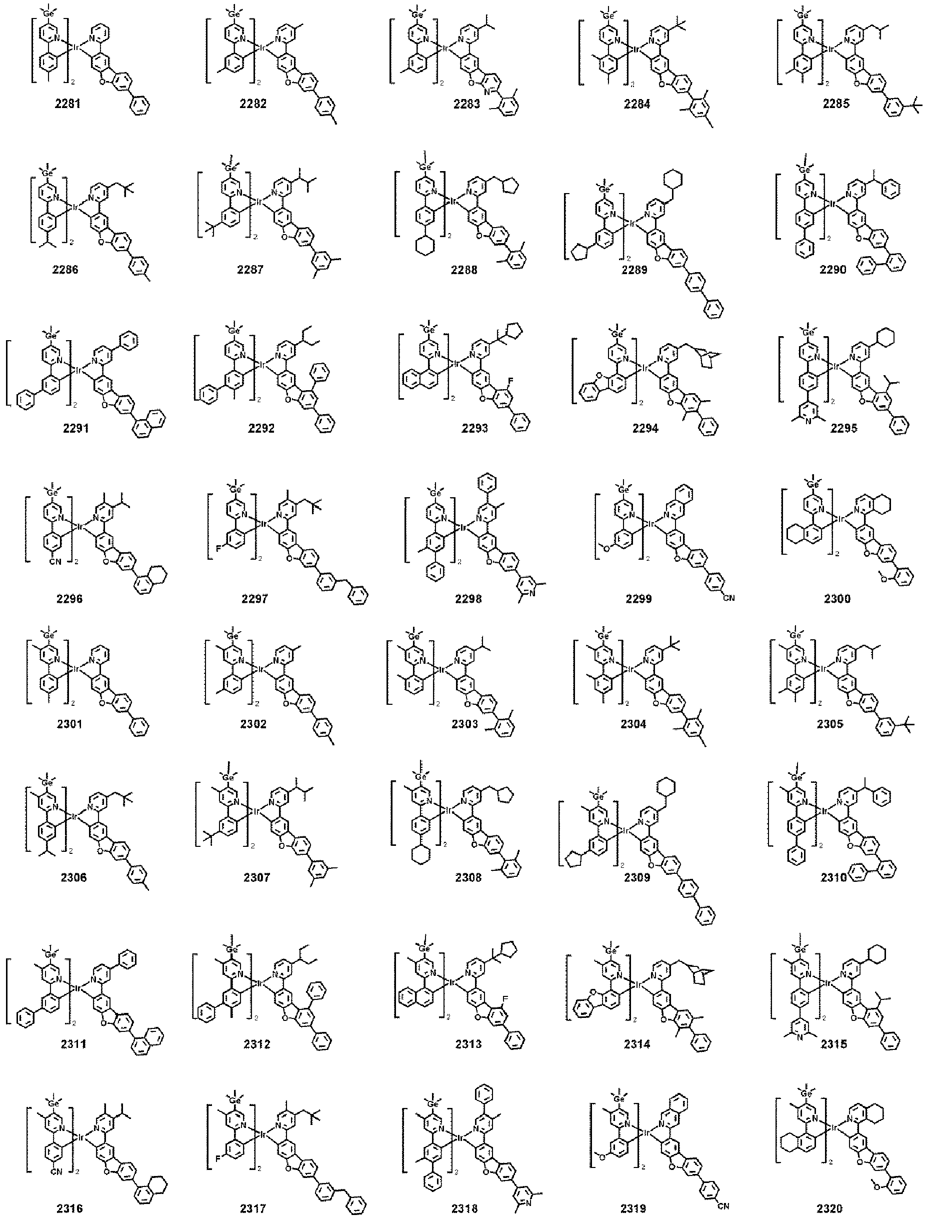

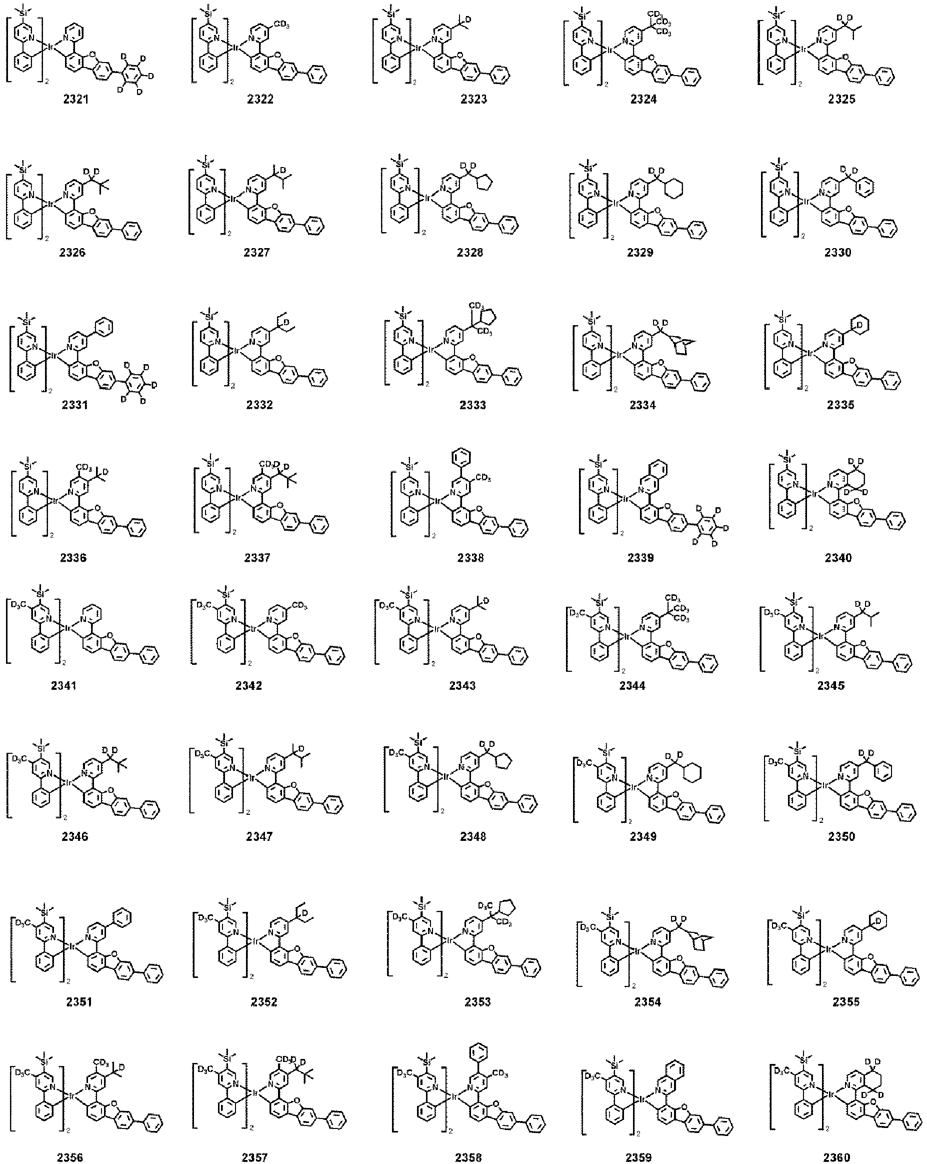

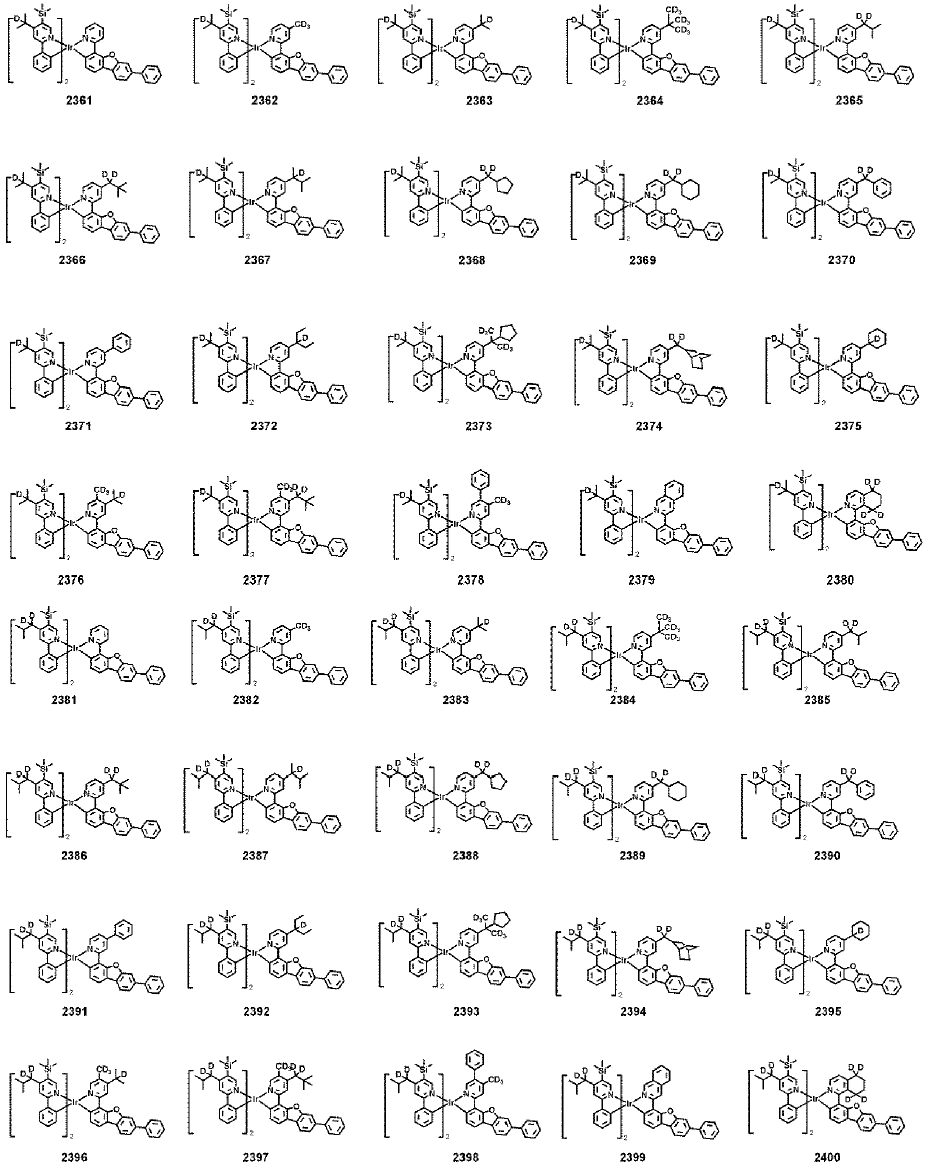

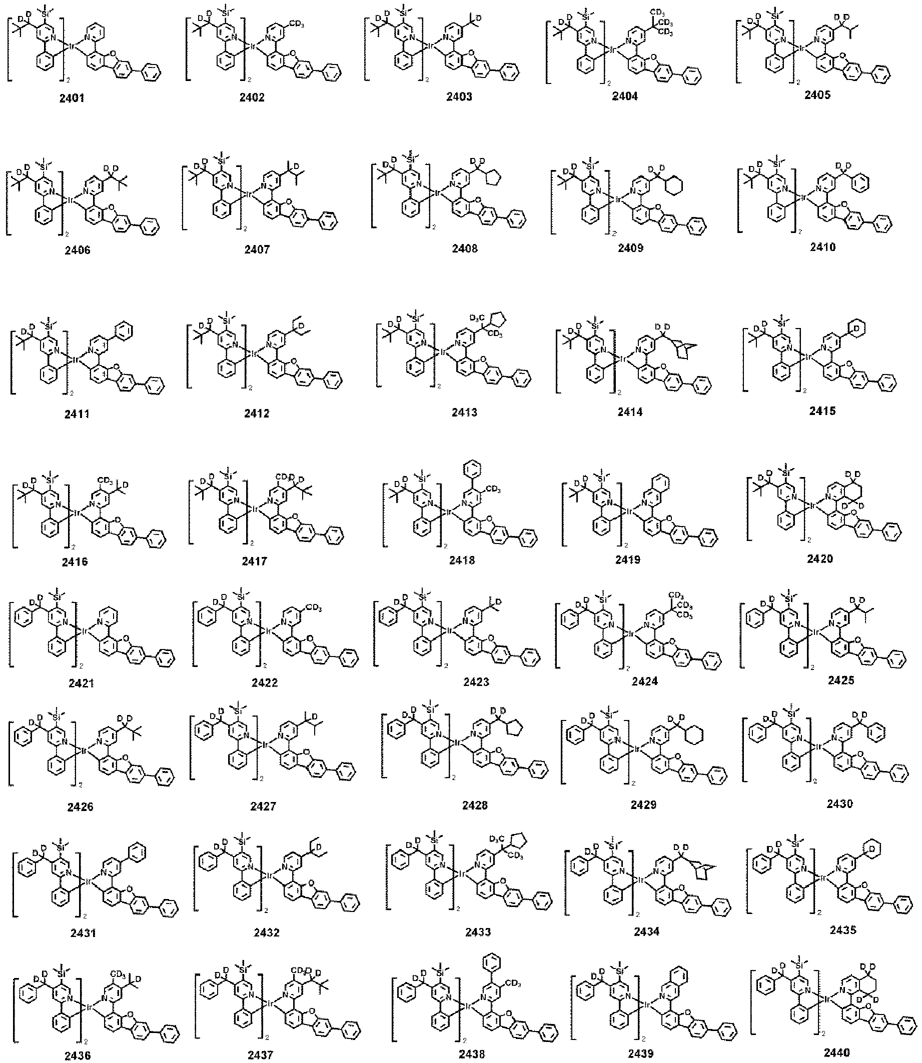

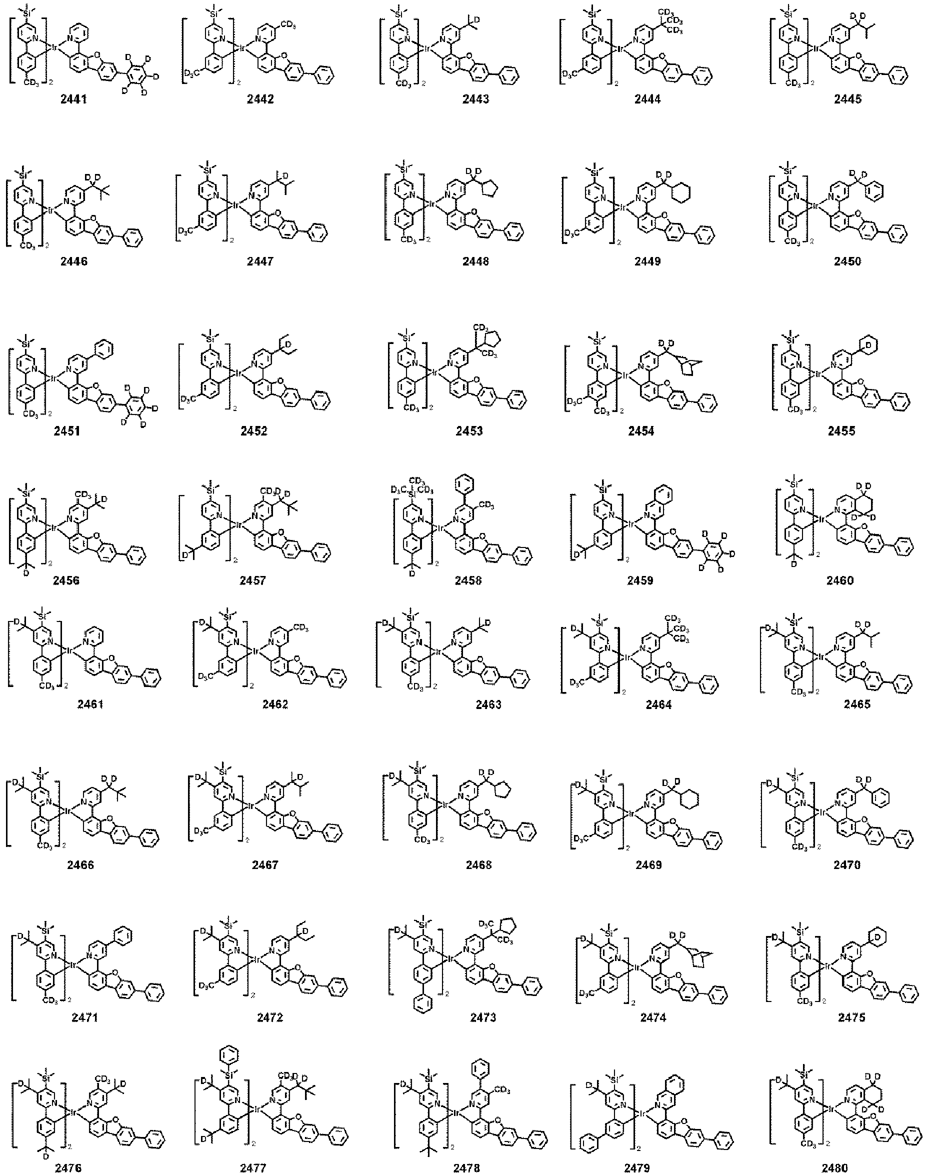

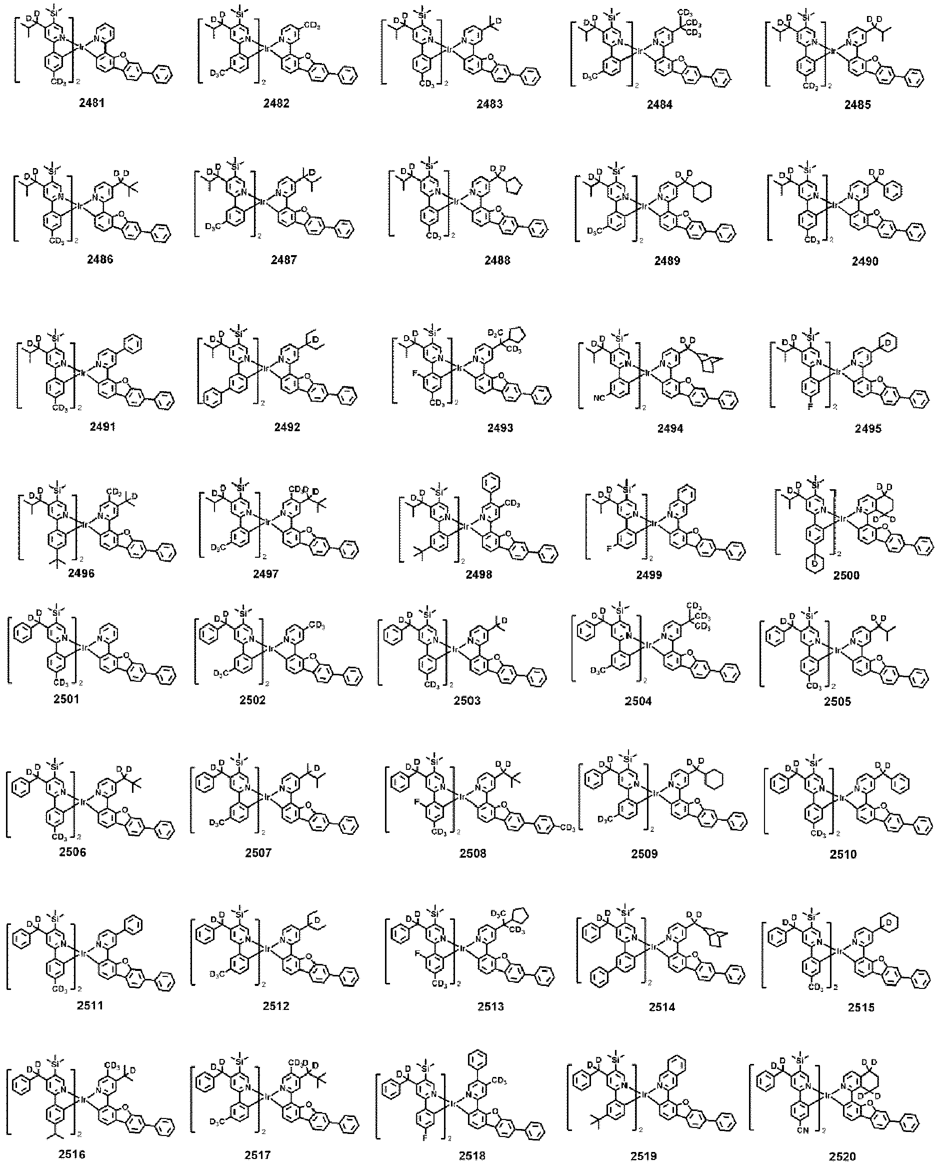

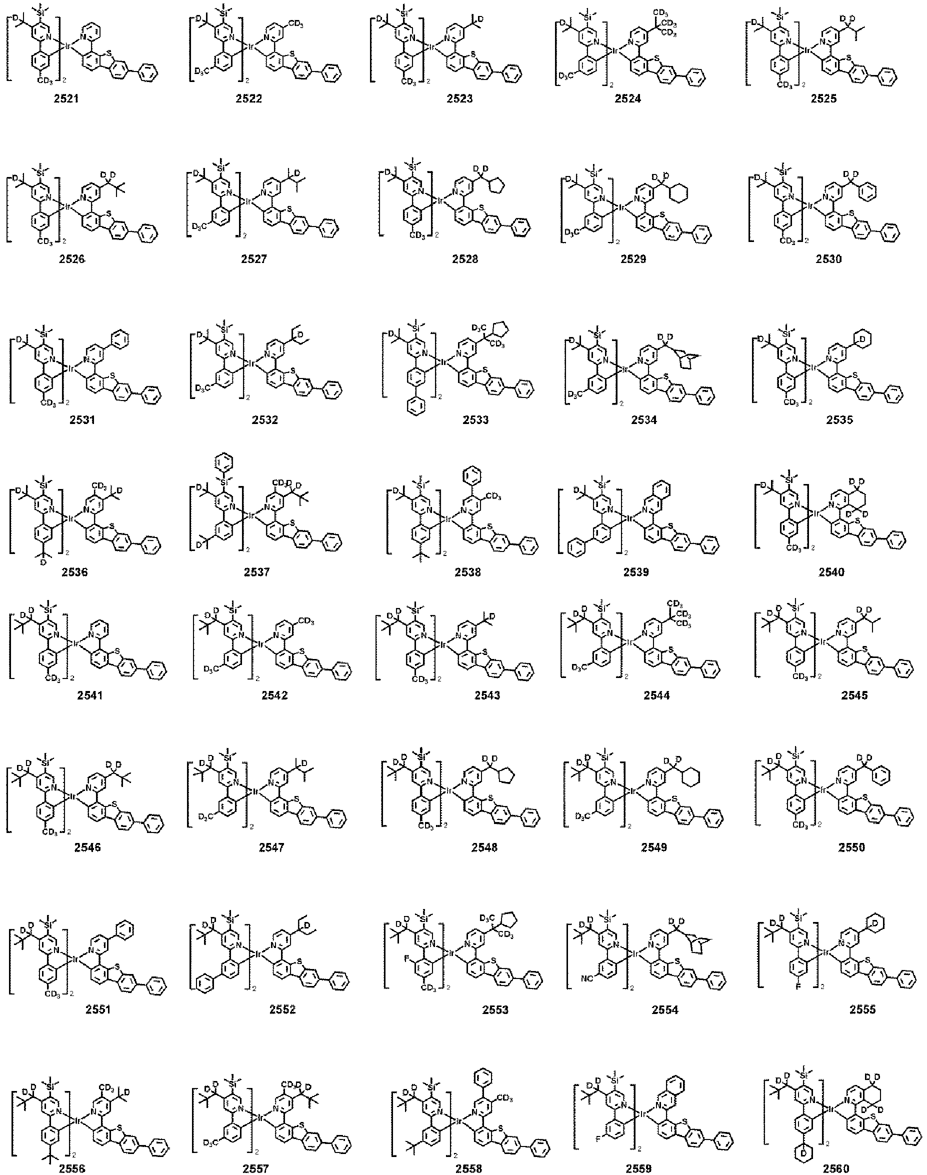

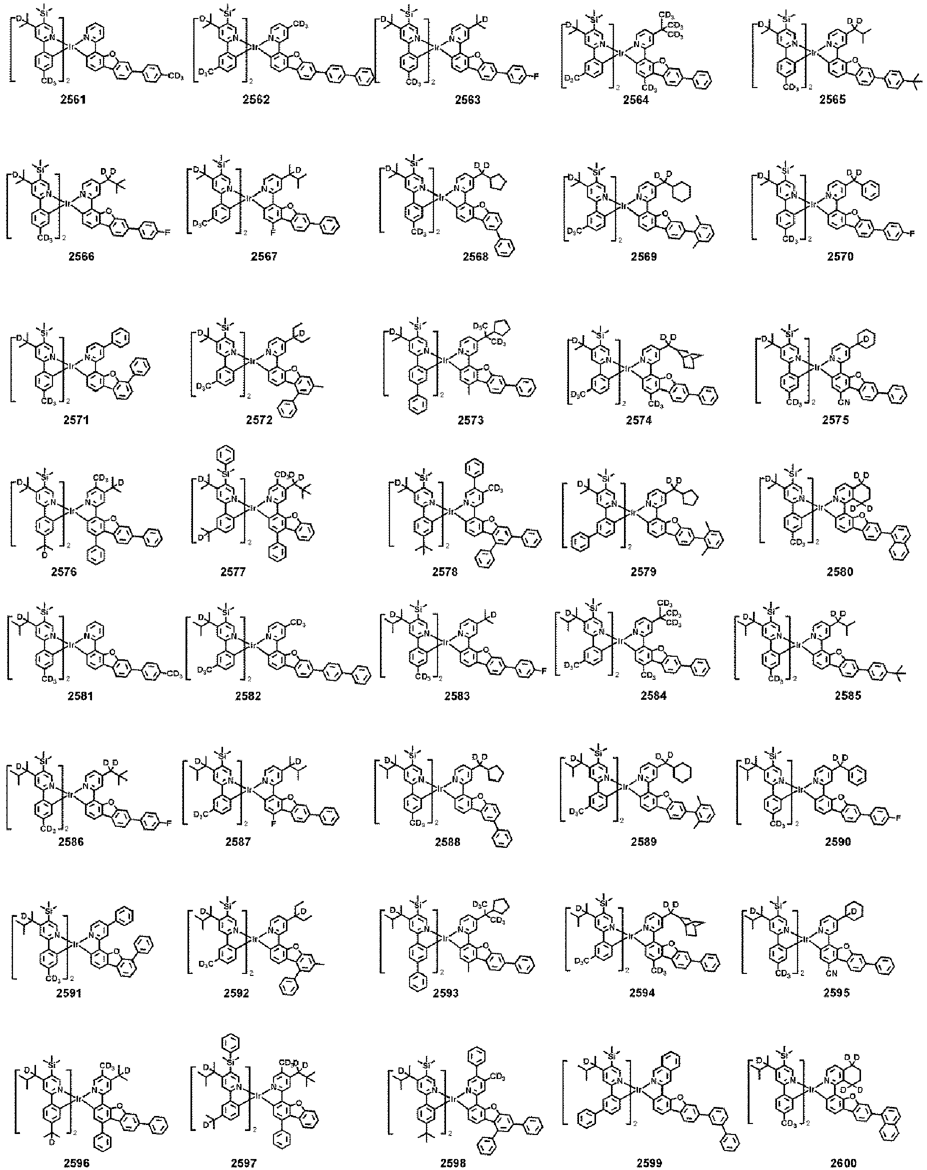

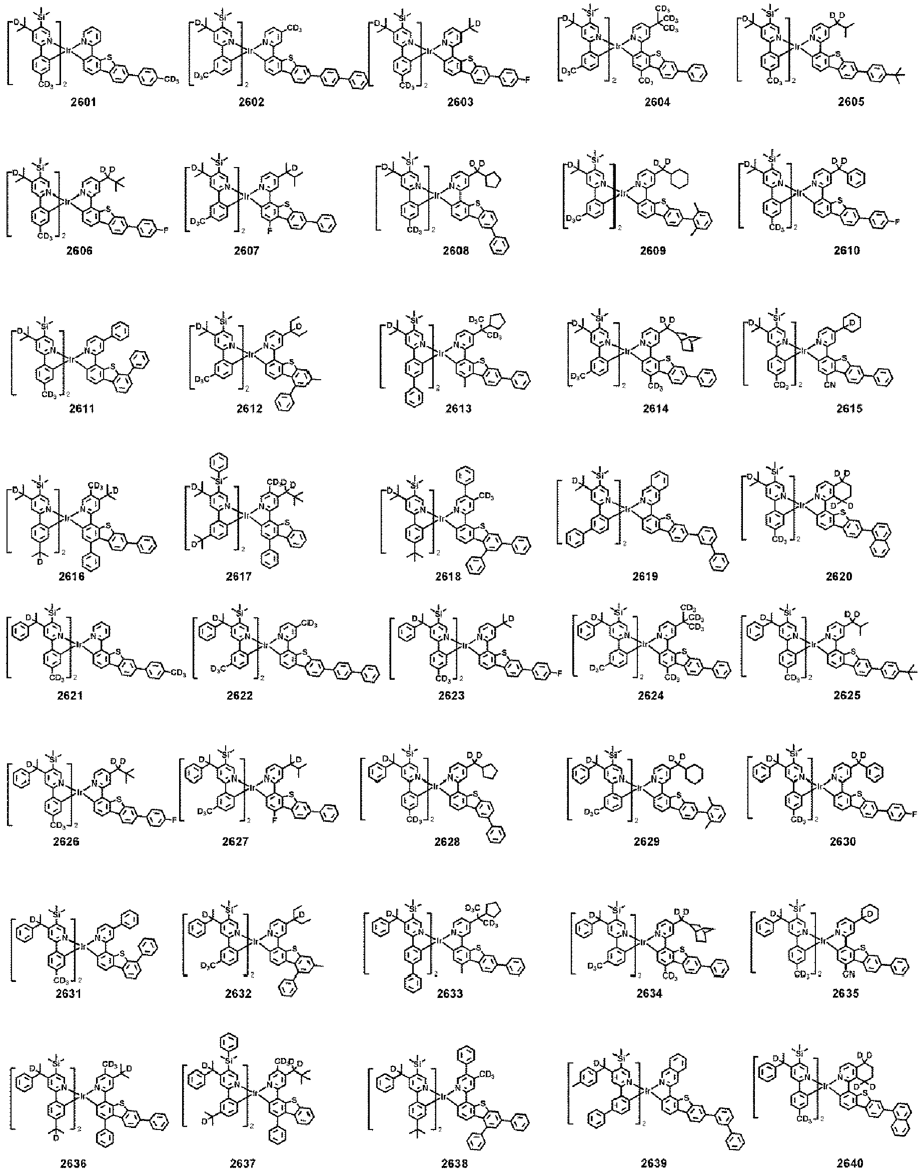

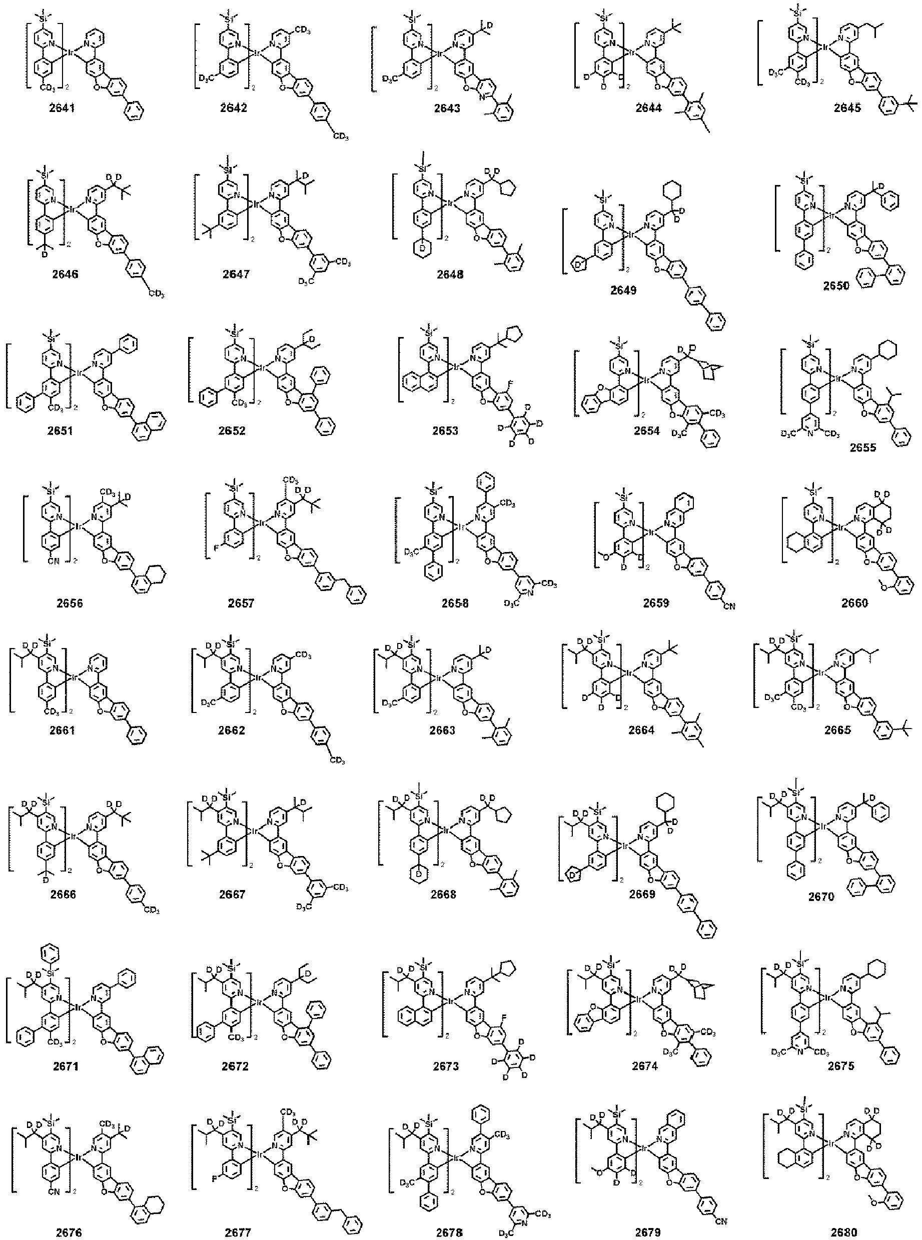

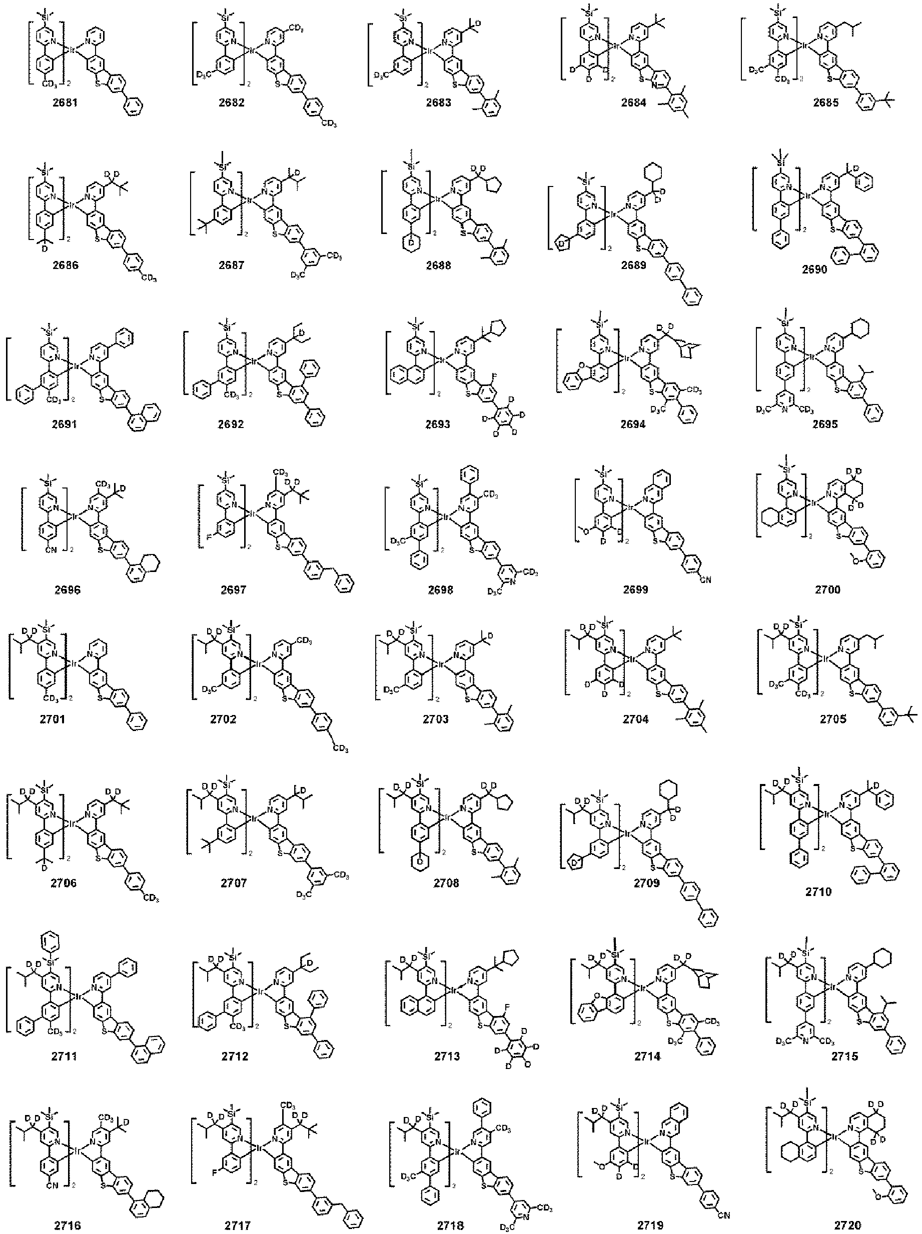

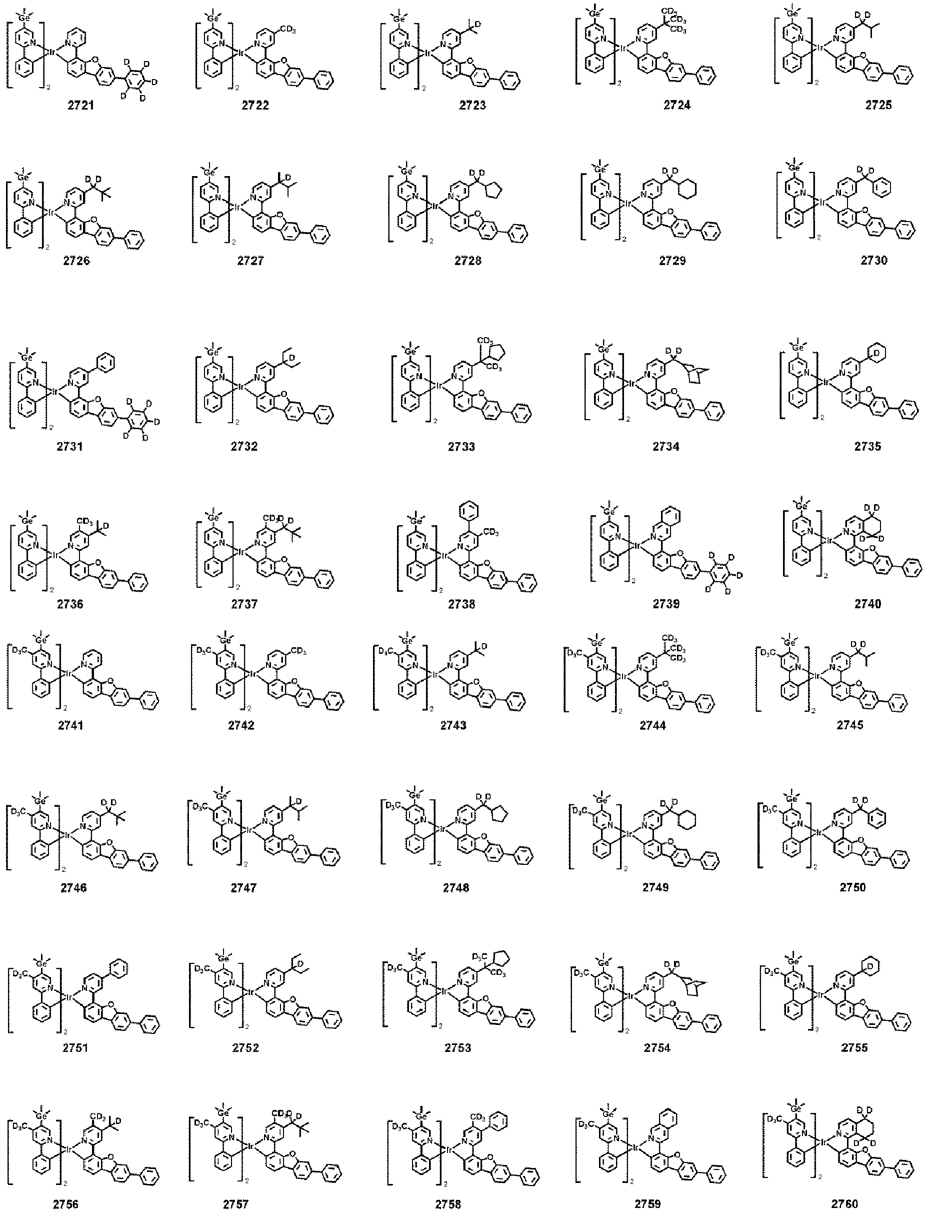

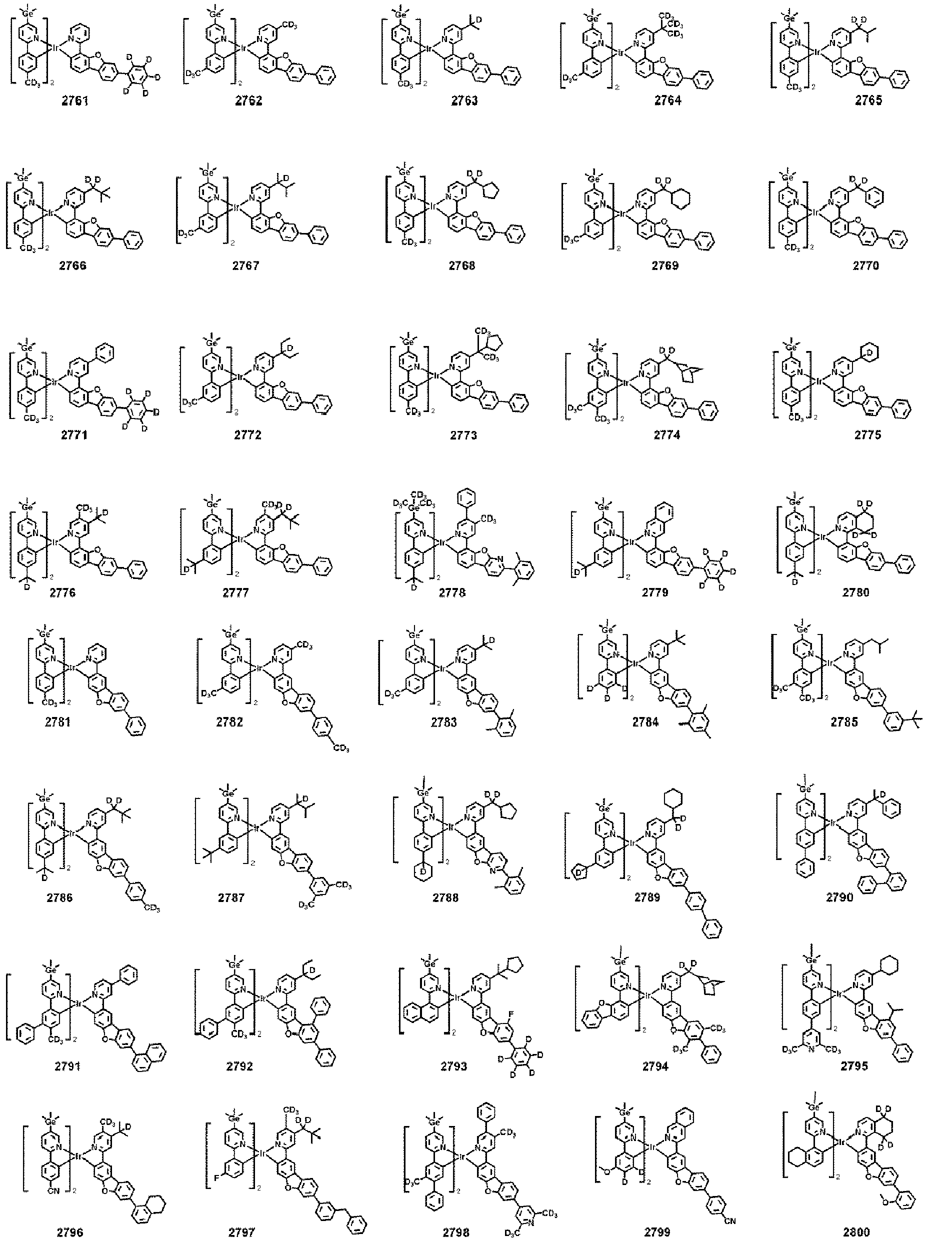

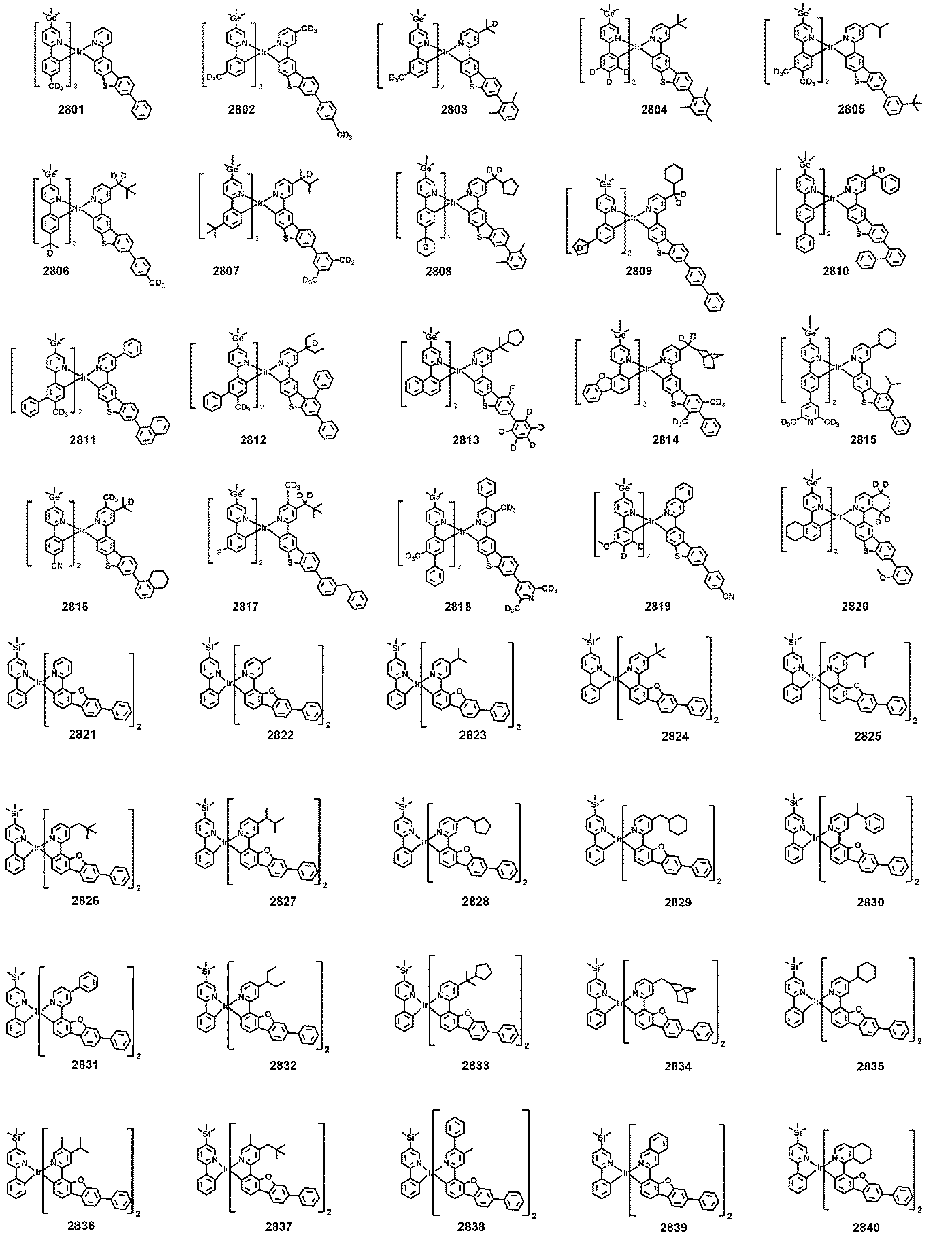

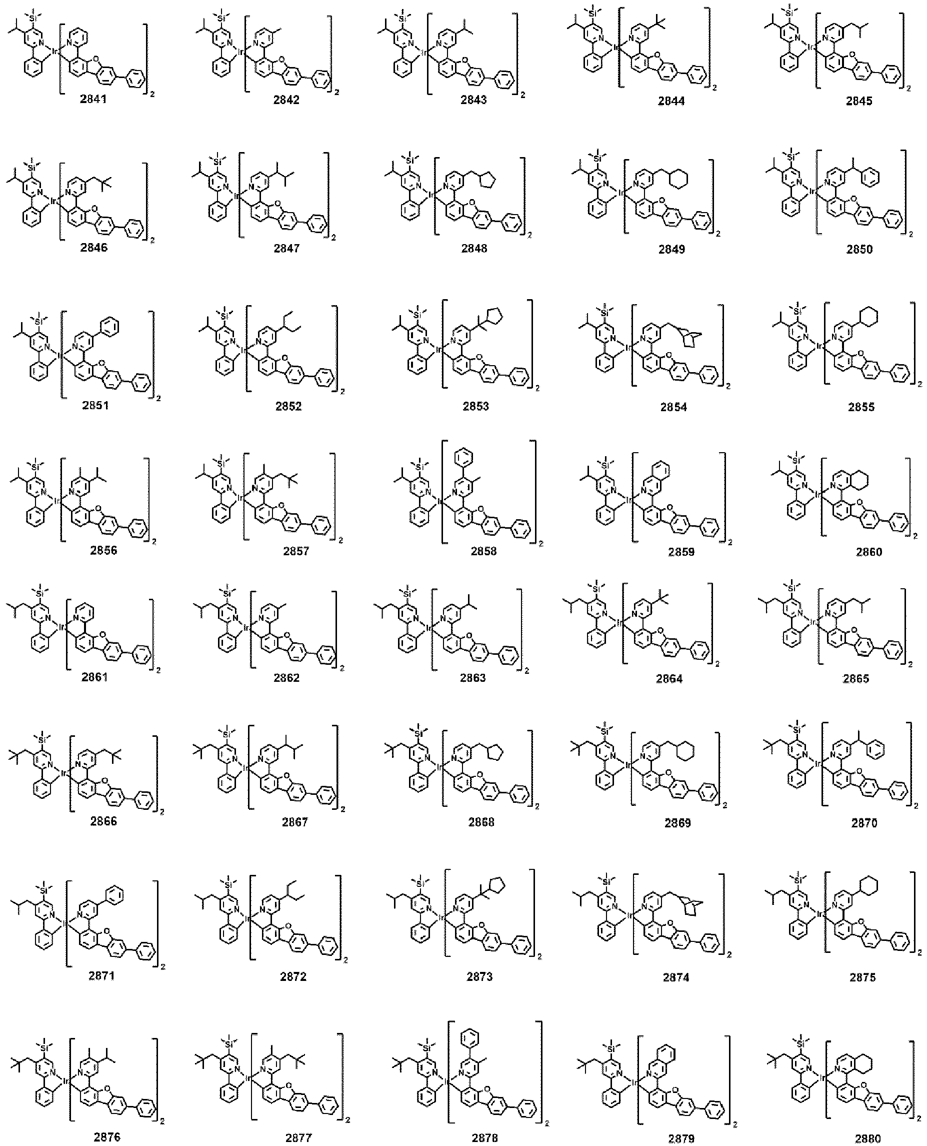

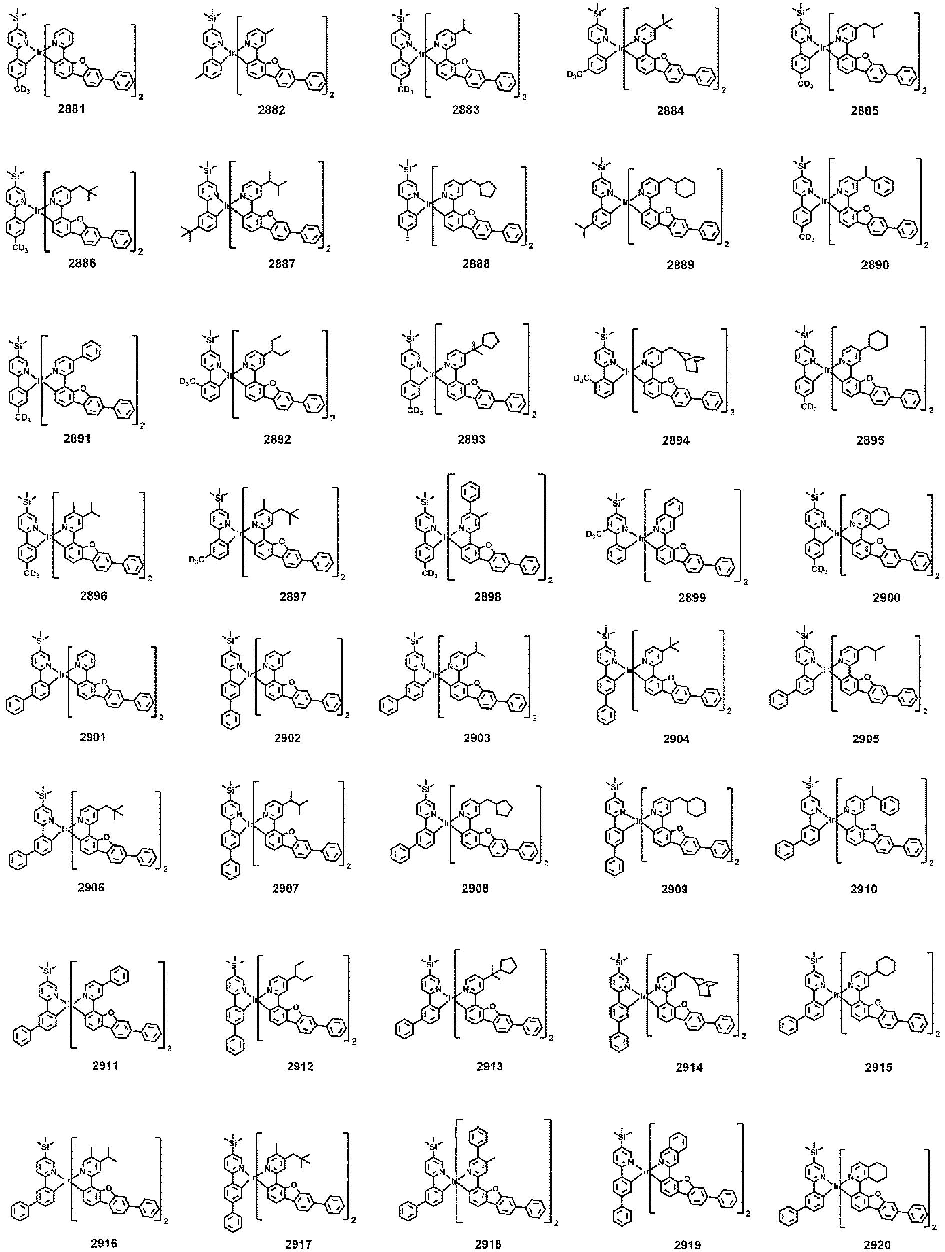

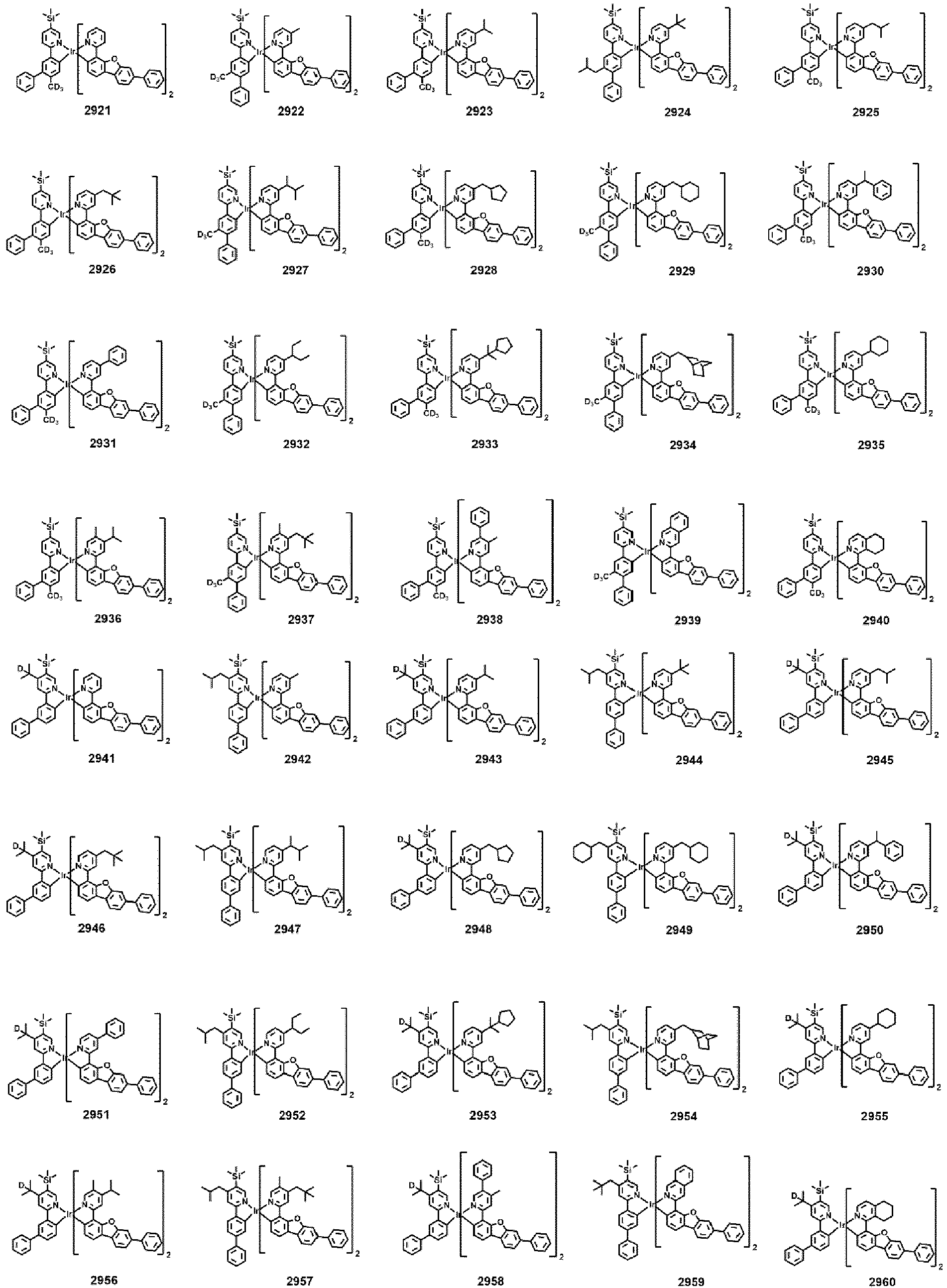

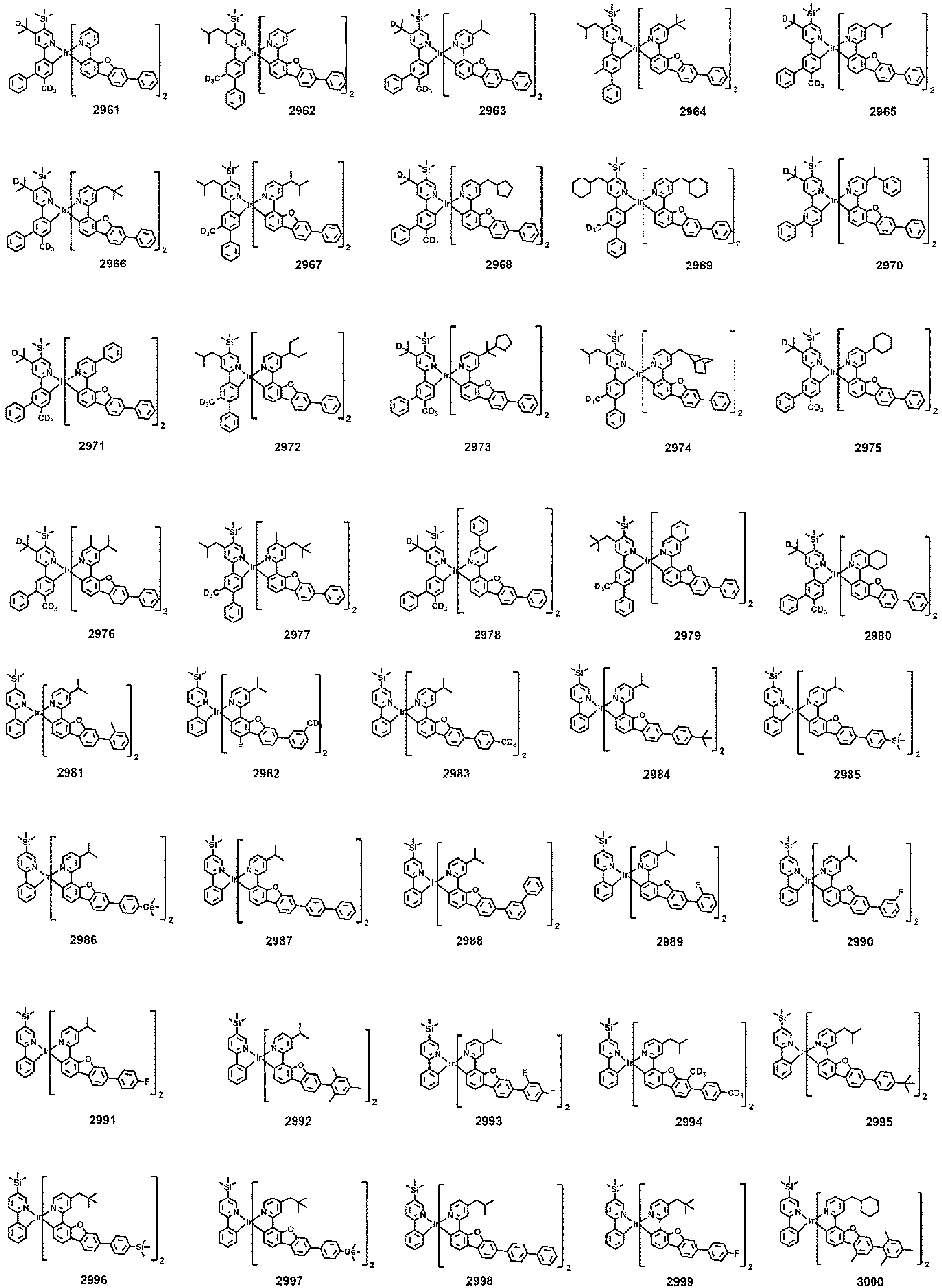

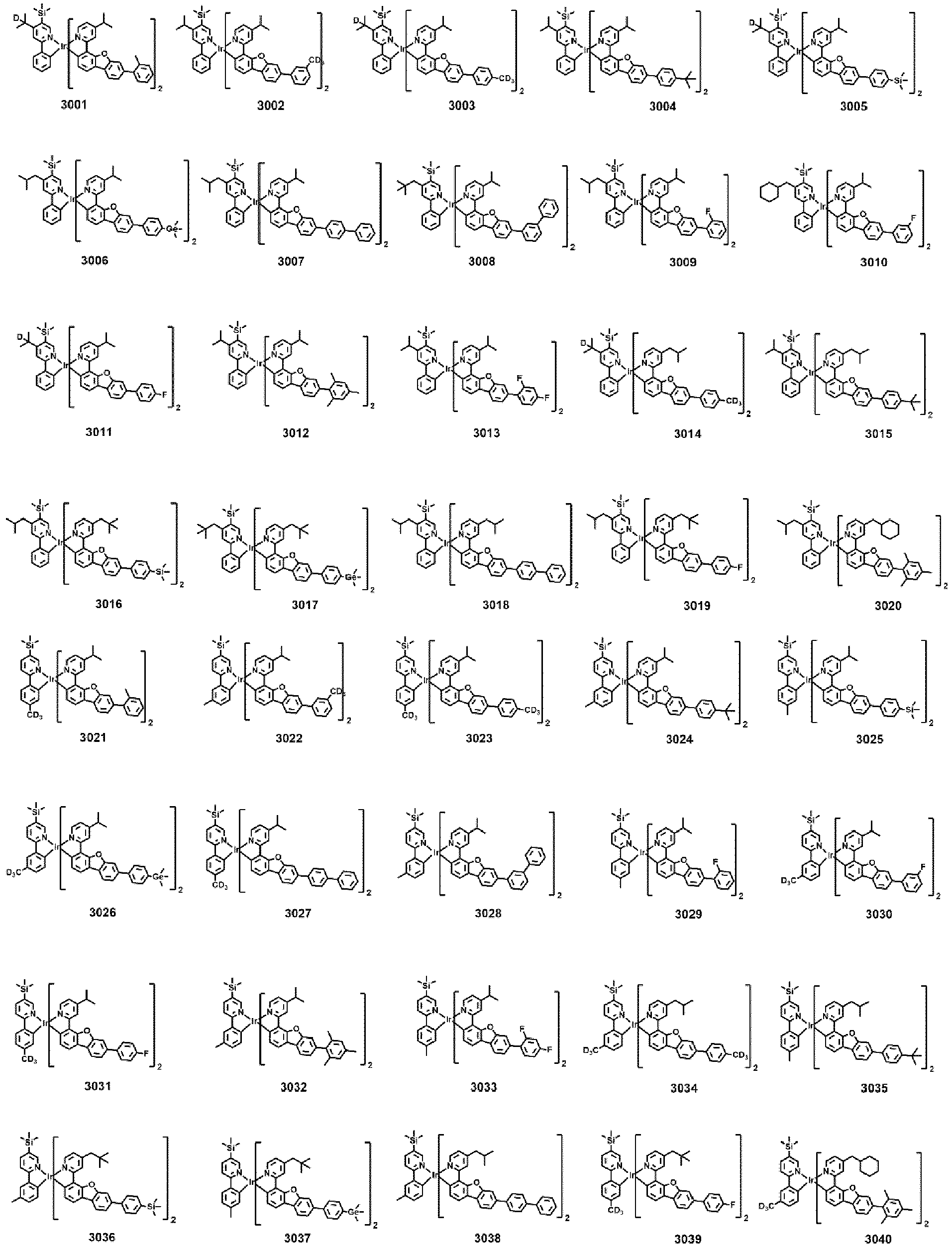

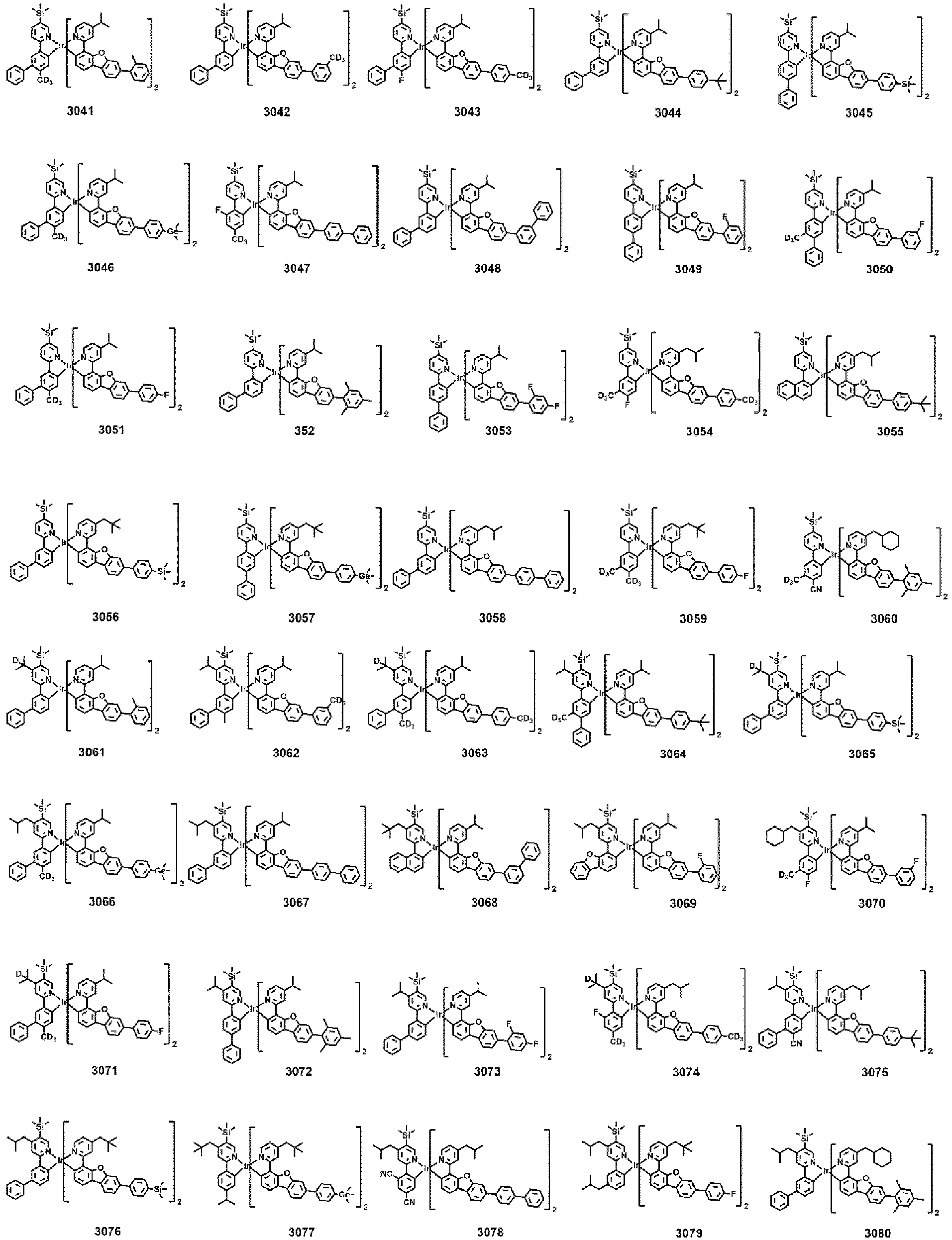

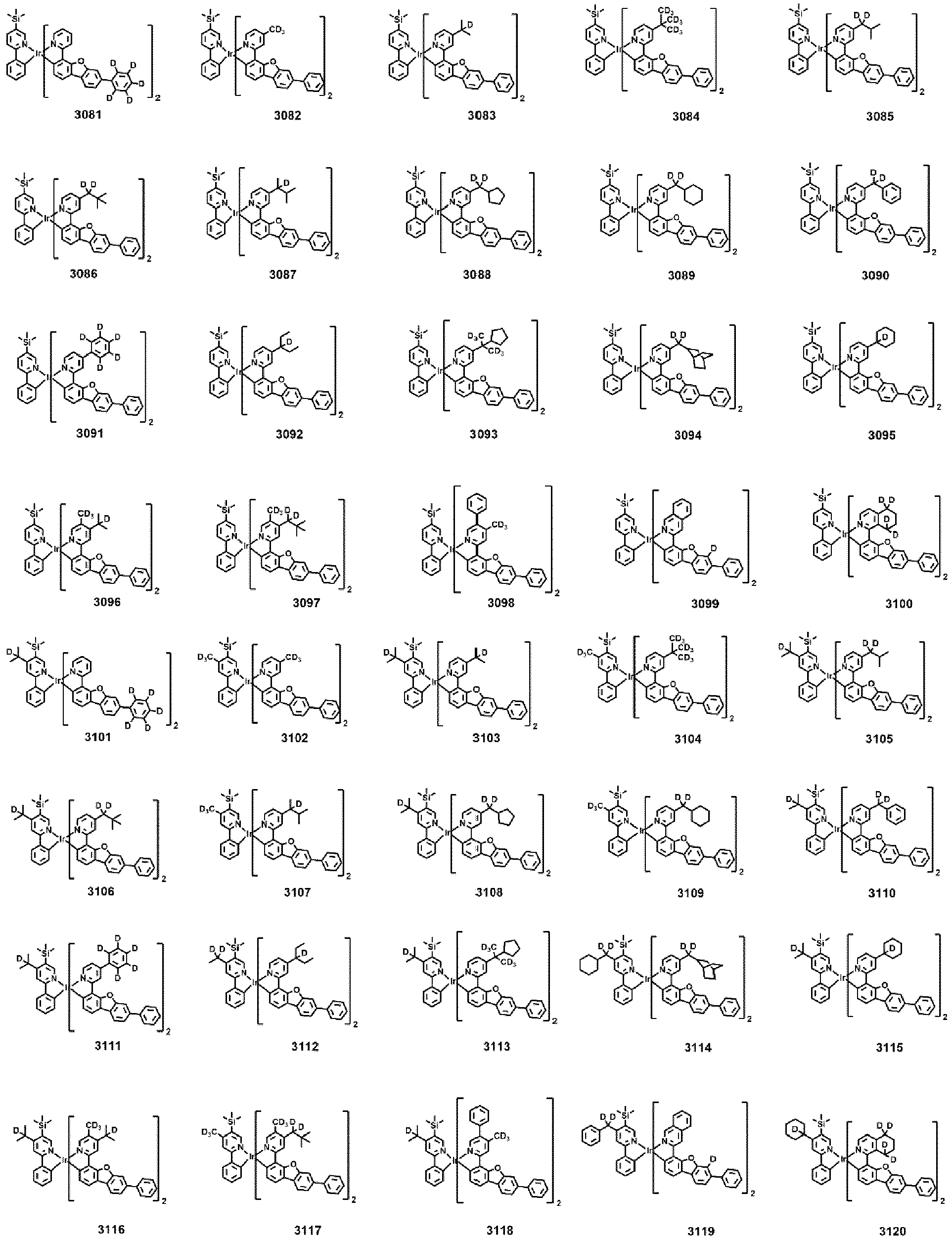

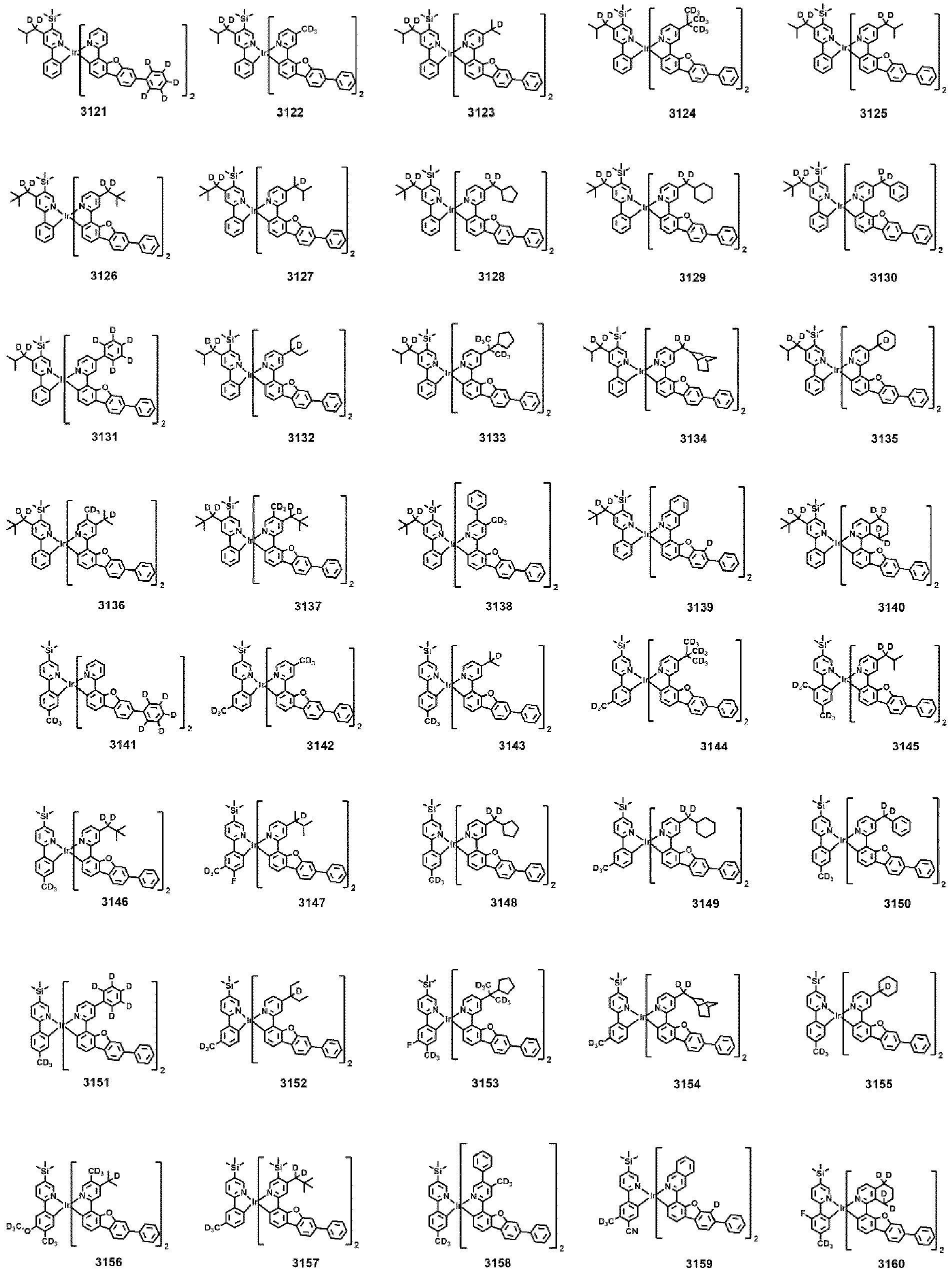

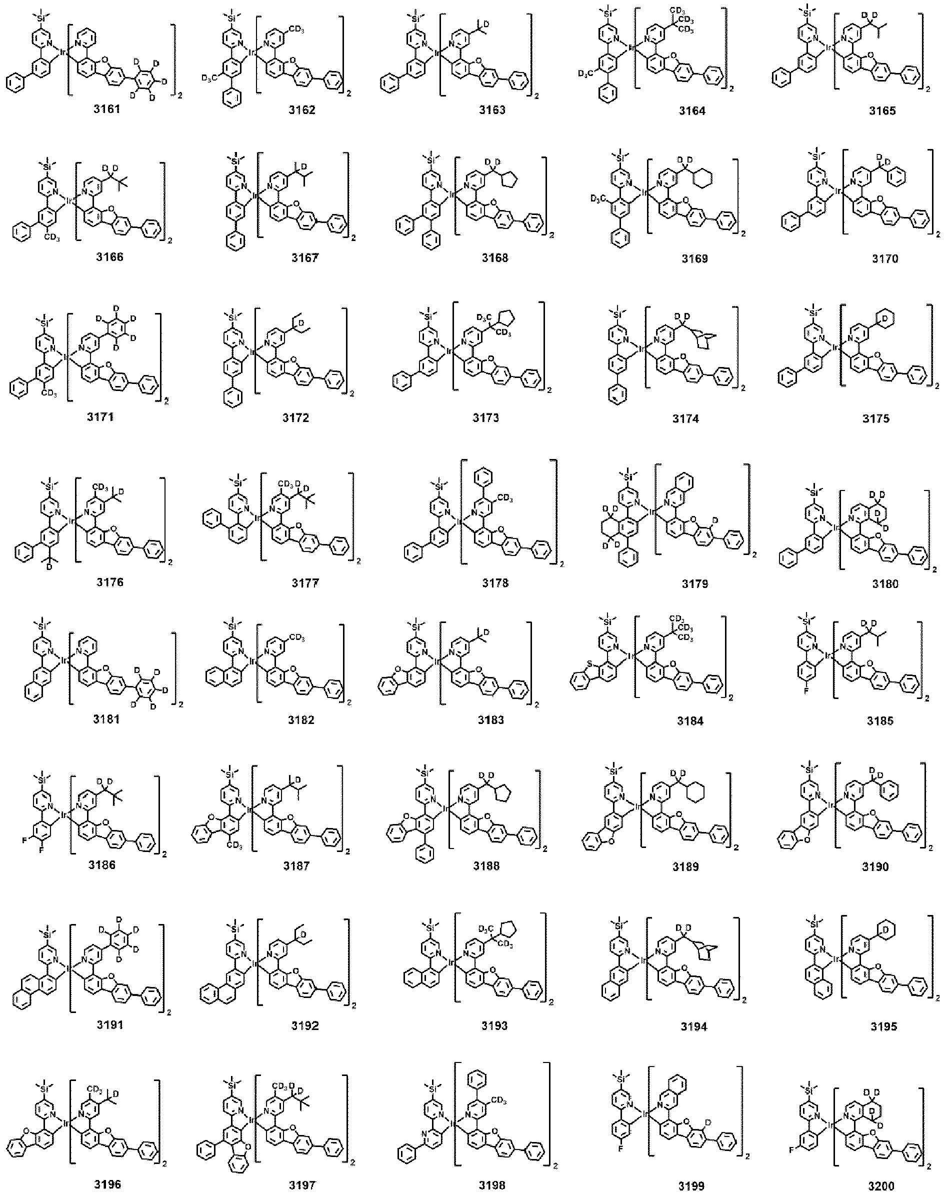

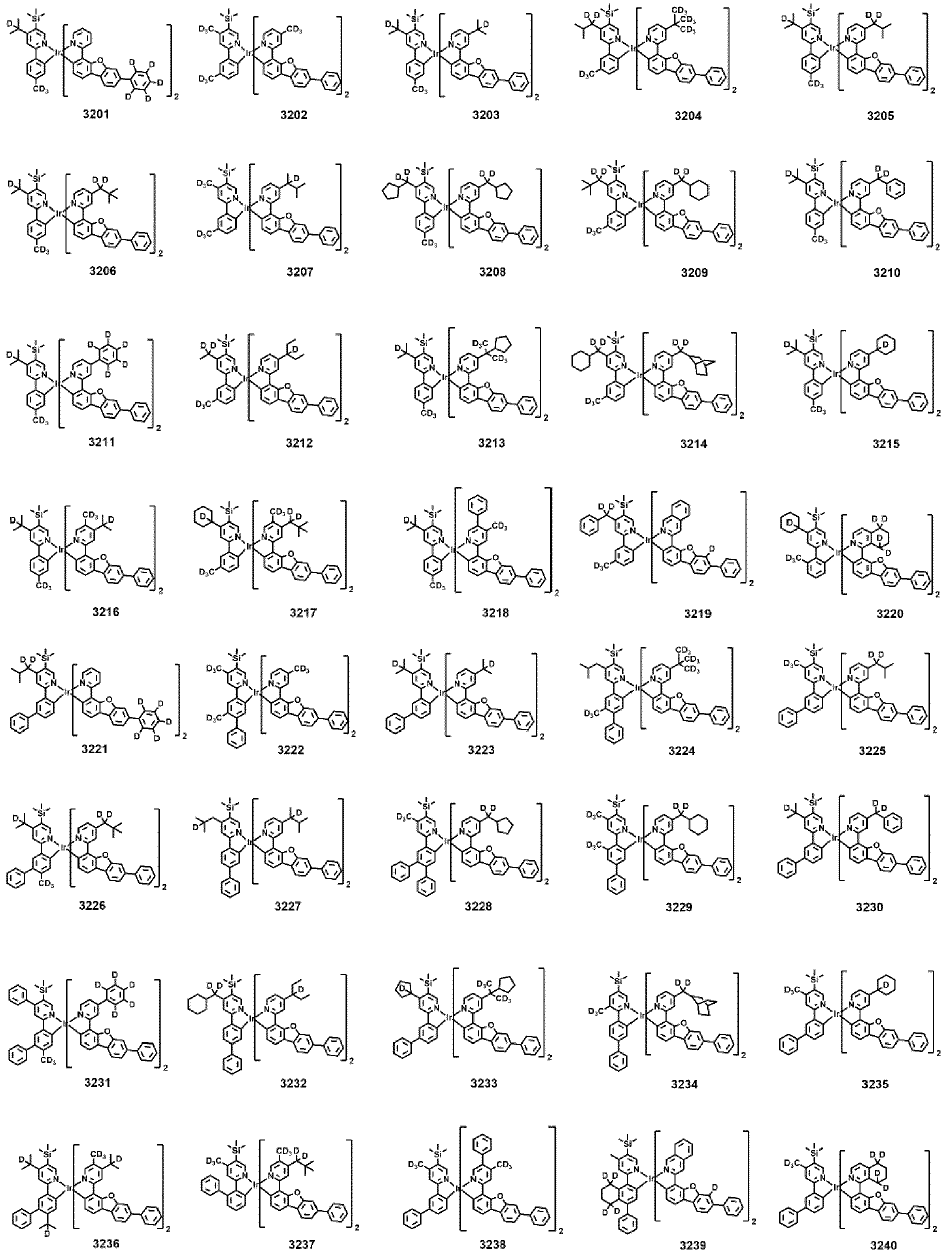

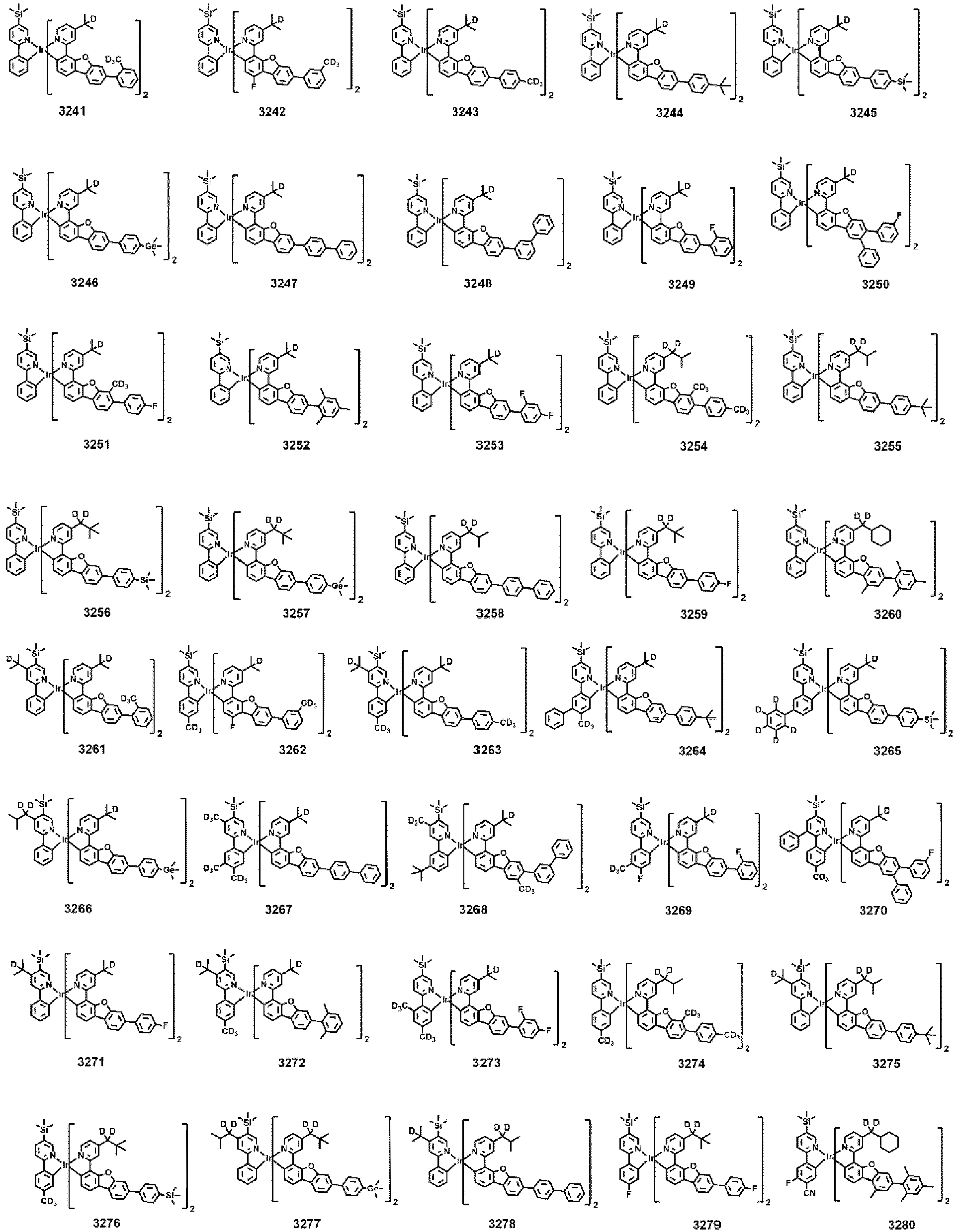

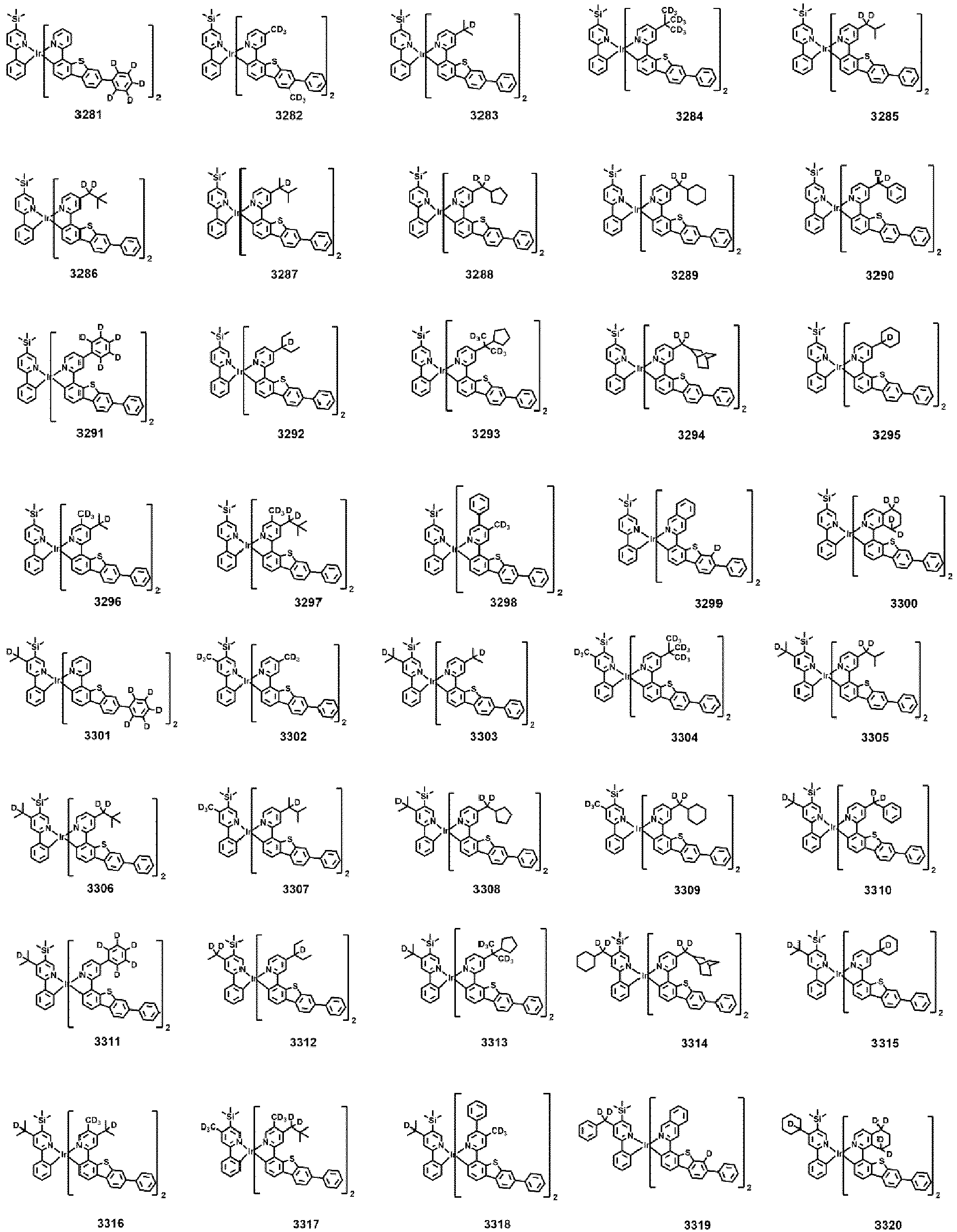

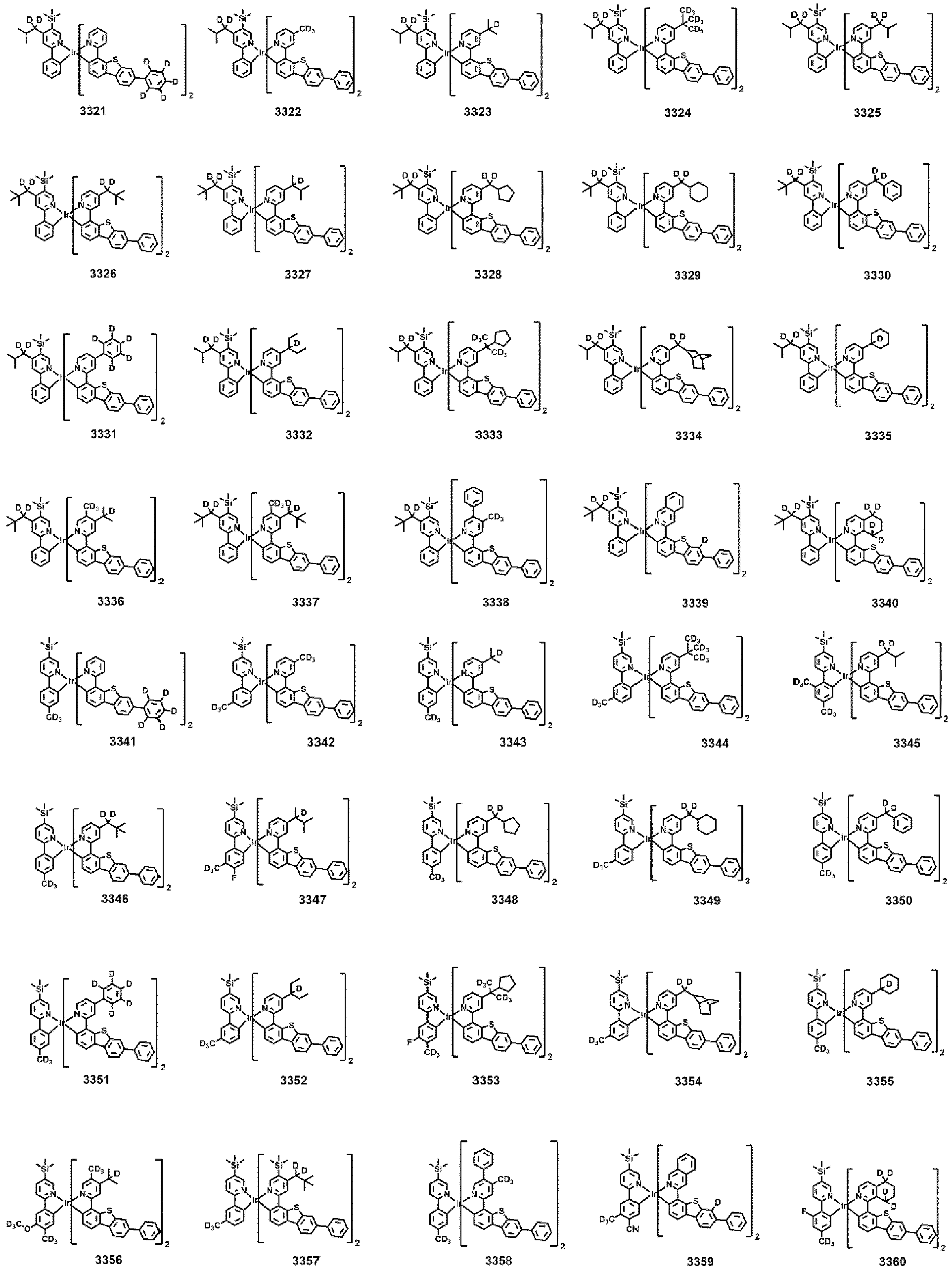

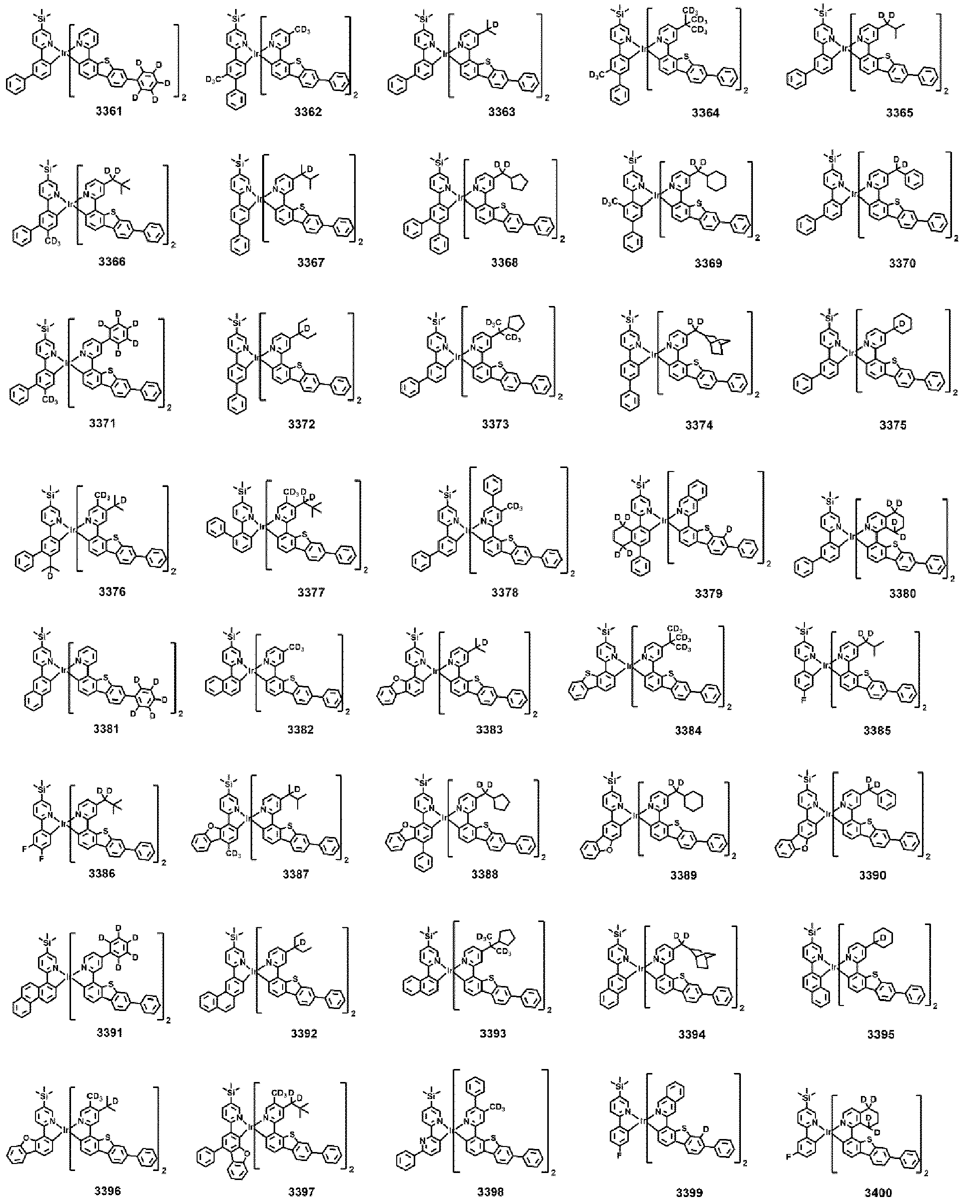

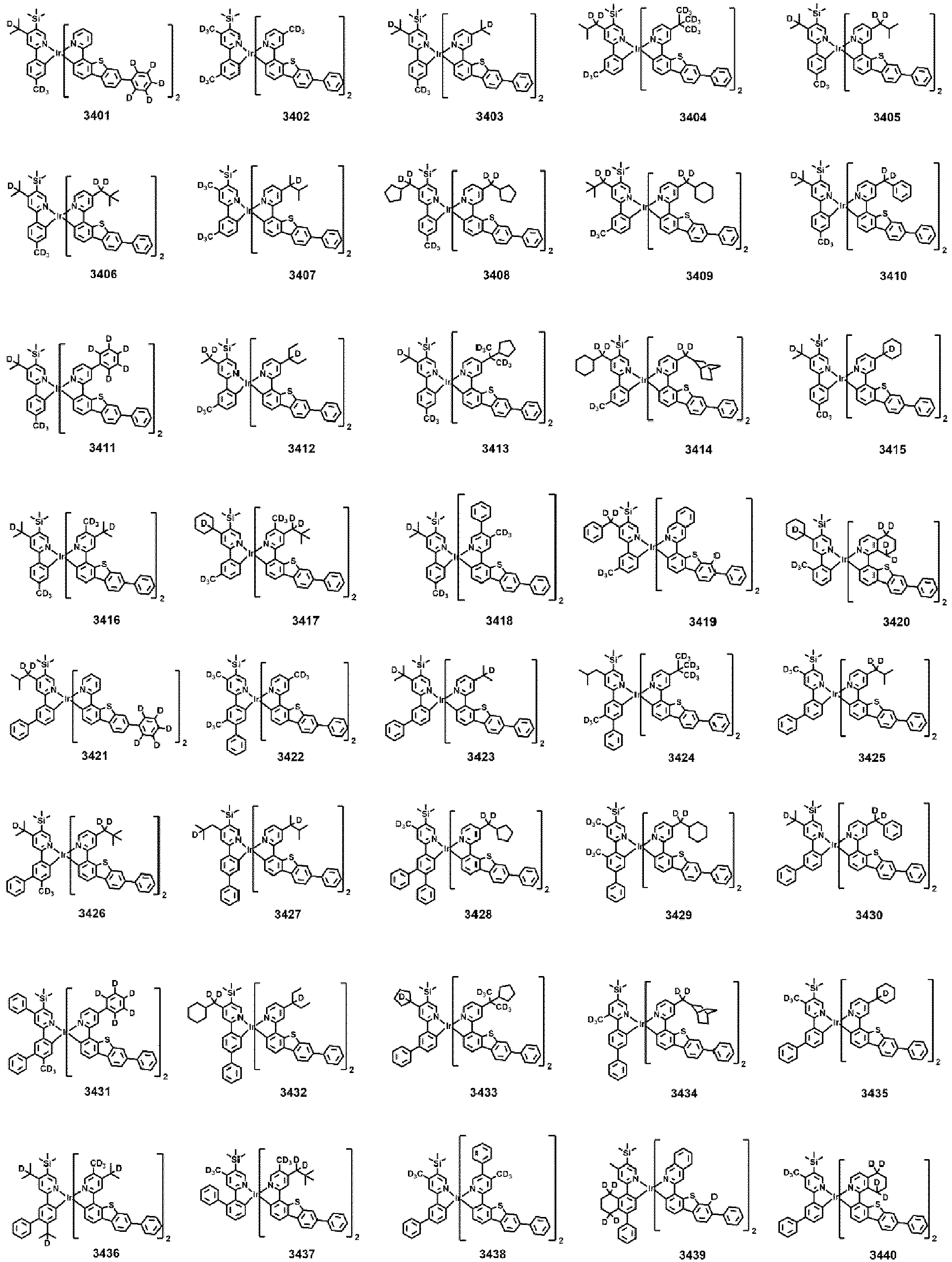

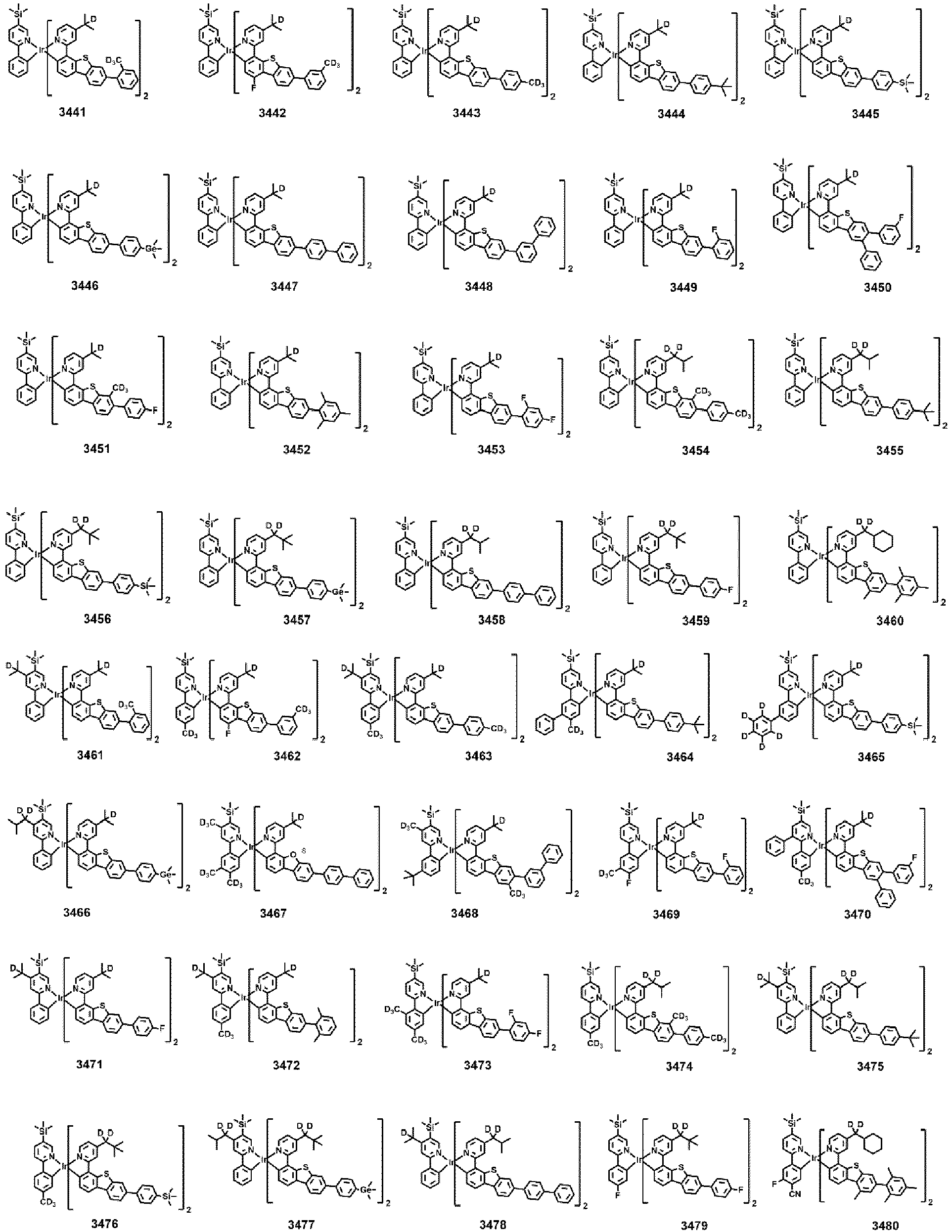

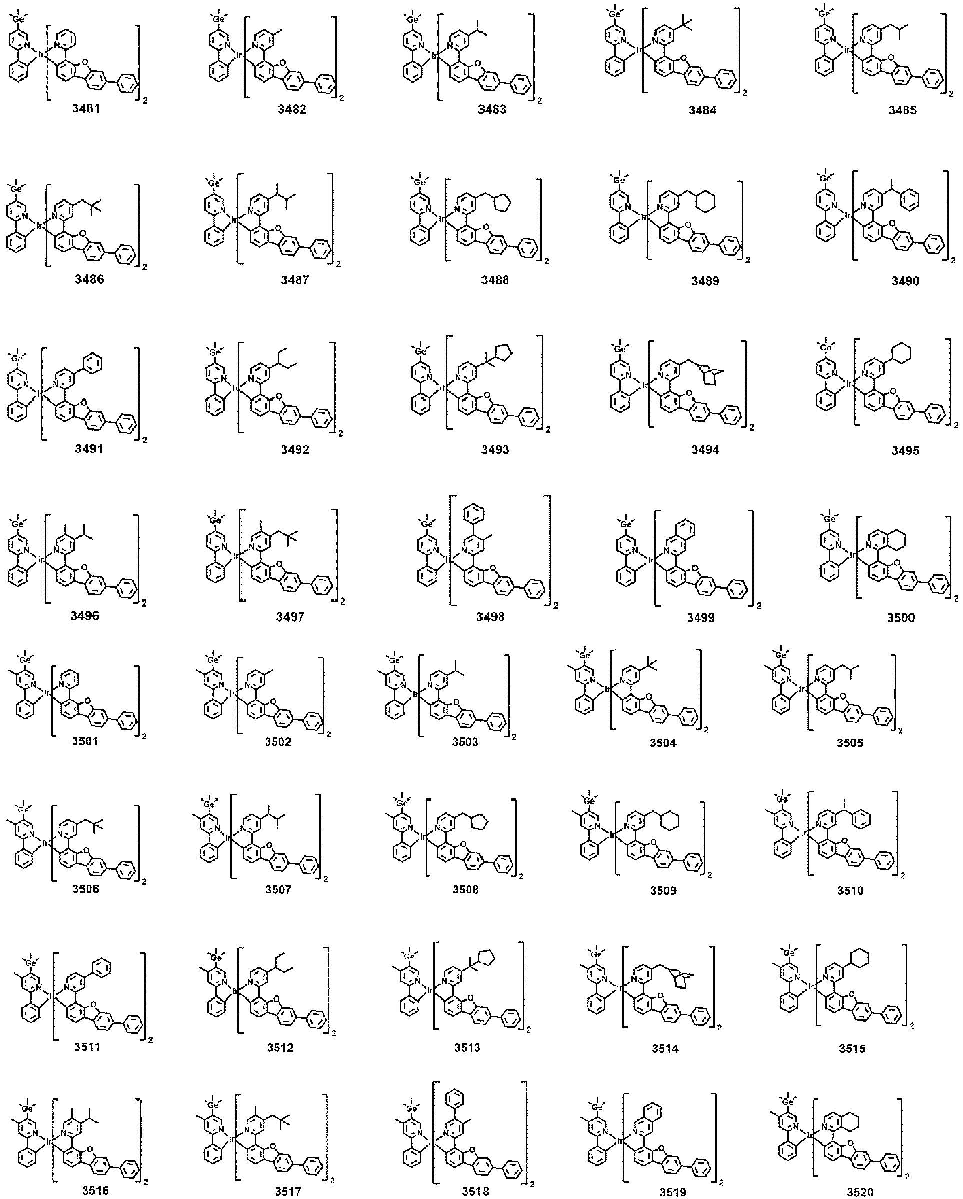

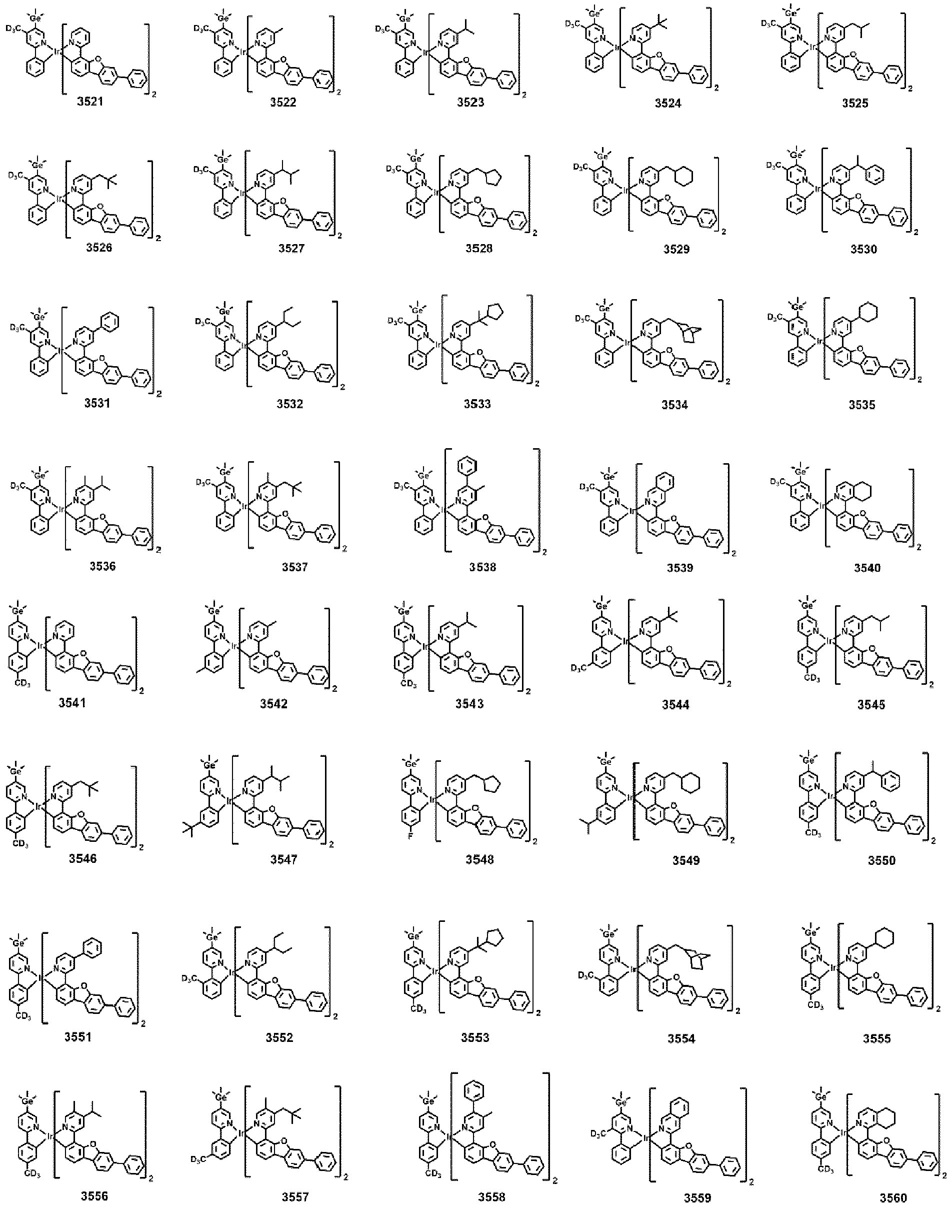

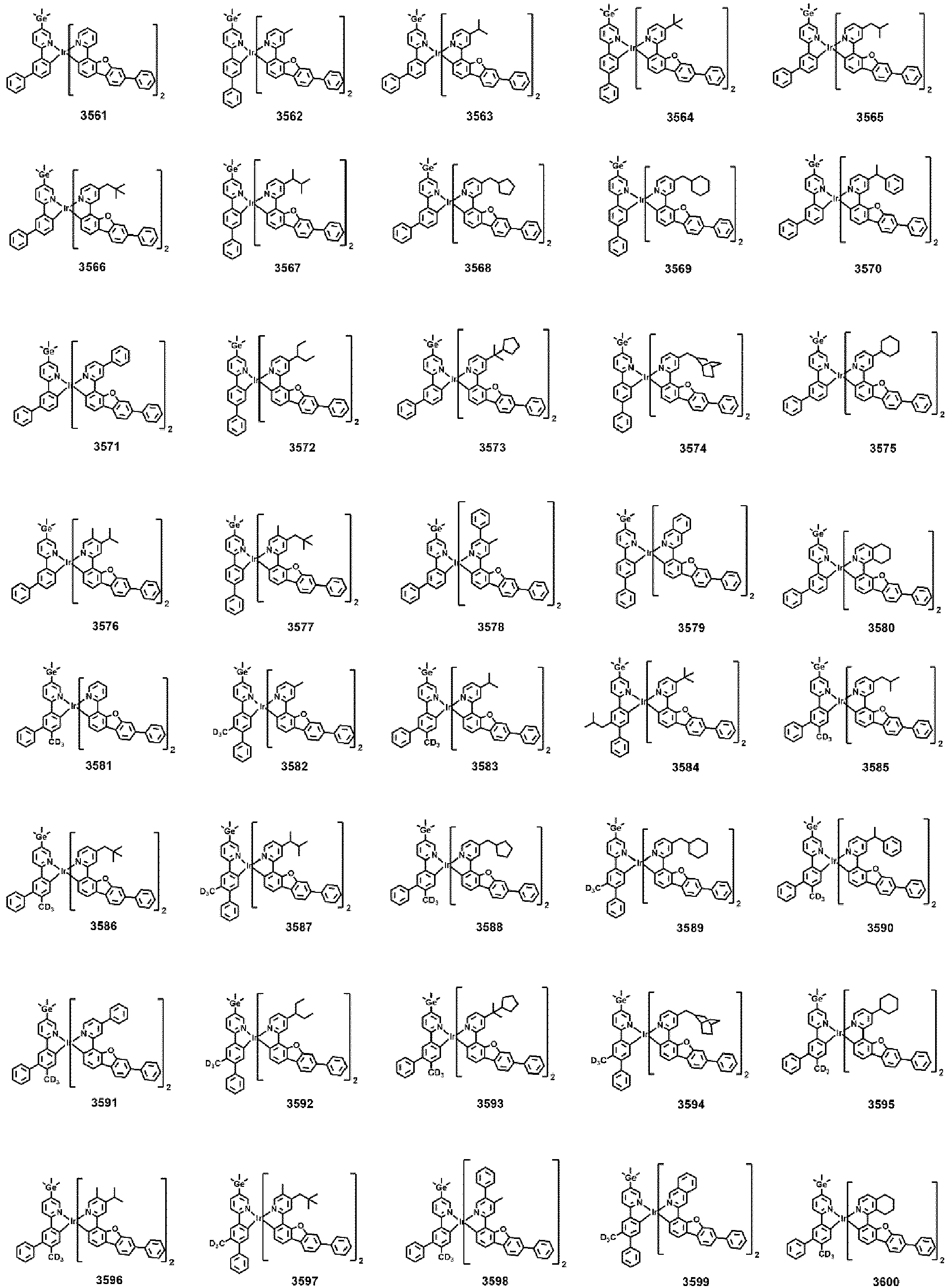

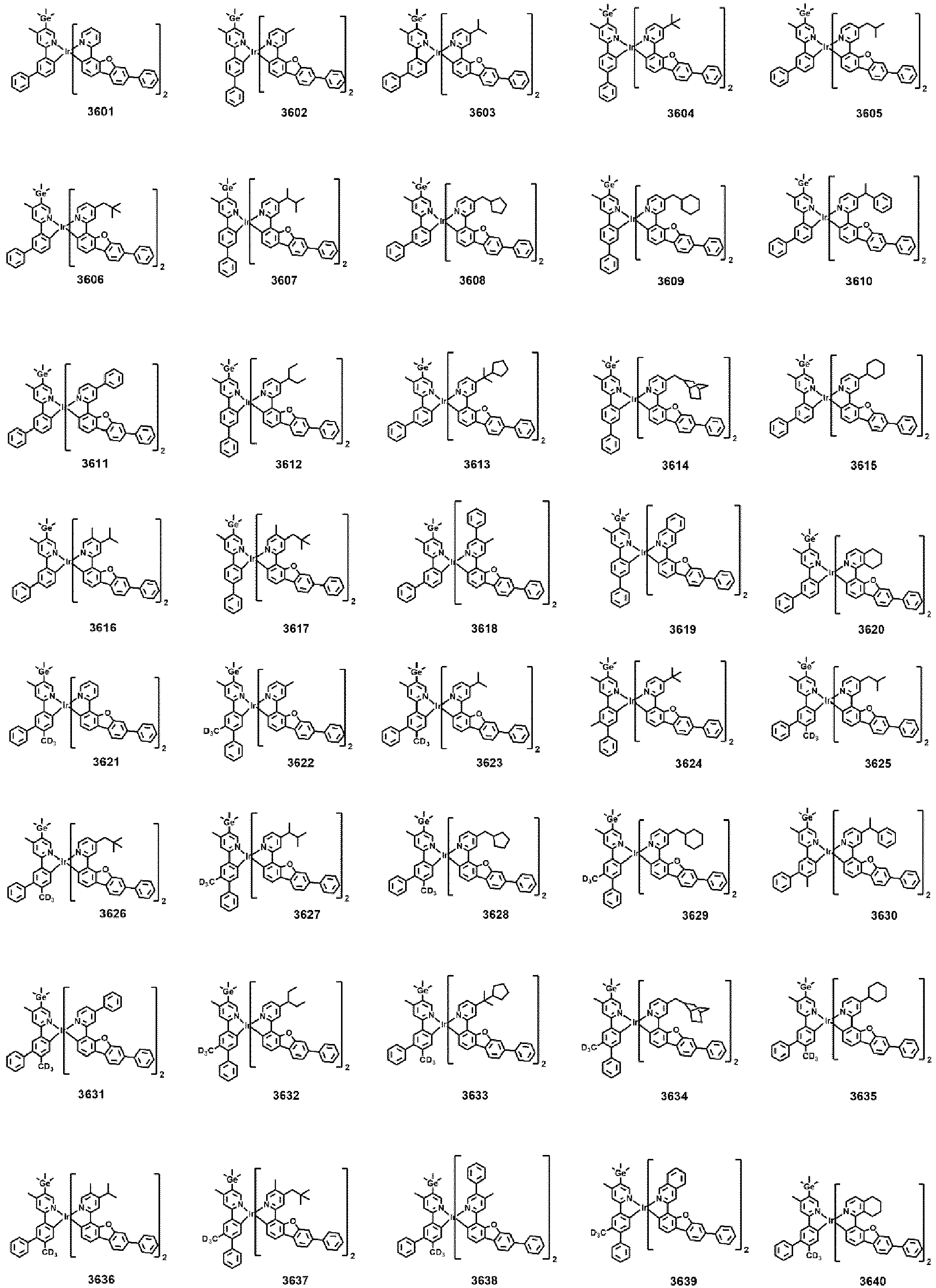

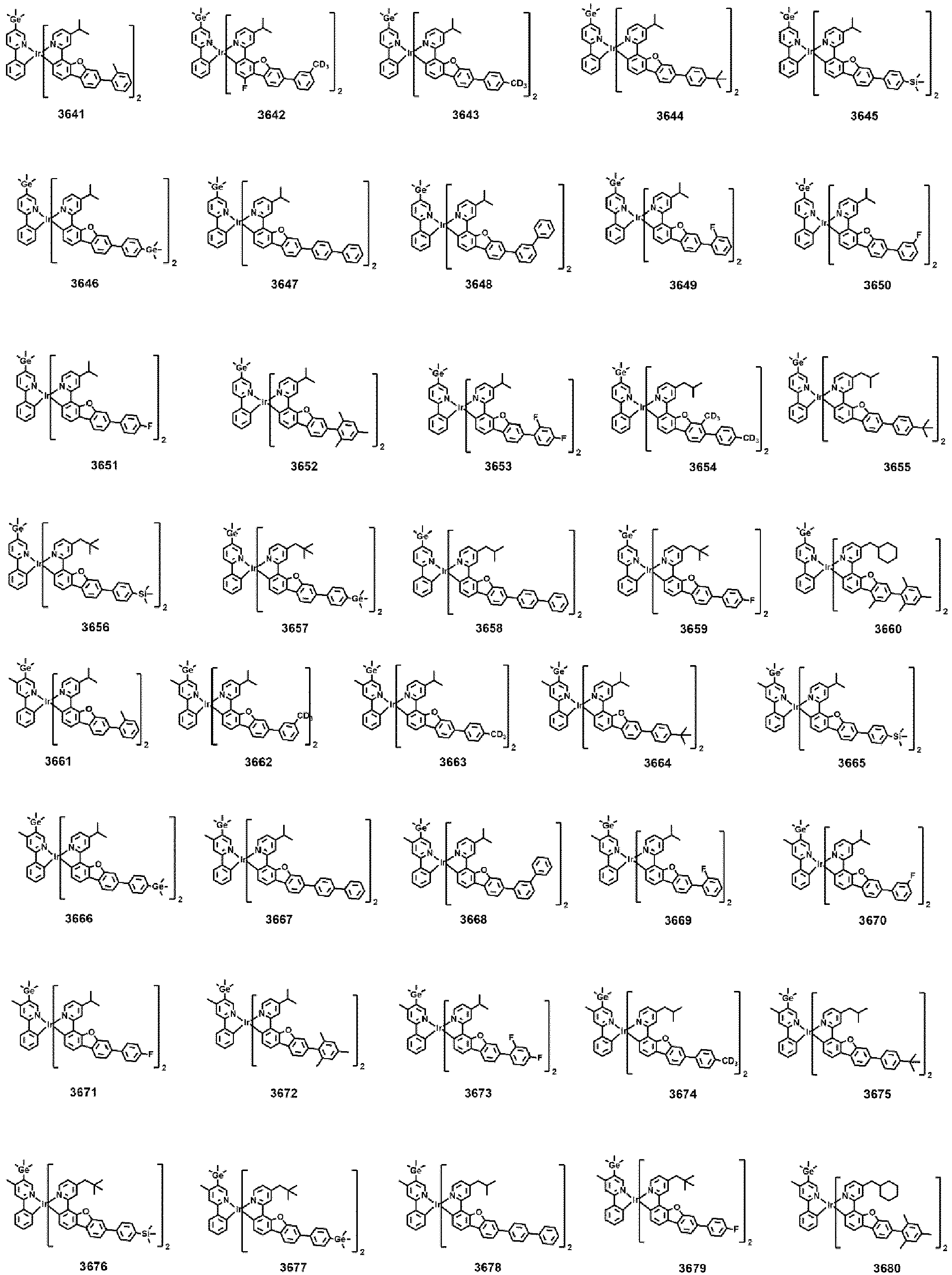

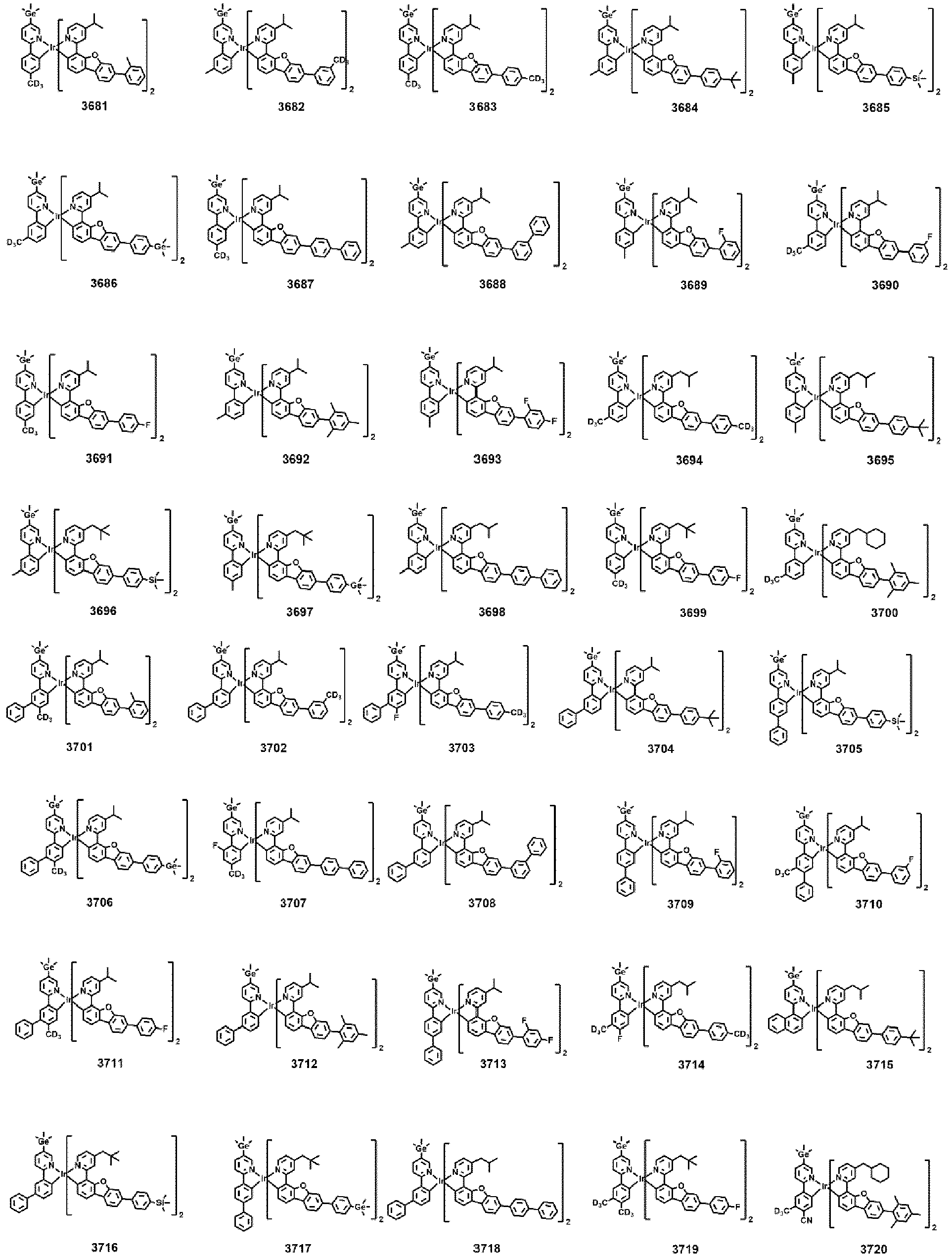

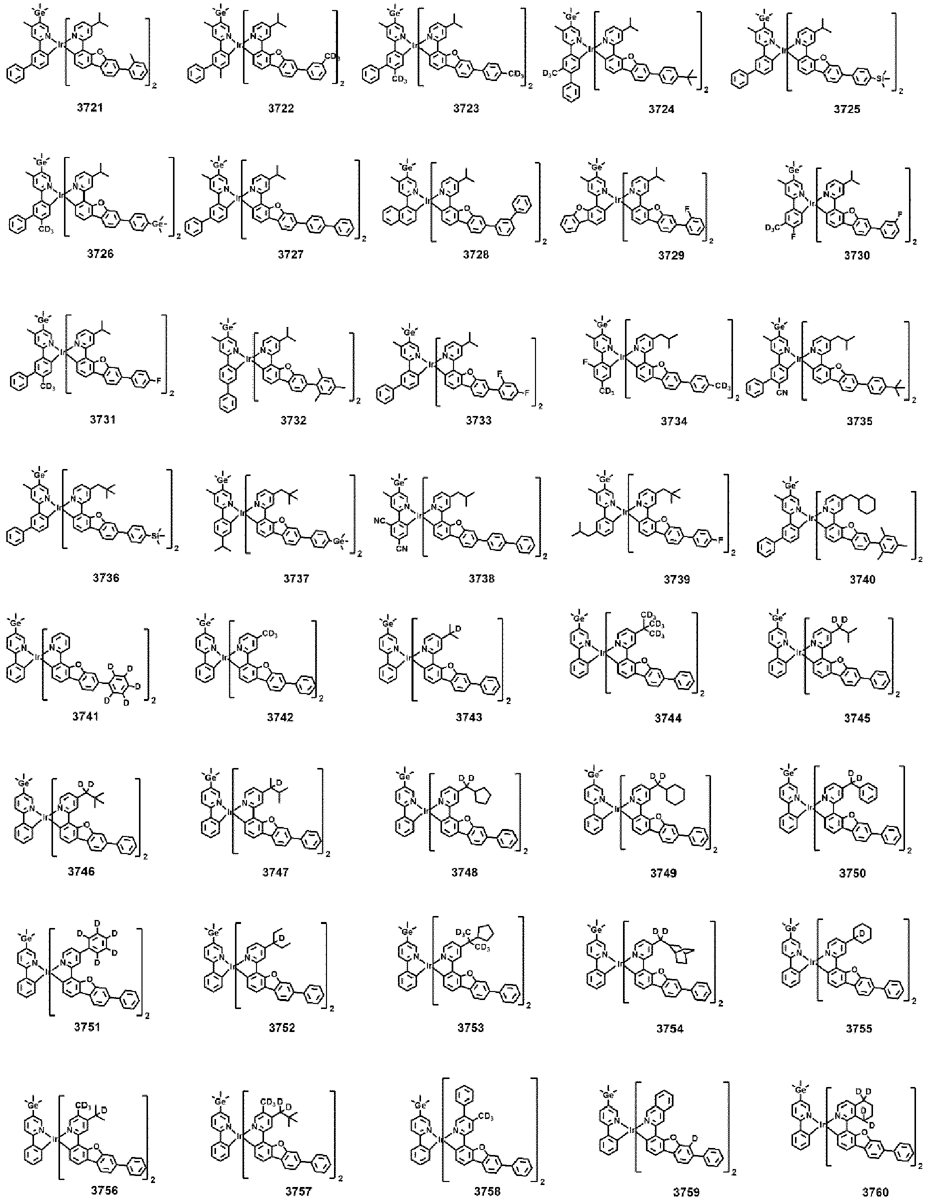

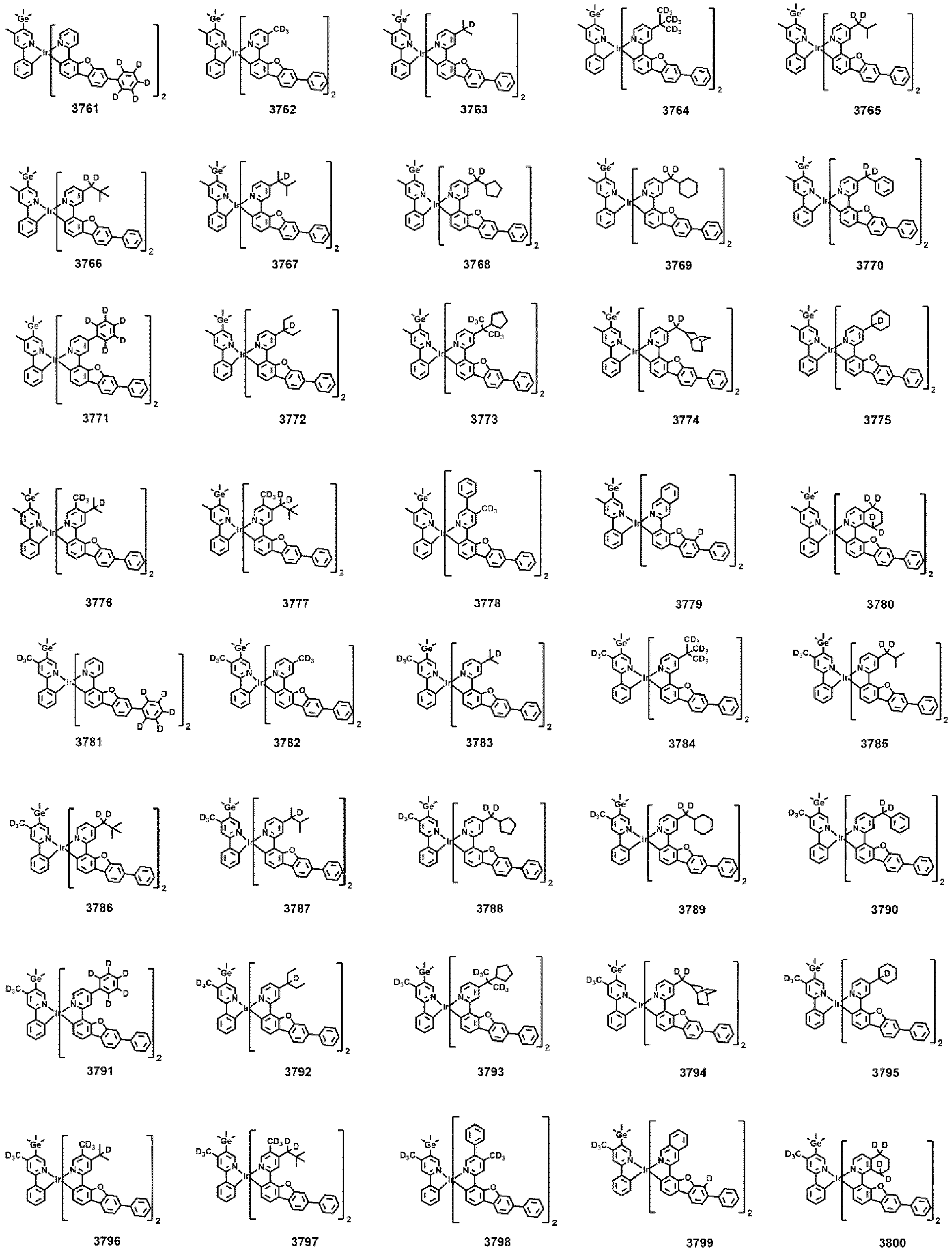

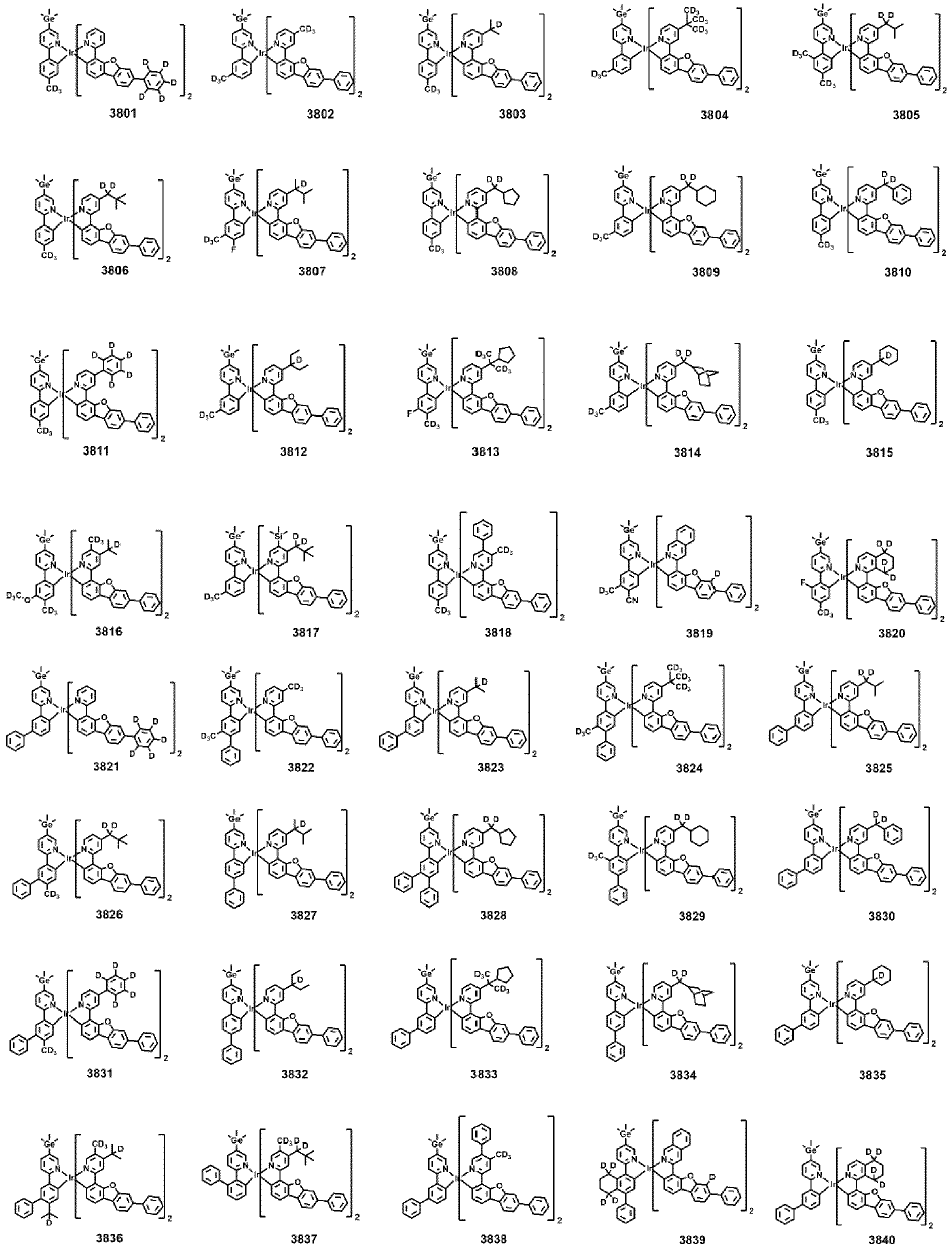

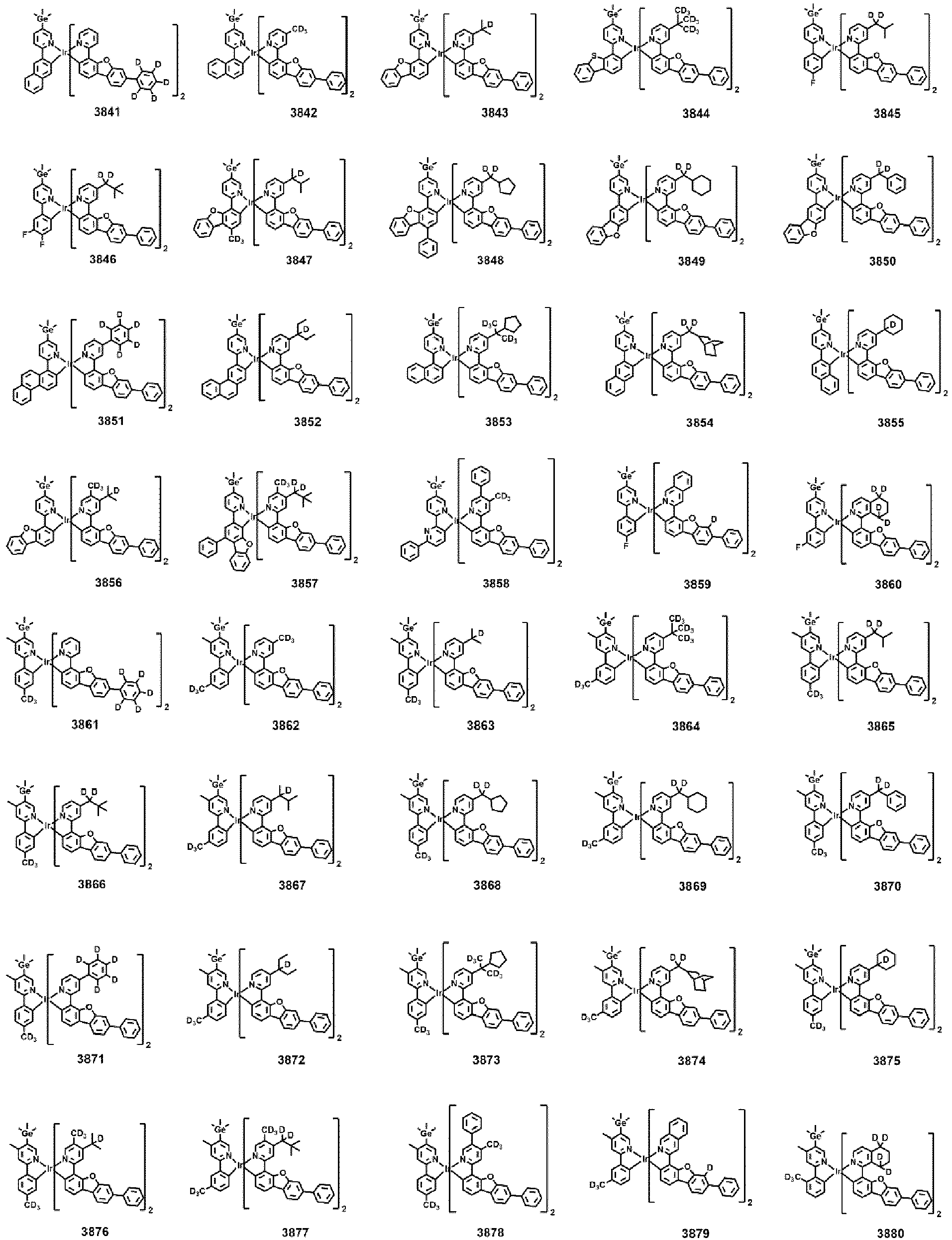

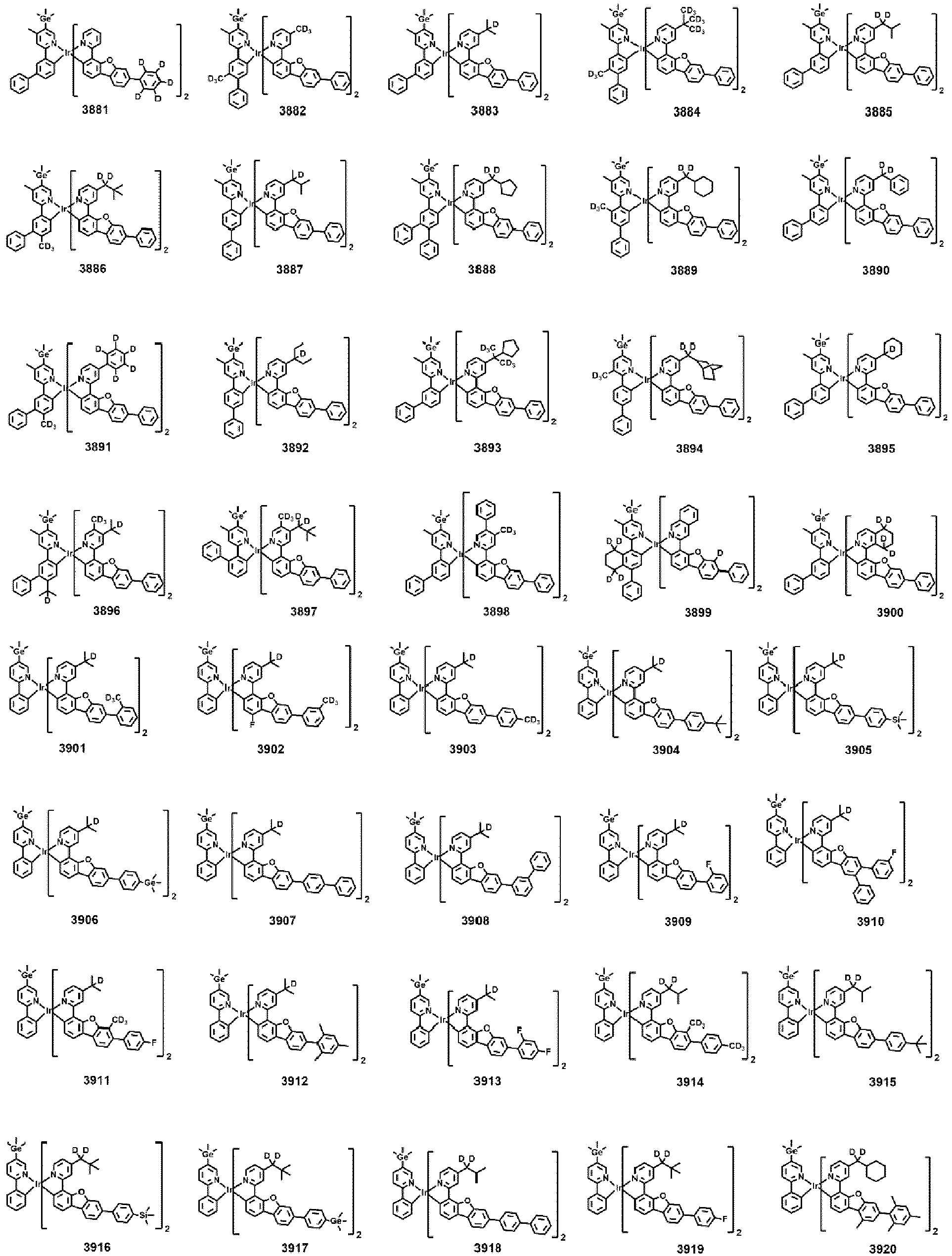

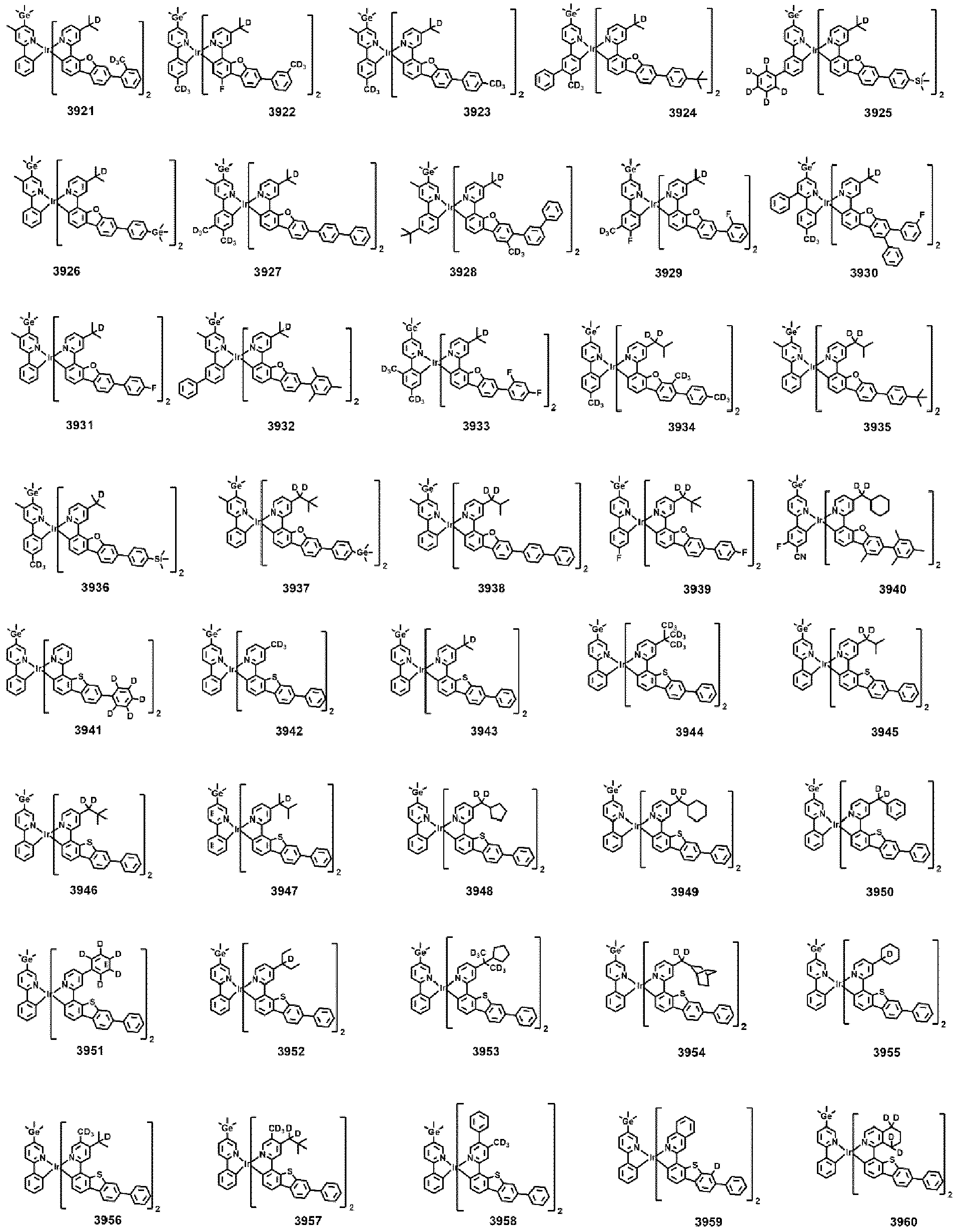

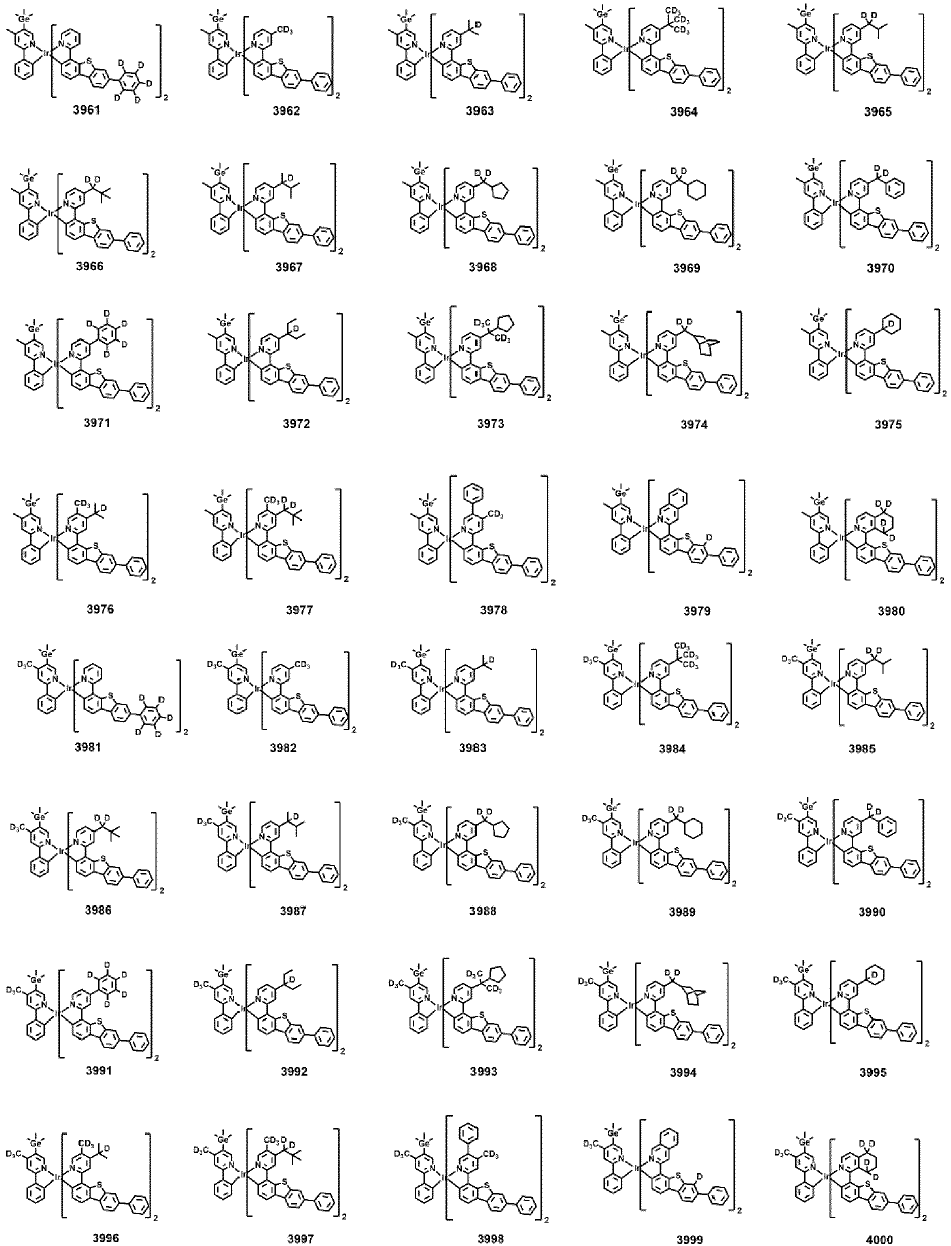

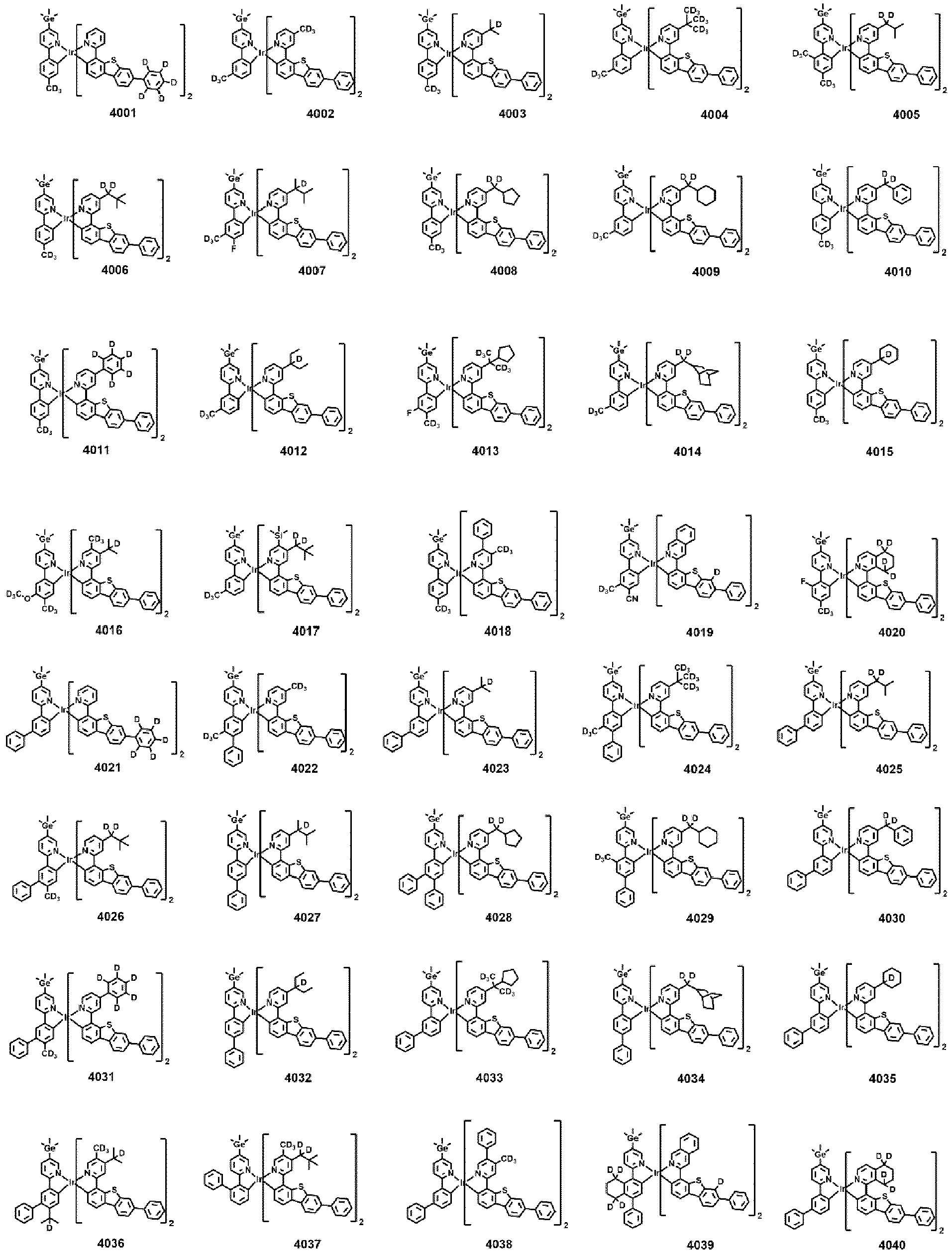

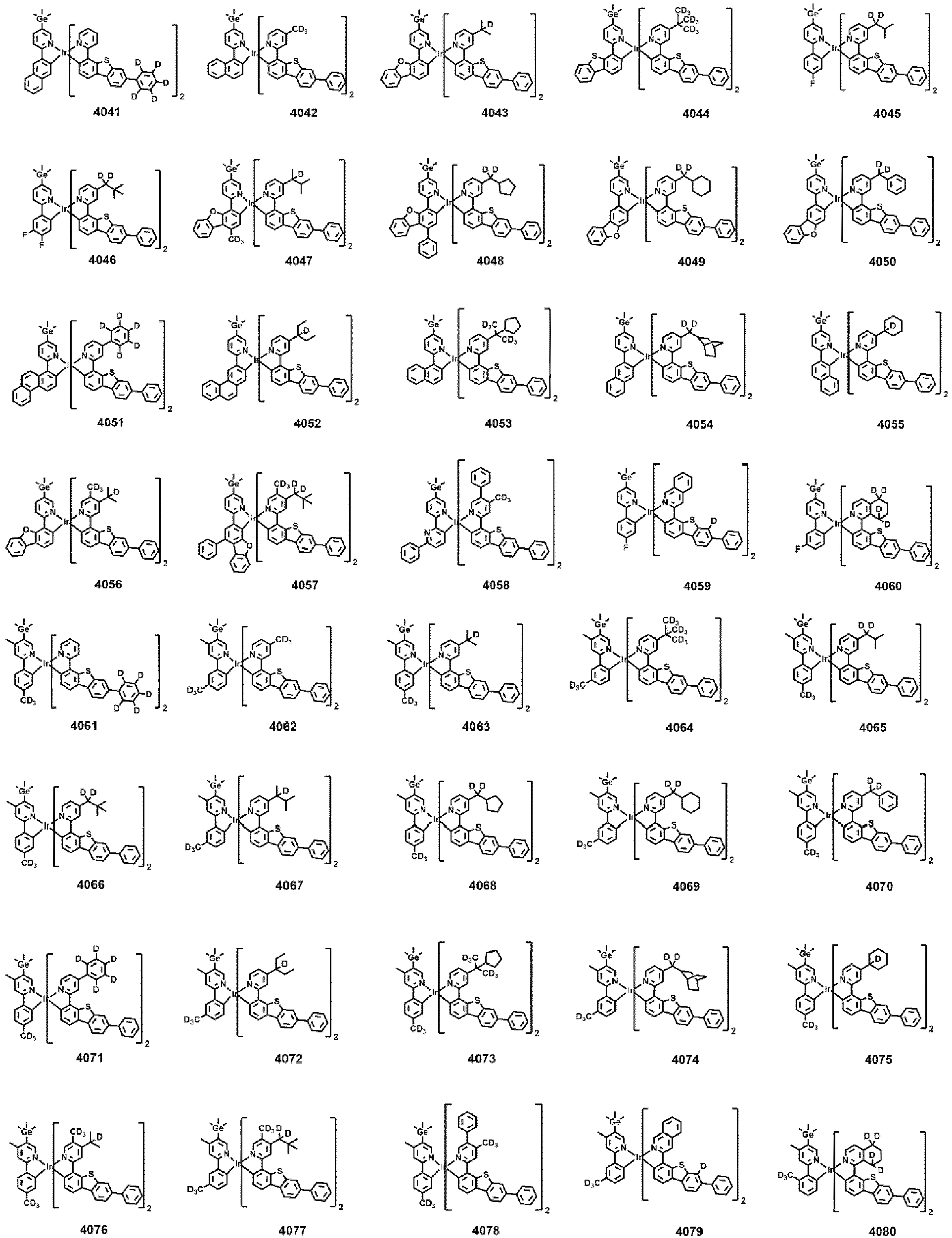

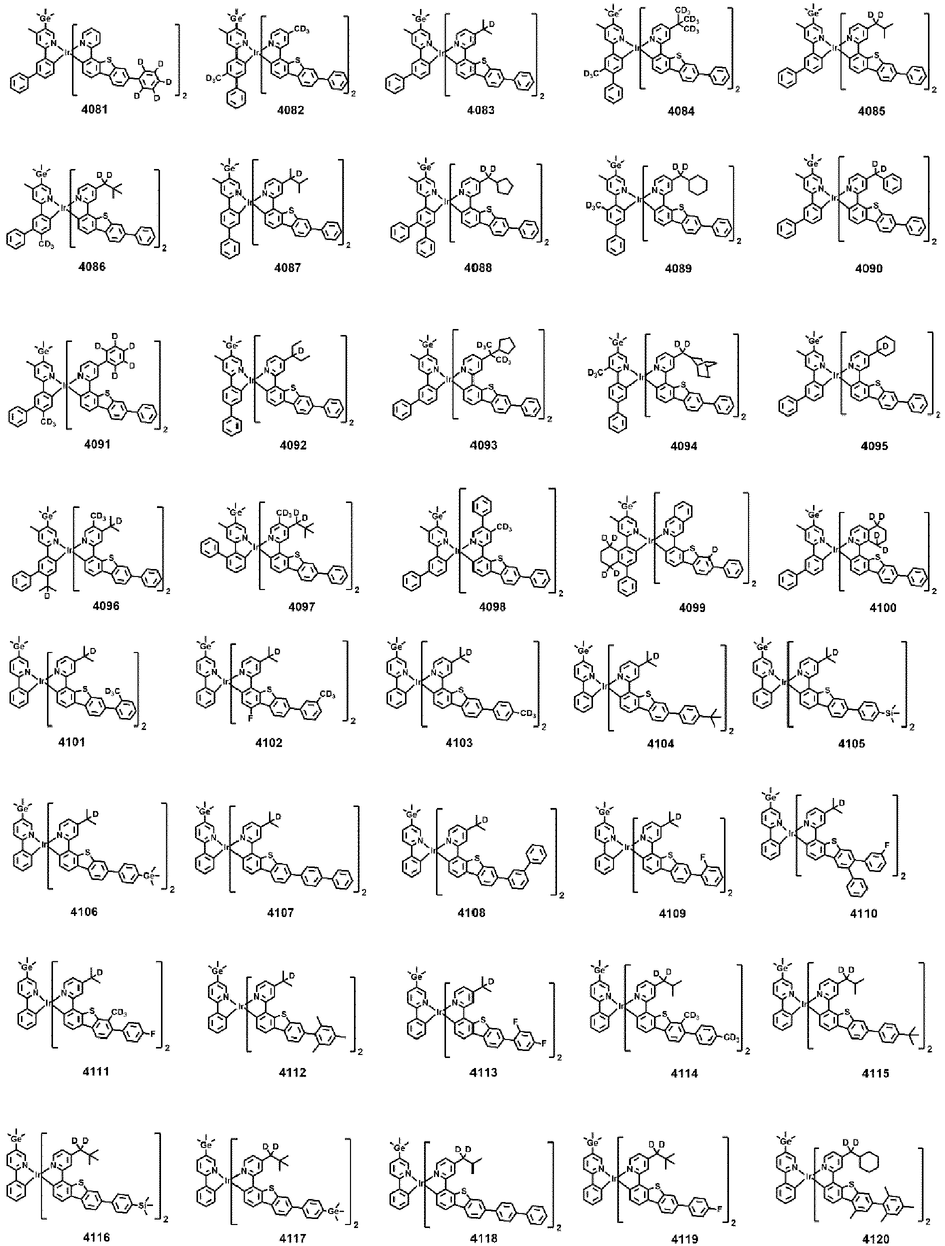

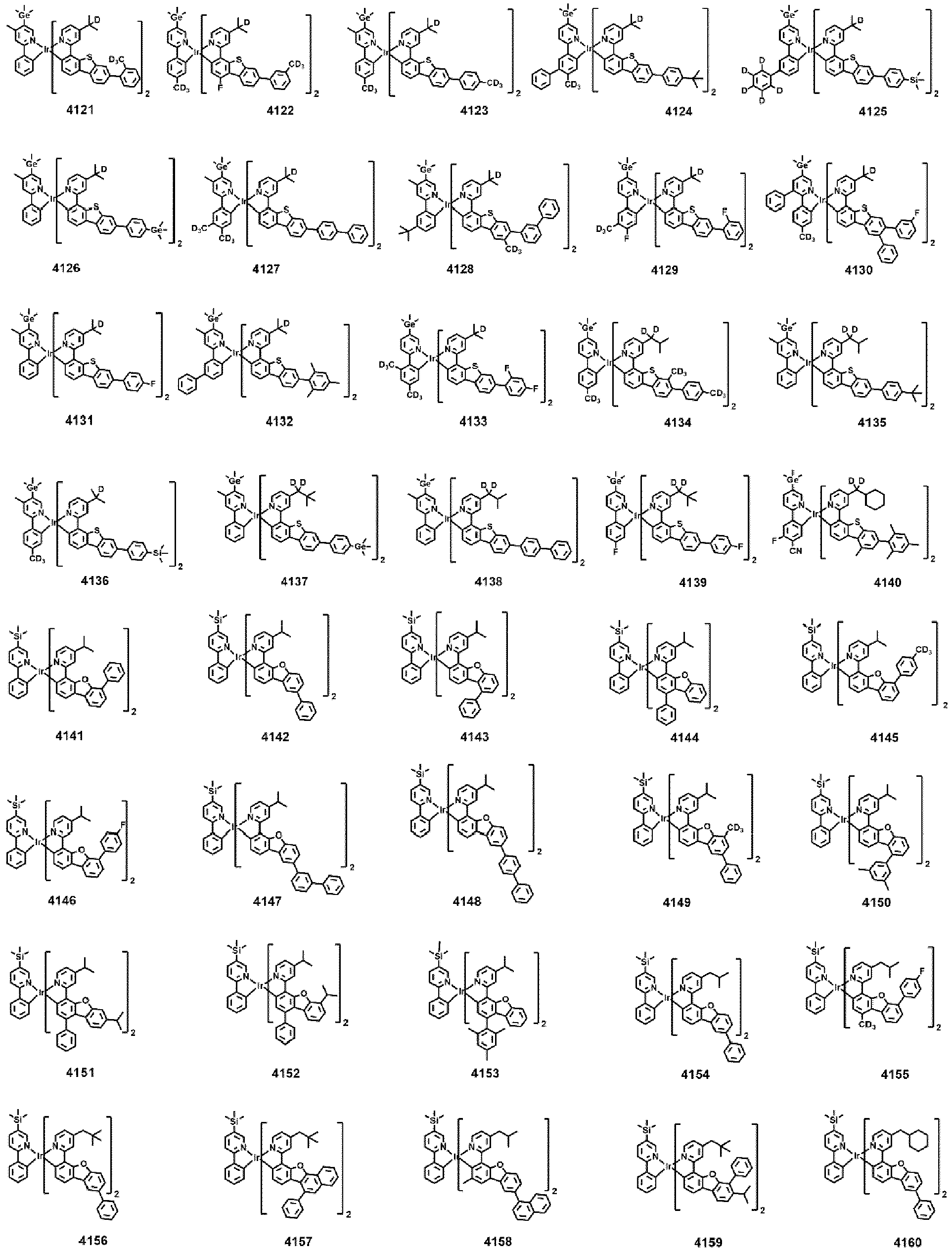

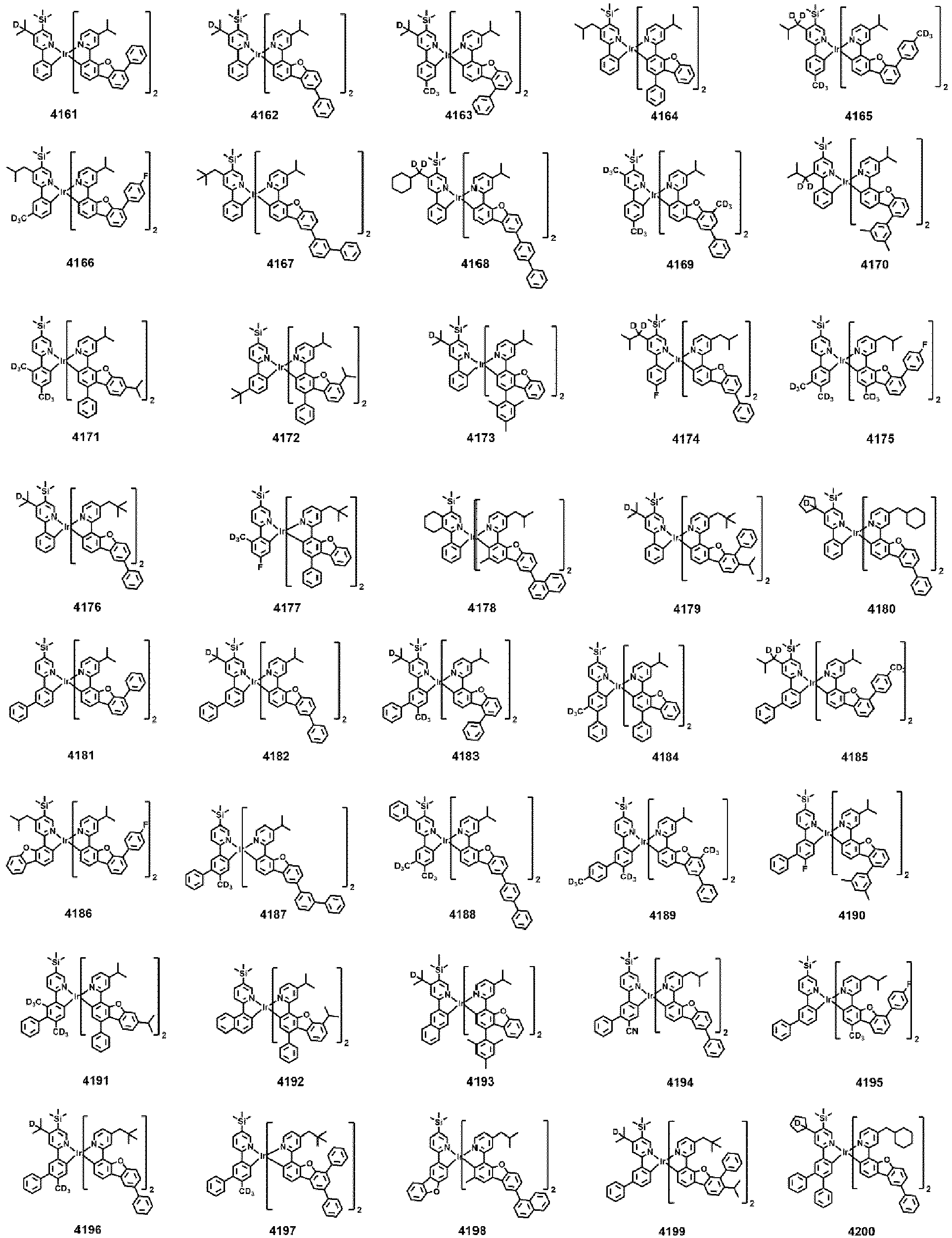

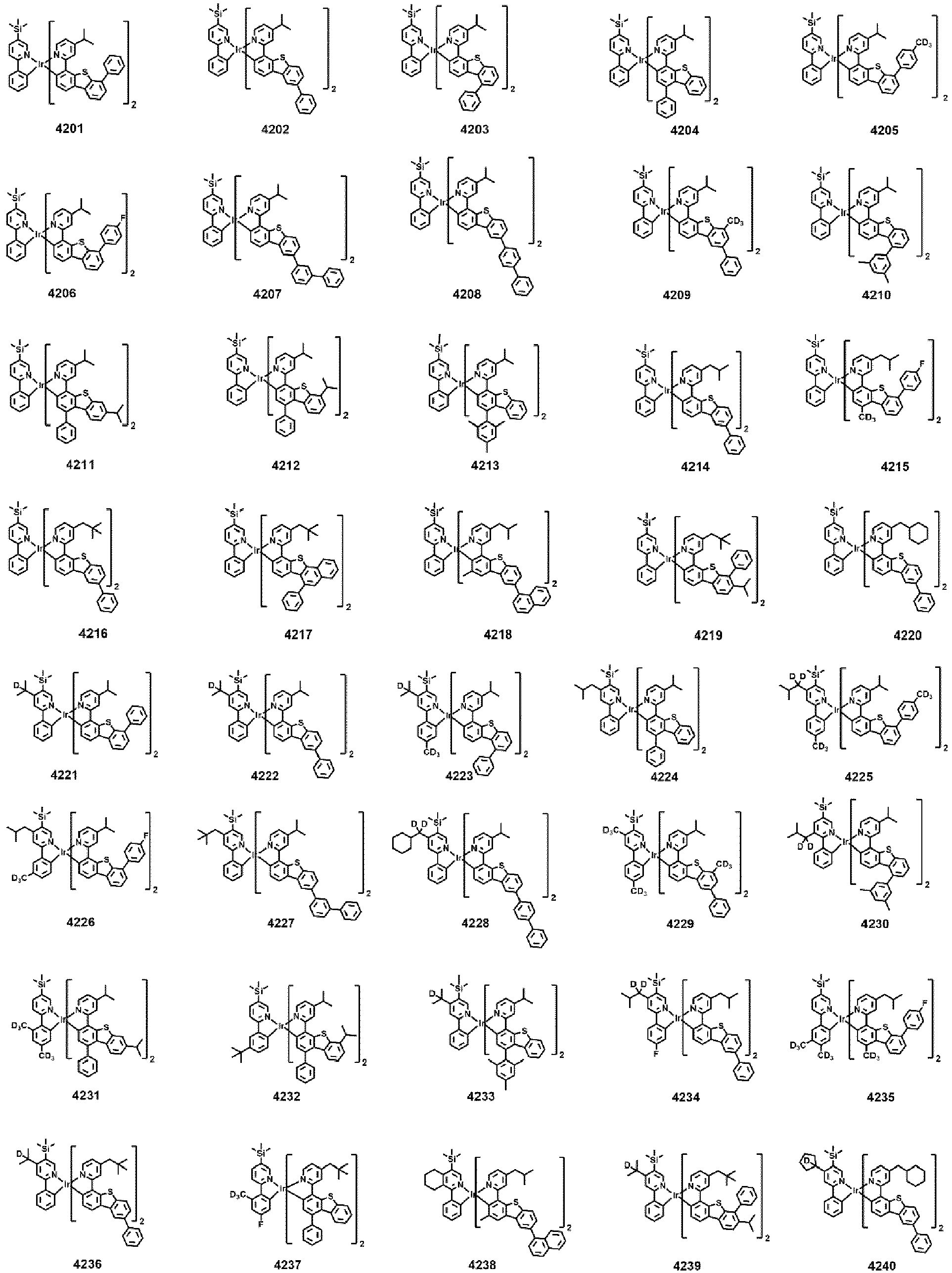

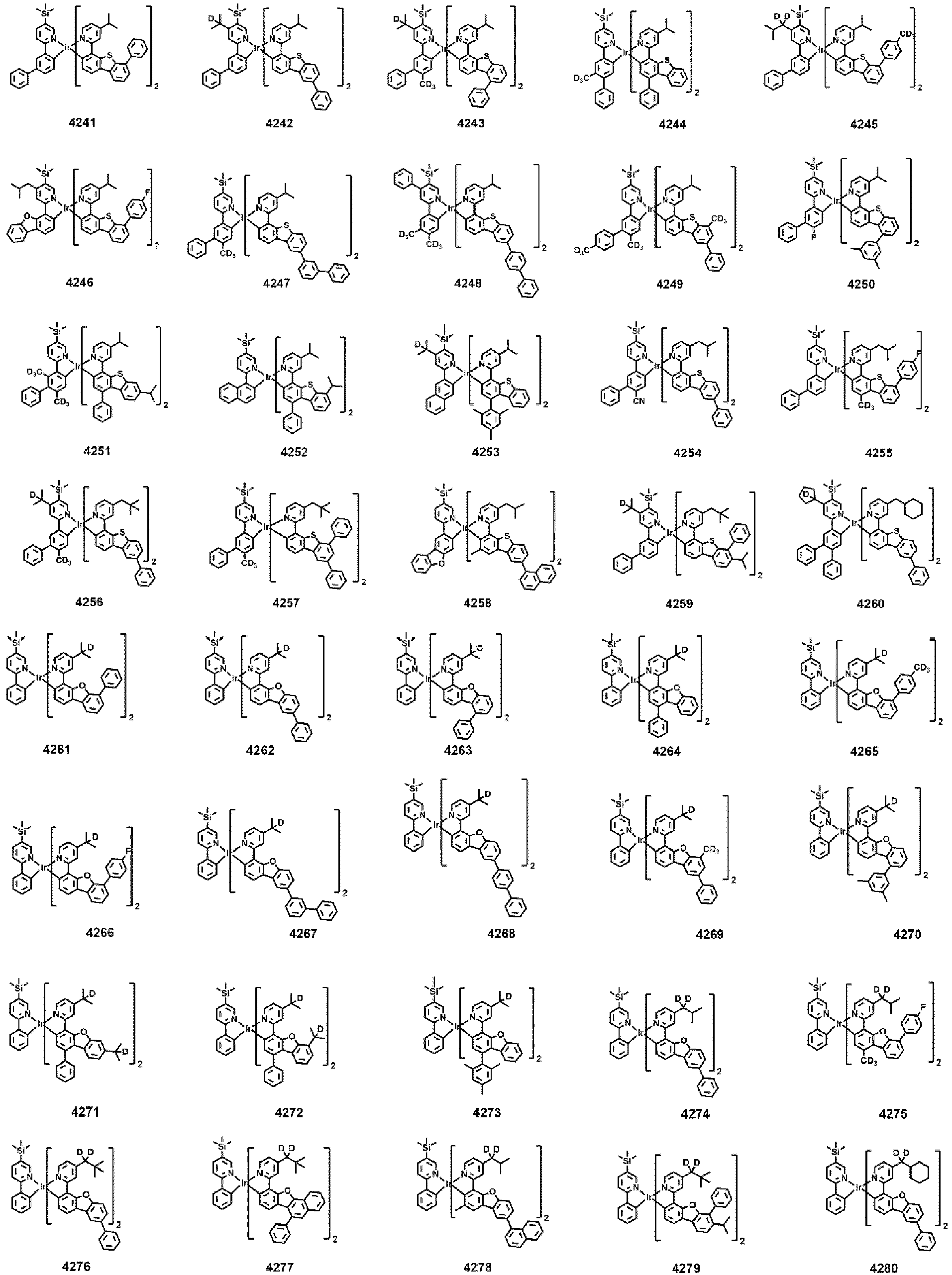

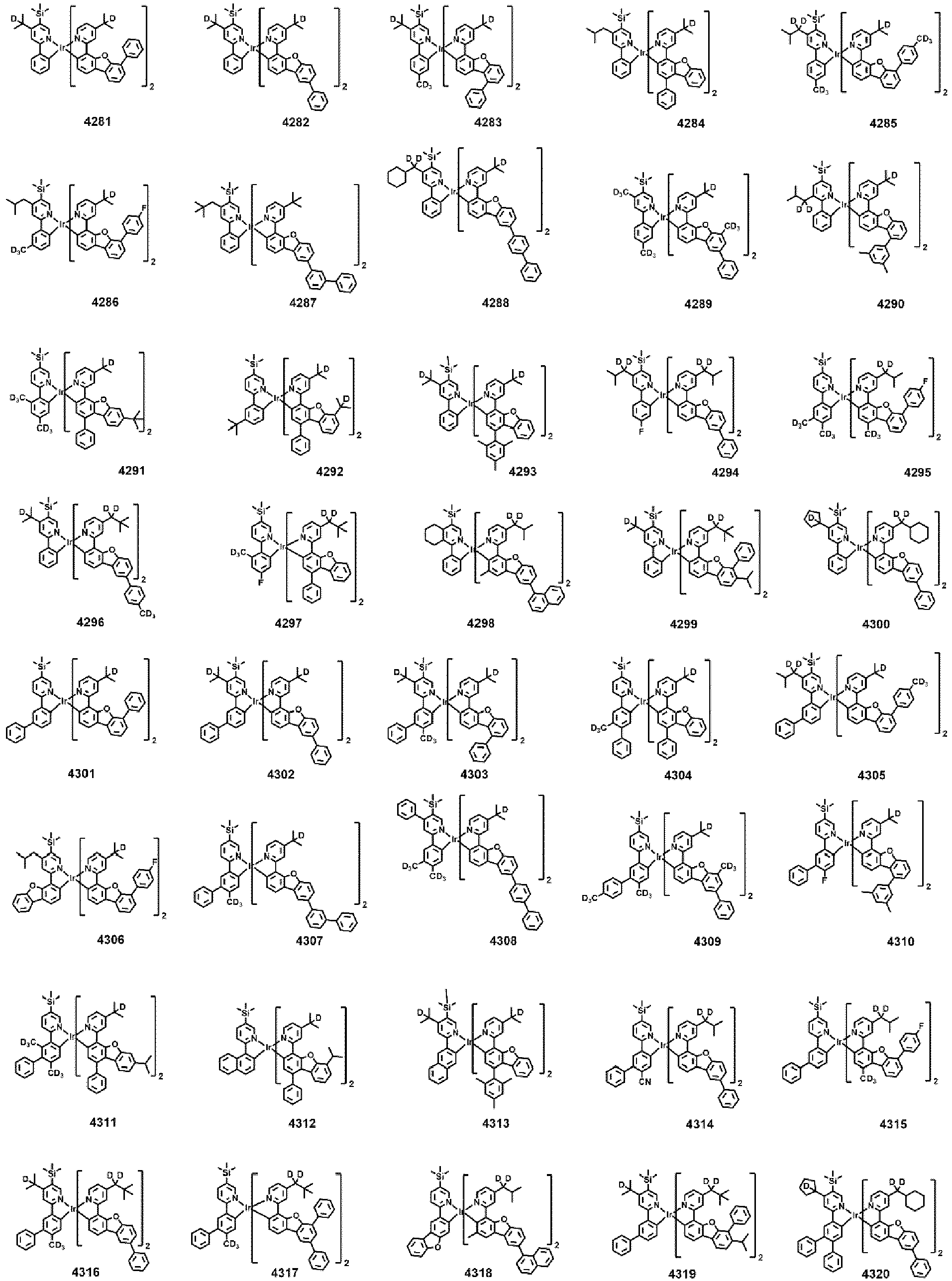

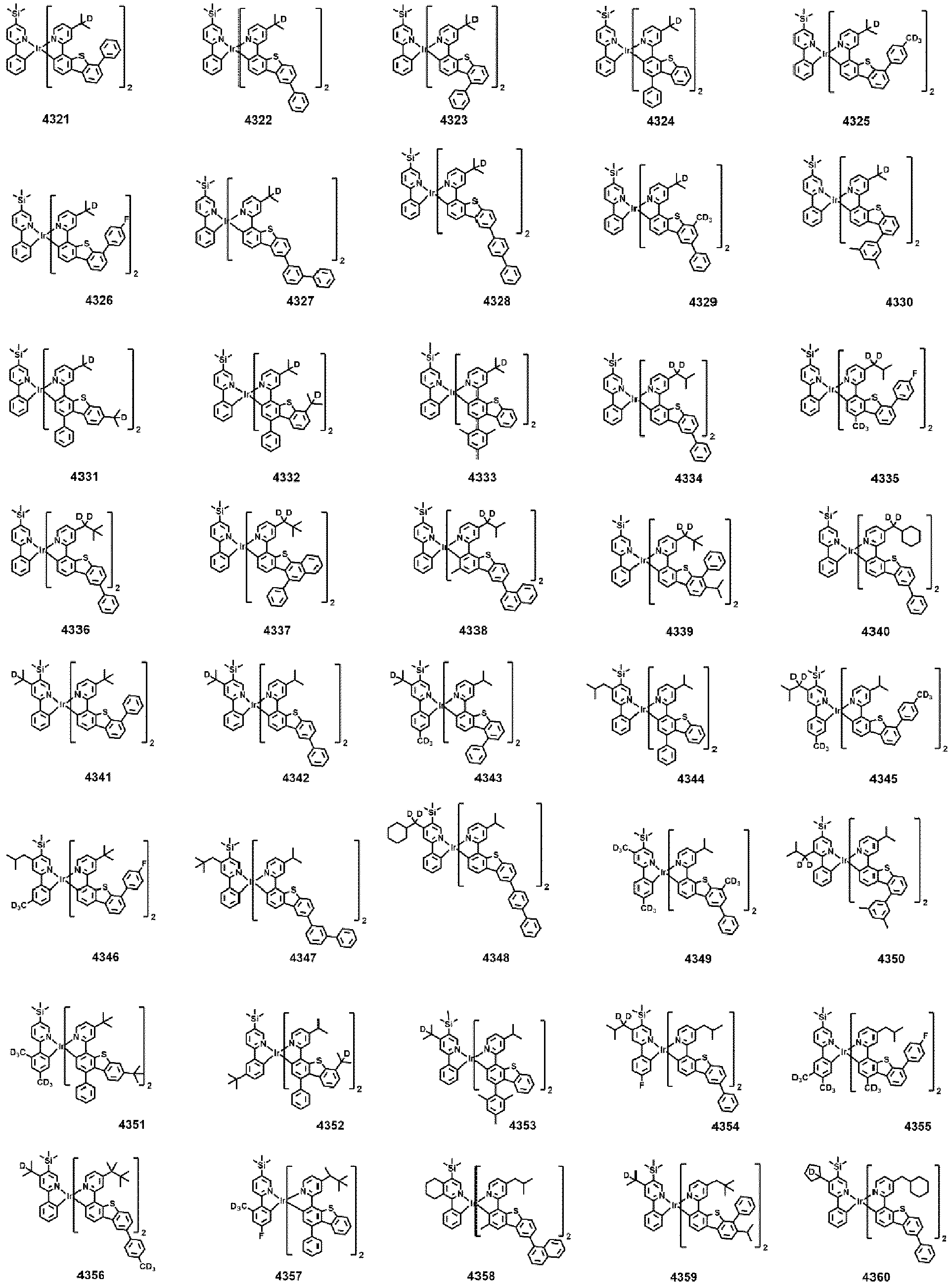

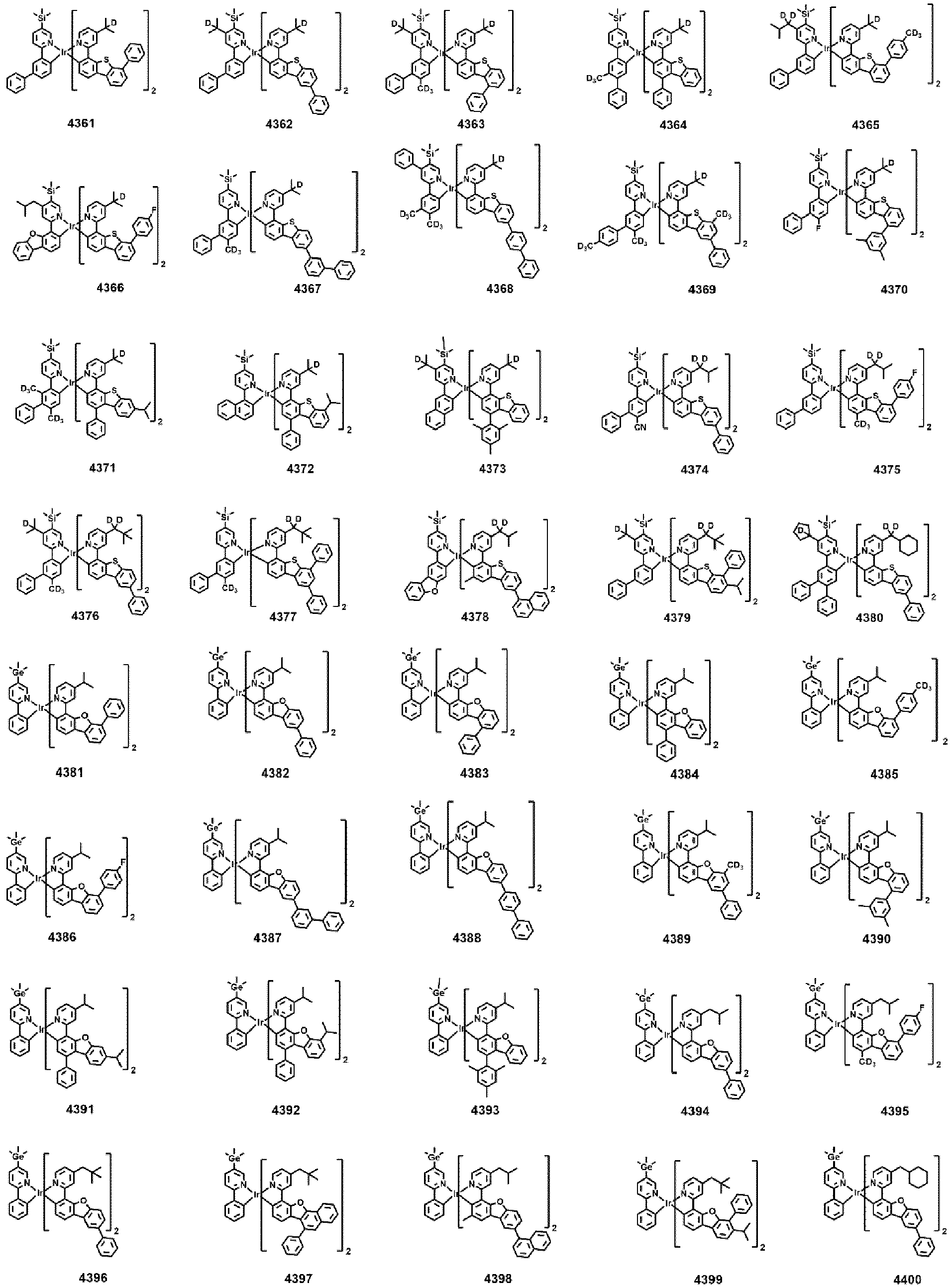

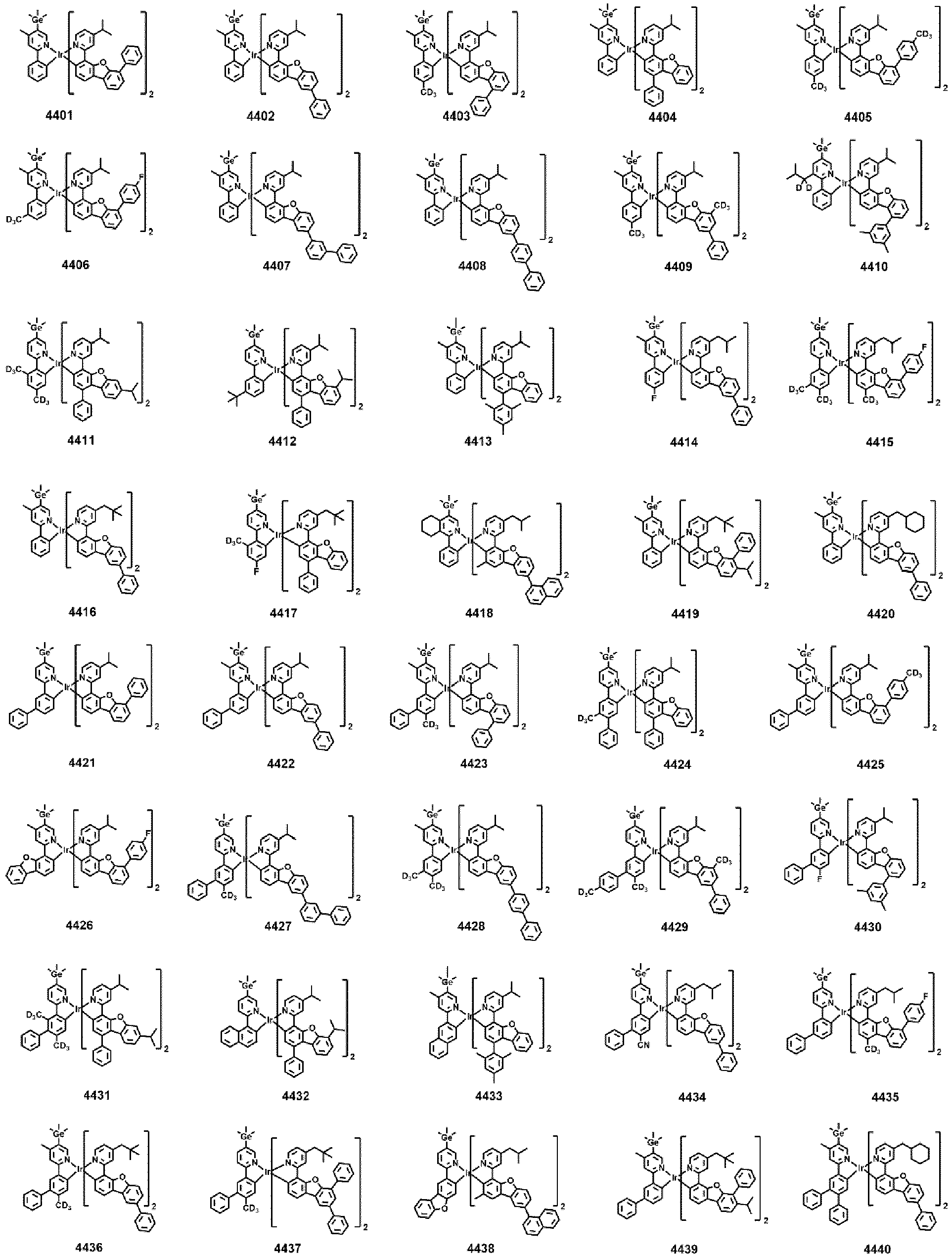

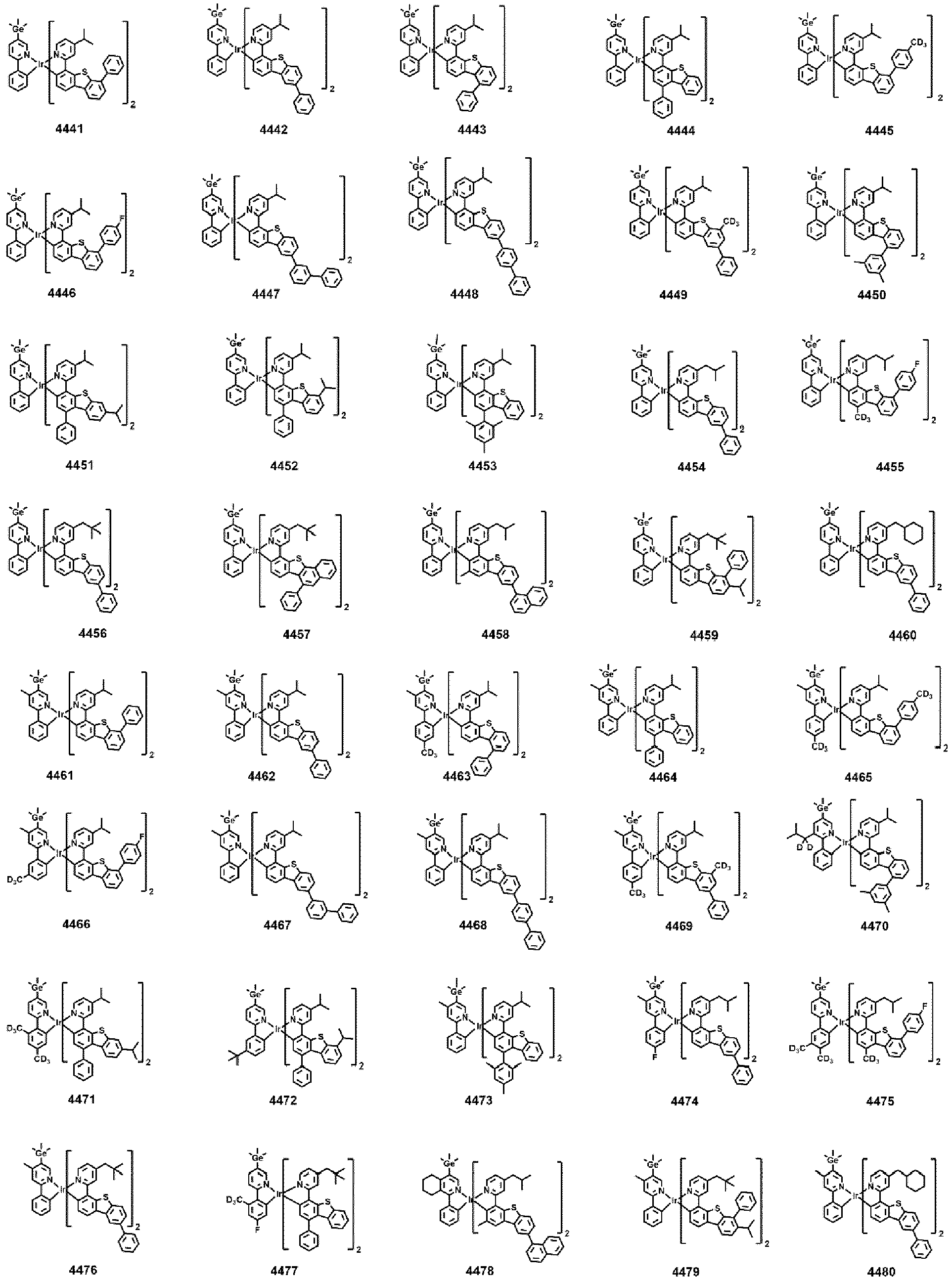

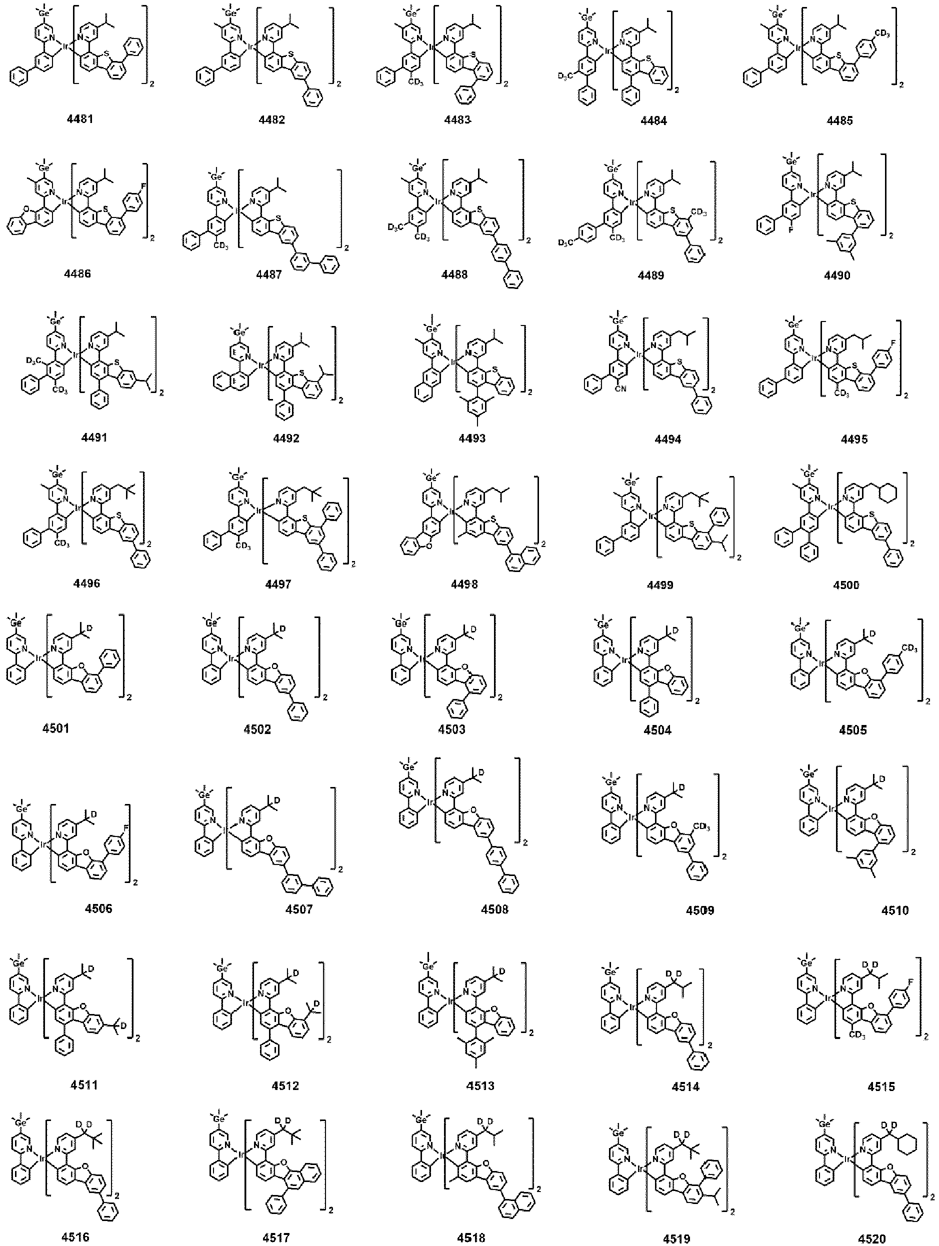

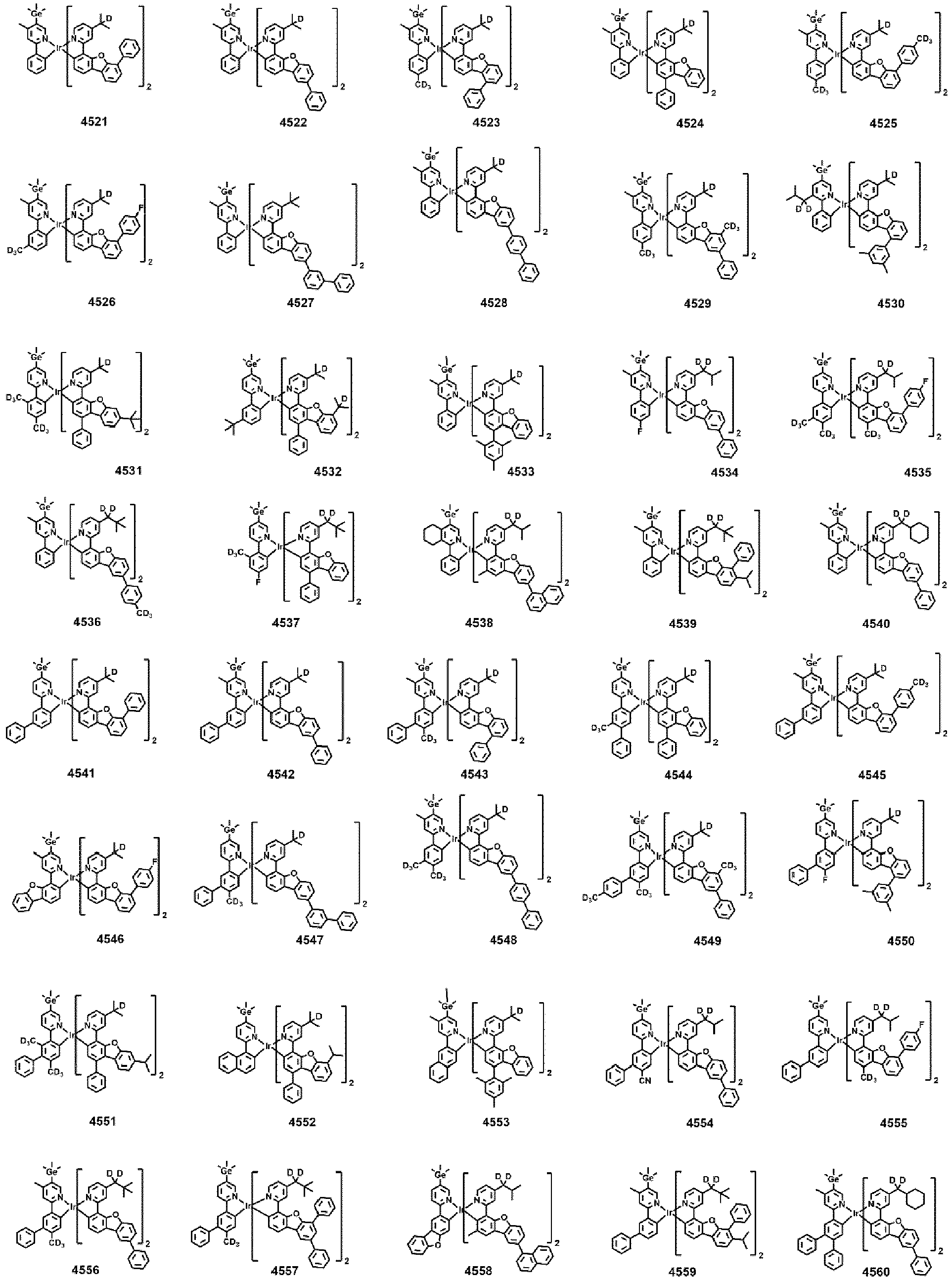

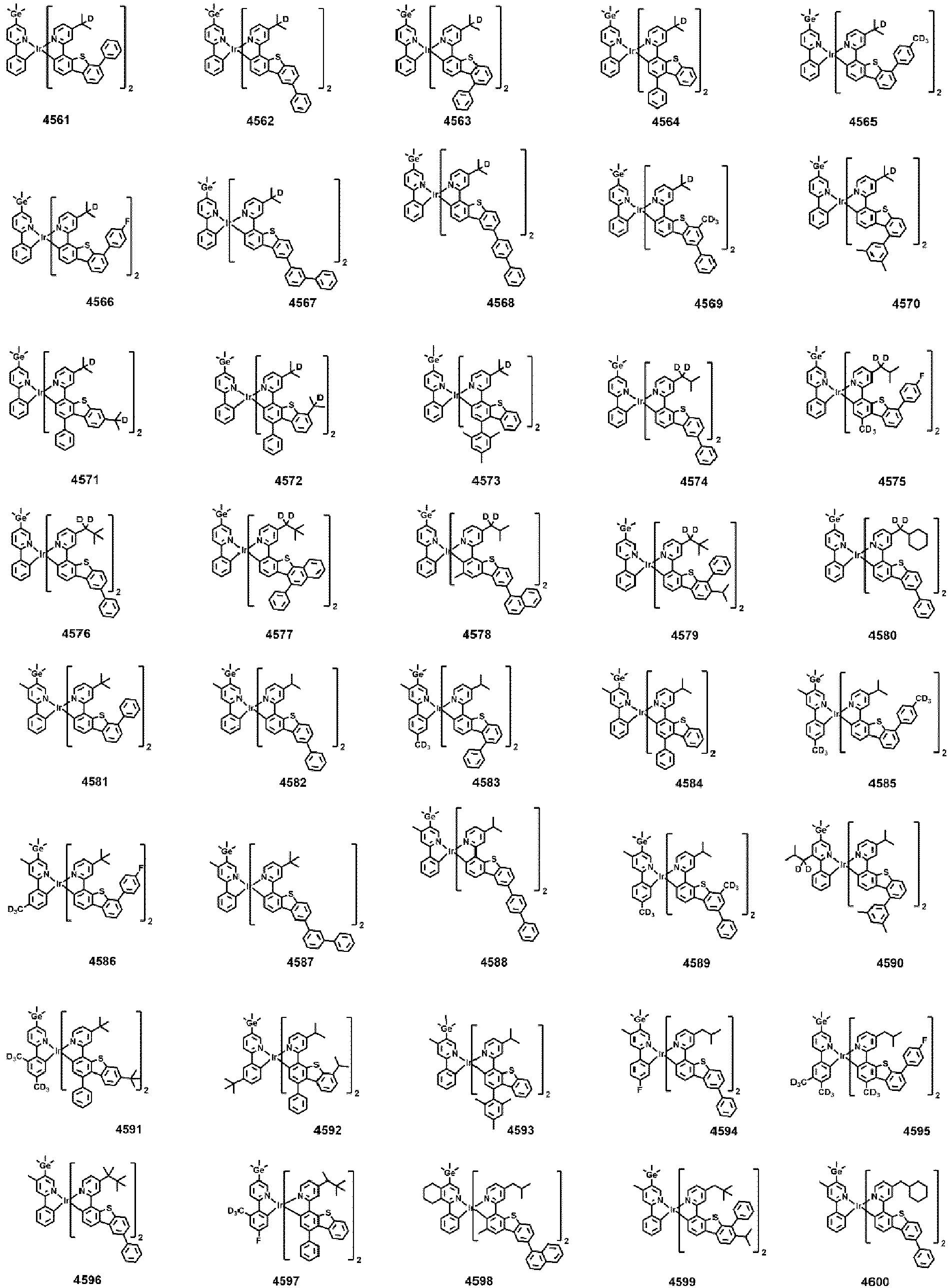

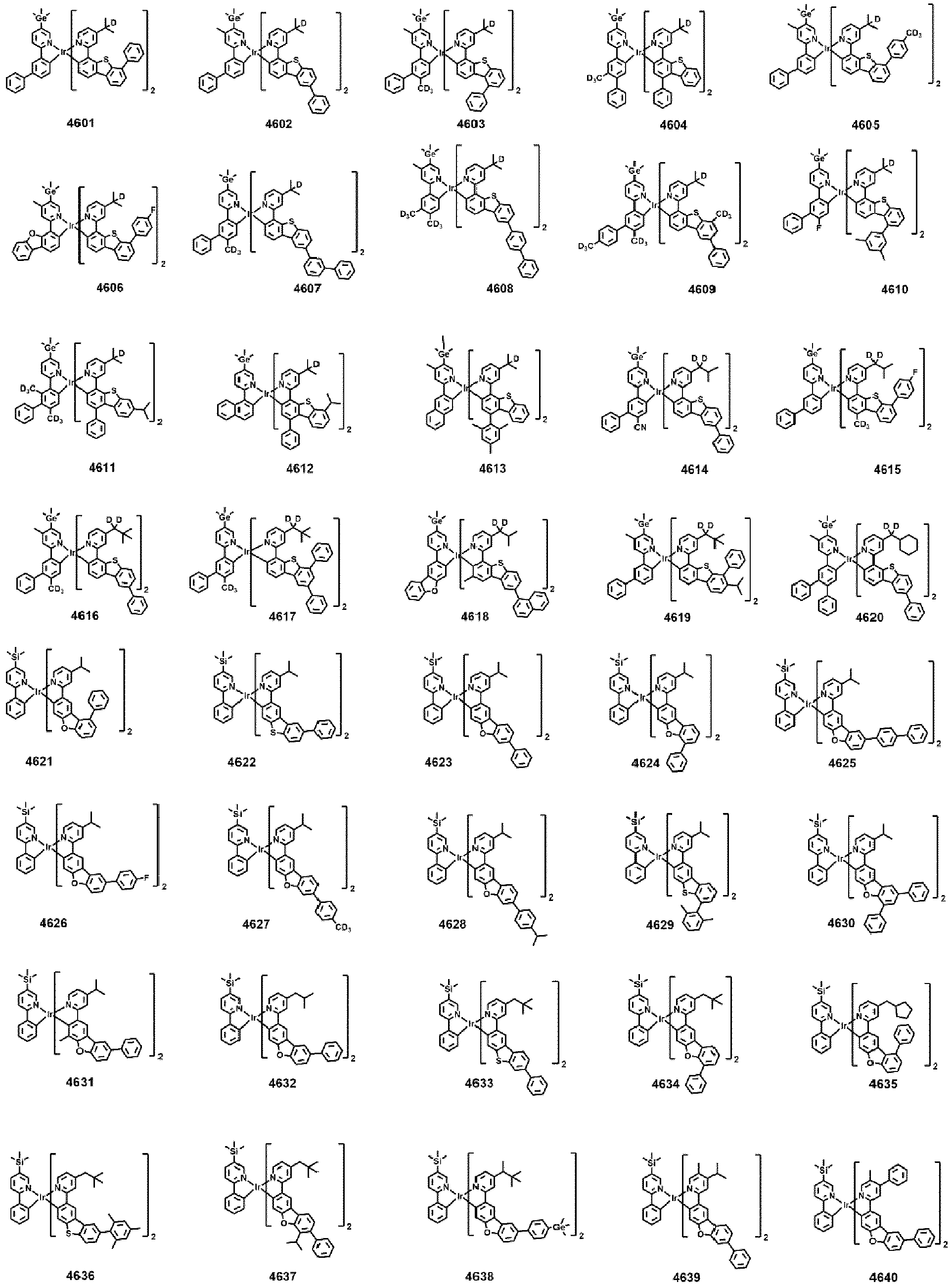

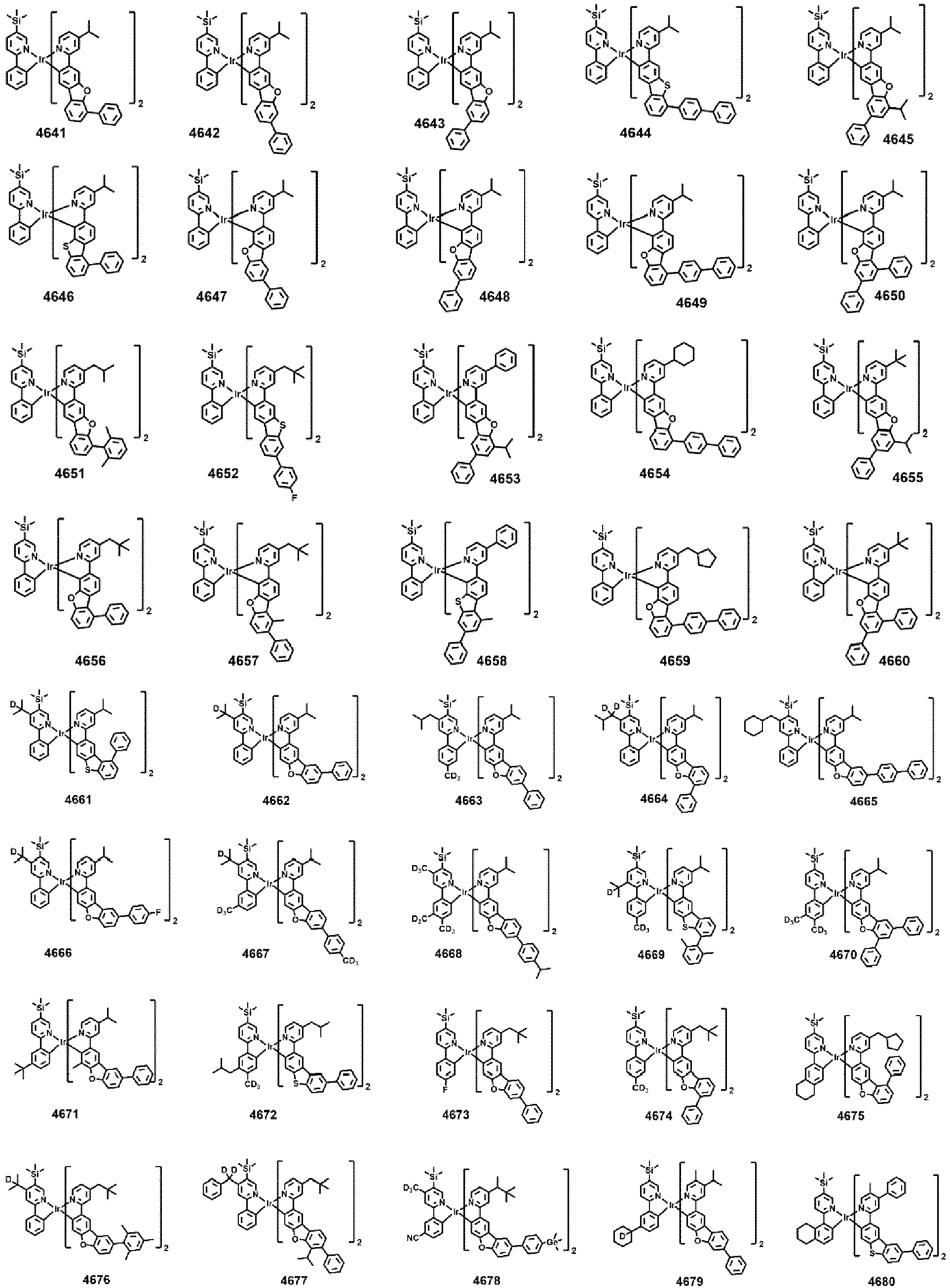

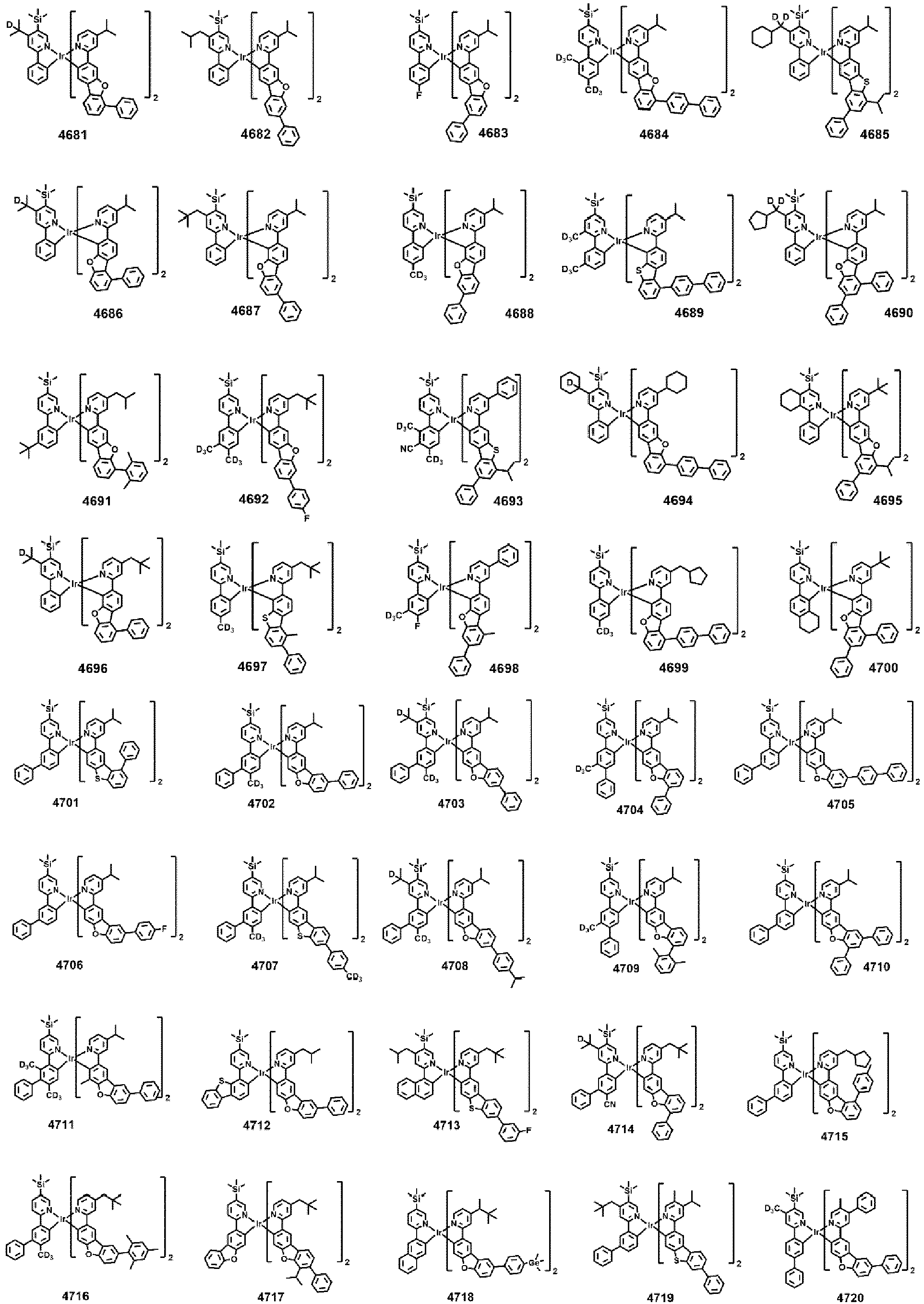

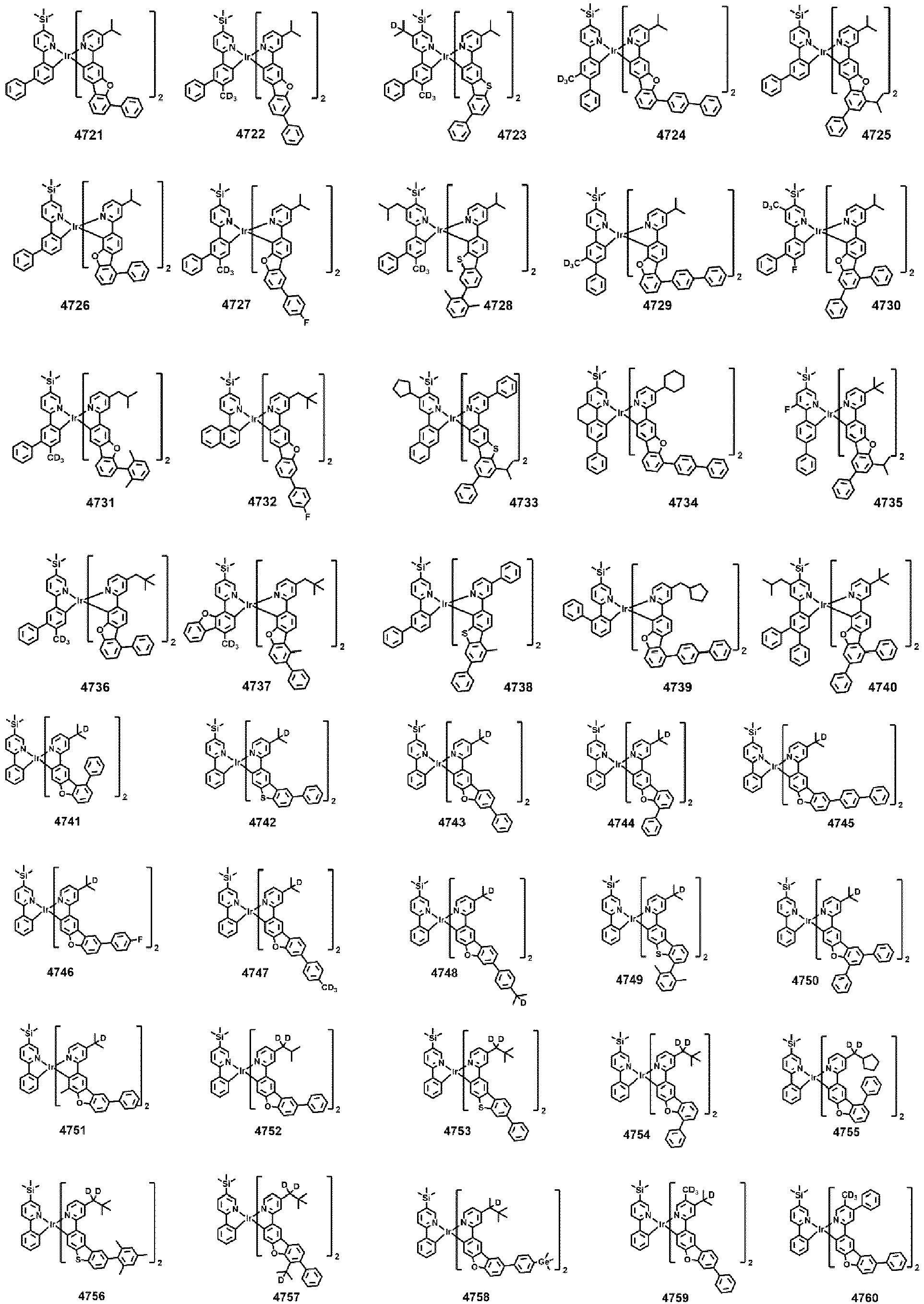

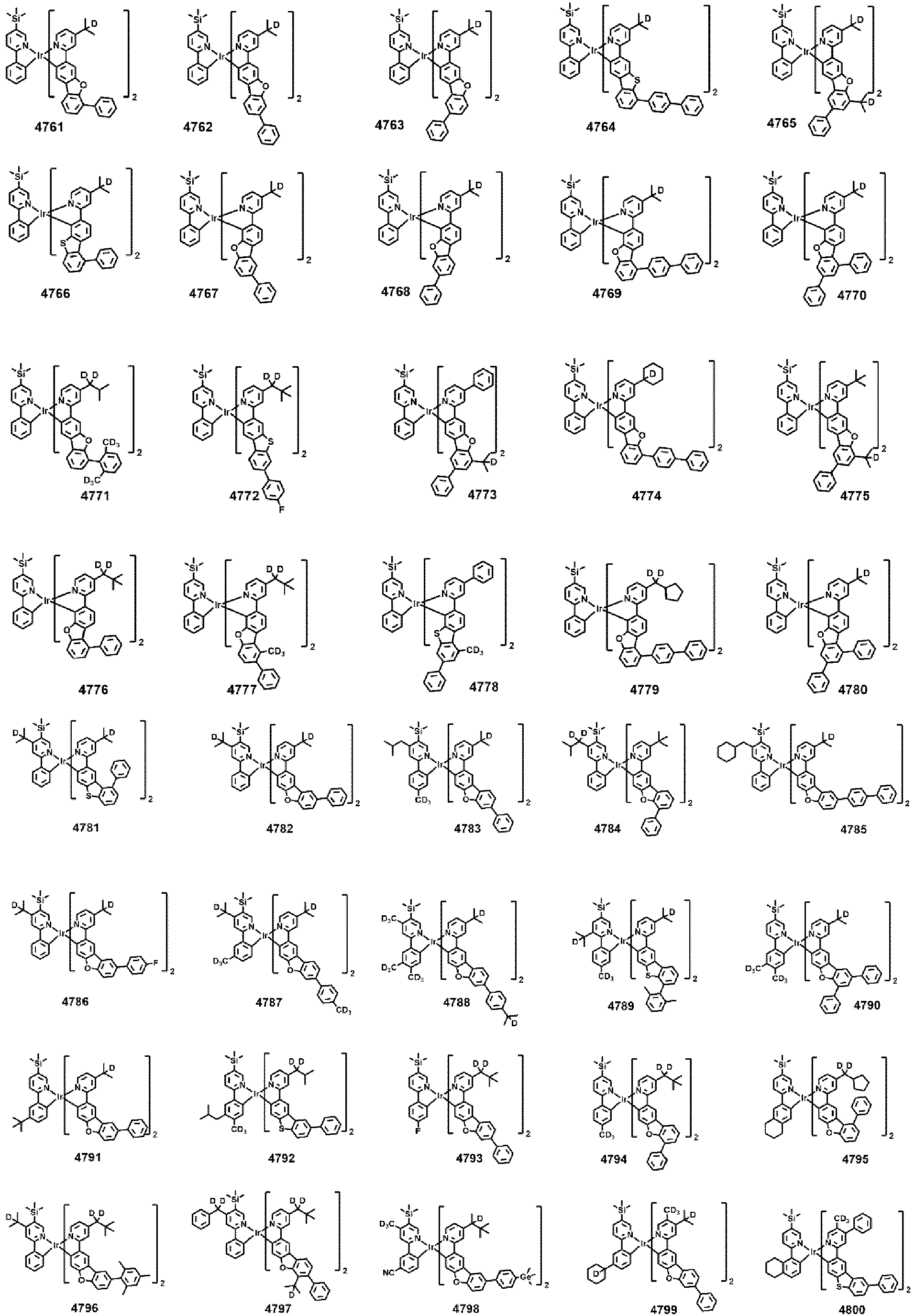

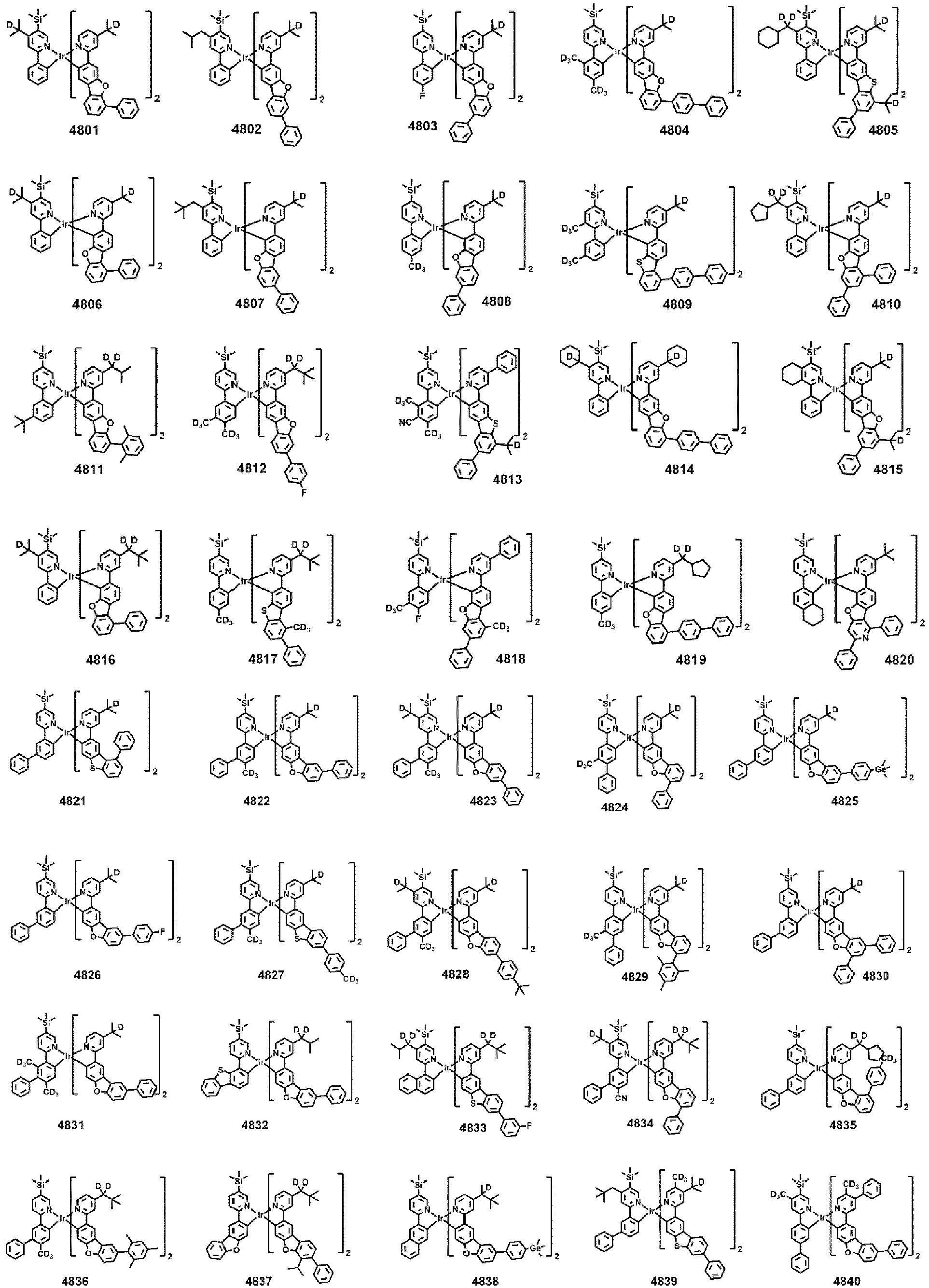

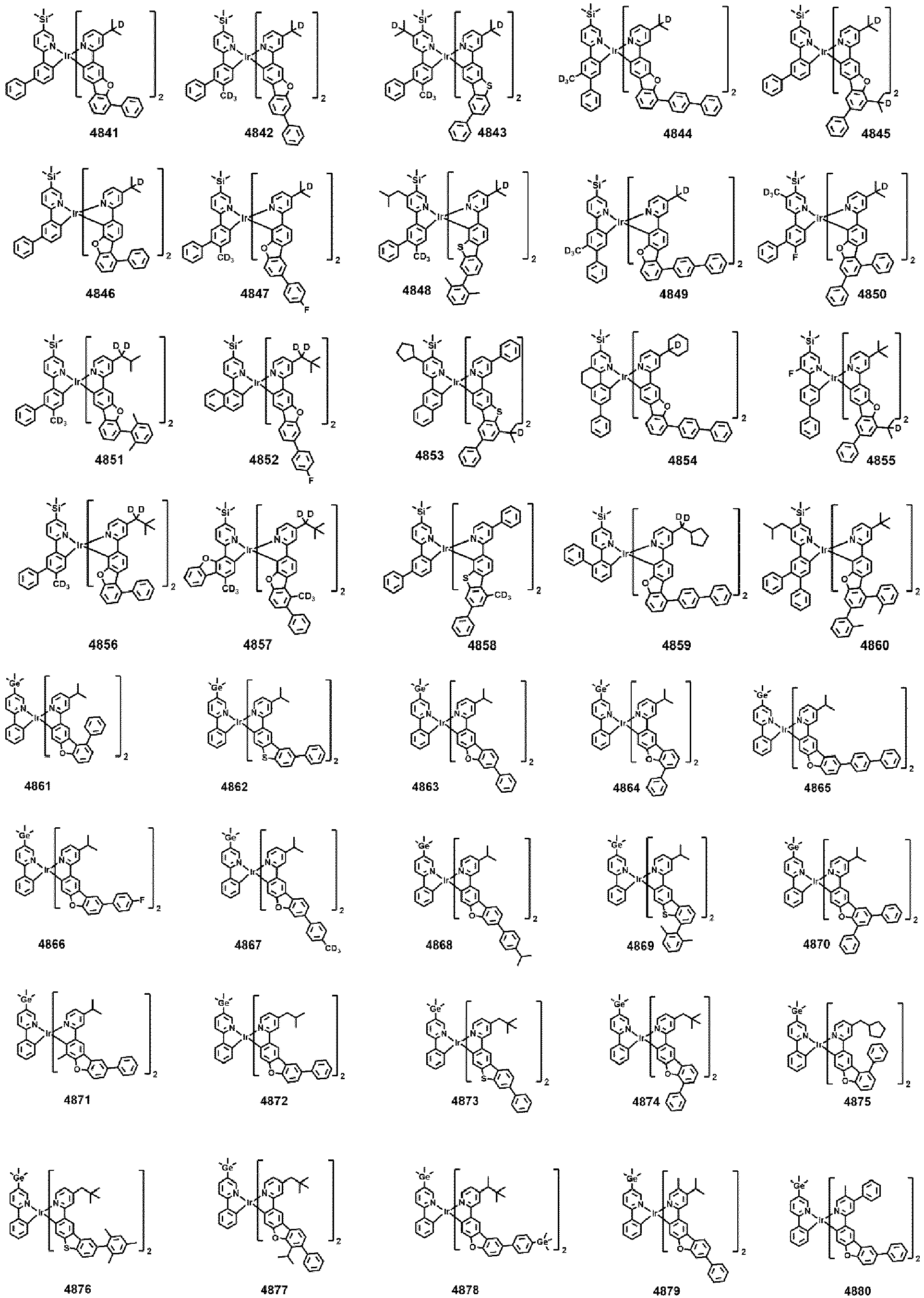

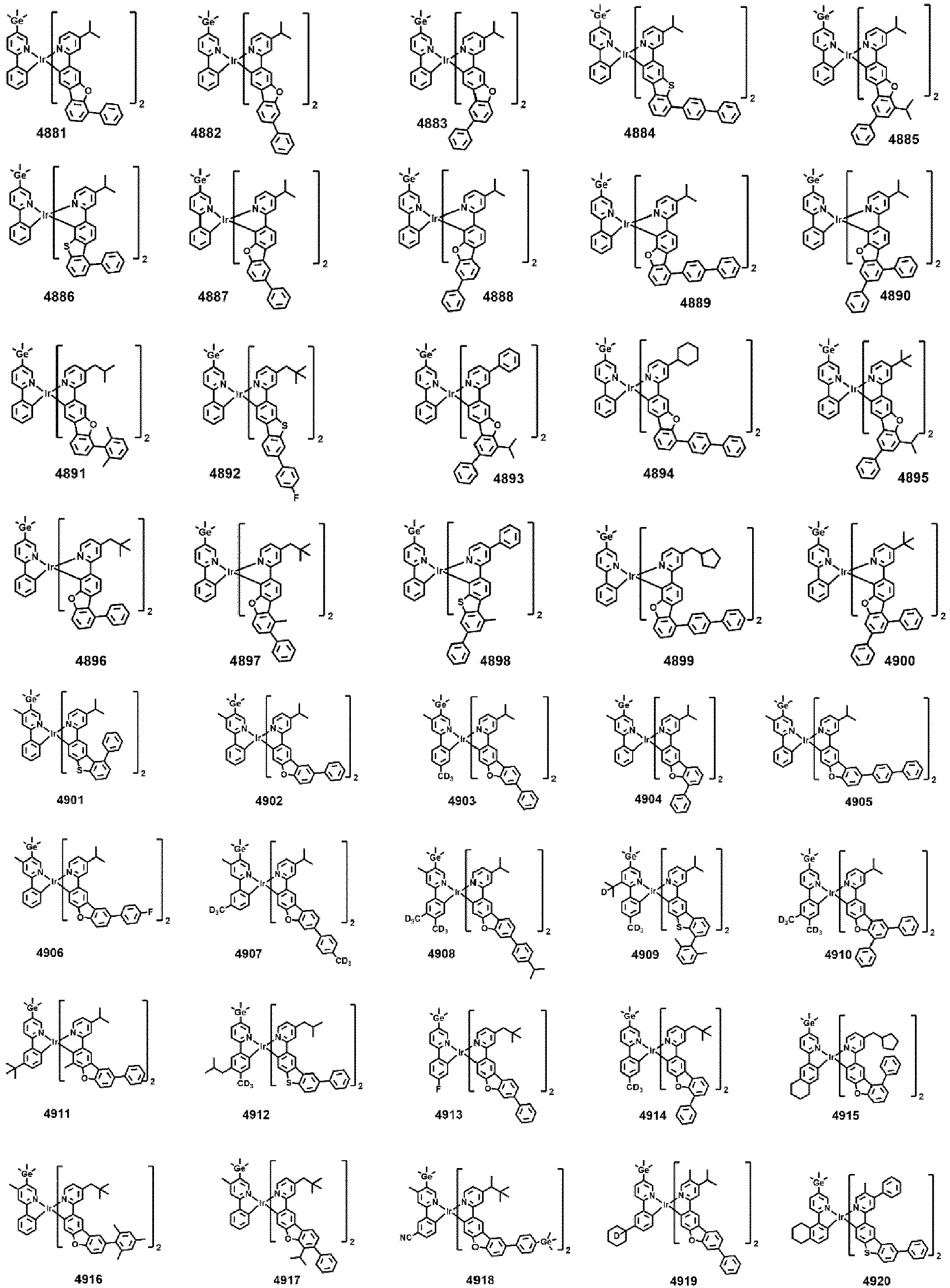

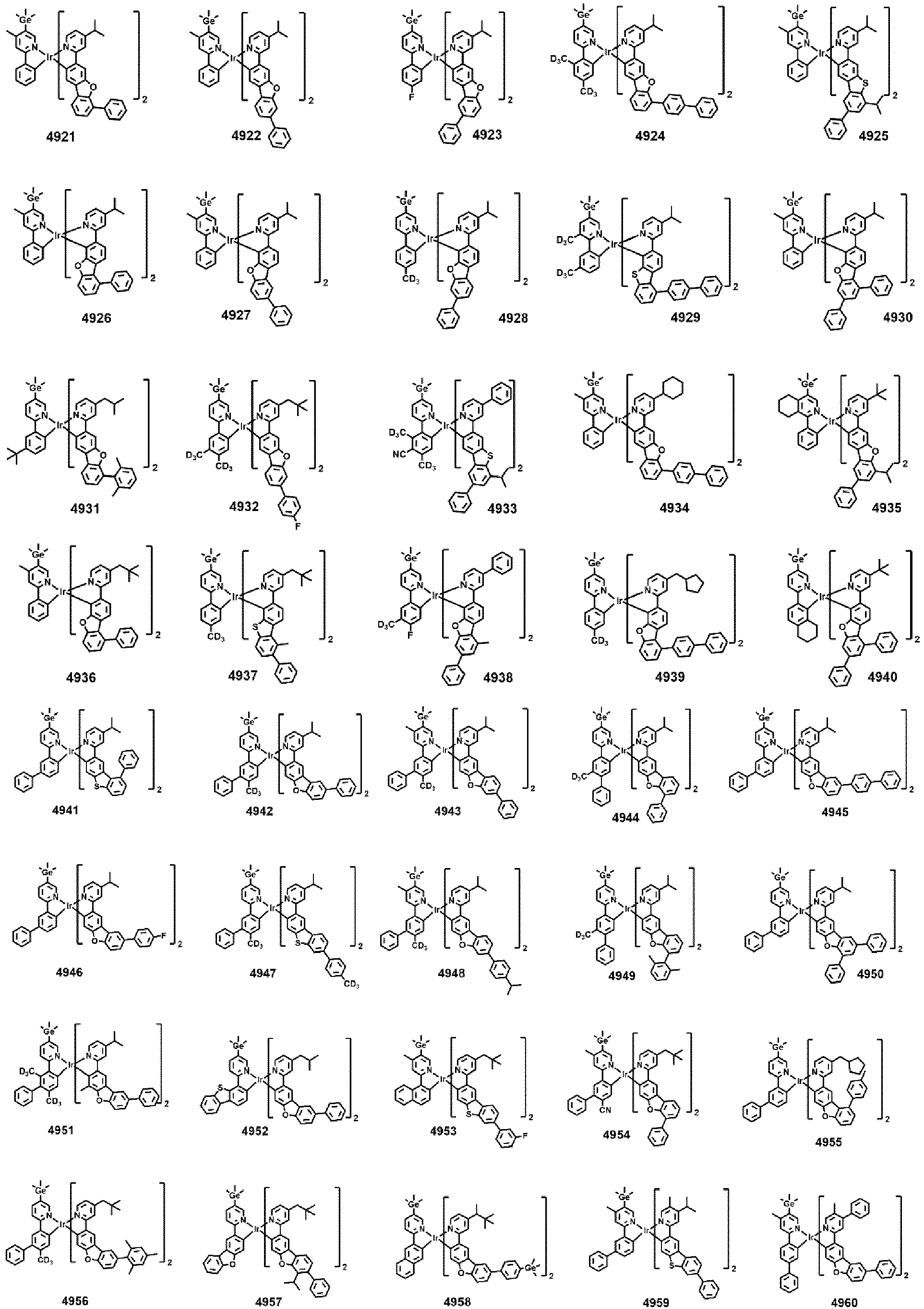

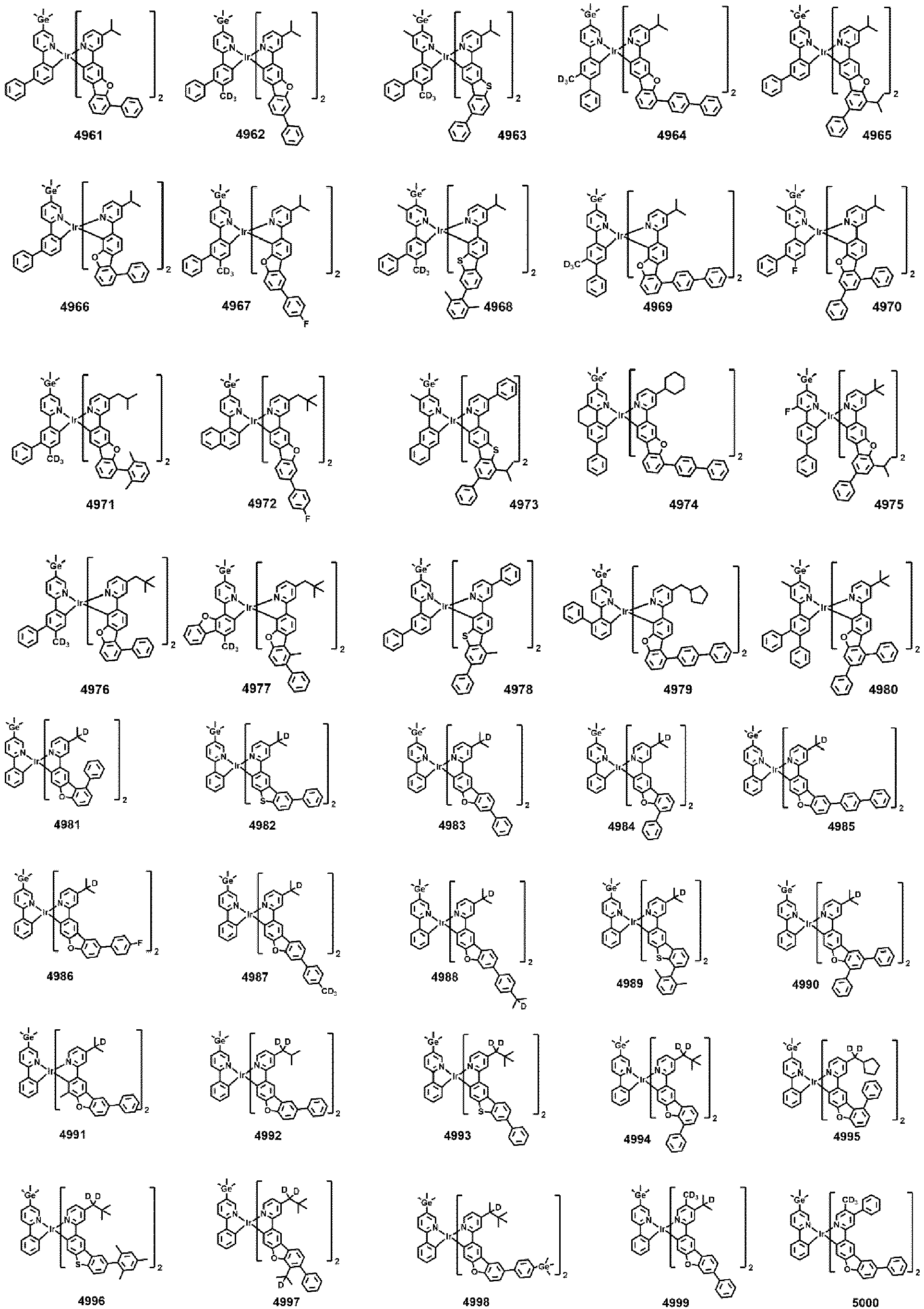

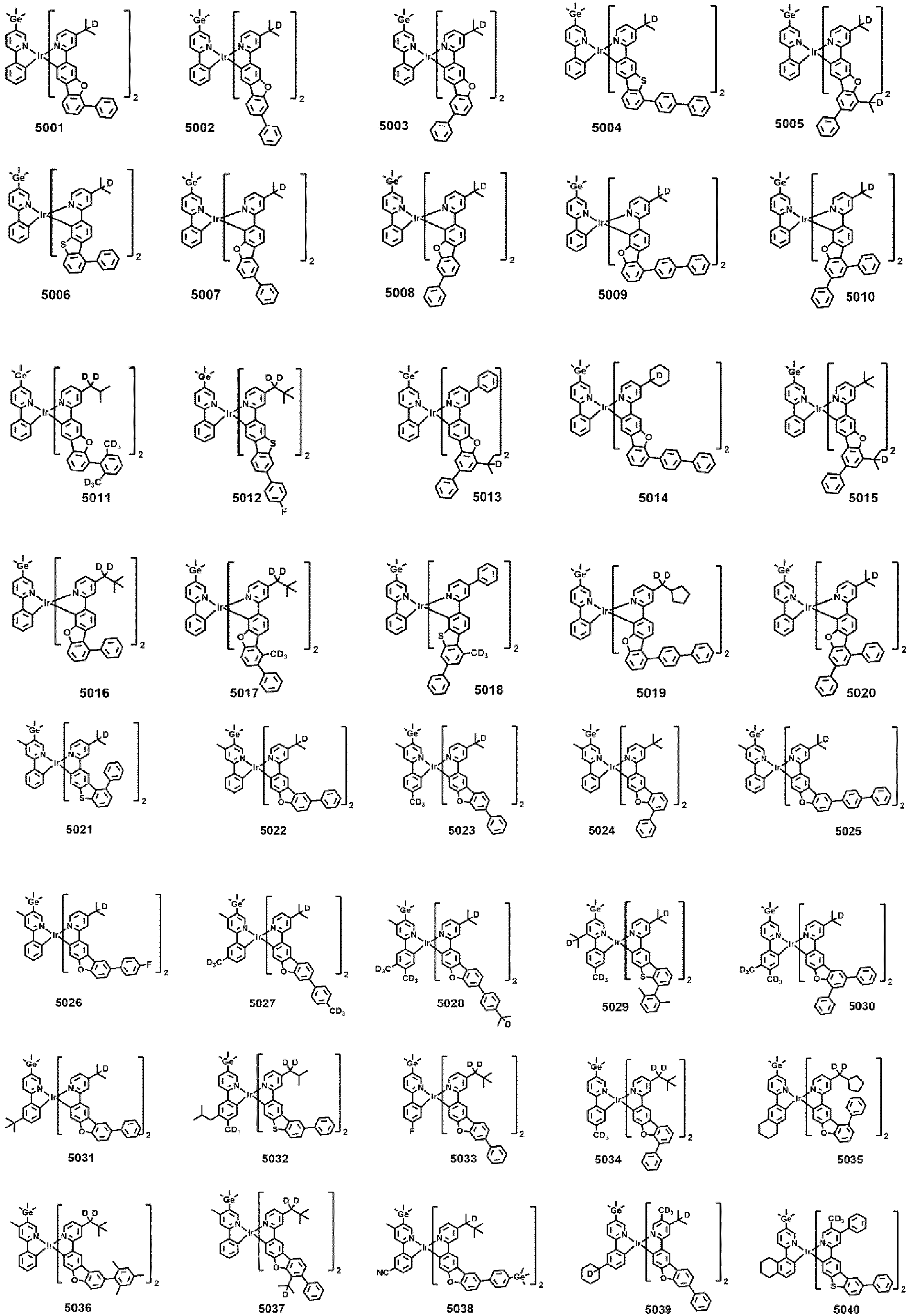

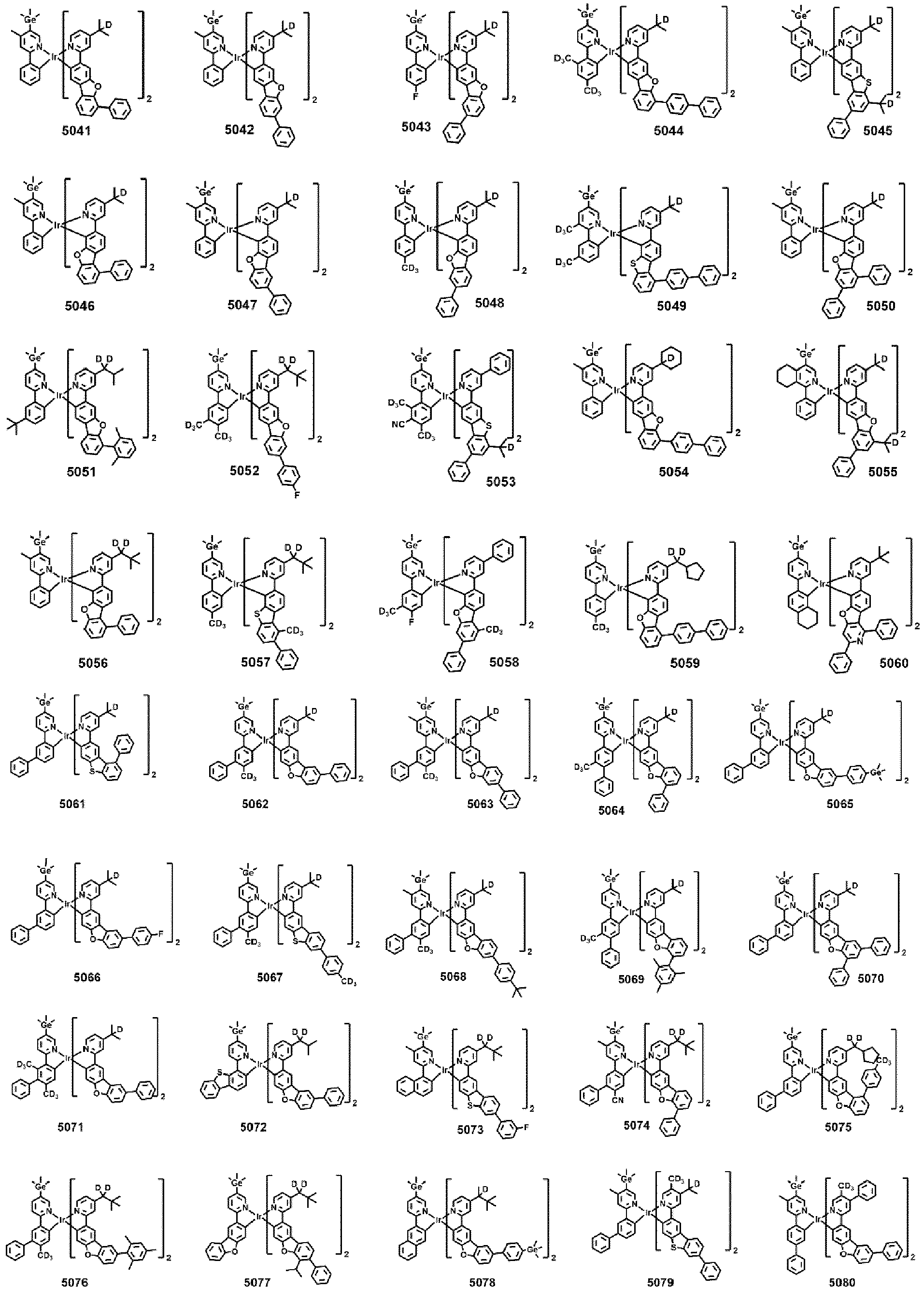

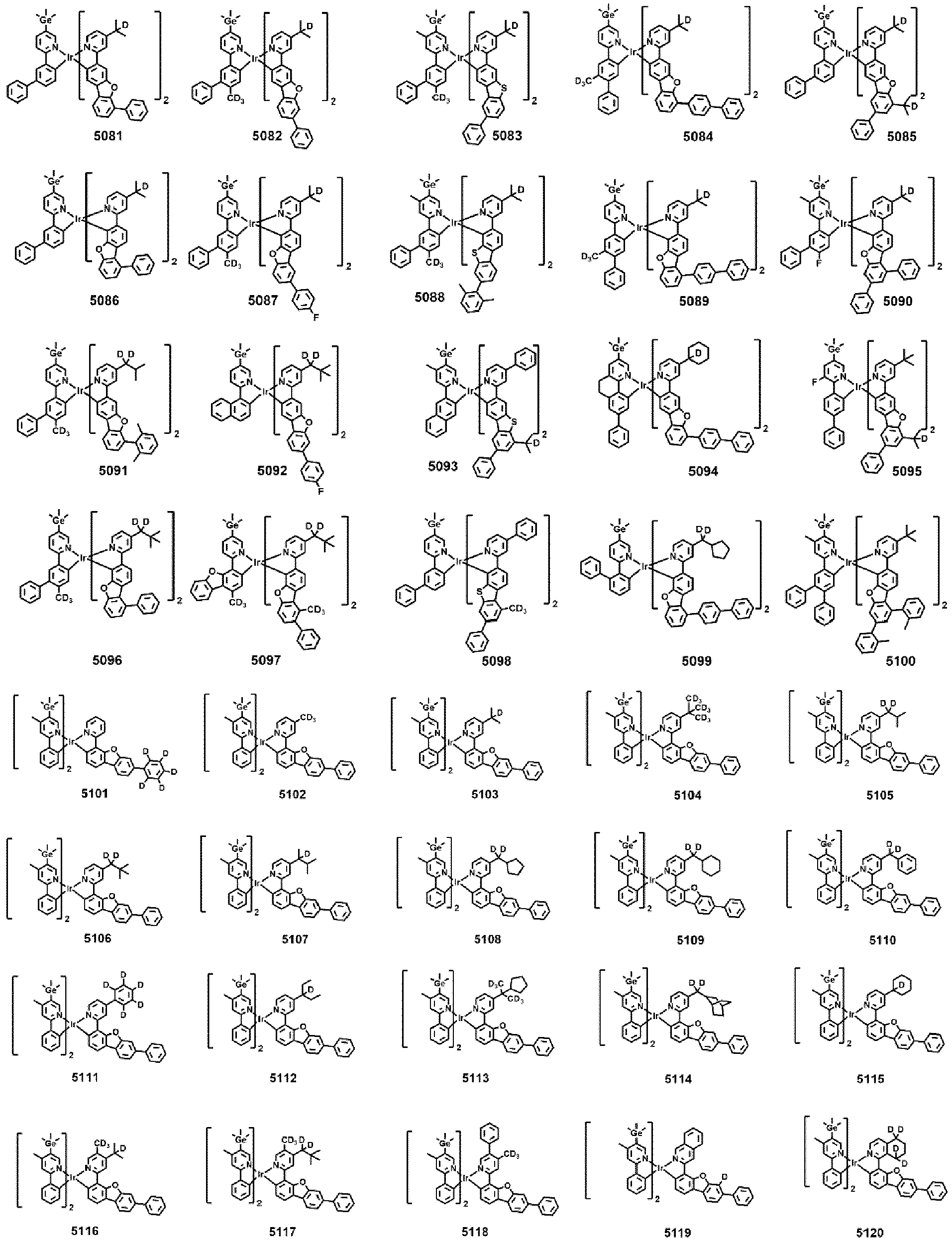

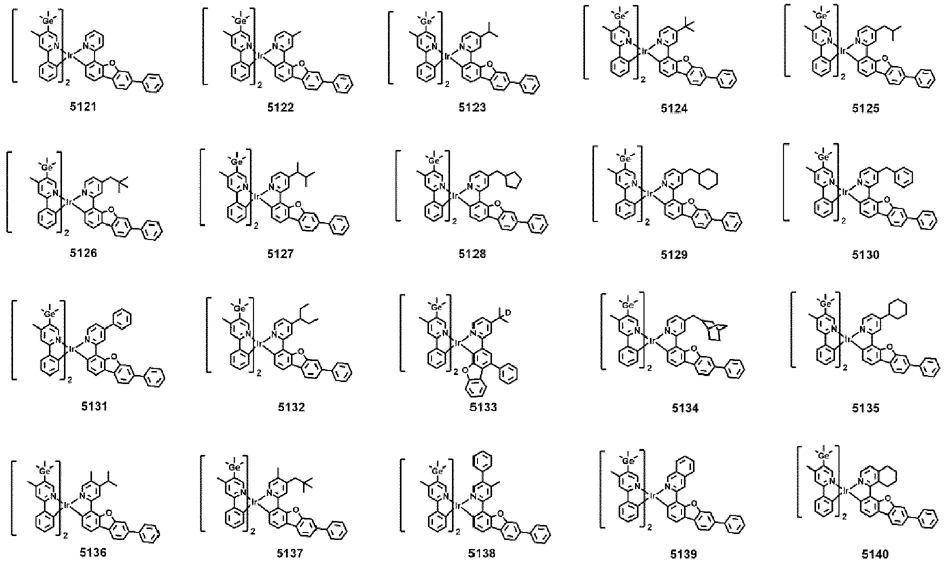

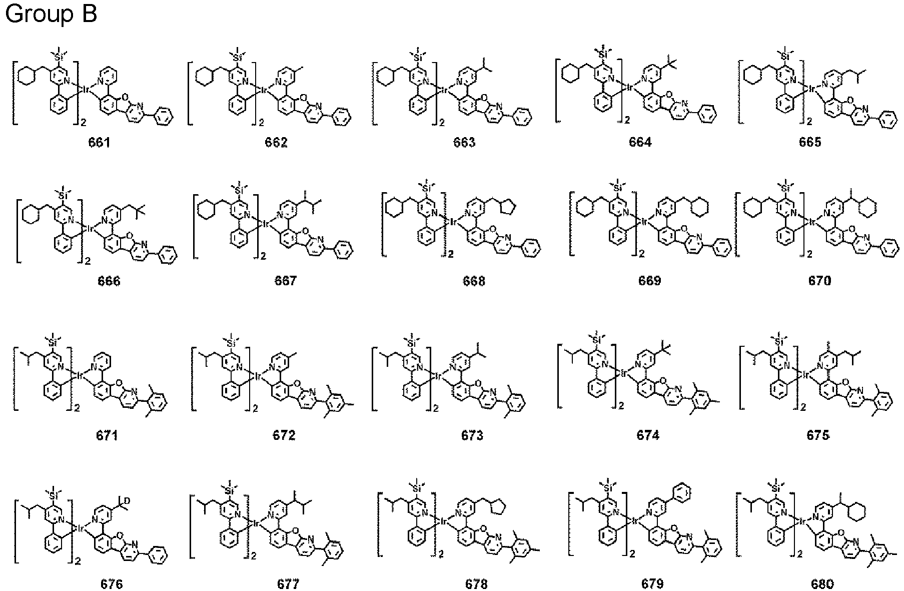

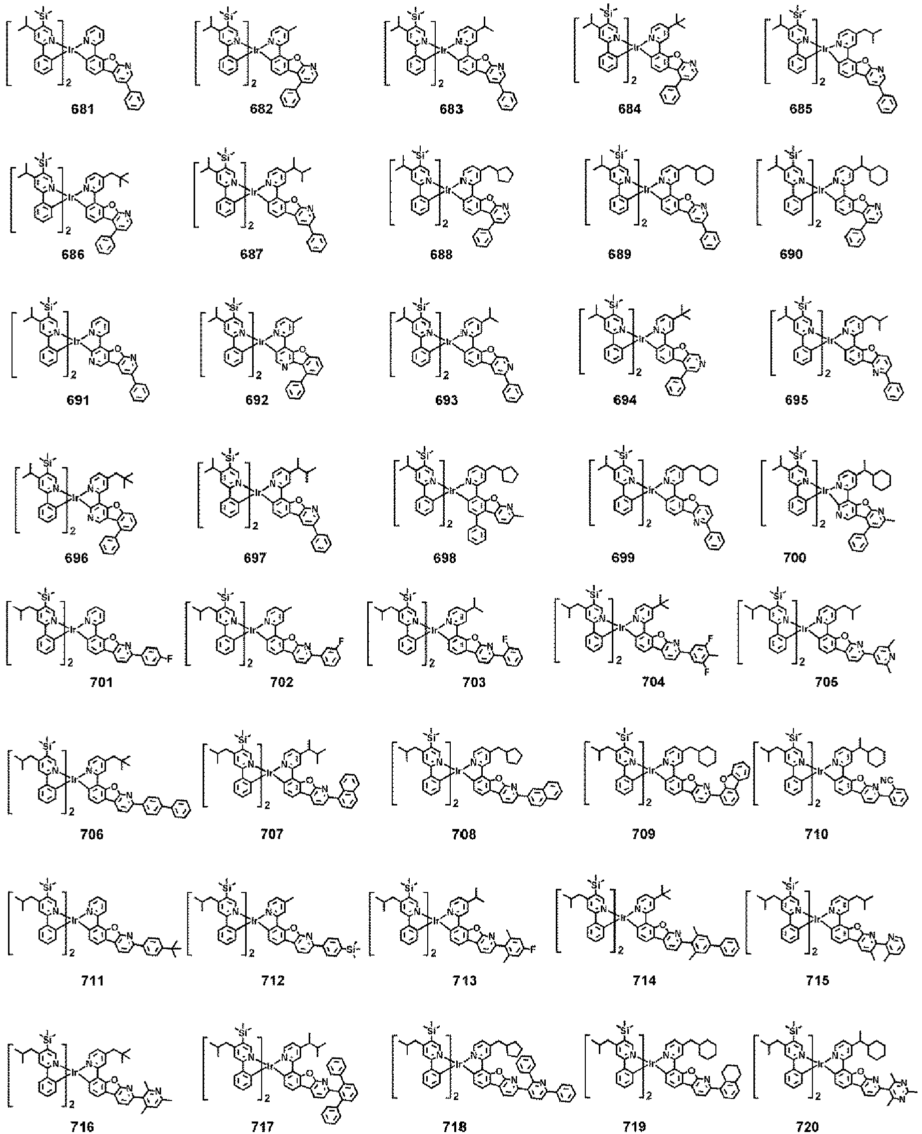

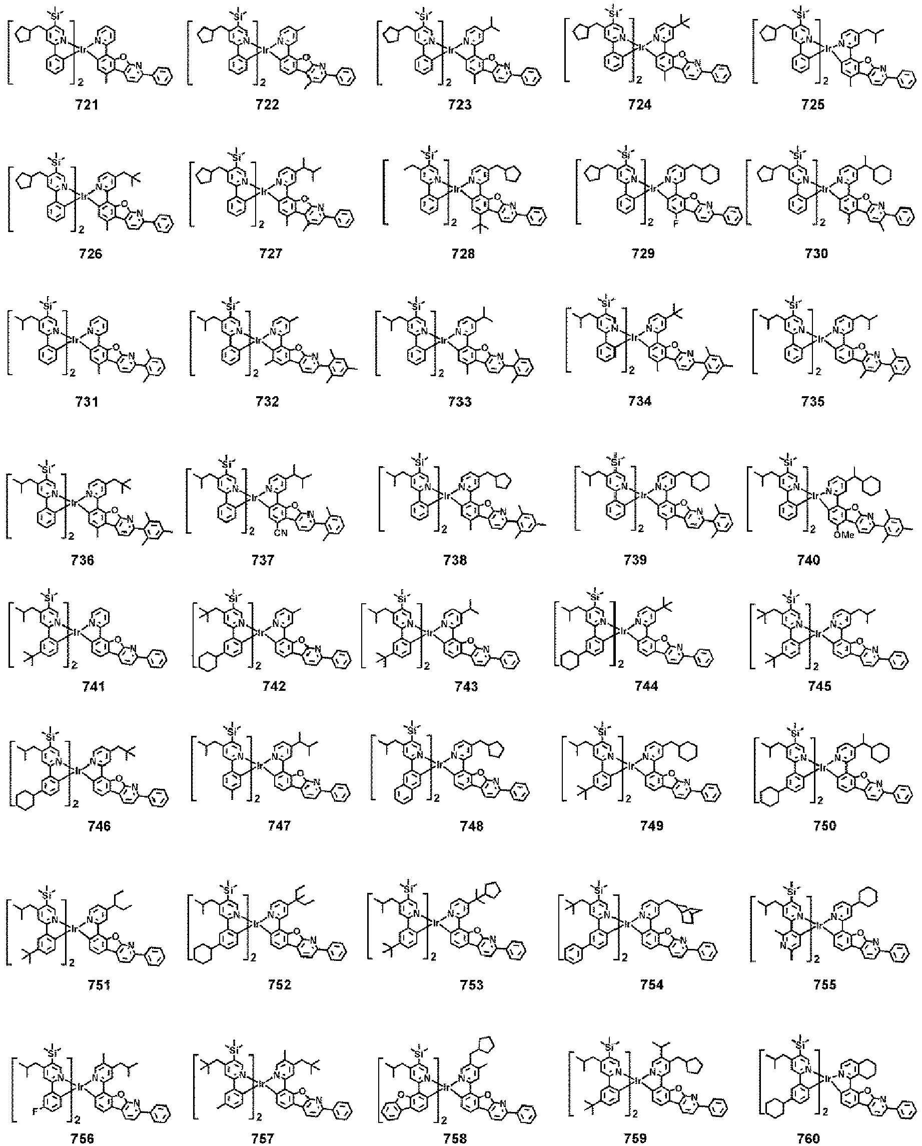

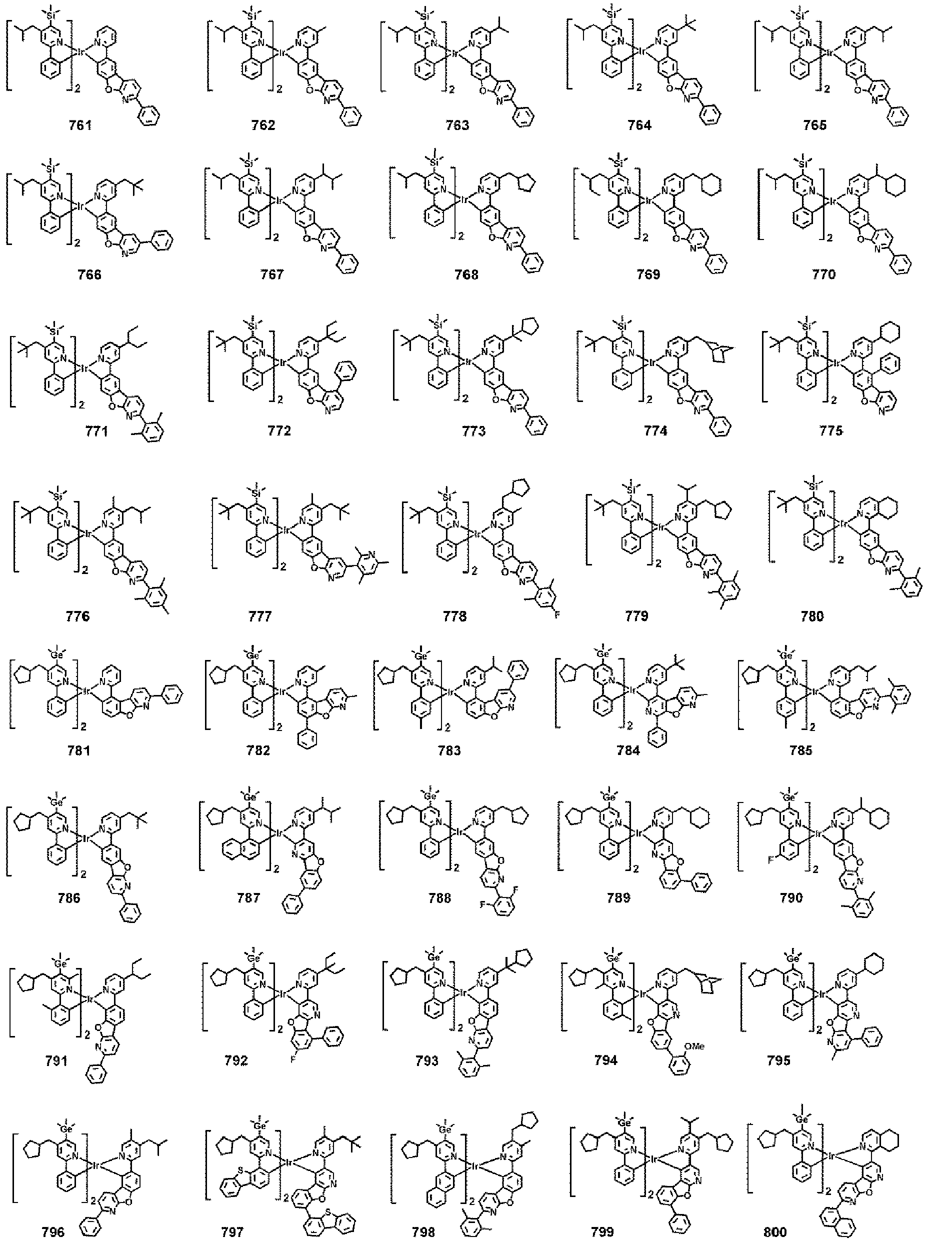

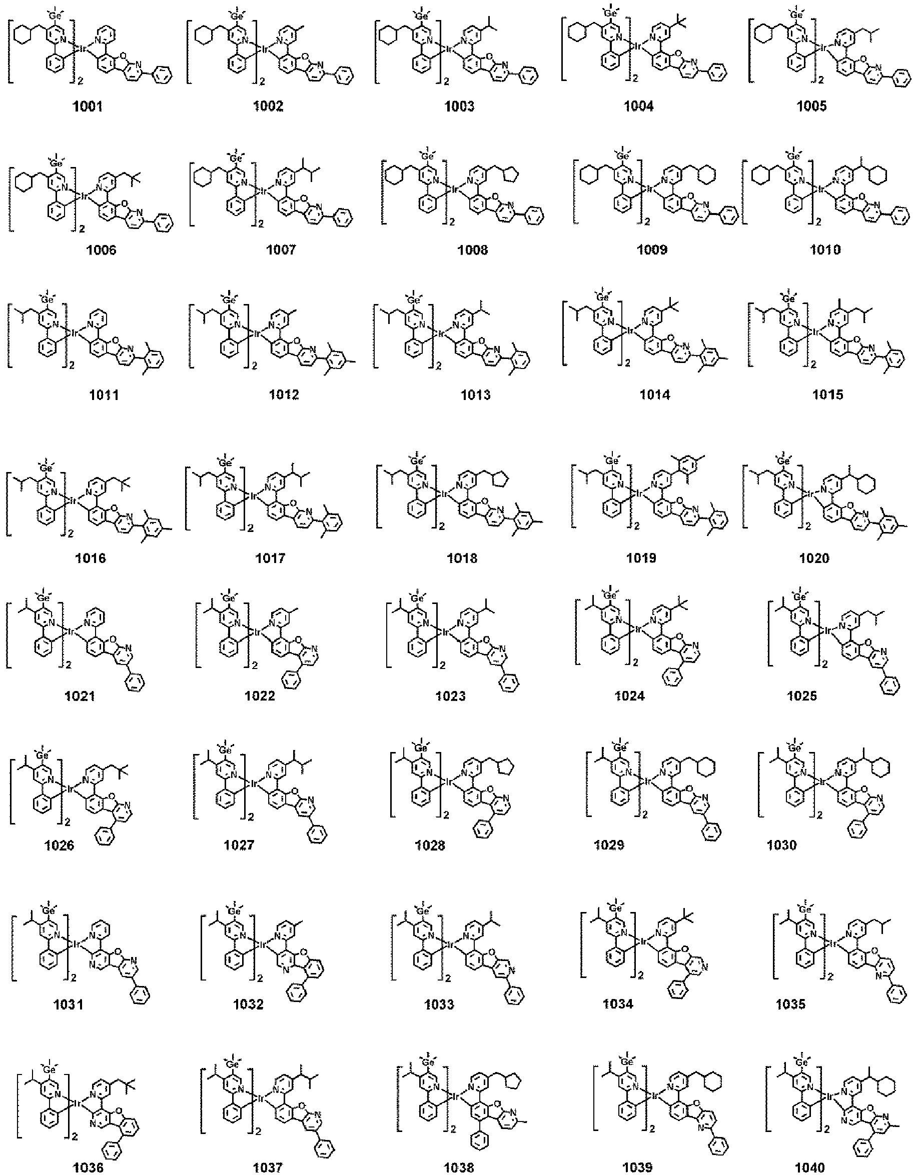

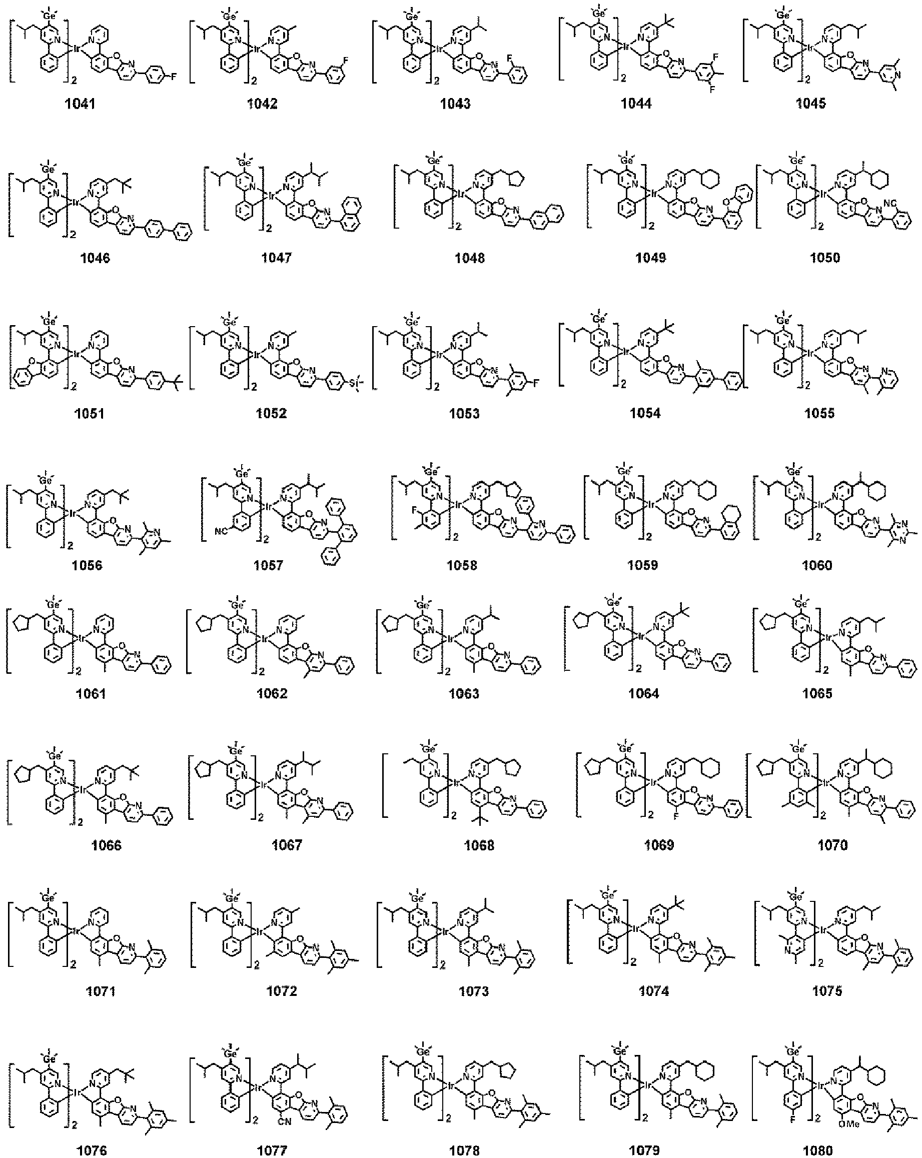

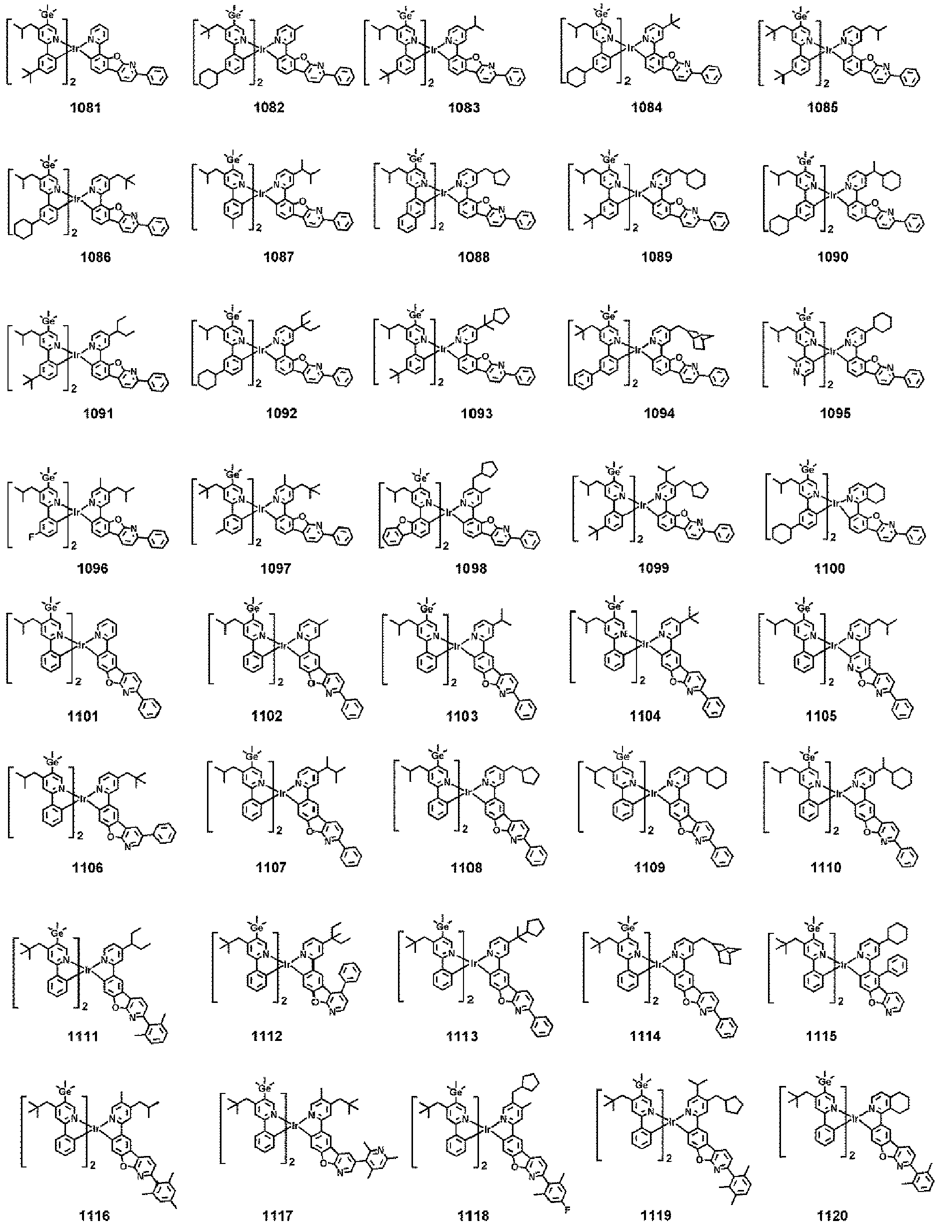

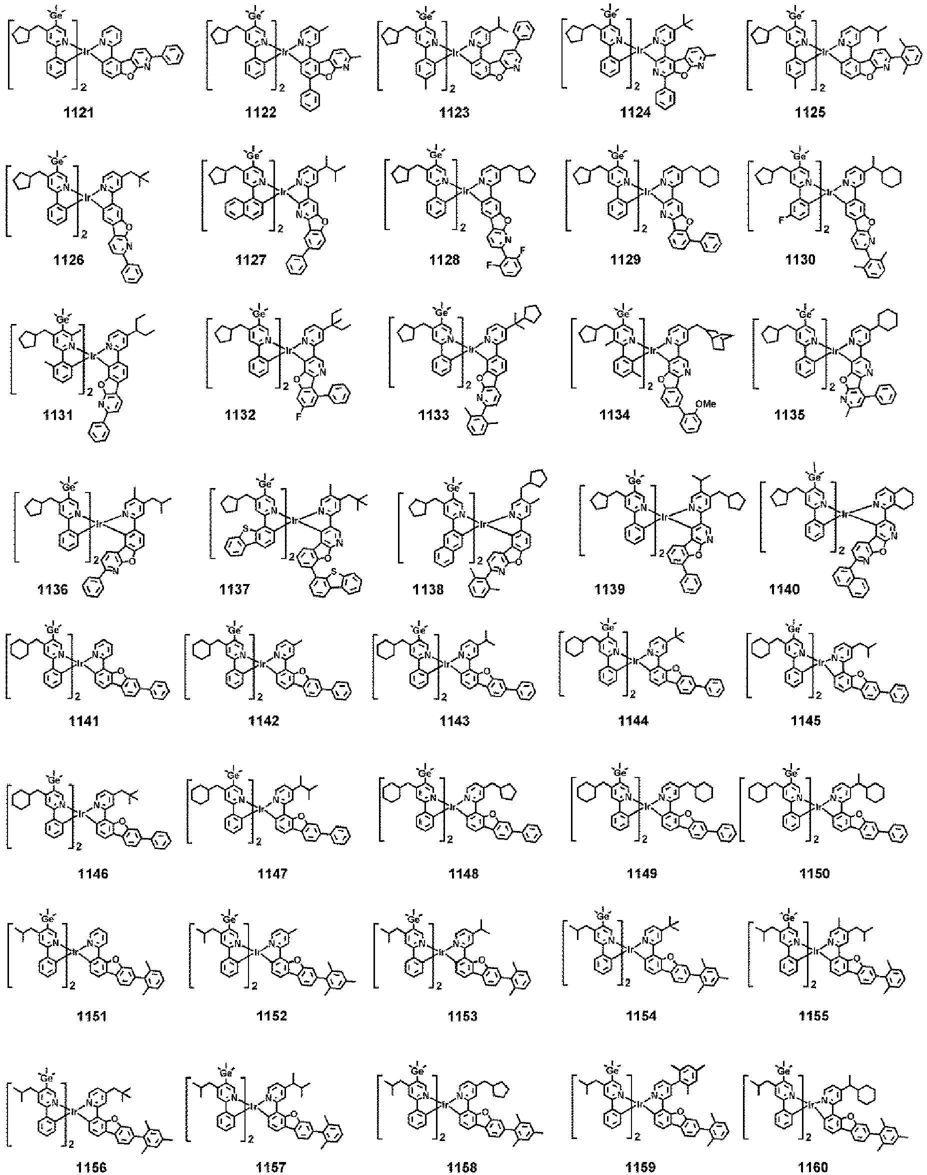

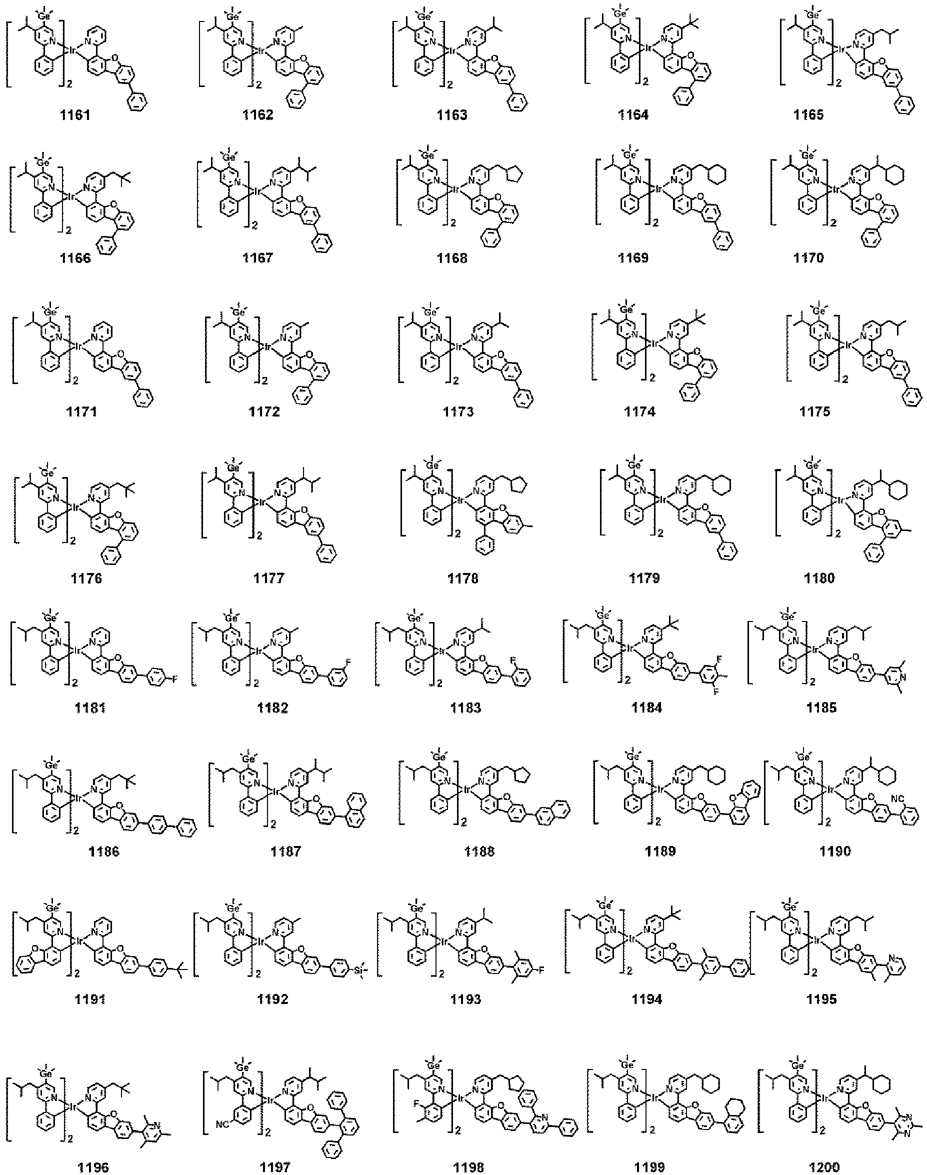

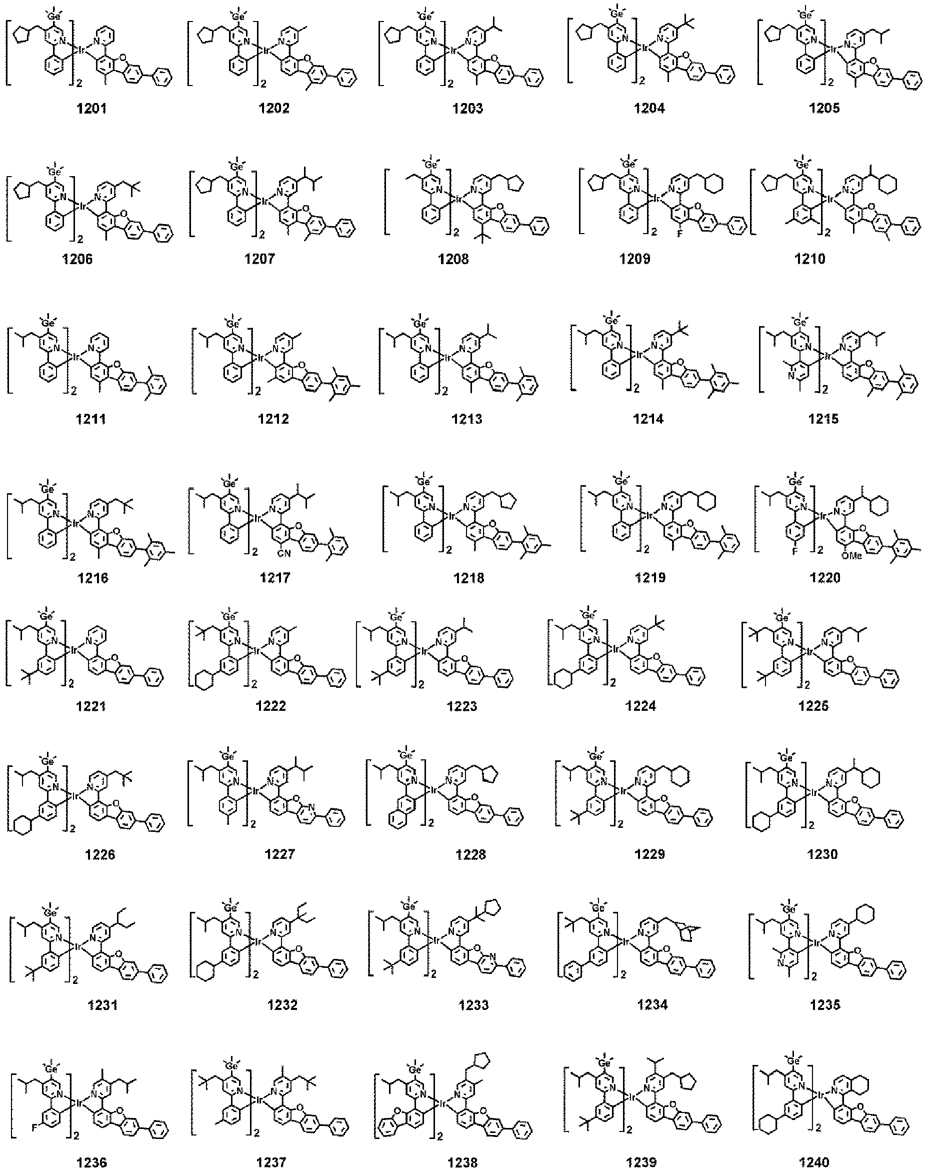

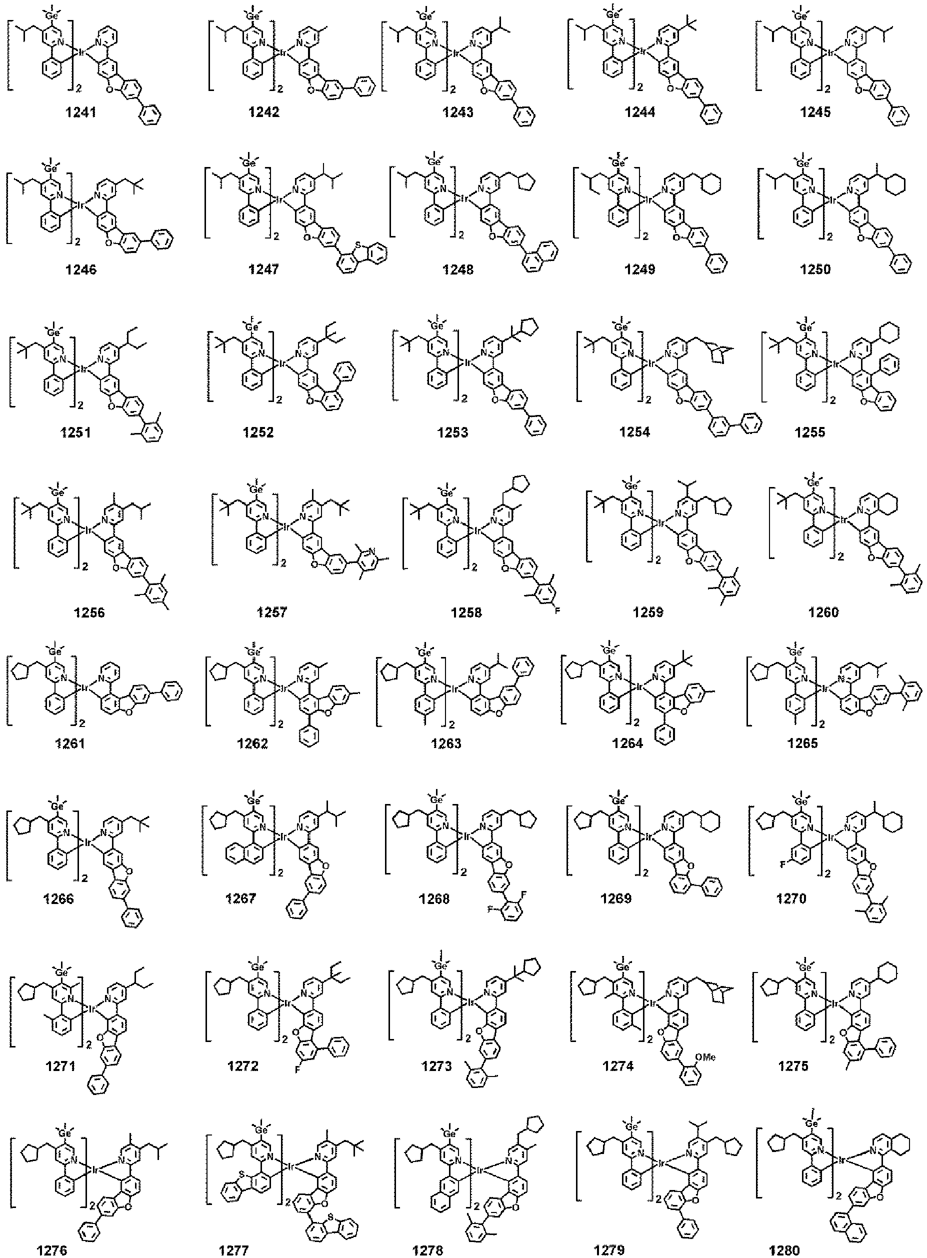

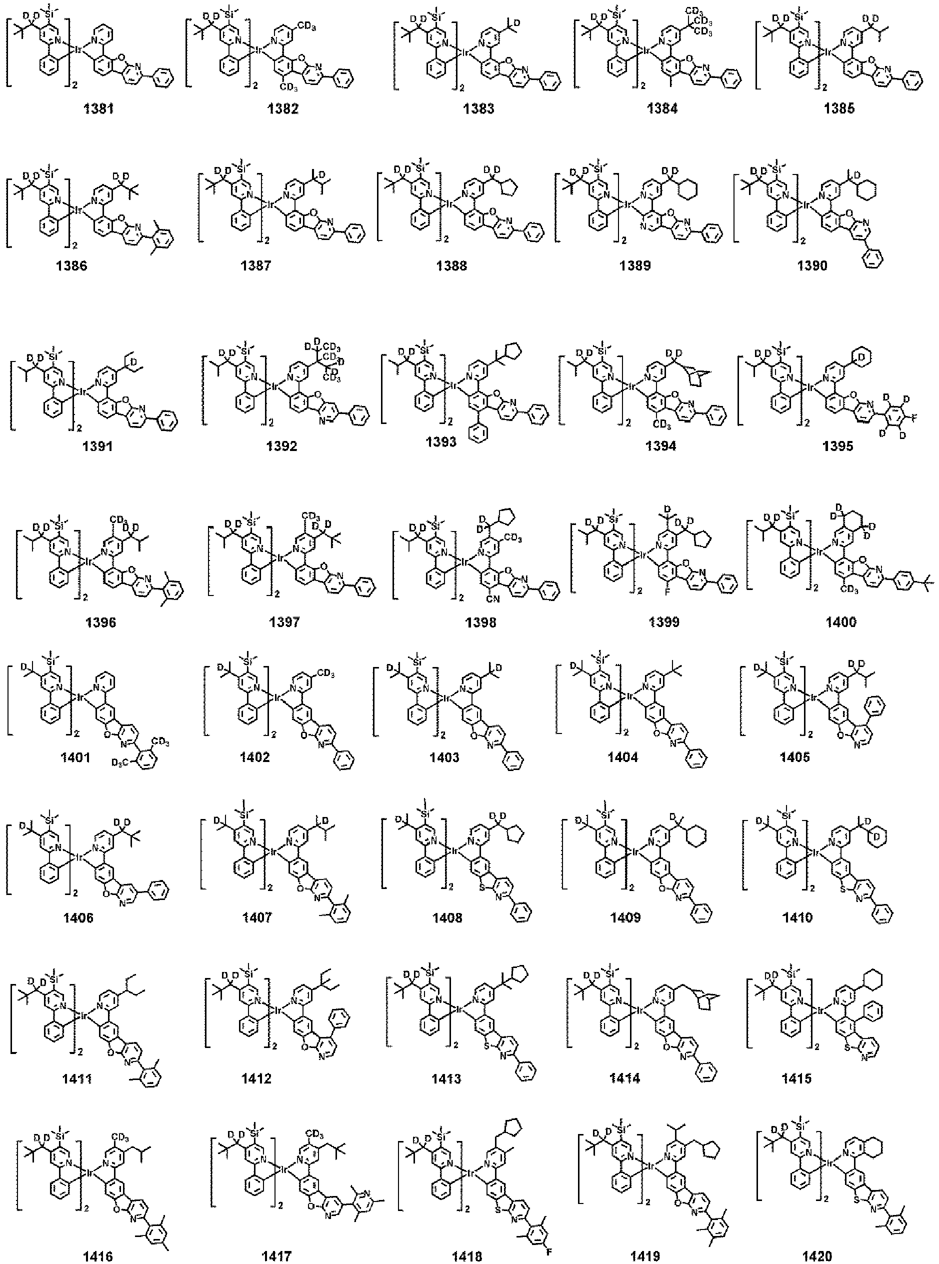

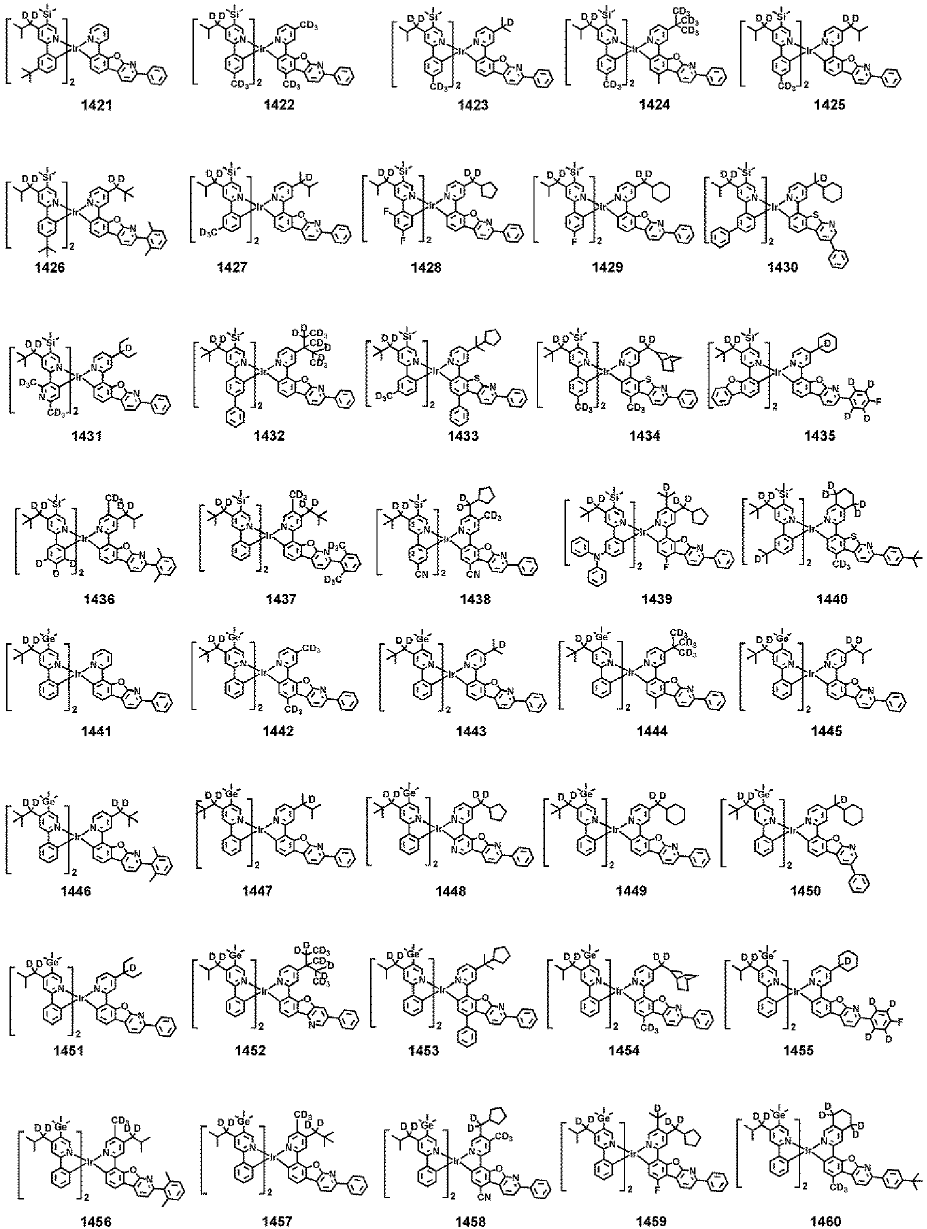

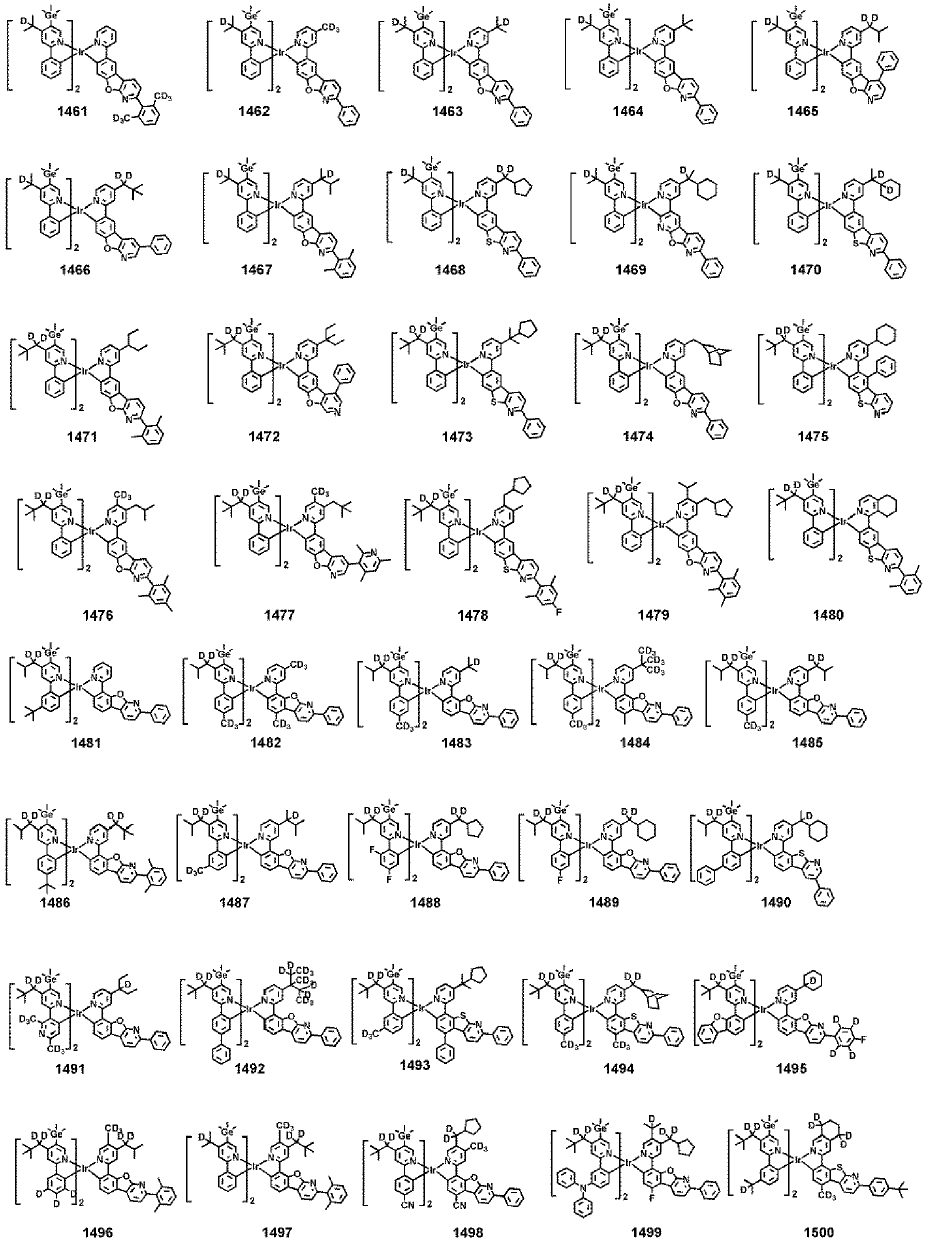

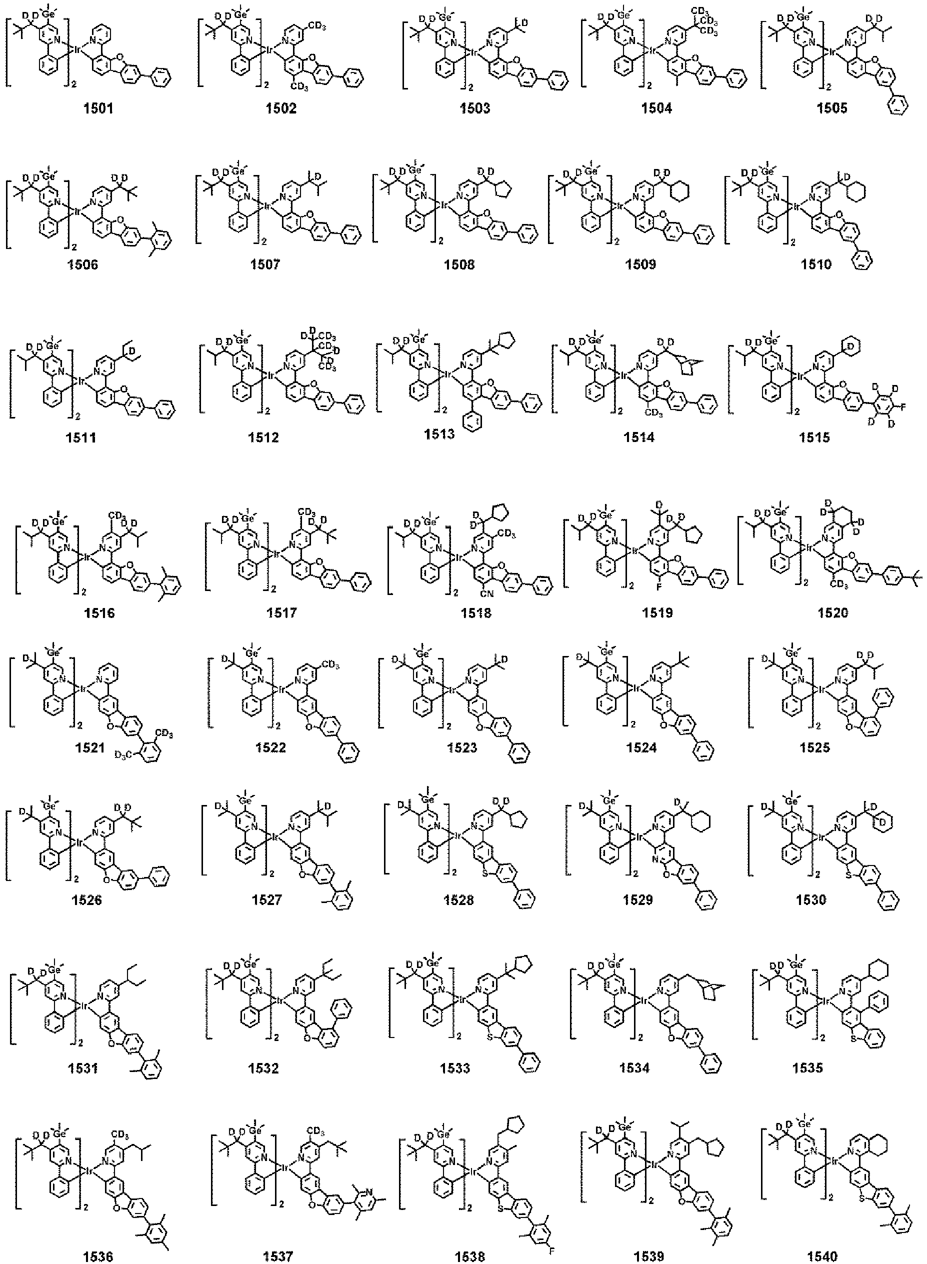

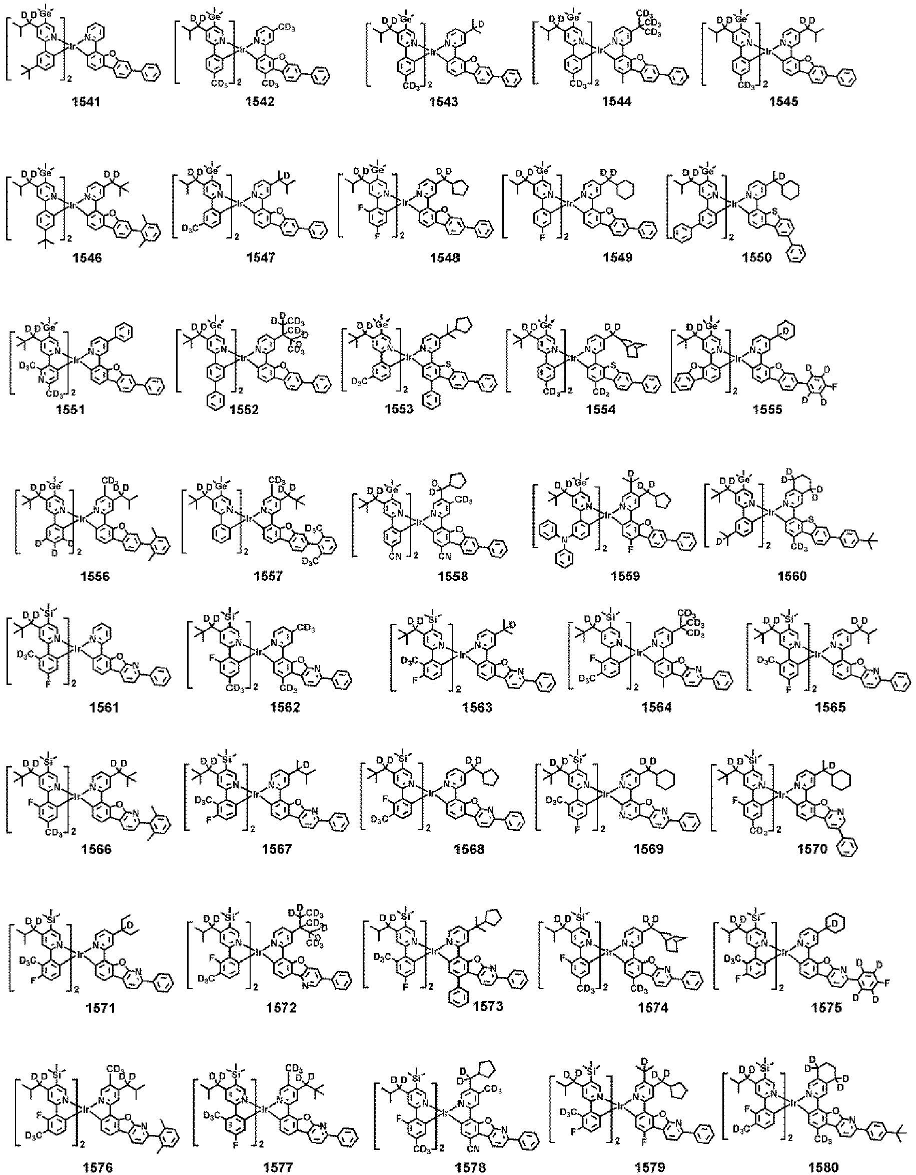

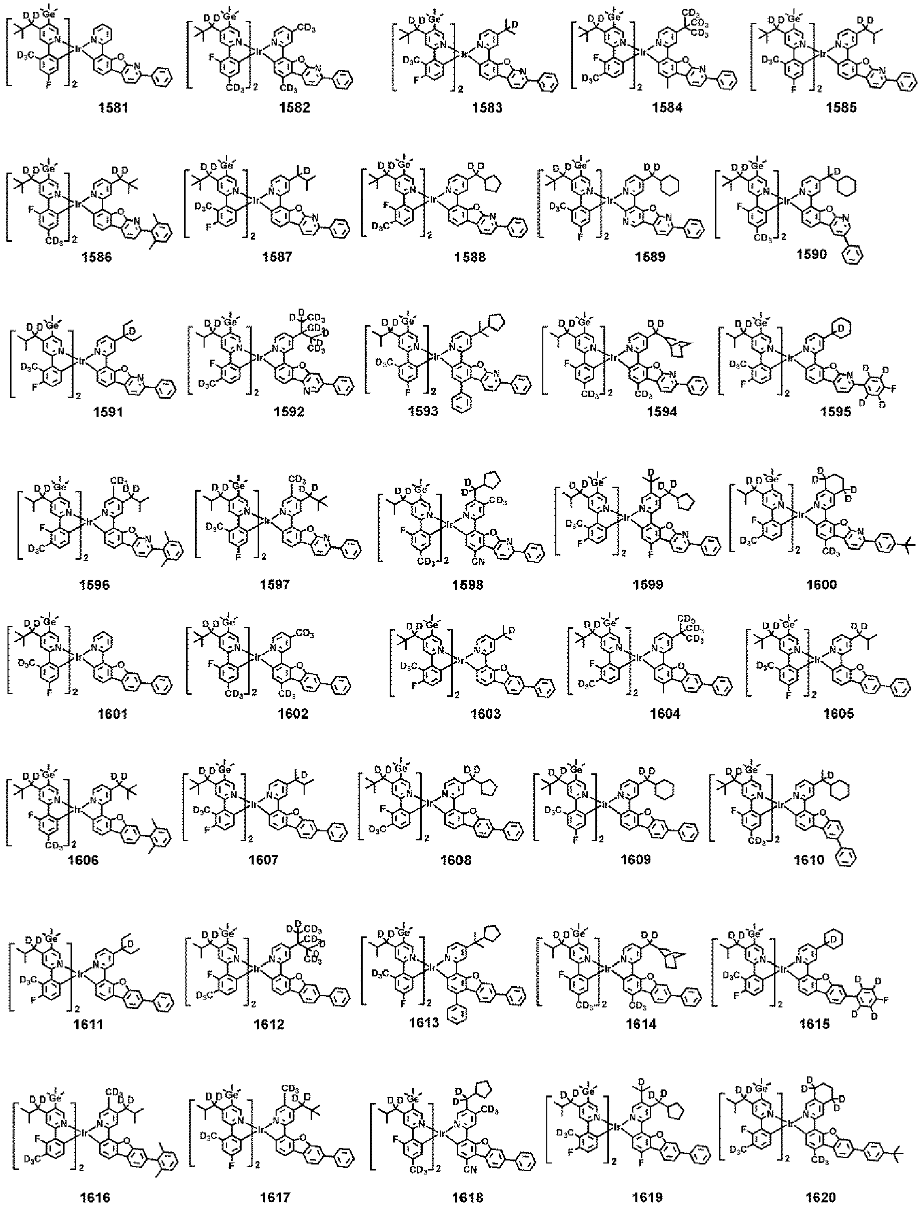

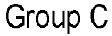

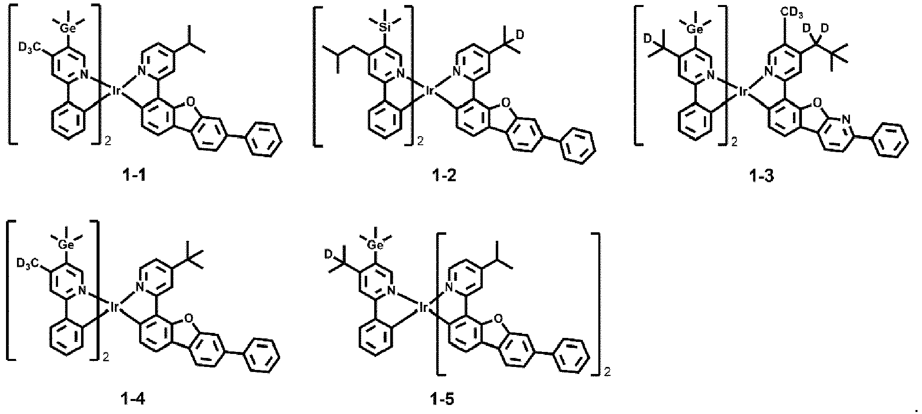

Meanwhile, the second compound is free of an electron-transporting group. The electron-transporting group may be, for example, a π-electron deficient nitrogen-containing cyclic group, a cyano group, a phosphine oxide group, a sulfoxide group, or the like.

The "π-electron deficient nitrogen-containing cyclic group" as used herein may be a C₁-C₆₀ heterocyclic group which has, as a ring-forming moiety, at least one *-N=*' moiety. Examples of the π-electron deficient nitrogen-containing cyclic group may include a triazine group, an imidazole group, and the like.

For example, the second compound may include two or more carbazole groups.

In an embodiment, the second compound may be a compound represented by Formula 6: 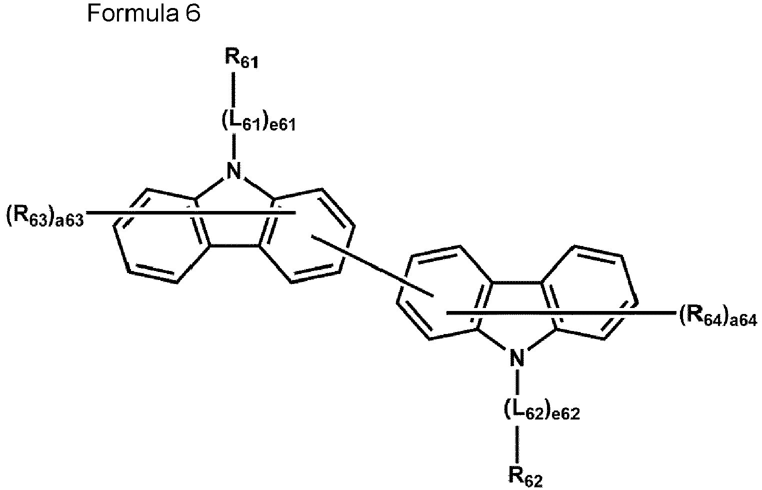 wherein, in Formula 6,
L₆₁ and L₆₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ, R₁₀ₐ is as described above in connection with R₁₀ₐ,
e61 and e62 may each independently be an integer from 1 to 6,
R₆₁ to R₆₄ are each independently the same as described in connection with Z₀, and
a63 and a64 may each independently be an integer from 0 to 7.

In one or more embodiments, the second compound may be a compound represented by Formula 6-1, 6-2, or 6-3: 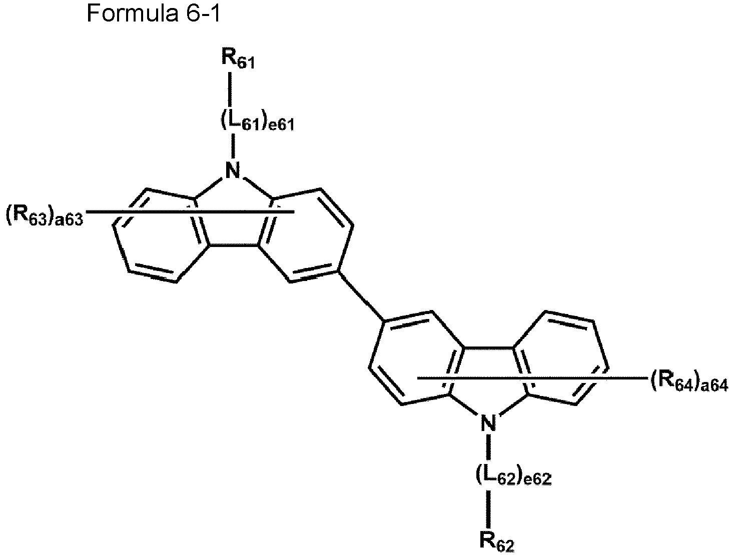 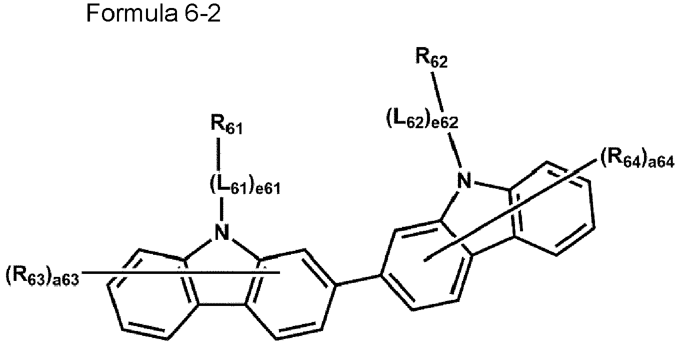 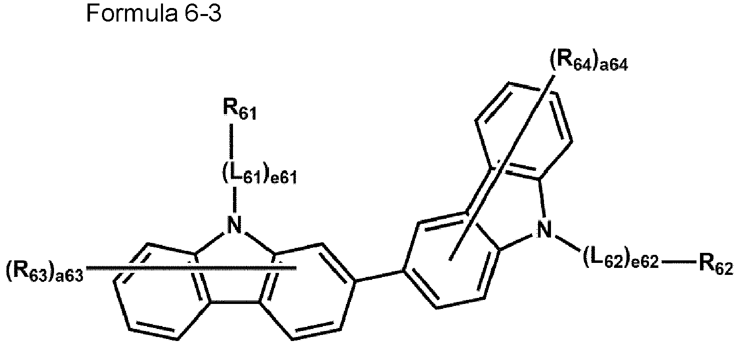 wherein, in Formulae 6-1 to 6-3, L₆₁, L₆₂, R₆₁ to R₆₄, e61, e62, a63, and a64 are respectively the same as those described herein.

In one or more embodiments, L₆₁ and L₆₂ in Formulae 6 and 6-1 to 6-3 may each independently be a benzene group, a naphthalene group, a carbazole group, a dibenzofuran group, or a dibenzothiophene group, each unsubstituted or substituted with at least one R₁₀ₐ.

In one or more embodiments, R₆₁ to R₆₄ in Formulae 6 and 6-1 to 6-3 may each independently be:
hydrogen, deuterium, -F, or a cyano group;
a C₁-C₂₀ alkyl group unsubstituted or substituted with deuterium, -F, a cyano group, or any combination thereof; or
a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In one or more embodiments, the second compound may be one of Compounds 2-1 to 2-13:

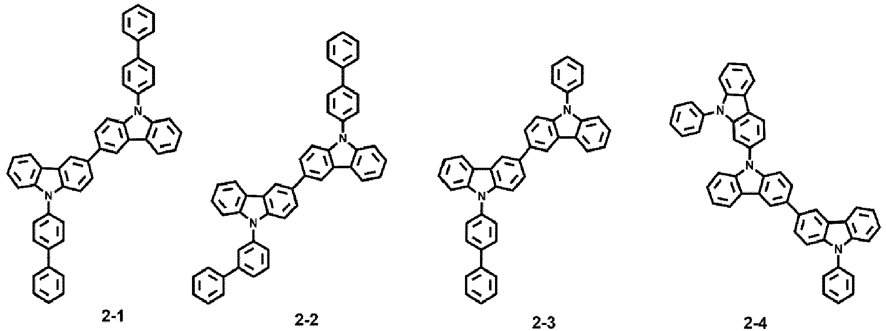

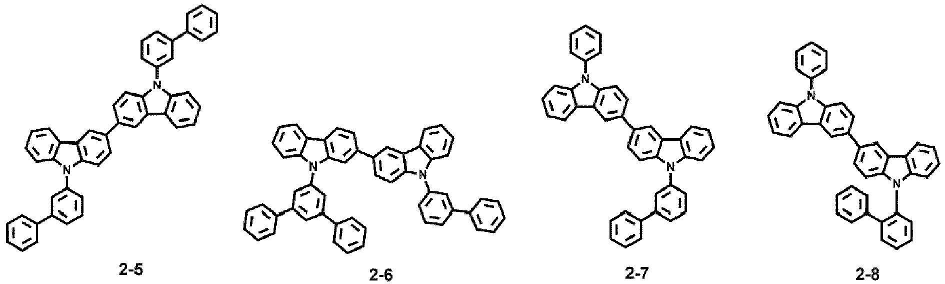

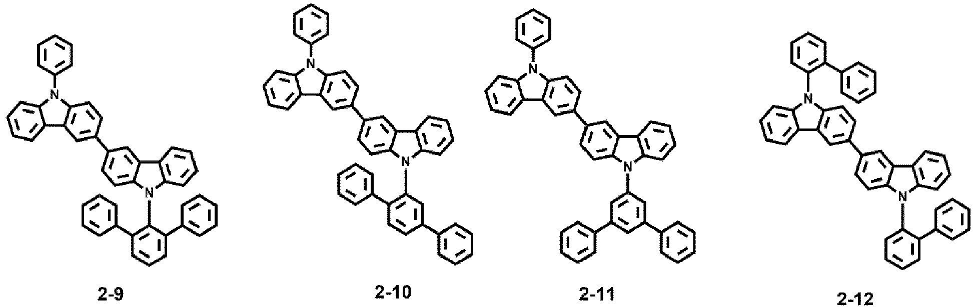

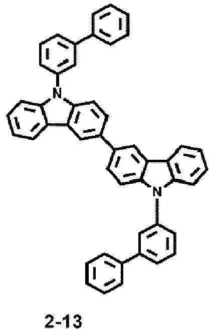

Meanwhile, X₇₄ to X₇₆ in Formula 7 may each be N.

In an embodiment, ring CY₇₁ in Formula 7 may be a benzene group. In one or more embodiments, a group represented by 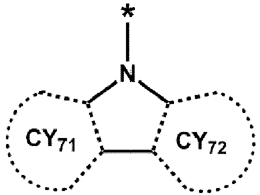 in Formula 7 may be represented by one of Formulae 7-1 to 7-7: 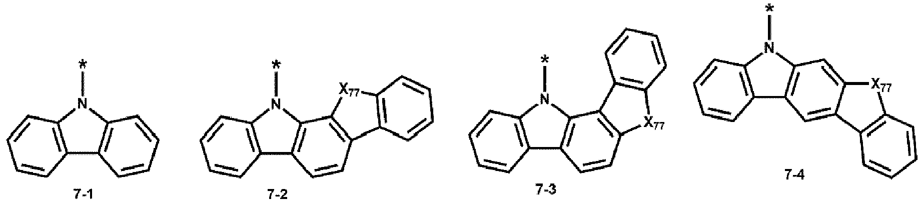 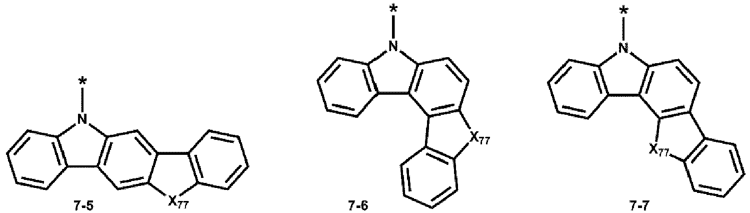 wherein, in Formulae 7-1 to 7-7,
* indicates a binding site to L₇₃ in Formula 7,
X₇₇ may be O, S, or N(R₇₇), and
R₇₇ is the same as described in connection with R₇₃.

In one or more embodiments, L₇₁ to L₇₃ in Formula 7 may each independently be:
a single bond; or
a benzene group, a naphthalene group, a dibenzofuran group, or a dibenzothiophene group, each unsubstituted or substituted with at least one R10a.

In one or more embodiments, R₇₁ to R₇₃ in Formula 7 may each independently be:
hydrogen, deuterium, -F, or a cyano group;
a C₁-C₂₀ alkyl group unsubstituted or substituted with deuterium, -F, a cyano group, or any combination thereof; or
a phenyl group, a biphenyl group, a dibenzofuranyl group, or a dibenzothiophenyl group, each unsubstituted or substituted with deuterium, - F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In one or more embodiments, in Formula 7,
ring CY₇₁ and ring CY₇₂ may each be a benzene group,
L₇₁ to L₇₃ may each independently be:
   a single bond; or
   a benzene group unsubstituted or substituted with at least one R₁₀ₐ,
   R₇₁ may be a dibenzofuranyl group or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof,
   R₇₂ may be a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof, and
   R73 may be:
      hydrogen, deuterium, -F, or a cyano group;
      a C₁-C₂₀ alkyl group unsubstituted or substituted with deuterium, -F, a cyano group, or any combination thereof; or
      a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In one or more embodiments, in Formula 7,
ring CY₇₁ may be a benzene group,
ring CY₇₂ may be a carbazole group,
L₇₁ to L₇₃ may each independently be:
   a single bond; or
   a benzene group unsubstituted or substituted with at least one R₁₀ₐ,
   R₇₁ and R₇₂ may each independently be a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof, and
   R₇₃ may be:
      hydrogen, deuterium, -F, or a cyano group;
      a C₁-C₂₀ alkyl group unsubstituted or substituted with deuterium, -F, a cyano group, or any combination thereof; or
      a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

In one or more embodiments, the third compound may be one of Compounds 3-1 to 3-12:

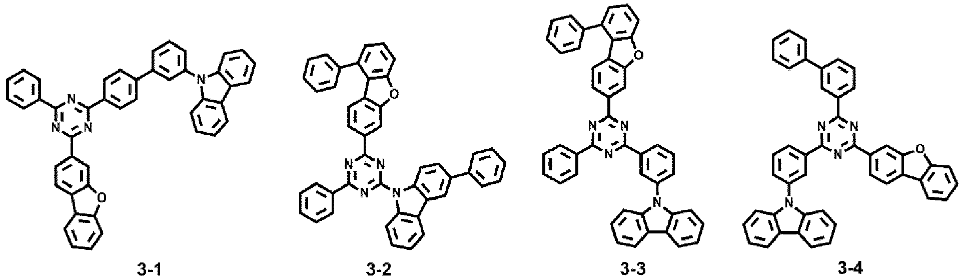

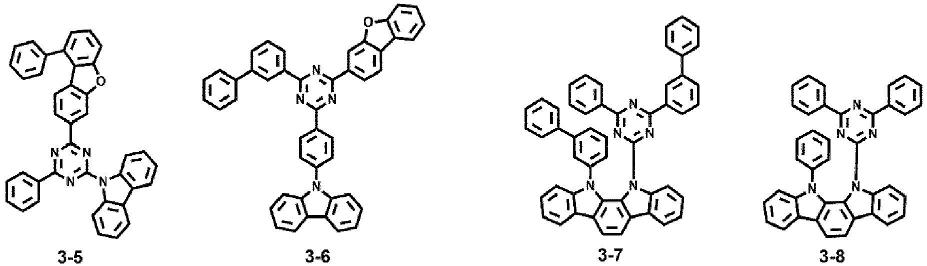

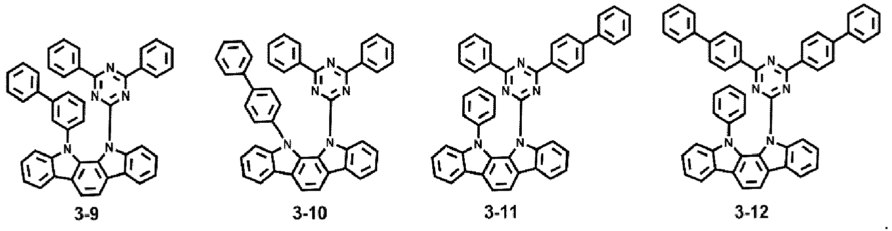

In the descriptions of Formulae 6, 6-1 to 6-3, and 7 provided herein, R₁₀ₐ may be, for example:
hydrogen, deuterium, -F, or a cyano group;
a C₁-C₂₀ alkyl group unsubstituted or substituted with deuterium, -F, a cyano group, or any combination thereof; or
a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

For example, a highest occupied molecular orbital (HOMO) energy level of the second compound may be -5.5 eV or more.

In an embodiment, the HOMO energy level of the second compound may be in a range of about -5.5 eV to about -4.81 eV, about -5.5 eV to about -4.85 eV, or about -5.5 eV to about -4.9 eV.

in an embodiment, a lowest unoccupied molecular orbital (LUMO) energy level of the third compound may be about -1.8 eV or less.

In an embodiment, the LUMO energy level of the third compound may be in a range of about -2.5 eV to about -1.85 eV, about -2.5 eV to about -1.90 eV, or about - 2.5 eV to about -1.95 eV.

The "HOMO energy level" as used herein may be a negative value that is evaluated based on density functional theory (DFT).

The first compound, the second compound, and the third compound as described herein may be included in the emission layer of the light-emitting device.

For example, the emission layer may include a mixture of the first compound, the second compound, and the third compound.

In an embodiment, the emission layer may include a dopant and a host, the dopant may include the first compound, and the host may include the second compound and the third compound. That is, the first compound may act as a dopant or an emitter in the emission layer. In this regard, a weight ratio of the second compound to the third compound may be in a range of about 1:9 to about 9:1, about 2:8 to about 8:2, about 3:7 to about 7:3, or about 4:6 to about 6:4. When the weight ratio of the second compound to the third compound is within the range described above, excitons may be effectively generated in the emission layer, and thus, the luminescence efficiency of the light-emitting device may be improved.

In one or more embodiments, in the emission layer, a total amount (for example, a weight) of the second compound and the third compound may be greater than an amount (for example, a weight) of the first compound.

In one or more embodiments, the emission layer may emit green light.

In one or more embodiments, the emission layer may emit green light having a maximum emission wavelength (or emission peak wavelength) in a range of about 500 nm to about 560 nm.

In the light-emitting device including the first compound, the second compound, and the third compound as described herein, migration of holes and electrons may be performed in a balanced manner, and excitons may be effectively formed. Accordingly, the light-emitting device may have excellent luminescence efficiency and long lifespan characteristics at the same time.

In the light-emitting device, the first electrode may be an anode, which is a hole injection electrode, and the second electrode may be a cathode, which is an electron injection electrode. Alternatively, the first electrode may be a cathode, which is an electron injection electrode, and the second electrode may be an anode, which is a hole injection electrode.

For example, in the light-emitting device, the first electrode may be an anode, the second electrode may be a cathode, and the interlayer may further include a hole transport region arranged between the first electrode and the emission layer and an electron transport region arranged between the emission layer and the second electrode, the hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

FIGURE schematically illustrates a cross-sectional view of an organic light-emitting device 10, which is a light-emitting device according to an embodiment of the present disclosure. Hereinafter, the structure and manufacturing method of the organic light-emitting device 10 according to an embodiment of the present disclosure will be described with reference to FIGURE. The organic light-emitting device 10 may have a structure in which a first electrode 11, an interlayer 15, and a second electrode 19 are sequentially stacked.

A substrate may be additionally arranged under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

The first electrode 11 may be, for example, formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. For example, the first electrode 11 may have a three-layered structure of ITO/Ag/ITO.

The interlayer 15 may be arranged on the first electrode 11.

The interlayer 15 may include a hole transport region, an emission layer, and an electron transport region.

The hole transport region may be arranged between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When the hole injection layer is formed by vacuum deposition, the deposition conditions may vary depending on a material for forming the hole injection layer, and the structure and thermal characteristics of the hole injection layer. For example, the deposition conditions may include a deposition temperature in a range of about 100 °C to about 500 °C, a vacuum pressure in a range of about 10⁻⁸ torr to about 10⁻³ torr, and a deposition rate in a range of about 0.01 Å/sec to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed in a range of about 2,000 rpm to about 5,000 rpm and a heat treatment temperature in a range of about 80 °C to about 200 °C for removing a solvent after coating.

Conditions for forming the hole transport layer and the electron blocking layer may be the same as the conditions for forming the hole injection layer.

The hole transport region may include m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or any combination thereof:

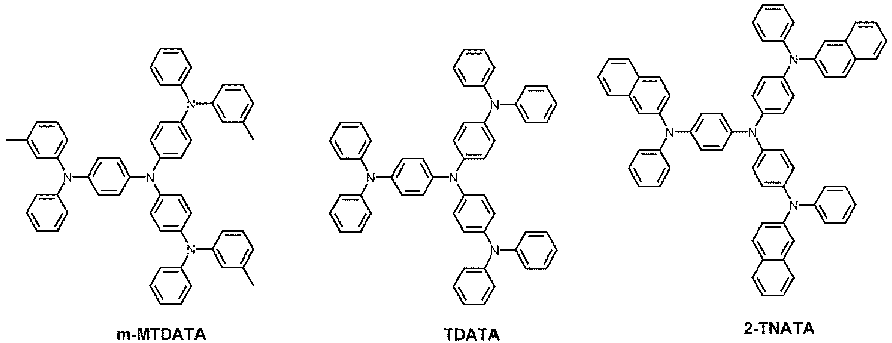

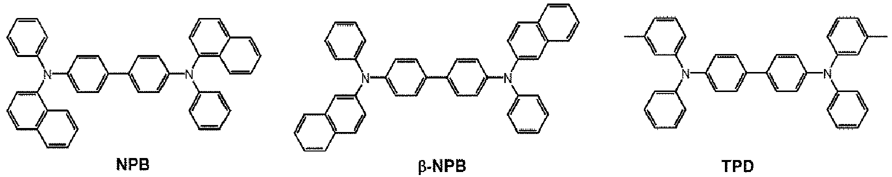

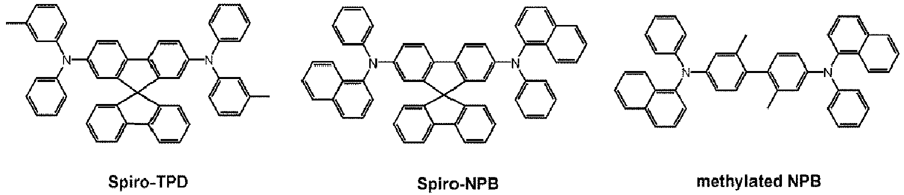

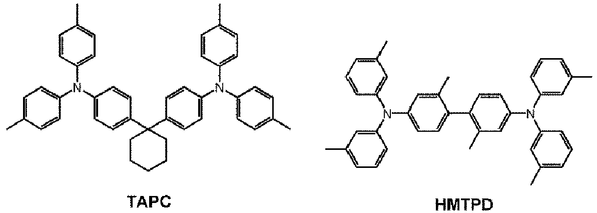

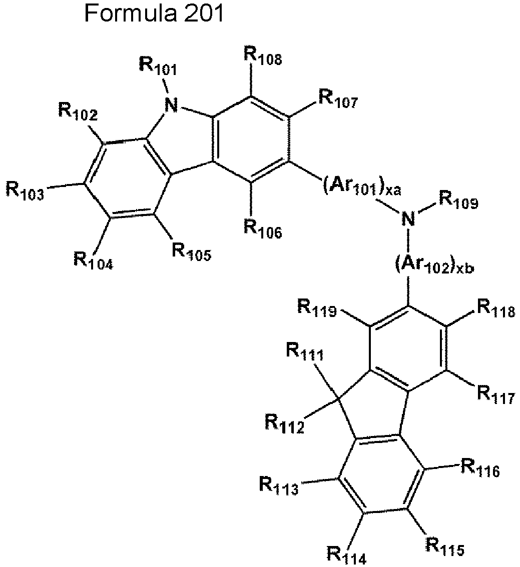

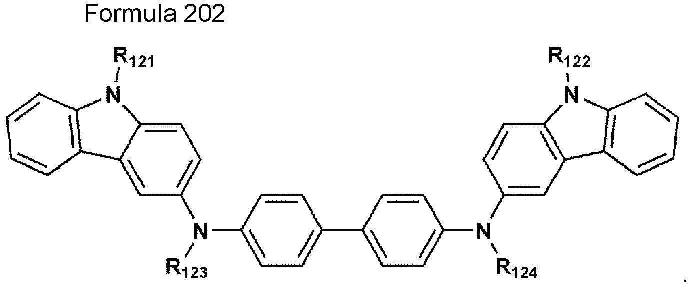

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, or a pentacenylene group, each unsubstituted or substituted with deuterium, -F, -Cl, -Br, - I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, etc.), or a C₁-C₁₀ alkoxy group (for example, a methoxy group, an ethoxy group, a propoxy group, a butoxy group, a pentoxy group, etc.);
a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof.

R₁₀₉ in Formula 201 may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In an embodiment, the compound represented by Formula 201 may be represented by Formula 201A: 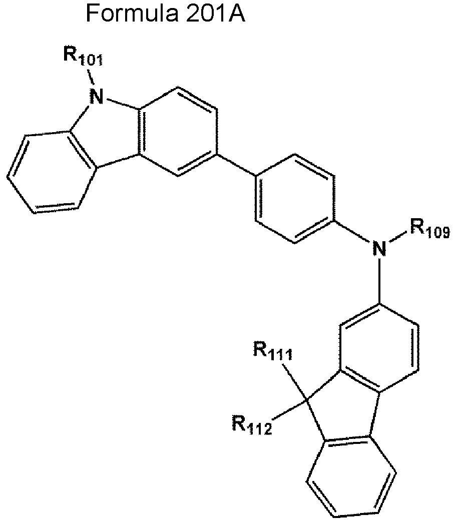 wherein, in Formula 201A, R₁₀₁, R₁₁₁, R₁₁₂, and R₁₀₉ are respectively the same as those described herein.

For example, the hole transport region may include one of Compounds HT1 to HT20 or any combination thereof:

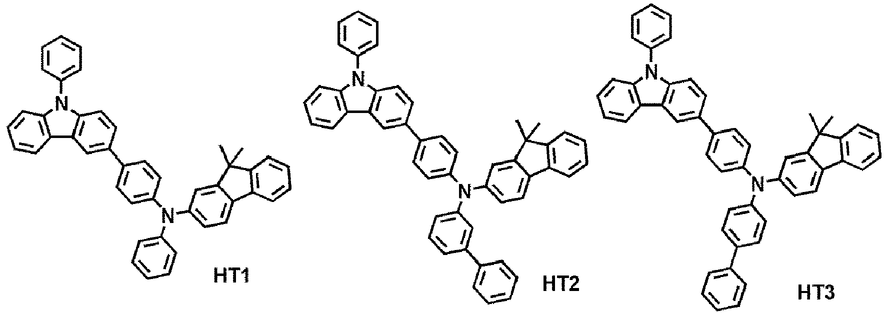

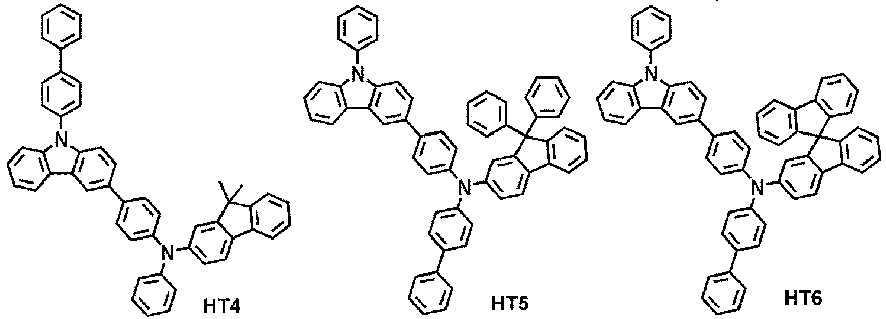

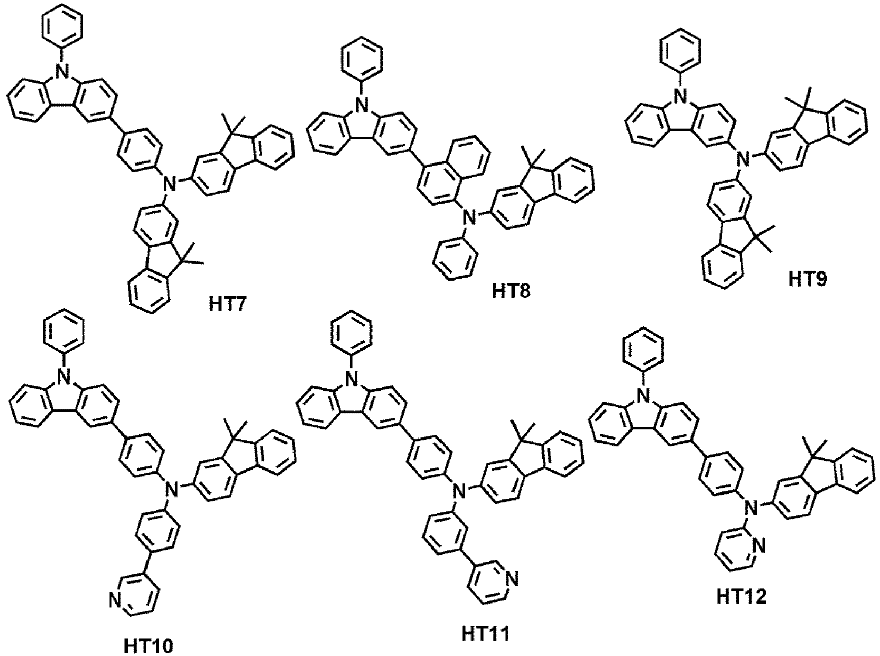

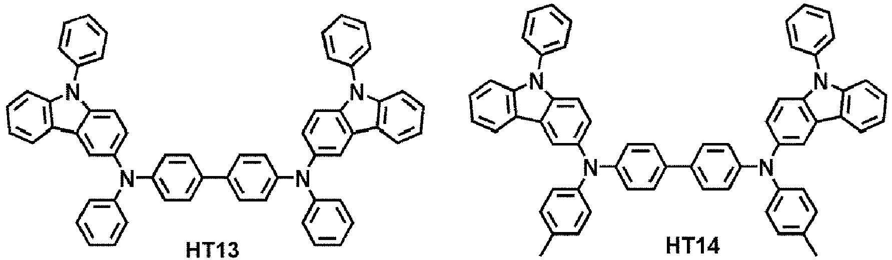

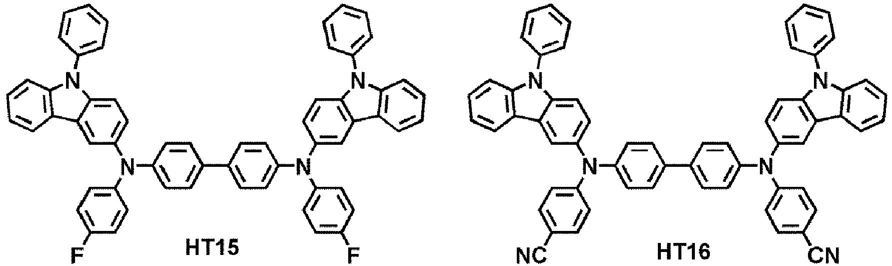

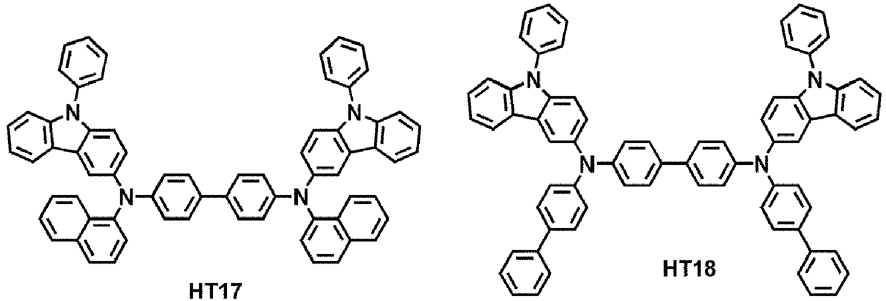

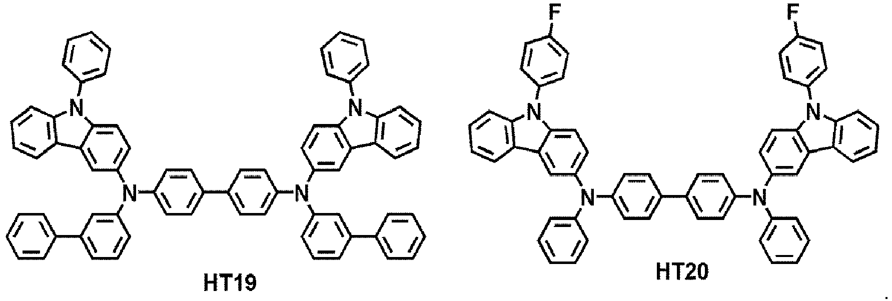

A thickness of the hole transport region may be in a range of about 100 Å to about 10,000 Å, for example, about 100 Å to about 3,000 Å. When the hole transport region includes a hole injection layer, a hole transport layer, an electron blocking layer, or any combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within the ranges described above, satisfactory hole transporting characteristics may be obtained without a substantial increase in driving voltage.

The hole transport region may further include, in addition to the materials as described above, a charge-generation material for improving conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or any combination thereof. For example, the p-dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or any combination thereof.

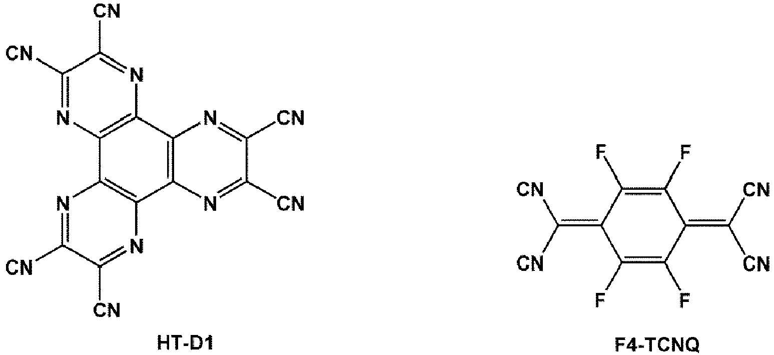

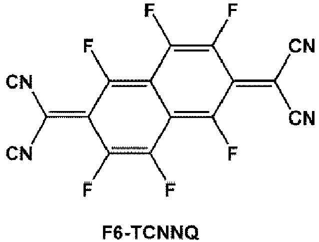

The hole transport region may further include a buffer layer.

The buffer layer may compensate for an optical resonance distance according to a wavelength of light emitted from the emission layer to increase efficiency.

Meanwhile, when the hole transport region includes an electron blocking layer, a material for forming the electron blocking layer may include a material that is used in the hole transport region as described above, a host material described below, or any combination thereof. For example, when the hole transport region includes an electron blocking layer, mCP described below, Compound 2-1 described above, or the like may be used as the material for forming the emission layer.

The emission layer may be formed on the hole transport region by using one or more suitable methods, such as vacuum deposition, spin coating, casting, or LB deposition. When the emission layer is formed by vacuum deposition or spin coating, the deposition or coating conditions may be similar to those applied in forming the hole injection layer although the deposition or coating conditions may vary according to a material that is used to form the hole transport layer.

For example, the emission layer may include a host and a dopant, wherein the dopant may include the first compound, and the host may include the second compound and the third compound. The first compound, the second compound, and the third compound are respectively the same as those described herein.

When the emission layer includes a host and a dopant, an amount of the dopant may be in a range of about 0.01 part by weight to about 15 parts by weight based on 100 parts by weight of the host.

A thickness of the emission layer may be in a range of about 100 Å to about 1,000 Å, for example, about 200 Å to about 1,000 Å. When the thickness of the emission layer is within the range described above, excellent light-emission characteristics may be obtained without a substantial increase in driving voltage.

Next, the electron transport region is arranged on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be the same as the conditions for forming the hole injection layer.

When the electron transport region includes a hole blocking layer, the hole blocking layer may include, for example, BCP, Bphen, BAlq, or any combination thereof:

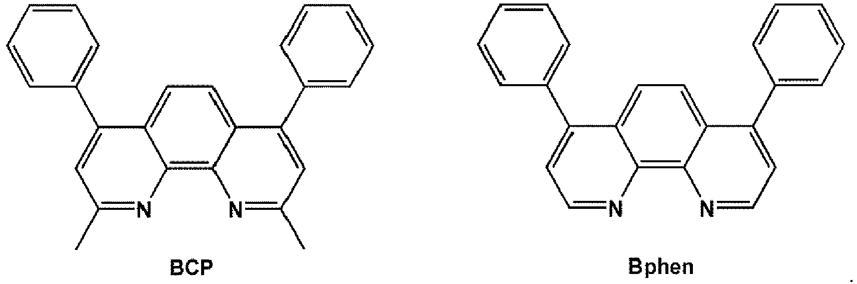

A thickness of the hole blocking layer may be in a range of about 20 Å to about 1,000 Å, for example, about 30 Å to about 600 Å. When the thickness of the hole blocking layer is within the range described above, excellent hole blocking characteristics may be obtained without a substantial increase in driving voltage.

The electron transport layer may include BCP, Bphen, TPBi, Alq₃, BAlq, TAZ, NTAZ, or any combination thereof:

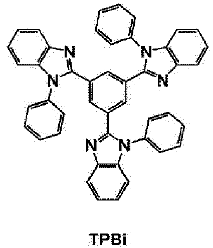

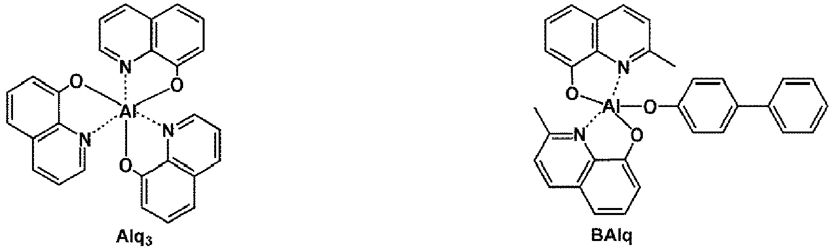

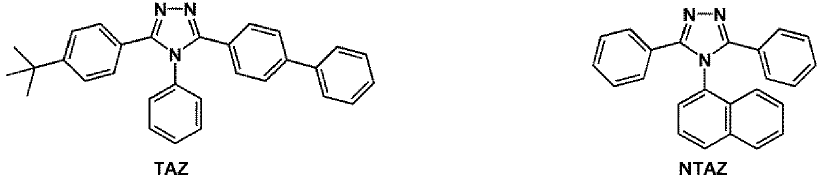

In one or more embodiments, the electron transport layer may include one of Compounds ET1 to ET25 or any combination thereof:

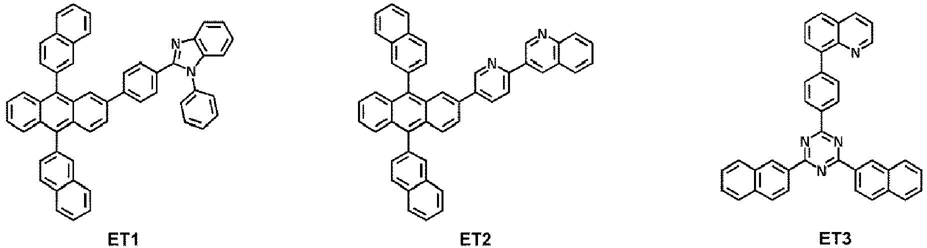

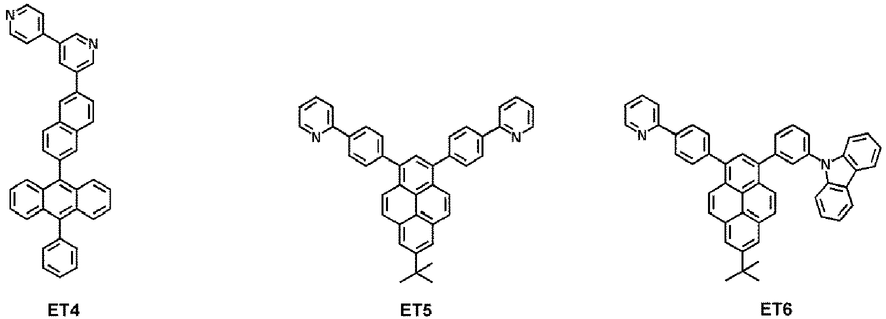

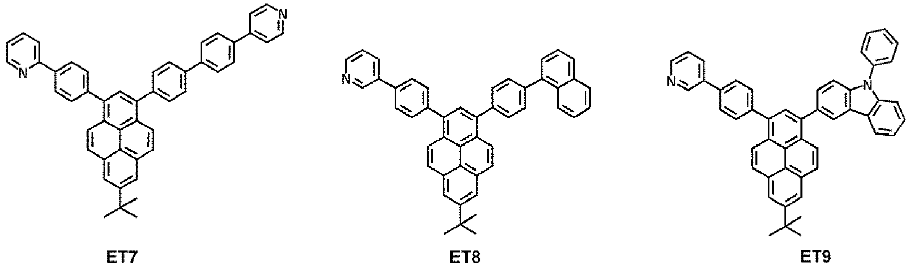

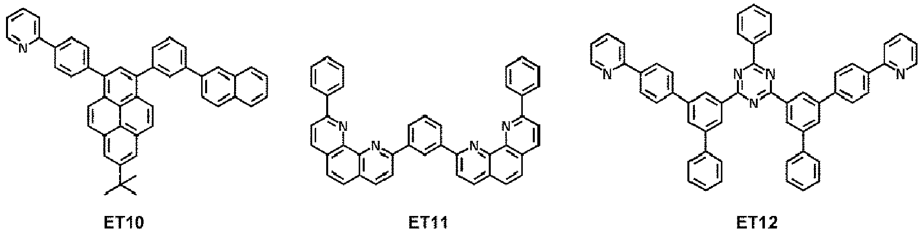

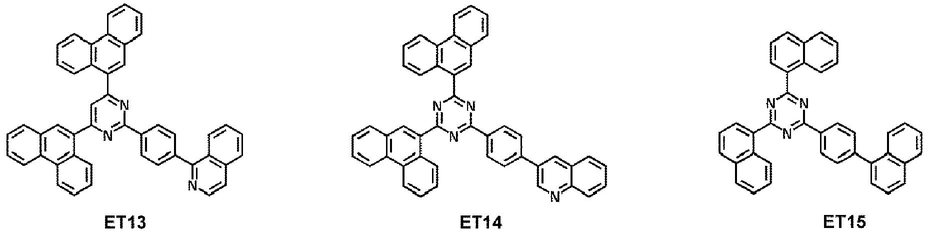

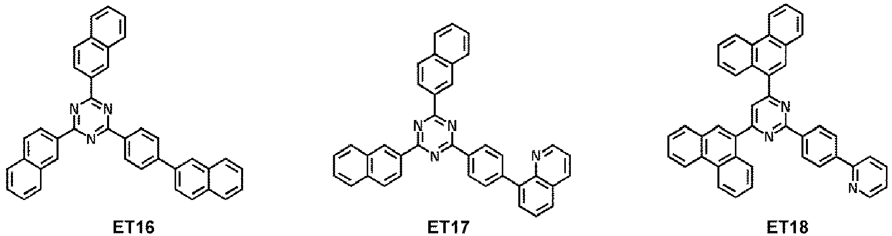

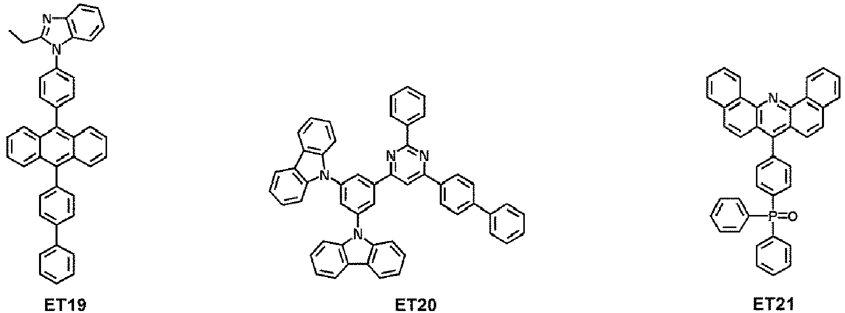

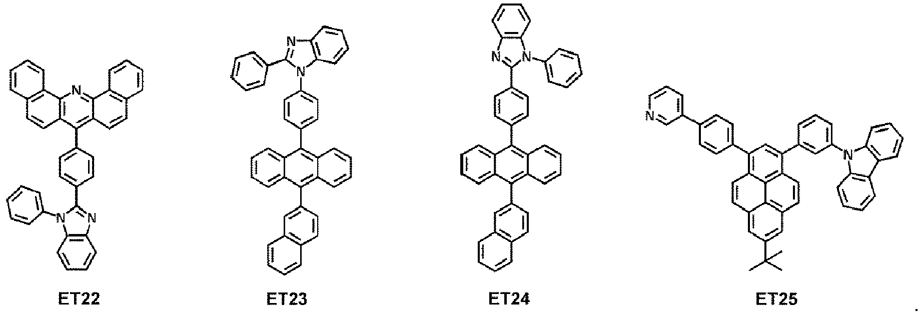

A thickness of the electron transport layer may be in a range of about 100 Å to about 1,000 Å, for example, about 150 Å to about 500 Å. When the thickness of the electron transport layer is within the range described above, satisfactory electron transporting characteristics may be obtained without a substantial increase in driving voltage.

The electron transport layer may include, in addition to the materials described above, a metal-containing material.

The metal-containing material may include a Li complex. The Li complex may include, for example, Compound ET-D1 or ET-D2:

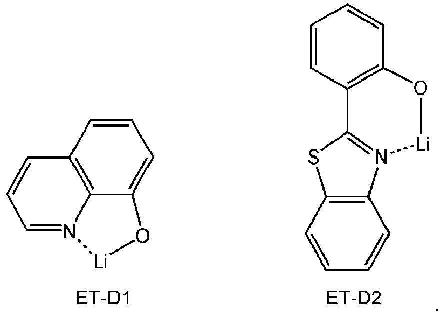

The electron transport region may include an electron injection layer that facilitates electron injection from the second electrode 19.

The electron injection layer may include LiF, NaCl, CsF, Li₂O, BaO, or any combination thereof.

A thickness of the electron injection layer may be in a range of about 1 Å to about 100 Å, for example, about 3 Å to about 90 Å. When the thickness of the electron injection layer is within the range described above, satisfactory electron injection characteristics may be obtained without a substantial increase in driving voltage.

The second electrode 19 is arranged on the interlayer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device 10 has been described with reference to FIGURE, but embodiments of the present disclosure are not limited thereto.

According to another aspect, the light-emitting device as described herein may be included in an electronic apparatus. Thus, an electronic apparatus including the light-emitting device is provided. The electronic apparatus may include, for example, a display, an illumination, a sensor, and the like.

According to another aspect, provided is a mixture including:
i) the third compound represented by Formula 7; and
ii) at least one of the first compound represented by Formula 1 and the second compound that is free of an electron-transporting group.

In an embodiment, the mixture may include the third compound and the first compound.

In one or more embodiments, the mixture may include the third compound and the second compound.

In one or more embodiments, the mixture may include all of the third compound, the second compound, and the first compound.

The first compound, the second compound, and the third compound are respectively the same as those described herein.

The mixture may be used in various methods, for example, deposition, coating, and the like, when forming the light-emitting device as described herein.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group), and examples thereof include a methoxy group, an ethoxy group, a propoxy group, a butoxy group, and a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the term "C₃-C₁₀ cycloalkylene group" as used herein refers to a divalent group having the same structure as the C₃-C₁₀ cycloalkyl group.

Examples of the C₃-C₁₀ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent saturated cyclic group that includes at least one heteroatom selected from N, O, P, Si, S, Se, Ge, and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group may include a silolanyl group, a silinanyl group, tetrahydrofuranyl group, a tetrahydro-2H-pyranyl group, and a tetrahydrothiophenyl group.

The term "C₃-C₁₀ cycloalkenyl group" as used herein refers to a monovalent cyclic group that includes 3 to 10 carbon atoms and at least one carbon-carbon double bond in the ring thereof and has no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₂-C₁₀ heterocycloalkenyl group" as used herein refers to a monovalent cyclic group that includes at least one heteroatom selected from N, O, P, Si, S, Se, Ge, and B as a ring-forming atom, 1 to 10 carbon atoms, and at least one carbon-carbon double bond in the ring thereof. Examples of the C₂-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₂-C₁₀ heterocycloalkenyl group.

The term "C₆-C₆₀ aryl group" as used herein refers to a monovalent group that includes a carbocyclic aromatic system having 6 to 60 carbon atoms, and the term "C₆-C₆₀ arylene group" as used herein refers to a divalent group that includes a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other.

The term "C₇-C₆₀ alkylaryl group" as used herein refers to a C₆-C₆₀ aryl group substituted with at least one C₁-C₆₀ alkyl group.

The term "C₁-C₆₀ heteroaryl group" as used herein refers to a monovalent group that includes at least one heteroatom selected from N, O, P, Si, S, Se, Ge, and B as a ring-forming atom and a cyclic aromatic system having 1 to 60 carbon atoms, and the term "C₁-C₆₀ heteroarylene group" as used herein refers to a divalent group that includes at least one hetero atom selected from N, O, P, Si, S, Se, Ge, and B as a ring-forming atom and a carbocyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the two or more rings may be fused to each other.

The C₂-C₆₀ alkylheteroaryl group used herein refers to a C₁-C₆₀ heteroaryl group substituted with at least one C₁-C₆₀ alkyl group.

The term "C₆-C₆₀ aryloxy group" as used herein indicates -OA₁₀₂ (wherein A₁₀₂ is the C₆-C₆₀ aryl group), the term "C₆-C₆₀ arylthio group" as used herein indicates - SA₁₀₃ (wherein A₁₀₃ is the C₆-C₆₀ aryl group), and the term "C₁-C₆₀ alkylthio group" as used herein indicates -SA₁₀₄ (wherein A₁₀₄ is the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (unsubstituted or substituted with at least one R₁₀ₐ (or at least one Z₀))" as used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ (or at least one Z₀)).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. Examples of the "C₁-C₃₀ heterocyclic group (unsubstituted or substituted with at least one R₁₀ₐ (or at least one Z₀))" as used herein may include a thiophene group, a furan group, a pyrrole group, a silole group, a borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group (each unsubstituted or substituted with at least one R₁₀ₐ (or at least one Z₀)).

Examples of the "C₅-C₃₀ carbocyclic group" and "C₁-C₃₀ heterocyclic group" as used herein include i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or a fluorinated C₁-C₂₀ alkyl group or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or a fully fluorinated C₁-C₂₀ alkyl group or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or a partially fluorinated C₁-C₂₀ alkyl group or the like), a partially fluorinated C₃-C₁₀ cycloalkyl group, a partially fluorinated C₁-C₁₀ heterocycloalkyl group, or a partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include - CD₃, -CD₂H, and -CDH₂, and examples of the "deuterated C₃-C₁₀ cycloalkyl group" are, for example, Formula 10-501 and the like. The "deuterated C₁-C₆₀ alkyl group (or the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein is substituted with deuterium, or ii) a partially deuterated C₁-C₆₀ alkyl group (or a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein is not substituted with deuterium.

The term "(C₁-C₂₀ alkyl) 'X' group" as used herein refers to an 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

As used herein, the number of carbons in each group that is substituted (e.g., C₁-C₆₀) excludes the number of carbons in the substituent. For example, a C₁-C₆₀alkyl group can be substituted with a C₁-C₆₀ alkyl group. The total number of carbons included in the C₁-C₆₀ alkyl group substituted with the C₁-C₆₀ alkyl group is not limited to 60 carbons. In addition, more than one C₁-C₆₀ alkyl substituent may be present on the C₁-C₆₀alkyl group. This definition is not limited to the C₁-C₆₀ alkyl group and applies to all substituted groups that recite a carbon range.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

At least one substituent of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₁-C₆₀ heteroaryl group, the substituted C₂-C₆₀ alkylheteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid or a salt thereof, a sulfonic acid or a salt thereof, a phosphoric acid or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₆), -B(Q₁₆)(Q₁₇), -P(=O)(Q₁₈)(Q₁₉), - P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₇-C₆₀ alkylaryl group, a C₆-C₆₀ aryloxy group, a C₆-C₆₀ arylthio group, a C₁-C₆₀ heteroaryl group, a C₂-C₆₀ alkylheteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -B(Q₃₆)(Q₃₇), -P(=O)(Q₃₈)(Q₃₉), or - P(Q₃₈)(Q₃₉); or
any combination thereof.

Q₁ to Q₉, Q₁₁ to Q₁₉, Q₂₁ to Q₂₉, and Q₃₁ to Q₃₉ as used herein may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₂-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

For example, Q₁ to Q₉, Q₁₁ to Q₁₉, Q₂₁ to Q₂₉, and Q₃₁ to Q₃₉ as used herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

Hereinafter, an organic light-emitting device according to an embodiment of the present disclosure will be described in detail with reference to Examples. However, the present disclosure is not limited to the following examples.

### Examples

### Evaluation Example 1

The HOMO energy level and LUMO energy level of each of Compounds 2-1, 2-A, 3-1, 3-A, and 3-B were evaluated using the Gaussian 09 program with molecular structure optimization obtained by B3LYP-based DFT. Results thereof are summarized in Table 1.

**Table 1**

| Compound No. | HOMO energy level (eV) | LUMO energy level (eV) |
|---|---|---|
| 2-1 | -4.9718 | -1.0044 |
| 2-A | -4.8080 | -0.7859 |
| 3-1 | -5.3713 | -2.0292 |
| 3-A | -5.1908 | -1.9173 |
| 3-B | -5.7054 | -1.8457 |

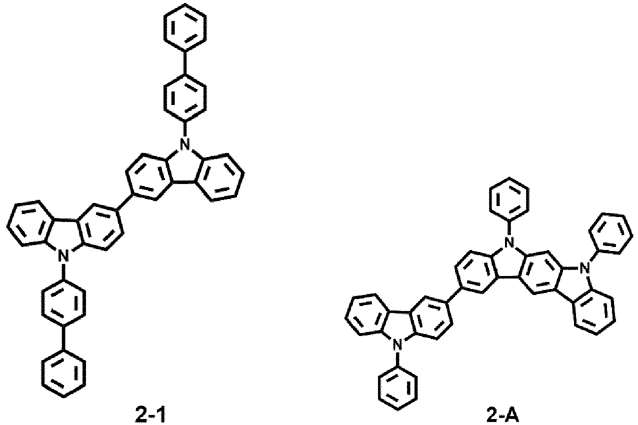

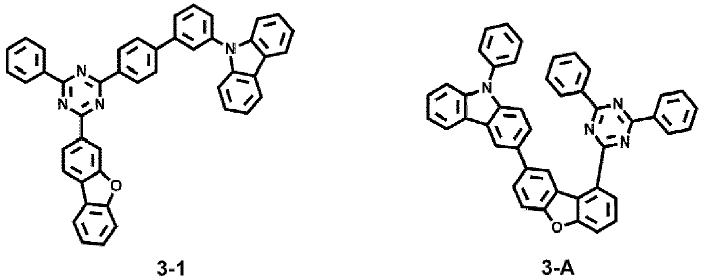

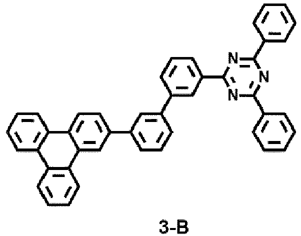

### Comparative Example A

An ITO(as an anode)-patterned glass substrate was cut to a size of 50 mm x 50 mm x 0.5 mm, sonicated with isopropyl alcohol and pure water, each for 5 minutes, and then cleaned by exposure to ultraviolet rays and ozone for 30 minutes. The resultant glass substrate was loaded onto a vacuum deposition apparatus.

Compound HT3 and F6-TCNNQ were vacuum-co deposited on the anode at a weight ratio of 98:2 to form a hole injection layer having a thickness of 100 Å, Compound HT3 was vacuum-deposited on the hole injection layer to form a hole transport layer having a thickness of 1,350 Å, and then, Compound 2-1 was deposited on the hole transport layer to form a buffer layer having a thickness of 300 Å.

Next, Compound 2-1 (second compound), Compound 3-1 (third compound), and Compound 1-A (first compound) were co-deposited on the buffer layer at a weight ratio of 57:38:5 to form an emission layer having a thickness of 400 Å.

Then, Compound ET3 and ET-D1 were co-deposited on the emission layer at a volume ratio of 50:50 to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

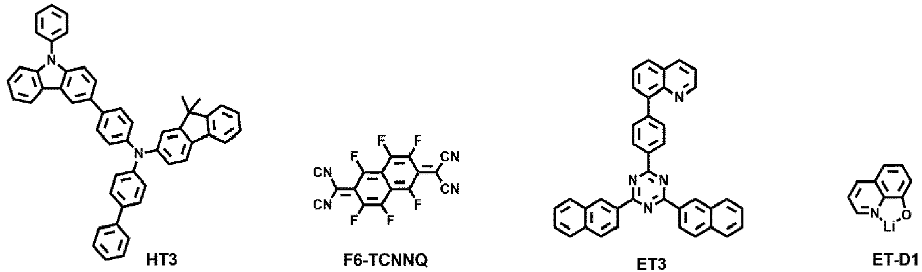

### Examples B to D and Example 1

Organic light-emitting devices were manufactured in the same manner as in Comparative Example A, except that each of the first compound, the second compound, and the third compound was changed as shown in Table 2 in forming the emission layer. Compound 1(1) is the same compound as Compound 21 of Group A described herein.

### Evaluation Example 2

The maximum value of external quantum efficiency (Max EQE) (%) and lifespan (LT₉₇) (hr) of each of the organic light-emitting devices manufactured according to Comparative Examples A to D and Example 1 were evaluated. Results thereof are summarized in Table 2 as relative values (%). A current-voltage meter (Keithley 2400) and a luminance meter (Minolta Cs-1 000A) were used as apparatuses for evaluation, the lifespan (LT₉₇) (at 16,000 nit) was obtained by measuring the amount of time (hr) that elapsed until luminance was reduced to 97 % of the initial luminance of 100 %, and the results were converted into relative values (%).

**Table 2**

| | First compound | Second compound | Third compound | Max EQE (relative value, %) | LT₉₇ (relative value, %) (at 16,000 nit) |
|---|---|---|---|---|---|
| Comparative Example A | 1-A | 2-1 | 3-1 | 100 | 100 |
| Comparative Example B | 1(1) | 2-1 | 3-A | 103 | 105 |
| Comparative Example C | 1(1) | 2-1 | 3-B | 101 | 100 |
| Comparative Example D | 1(1) | 2-A | 3-1 | 96 | 97 |
| Example 1 | 1(1) | 2-1 | 3-1 | 119 | 126 |

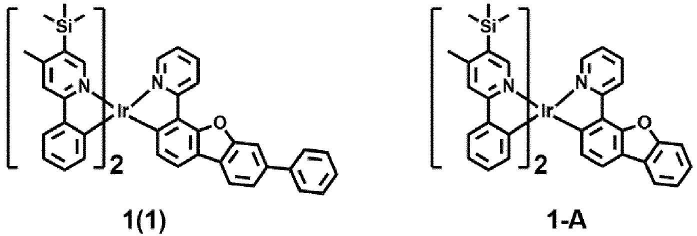

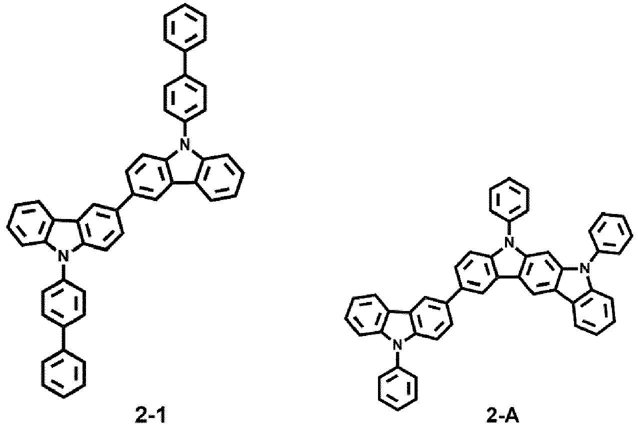

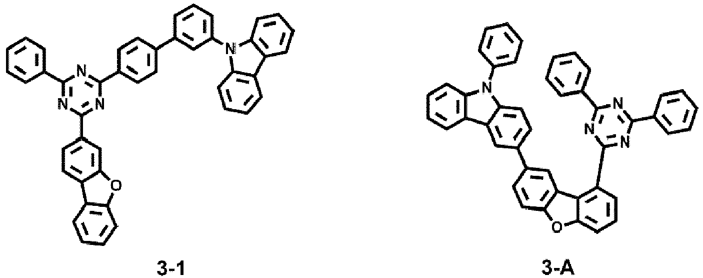

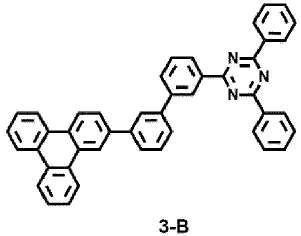

From Table 2, it was confirmed that the organic light-emitting device of Example 1 had excellent luminescence efficiency (external quantum efficiency) and lifespan characteristics at the same time, as compared with the organic light-emitting devices of Comparative Examples A to D.

### Examples 11 to 15

Organic light-emitting devices were manufactured in the same manner as in Comparative Example A, except that the first compound in the emission layer was changed as shown in Table 3.

### Evaluation Example 3

The maximum value of external quantum efficiency (Max EQE) (%) and lifespan (LT₉₇) (hr) of each of the organic light-emitting devices manufactured according to Examples 11 to 15 were evaluated in the same manner as in Evaluation Example 2. Results thereof are summarized in Table 3 as relative values (%). For comparison, the external quantum efficiency and lifespan data of Comparative Example A are also shown in Table 3.

**Table 3**

| | First compound | Second compound | Third compound | Max EQE (relative value, %) | LT₉₇ (relative value, %) (at 16,000 nit) |
|---|---|---|---|---|---|
| Comparative Example A | 1-A | 2-1 | 3-1 | 100 | 100 |
| Example 11 | 1-1 | 2-1 | 3-1 | 122 | 139 |
| Example 12 | 1-2 | 2-1 | 3-1 | 126 | 148 |
| Example 13 | 1-3 | 2-1 | 3-1 | 127 | 175 |
| Example 14 | 1-4 | 2-1 | 3-1 | 126 | 149 |
| Example 15 | 1-5 | 2-1 | 3-1 | 131 | 195 |

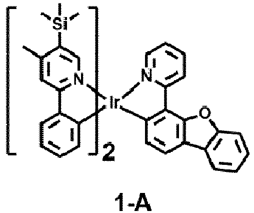

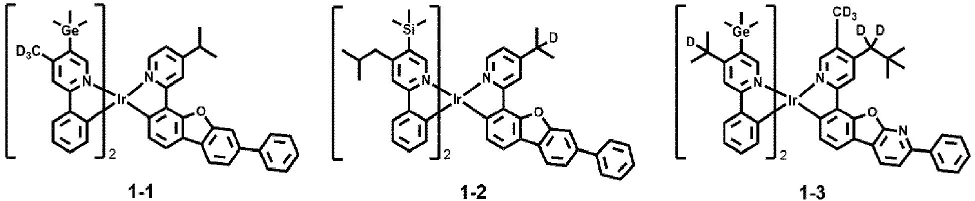

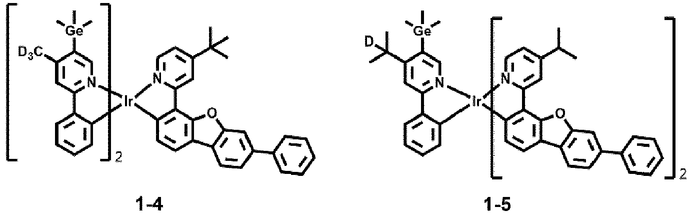

From Table 3, it was confirmed that the organic light-emitting devices of Examples 11 to 15 had excellent luminescence efficiency (external quantum efficiency) and lifespan characteristics at the same time, as compared with the organic light-emitting device of Comparative Example A.

The light-emitting device according to an embodiment of the present disclosure may have excellent luminescence efficiency (external quantum efficiency) and excellent lifespan characteristics at the same time. Accordingly, a high-quality electronic apparatus may be manufactured by using the light-emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light-emitting device comprising:
a first electrode;
a second electrode; and
an interlayer arranged between the first electrode and the second electrode and comprising an emission layer,
wherein the interlayer comprises a first compound represented by Formula 1, a second compound that is free of an electron-transporting group, and a third compound represented by Formula 7,
the second compound does not comprise an indolocarbazole group, and
the second compound and the third compound are different from each other:
Formula 1 M(L₁)ₙ₁(L₂)ₙ₂
wherein, in Formula 1,
M is a transition metal,
L₁ is a ligand represented by Formula 2A,
L₂ is a ligand represented by Formula 2B,
n1 and n2 are each independently 1 or 2, wherein, when n1 is 2, two of L₁(s) are identical to or different from each other, and when n2 is 2, two of L₂(s) are identical to or different from each other,
the sum of n1 and n2 is 2 or 3, and
L₁ and L₂ are different from each other, 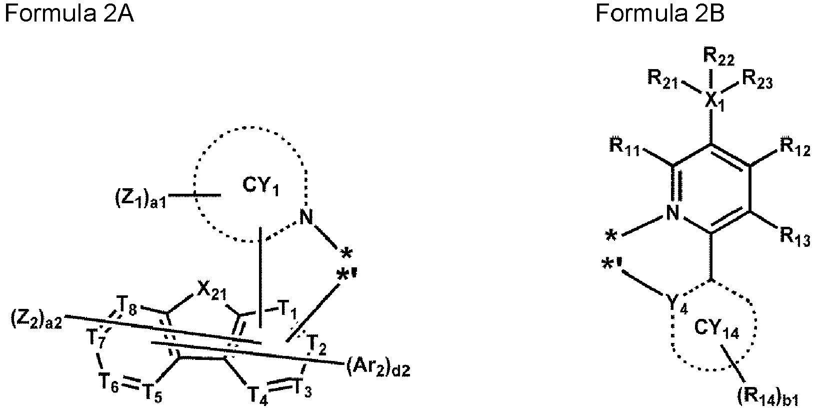 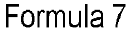 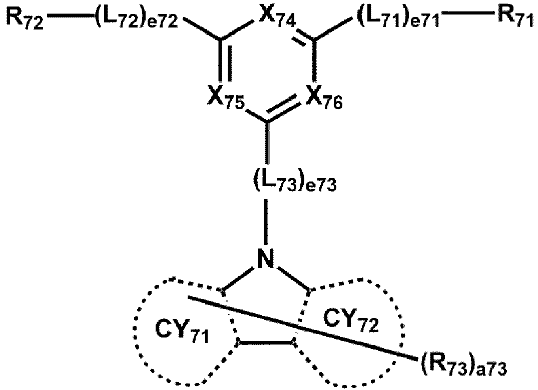
in Formulae 2A, 2B, and 7,
Y₄ is C or N,
X₁ is Si or Ge,
X₂₁ is O, S, S(=O), N(Z₂₉), C(Z₂₉)(Z₃₀), or Si(Z₂₉)(Z₃₀),
T₁ to T₄ are each independently C, N, a carbon atom bonded to ring CY₁, or a carbon atom bonded to M in Formula 1, wherein one of T₁ to T₄ is a carbon atom bonded to M in Formula 1, and one of the remaining T₁ to T₄ that is not bonded to M is a carbon atom bonded to ring CY₁,
T₅ to T₈ are each independently C or N,
X₇₄ is C(R₇₄) or N, X₇₅ is C(R₇₅) or N, X₇₆ is C(R₇₆) or N, and at least one of X₇₄ to X76 is N,
ring CY₁ and ring CY₁₄ are each independently a C₅-C₃₀ carbocyclic group or a C₁-C₃₀ heterocyclic group,
Ar₂ is ring CY₂ unsubstituted or substituted with at least one Z₀, wherein ring CY₂ is an unsaturated C₅-C₃₀ carbocyclic group or an unsaturated C₁-C₃₀ heterocyclic group,
ring CY₇₁ and ring CY₇₂ are each independently a benzene group, a dibenzofuran group, a dibenzothiophene group, a carbazole group, or a fluorene group,
L₇₁ to L₇₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
R₂₁ to R₂₃ are each independently a C₁-C₆₀ alkyl group or a C₆-C₆₀ aryl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof,
Z₀, Z₁, Z₂, Z₂₉, Z₃₀, R₁₁ to R₁₄, and R₇₁ to R₇₆ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
d2 and e71 to e73 are each independently an integer from 1 to 6, wherein, when d2 is 2 or more, two or more of Ar₂(s) are identical to or different from each other, when e71 is 2 or more, two or more of L₇₁(s) are identical to or different from each other, when e72 is 2 or more, two or more of L₇₂(s) are identical to or different from each other, and when e73 is 2 or more, two or more of L₇₃(s) are identical to or different from each other,
a1 and b1 are each independently an integer from 0 to 20, wherein, when a1 is 2 or more, two or more of Z₁(s) are identical to or different from each other, and when b1 is 2 or more, two or more of R₁₄(s) are identical to or different from each other,
a2 is an integer from 0 to 5, wherein, when a2 is 2 or more, two or more of Z₂(s) are identical to or different from each other,
a73 is an integer from 0 to 8, wherein, when a73 is 2 or more, two or more of R₇₃(s) are identical to or different from each other,
each of: i) two or more of R₂₁ to R₂₃; ii) two or more of a plurality of Z₁(s); iii) two or more of a plurality of Z₂(s); iv) R₁₂ and R₁₃; v) two or more of a plurality of R₁₄(s); and vi) two or more of Z₀, Z₁, Z₂, Z₂₉, Z₃₀, and R₁₁ to R₁₄ are optionally linked together to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as described in connection with R₁₄,
* and *' in Formulae 2A and 2B each indicate a binding site to M in Formula 1,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₆), -Ge(Q₁₃)(Q₁₄)(Q₁₆), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof, and
Q₁ to Q9, Q11 to Q19, Q21 to Q29, and Q31 to Q39 are each independently: hydrogen; deuterium; -F; -Cl; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₂-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

2. The light-emitting device of claim 1, wherein M in Formula 1 is Ir, and i) n1 is 1 and n2 is 2; or ii) n1 is 2 and n2 is 1.

3. The light-emitting device of claims 1 or 2, wherein X₂₁ in Formula 2A is O or S; and/or
wherein ring CY₂ is a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, a borole group, a phosphole group, a silole group, a germole group, a selenophene group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

4. The light-emitting device of any of claims 1-3, wherein Z₁ in Formula 2A is not a group represented by -Si(Q₃)(Q₄)(Q₅); and/or
wherein the first compound comprises at least one deuterium atom, at least one fluoro group (-F), at least one cyano group (-CN), or any combination thereof.

5. The light-emitting device of any of claims 1-4, wherein a group represented by 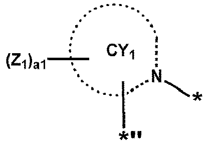 in Formula 2A is a group represented by one of Formulae CY1-1 to CY1-28: 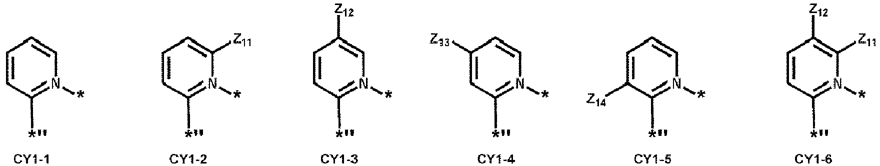 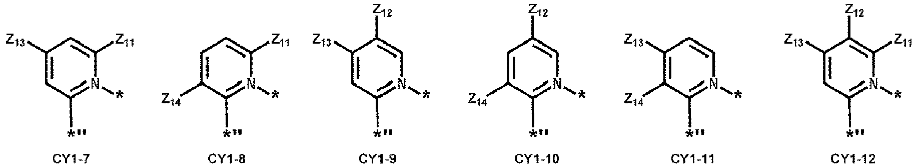 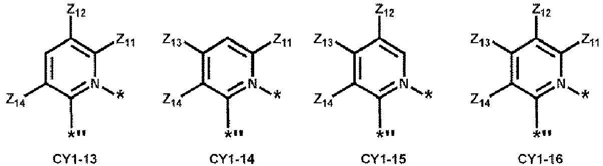 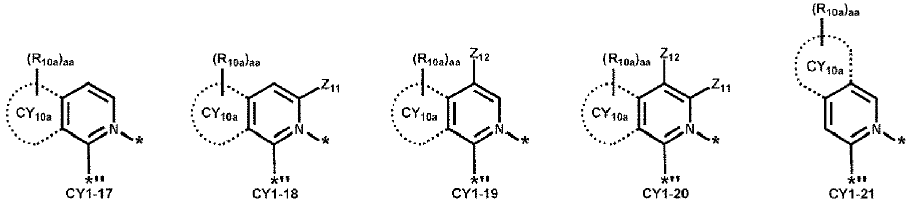 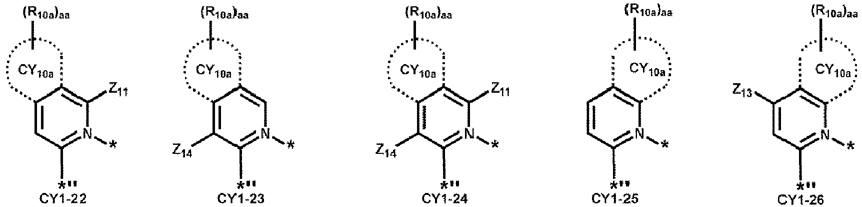 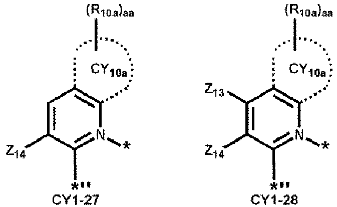 wherein, in Formulae CY1-1 to CY1-28,
Z₁₁ to Z₁₄ are each the same as Z₁, wherein Z₁₁ to Z₁₄ are each not hydrogen, ring CY₁₀ₐ is a C₅-C₃₀ carbocyclic group or a C₁-C₃₀ heterocyclic group,
R₁₀ₐ is the same as R₁₀ₐ,
aa is an integer from 0 to 10,
* indicates a binding site to M in Formula 1, and
*" indicates a binding site to one of T₁ to T₄ in Formula 2A.

6. The light-emitting device of any of claims 1-5, wherein a group represented by 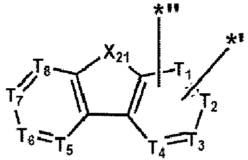 in Formula 2A is a group represented by one of Formulae CY2-1 to CY2-6: 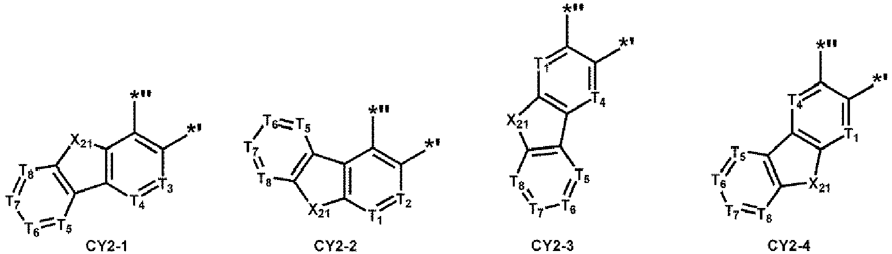 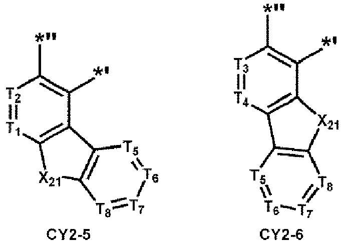 wherein, in Formulae CY2-1 to CY2-6,
T₁ to T₈ are each independently C or N,
X₂₁ is the same as X₂₁,
*" indicates a binding site to ring CY₁ in Formula 2A, and
*' indicates a binding site to M in Formula 1.

7. The light-emitting device of any of claims 1-6, wherein the second compound is a compound represented by Formula 6: 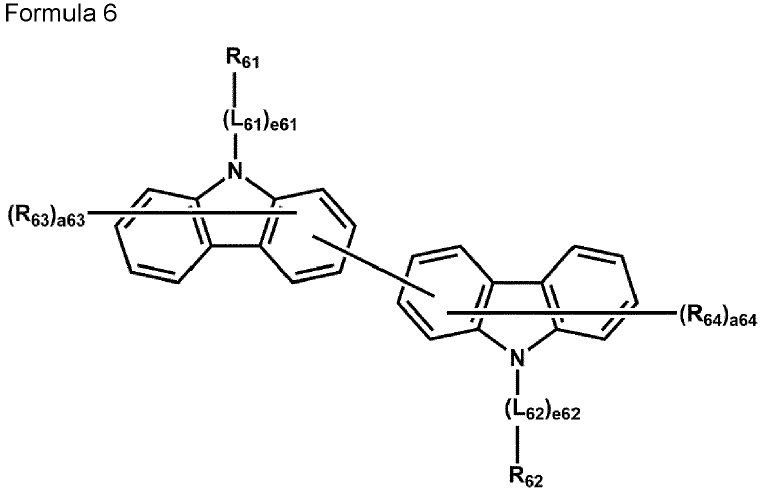 wherein, in Formula 6,
L₆₁ and L₆₂ are each independently a C₅-C₃₀ carbocyclic group unsubstituted or substituted with at least one R₁₀ₐ or a C₁-C₃₀ heterocyclic group unsubstituted or substituted with at least one R₁₀ₐ, R₁₀ₐ is as defined in connection with R₁₀ₐ in claim 1,
e61 and e62 are each independently an integer from 1 to 6,
R₆₁ to R₆₄ are each independently the same as Z₀, and
a63 and a64 are each independently an integer from 0 to 7.

8. The light-emitting device of claim 7, wherein L₆₁ and L₆₂ in Formula 6 are each independently a benzene group, a naphthalene group, a carbazole group, a dibenzofuran group, or a dibenzothiophene group, each unsubstituted or substituted with at least one R₁₀ₐ, and
R₆₁ to R₆₄ in Formula 6 are each independently:
hydrogen, deuterium, -F, or a cyano group;
a C₁-C₂₀ alkyl group unsubstituted or substituted with deuterium, -F, a cyano group, or any combination thereof; or
a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

9. The light-emitting device of any of claims 1-8, wherein, in Formula 7, X₇₄ to X₇₆ are each N, and ring CY₇₁ is a benzene group.

10. The light-emitting device of any of claims 1-9, wherein L₇₁ to L₇₃ in Formula 7 are each independently:
a single bond; or
a benzene group, a naphthalene group, a dibenzofuran group, or a dibenzothiophene group, each unsubstituted or substituted with at least one R₁₀ₐ, and
R₇₁ to R₇₃ in Formula 7 are each independently:
hydrogen, deuterium, -F, or a cyano group;
a C₁-C₂₀ alkyl group unsubstituted or substituted with deuterium, -F, a cyano group, or any combination thereof; or
a phenyl group, a biphenyl group, a dibenzofuranyl group, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

11. The light-emitting device of any of claims 1-10, wherein, in Formula 7, ring CY₇₁ and ring CY₇₂ are each a benzene group,
L₇₁ to L₇₃ are each independently:
a single bond; or
a benzene group unsubstituted or substituted with at least one R₁₀ₐ,
R₇₁ is a dibenzofuranyl group or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof,
R₇₂ is a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof, and
R₇₃ is:
hydrogen, deuterium, -F, or a cyano group;
a C₁-C₂₀ alkyl group unsubstituted or substituted with deuterium, -F, a cyano group, or any combination thereof; or
a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

12. The light-emitting device of any of claims 1-11, wherein, in Formula 7, ring CY₇₁ is a benzene group,
ring CY₇₂ is a carbazole group,
L₇₁ to L₇₃ are each independently:
a single bond; or
a benzene group unsubstituted or substituted with at least one R₁₀ₐ,
R₇₁ and R₇₂ are each independently a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof, and
R₇₃ is:
hydrogen, deuterium, -F, or a cyano group;
a C₁-C₂₀ alkyl group unsubstituted or substituted with deuterium, -F, a cyano group, or any combination thereof; or
a phenyl group or a biphenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, or any combination thereof.

13. The light-emitting device of any of claims 1-12, wherein a highest occupied molecular orbital (HOMO) energy level of the second compound is -5.5 eV or more; and/or
wherein a lowest unoccupied molecular orbital (LUMO) energy level of the third compound is -1.8 eV or less; and/or
wherein the emission layer comprises the first compound, the second compound, and the third compound; and/or
wherein the emission layer comprises a mixture of the first compound, the second compound, and the third compound.

14. An electronic apparatus comprising the light-emitting device of any of claims 1-13.

15. A mixture comprising:
i) a third compound represented by Formula 7; and
ii) at least one of a first compound represented by Formula 1, a second compound that is free of an electron-transporting group, or a combination thereof,
wherein the second compound does not comprise an indolocarbazole group, and
the second compound and the third compound are different from each other:
Formula 1 M(L₁)ₙ₁(L₂)ₙ₂
wherein, in Formula 1,
M is a transition metal,
L₁ is a ligand represented by Formula 2A,
L₂ is a ligand represented by Formula 2B,
n1 and n2 are each independently 1 or 2, when n1 is 2, two of L₁(s) are identical to or different from each other, and when n2 is 2, two of L₂(s) are identical to or different from each other,
the sum of n1 and n2 is 2 or 3, and
L₁ and L₂ are different from each other, 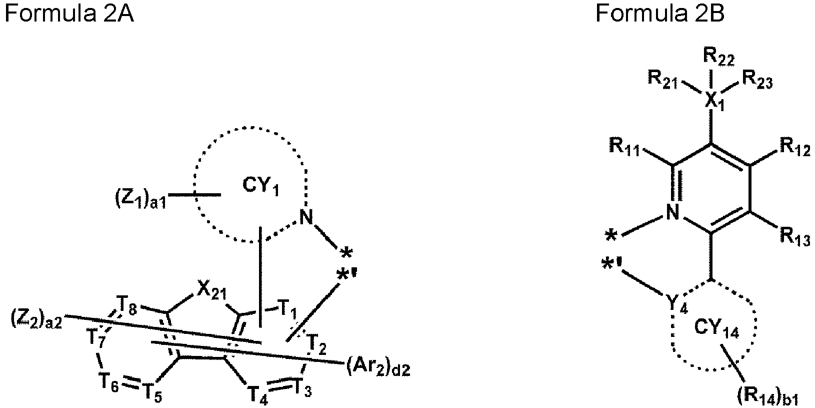 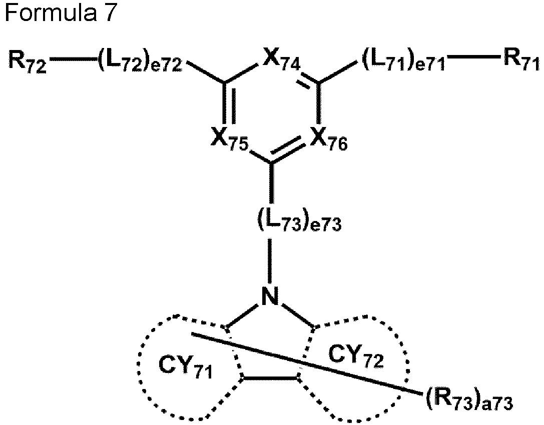
in Formulae 2A, 2B, and 7,
Y₄ is C or N,
X₁ is Si or Ge,
X₂₁ is O, S, S(=O), N(Z₂₉), C(Z₂₉)(Z₃₀), or Si(Z₂₉)(Z₃₀),
T₁ to T₄ are each independently C, N, a carbon atom bonded to ring CY₁, or a carbon atom bonded to M in Formula 1, wherein one of T₁ to T₄ is a carbon atom bonded to M in Formula 1, and one of the remaining T₁ to T₄ that are not bonded to M is a carbon atom bonded to ring CY₁,
T₅ to T₈ are each independently C or N,
X₇₄ is C(R₇₄) or N, X₇₅ is C(R₇₅) or N, X₇₆ is C(R₇₆) or N, and at least one of X₇₄ to X₇₆ is N,
ring CY₁ and ring CY₁₄ are each independently a C₅-C₃₀ carbocyclic group or a C₁-C₃₀ heterocyclic group,
Ar₂ is ring CY₂ unsubstituted or substituted with at least one Z₀, wherein ring CY₂ is an unsaturated C₅-C₃₀ carbocyclic group or an unsaturated C₁-C₃₀ heterocyclic group,
ring CY₇₁ and ring CY₇₂ are each independently a benzene group, a dibenzofuran group, a dibenzothiophene group, a carbazole group, or a fluorene group,
L₇₁ to L₇₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
R₂₁ to R₂₃ are each independently a C₁-C₆₀ alkyl group or a C₆-C₆₀ aryl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₃-C₁₀ cycloalkyl group, a phenyl group, or any combination thereof,
Z₀, Z₁, Z₂, Z₂₉, Z₃₀, R₁₁ to R₁₄, and R₇₁ to R₇₆ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉),
d2 and e71 to e73 are each independently an integer from 1 to 6, wherein, when d2 is 2 or more, two or more of Ar₂(s) are identical to or different from each other, when e71 is 2 or more, two or more of L₇₁(s) are identical to or different from each other, when e72 is 2 or more, two or more of L₇₂(s) are identical to or different from each other, and when e73 is 2 or more, two or more of L₇₃(s) are identical to or different from each other,
a1 and b1 are each independently an integer from 0 to 20, wherein, when a1 is 2 or more, two or more of Z₁(s) are identical to or different from each other, and when b1 is 2 or more, two or more of R₁₄(s) are identical to or different from each other,
a2 is an integer from 0 to 5, wherein, when a2 is 2 or more, two or more of Z₂(s) are identical to or different from each other,
a73 is an integer from 0 to 8, wherein, when a73 is 2 or more, two or more of R₇₃(s) are identical to or different from each other,
each of: i) two or more of R₂₁ to R₂₃; ii) two or more of a plurality of Z₁(s); iii) two or more of a plurality of Z₂(s); iv) R₁₂ and R₁₃; v) two or more of a plurality of R₁₄(s); and vi) two or more of Z₀, Z₁, Z₂, Z₂₉, Z₃₀, and R₁₁ to R₁₄ are optionally linked together to form a C₅-C₃₀ carbocyclic group unsubstituted or substituted with at least one R₁₀ₐ or a C₁-C₃₀ heterocyclic group unsubstituted or substituted with at least one R₁₀ₐ,
R₁₀ₐ is the same as described in connection with R₁₄,
* and *' in Formulae 2A and 2B each indicate a binding site to M in Formula 1,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₂-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is:
deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₆), -Ge(Q₁₃)(Q₁₄)(Q₁₆), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₂-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof, and
Q₁ to Q9, Q11 to Q19, Q21 to Q29, and Q31 to Q39 are each independently: hydrogen; deuterium; -F; -Cl; -Br; -I; a hydroxyl group; a cyano group; a nitro group; an amino group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₁-C₆₀ alkylthio group; a C₃-C₁₀ cycloalkyl group; a C₁-C₁₀ heterocycloalkyl group; a C₃-C₁₀ cycloalkenyl group; a C₂-C₁₀ heterocycloalkenyl group; a C₆-C₆₀ aryl group unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.
